(19) Europäisches Patentamt
European Patent Office
Office européen des brevets

(11) EP 3 761 385 B1

(12) **EUROPEAN PATENT SPECIFICATION**

(45) Date of publication and mention of the grant of the patent:
**14.01.2026 Bulletin 2026/03**

(21) Application number: **20182208.7**

(22) Date of filing: **25.06.2020**

(51) International Patent Classification (IPC):
***H10K 85/60*** *(2023.01)* ***H10K 85/30*** *(2023.01)*
*H10K 50/11* *(2023.01)* *H10K 101/30* *(2023.01)*
*H10K 101/40* *(2023.01)*

(52) Cooperative Patent Classification (CPC):
**H10K 85/346; H10K 85/636; H10K 85/6572;**
H10K 50/11; H10K 85/633; H10K 85/6574;
H10K 85/6576; H10K 2101/30; H10K 2101/40;
H10K 2101/90

(54) **COMPOSITION AND ORGANIC LIGHT-EMITTING DEVICE INCLUDING THE SAME**

ZUSAMMENSETZUNG UND ORGANISCHE LICHTEMITTIERENDE VORRICHTUNG DAMIT

COMPOSITION ET DISPOSITIF ÉLECTROLUMINESCENT ORGANIQUE LA COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.07.2019 KR 20190078954**

(43) Date of publication of application:
**06.01.2021 Bulletin 2021/01**

(73) Proprietors:
- **Samsung Display Co., Ltd.**
  **Gyeonggi-do 17113 (KR)**
- **Samsung SDI Co., Ltd.**
  **Gyeonggi-do (KR)**

(72) Inventors:
- **KIM, Sangdong**
  **16678 Gyeonggi-do (KR)**
- **KWAK, Seungyeon**
  **16678 Gyeonggi-do (KR)**
- **KOO, Hyun**
  **16678 Gyeonggi-do (KR)**
- **KIM, Sungjun**
  **16678 Gyeonggi-do (KR)**
- **KIM, Hyungsun**
  **Gyeonggi-do (KR)**
- **BAIK, Chul**
  **16678 Gyeonggi-do (KR)**
- **SIM, Myungsun**
  **16678 Gyeonggi-do (KR)**
- **YANG, Yongtak**
  **Gyeonggi-do (KR)**
- **LEE, Banglin**
  **16678 Gyeonggi-do (KR)**
- **LEE, Sunyoung**
  **16678 Gyeonggi-do (KR)**
- **LEE, Sunghun**
  **16678 Gyeonggi-do (KR)**
- **YI, Jeoungin**
  **16678 Gyeonggi-do (KR)**
- **CHO, Yuri**
  **16678 Gyeonggi-do (KR)**
- **CHO, Pyeongseok**
  **Gyeonggi-do (KR)**
- **CHOI, Byoungki**
  **16678 Gyeonggi-do (KR)**
- **CHOI, Hyeonho**
  **16678 Gyeonggi-do (KR)**
- **HUH, Dalho**
  **Gyeonggi-do (KR)**
- **HONG, Seokhwan**
  **16678 Gyeonggi-do (KR)**

(74) Representative: **Marks & Clerk LLP**
**15 Fetter Lane**
**London EC4A 1BW (GB)**

(56) References cited:
**EP-A1- 3 439 063** **EP-A2- 3 435 438**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 761 385 B1

## Description

### FIELD OF THE INVENTION

One or more embodiments relate to a composition and an organic light-emitting device including the same.

### BACKGROUND OF THE INVENTION

Organic light-emitting devices are self-emission devices, which have better characteristics in terms of viewing angle, response time, brightness, driving voltage, and response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light. EP 3435438A2 relates to organic electroluminescent materials and devices. EP 3439063 A1 relates to an organic light-emitting device.

### SUMMARY OF THE INVENTION

One or more embodiments relate to a novel composition and an organic light-emitting device including the same.

Additional aspects will be set forth in part in the description which follows and, in part, will be apparent from the description, or may be learned by practice of the presented embodiments.

An aspect of the present disclosure provides a composition defined in the appended set of claims.

Another aspect of the present disclosure provides an organic light-emitting device including: a first electrode; a second electrode; and an organic layer disposed between the first electrode and the second electrode and including an emission layer, wherein the organic layer includes the composition.

### BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms These terms are only used to distinguish one element, component, region, layer or section from another element, component, region, layer or section Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the

associated listed items It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

A composition according to an aspect of the present disclosure includes a platinum (Pt)-containing organometallic compound, a first compound, a second compound, and a third compound. The Pt-containing organometallic compound, the first compound, the second compound, and the third compound will be described in detail below.

The composition does not include iridium (Ir).

The Pt-containing organometallic compound, the first compound, the second compound, and the third compound included in the composition are different from each other. That is, the composition includes 4 or more different compounds.

In one or more embodiments, the Pt-containing organometallic compound may include Pt and an organic ligand, and the Pt and the organic ligand may form 1, 2, 3, or 4 cyclometallated ring(s).

In one or more embodiments, the Pt-containing organometallic compound may include Pt and a tetradentate organic ligand, and the Pt and the tetradentate organic ligand may form 3 or 4 cyclometallated rings.

In one or more embodiments, the Pt-containing organometallic compound may include Pt and a tetradentate organic ligand, and the tetradentate organic ligand may include a benzimidazole group and a pyridine group. Each of the benzimidazole group and the pyridine group may be directly linked to the Pt of the Pt-containing organometallic compound.

An absolute value of a highest occupied molecular orbital (HOMO) energy level of the Pt-containing organometallic compound may be 5.25 eV to 5.55 eV.

The first compound includes at least one electron transport moiety.

In the present specification, the term "electron transport moiety" may be a cyano group, a fluoro group, a π-electron-deficient nitrogen-containing cyclic group, a group represented by one of the following formulae, or any combination thereof:

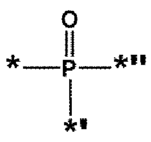 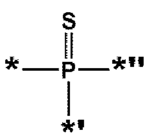 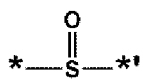 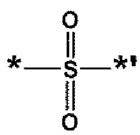 .

In the formulae above, *, *', and *" each indicate a binding site to a neighboring atom.

Neither of the second compound and third compound include a metal.

Each of the absolute value of the HOMO energy level of the second compound and the absolute value of the HOMO energy level of the third compound is 5.30 eV to 5.85 eV, for example, 5.50 eV to 5.75 eV.

The difference between the absolute value of the HOMO energy level of the second compound and the absolute value of the HOMO energy level of the third compound is 0.01 eV to 0.30 eV, for example, 0.05 eV to 0.10 eV. When the difference between the absolute value of the HOMO energy level of the second compound and the absolute value of the HOMO energy level of the third compound is satisfied within the ranges above, the effective HOMO energy disorder parts of the Gaussian disorder model (GDM) are increased to facilitate hole transfer among the Pt-containing organometallic compound, the second compound, and the third compound, and the positive polaron density of the Pt-containing organometallic compound may be maintained at a high level. Accordingly, an electronic device, for example, an organic light-emitting device, including the composition may have high external quantum luminescence efficiency, low driving voltage, and high lifetime characteristics.

In one or more embodiments, at least one of the second compound and the third compound (for example, all of the second compound and the third compound) may not include the electron transport moiety.

In one or more embodiments, the first compound may include at least one $\pi$-electron-rich $C_3$-$C_{30}$ cyclic group and at least one electron transport moiety, and at least one of the second compound and the third compound (for example, all of the second compound and the third compound) may each independently include at least one $\pi$-electron-rich $C_3$-$C_{30}$ cyclic group and may not include the electron transport moiety.

In one or more embodiments, at least one of the second compound and the third compound (for example, all of the second compound and the third compound) may each independently be:

i) a condensed ring in which one or more fifth rings and one or more sixth rings are condensed with each other,
ii) a group represented by

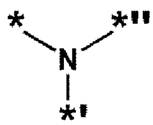

,

or
iii) any combination thereof,

wherein the fifth ring may be a cyclopentadiene group, a pyrrole group, a furan group, a thiophene group, or a silole group,
the sixth ring may be a $\pi$-electron-rich $C_3$-$C_{30}$ cyclic group, and
*, *', and *" each indicate a binding site to a neighboring atom.

In the present specification, the HOMO energy level of each of the Pt-containing organometallic compound, the first compound, the second compound, and the third compound may be measured using a photoelectron spectrometer (for example, AC3 manufactured by RIKEN KEIKI Co., Ltd.) in air.

In one or more embodiments, the Pt-containing organometallic compound may be an organometallic compound represented by Formula 1, and/or
the first compound may be a compound represented by Formula 2. The second compound and the third compound are each independently a compound represented by one of Formulae 3-1 to 3-4:

Formula 1

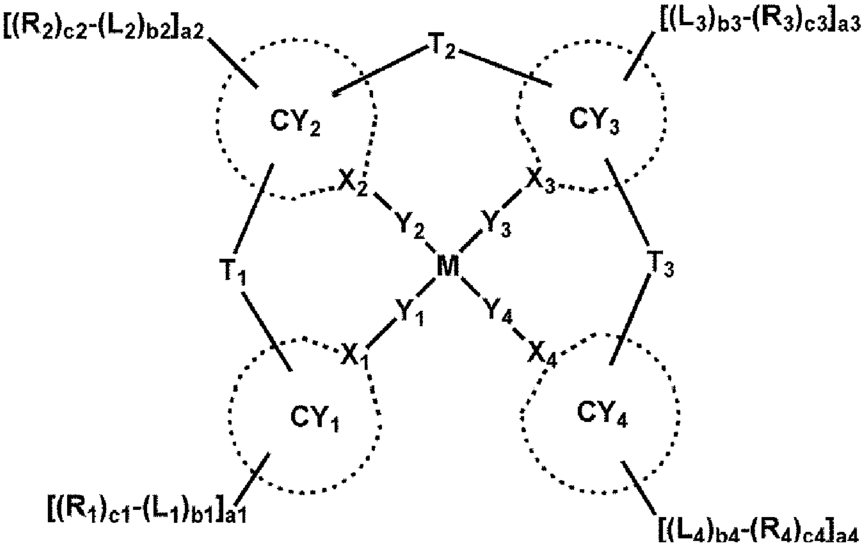

Formula 2

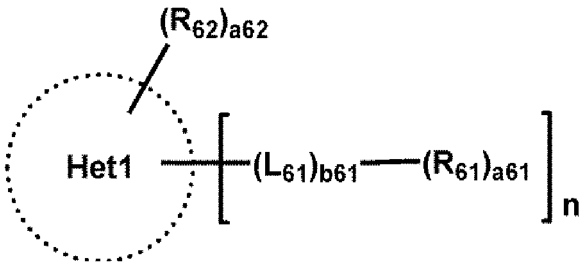

Formula 3-1

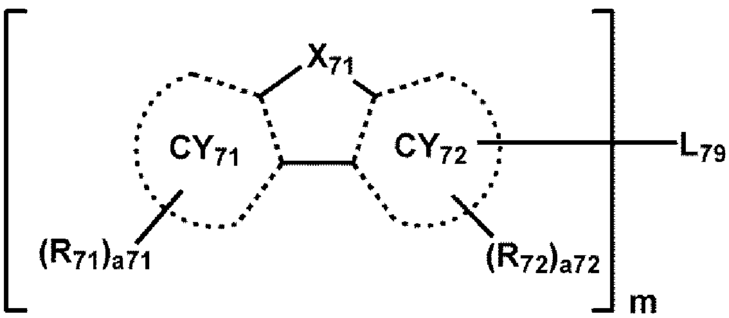

Formula 3-2

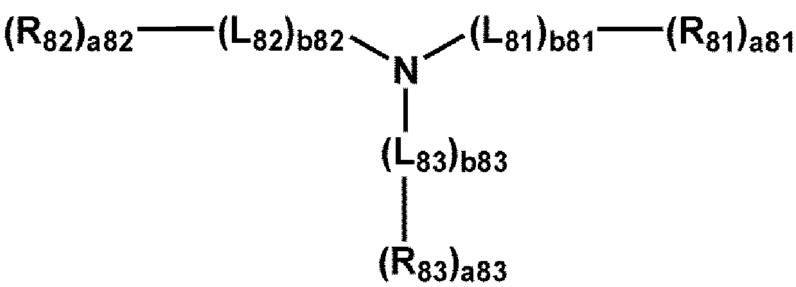

Formula 3-3

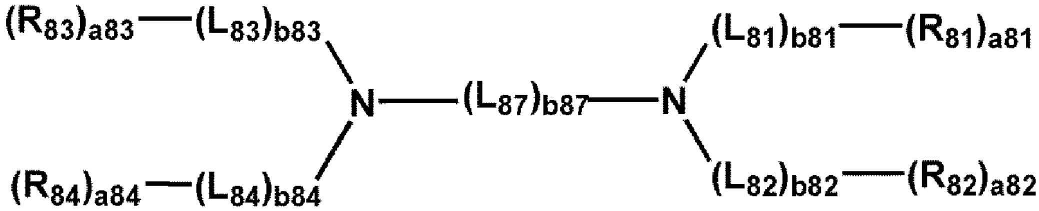

Formula 3-4

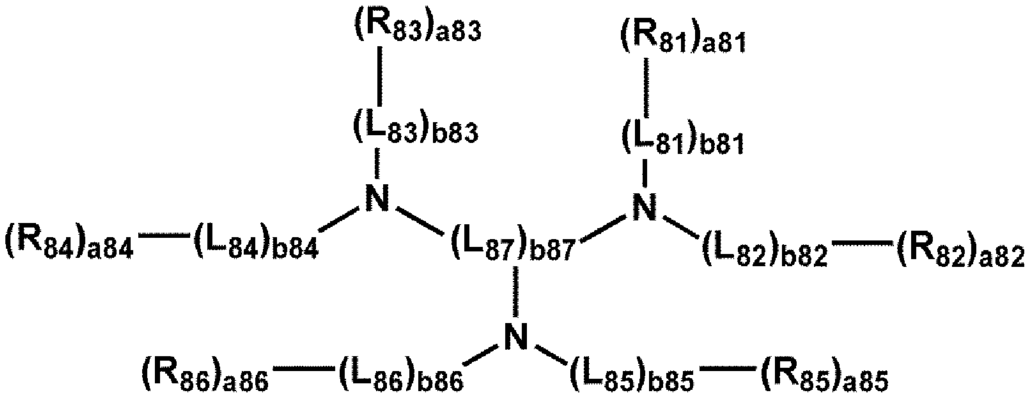

.

In Formula 1, M may be Pt.

In Formula 1, $Y_1$ to $Y_4$ may each independently be a chemical bond (e.g., a covalent bond or a coordinate bond), O, S, $N(R_a)$, $C(R_a)(R_b)$, or $Si(R_a)(R_b)$. When $Y_1$ is a chemical bond, $X_1$ may directly bind to M, when $Y_2$ is a chemical bond, $X_2$ may directly bind to M, when $Y_3$ is a chemical bond, $X_3$ may directly bind to M, and when $Y_4$ is a chemical bond, $X_4$ may directly bind to M.

For example, in Formula 1, $Y_1$ may be O or S, and $Y_2$ to $Y_4$ may be chemical bonds.

In Formula 1, $X_1$ to $X_4$ may each independently be C or N.

In one or more embodiments, in Formula 1, $Y_1$ may be O or S, $Y_2$ to $Y_4$ may each be a chemical bond, $X_1$ and $X_3$ may each be C, and $X_2$ and $X_4$ may each independently be N, but embodiments of the present disclosure are not limited thereto.

In Formula 1, two bonds among a bond between M and $Y_1$ or $X_1$, a bond between M and $Y_2$ or $X_2$, a bond between M and $Y_3$ or $X_3$, and a bond between M and $Y_4$ or $X_4$ may be coordinate bonds, and the other two bonds may each be covalent bonds. Therefore, the organometallic compound represented by Formula 1 may be electrically neutral.

For example, $Y_1$ may not be a chemical bond. $Y_2$ to $Y_4$ may each be a chemical bond. A bond between $Y_1$ and M and a bond between $X_3$ and M may be covalent bonds. A bond between $X_2$ and M and a bond between $X_4$ and M may be coordinate bonds.

In Formula 1, ring $CY_1$ to ring $CY_4$ may each independently be a $C_5$-$C_{30}$ carbocyclic group or a $C_1$-$C_{30}$ heterocyclic group.

In one or more embodiments, in Formula 1, ring $CY_1$ to ring $CY_4$ may each independently be i) a first ring, ii) a second ring, iii) a condensed ring in which two or more first rings are condensed with each other, iv) a condensed ring in which two or more second rings are condensed with each other, or v) a condensed ring in which one or more first rings are condensed with one or more second rings, wherein

the first ring may be a cyclohexane group, a cyclohexene group, an adamantane group, a norbornane group, a norbornene group, a benzene group, a pyridine group, a pyrimidine group, a pyrazine group, a pyridazine group, or a triazine group, and

the second ring may be a cyclopentane group, a cyclopentene group, a cyclopentadiene group, a furan group, a thiophene group, a silole group, a pyrrole group, a pyrazole group, an imidazole group, a triazole group, an oxazole group, an isoxazole group, a thiazole group, an isothiazole group, an azasilole group, an oxadiazole group, or thiadiazole group.

In one or more embodiments, in Formula 1, ring $CY_1$ to ring $CY_4$ may each independently be a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments,

ring $CY_1$ in Formula 1 may be a group represented by one of Formulae CY1-1 to CY1-26, and/or
ring $CY_2$ in Formula 1 may be a group represented by one of Formulae CY2-1 to CY2-19, and/or
ring $CY_3$ in Formula 1 may be a group represented by one of Formulae CY3-1 to CY3-18, and/or
ring $CY_4$ in Formula 1 may be a group represented by one of Formulae CY4-1 to CY4-26:

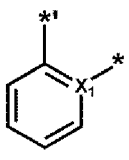
CY1-1

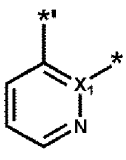
CY1-2

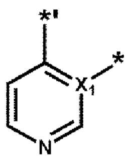
CY1-3

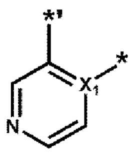
CY1-4

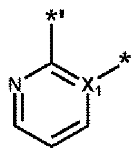
CY1-5

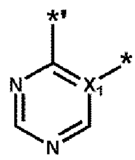
CY1-6

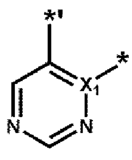
CY1-7

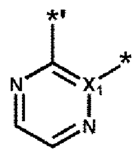
CY1-8

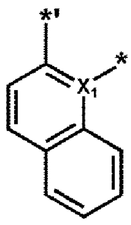
CY1-9

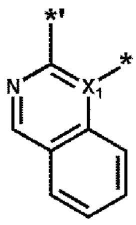
CY1-10

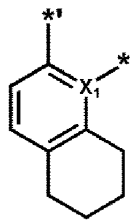
CY1-11

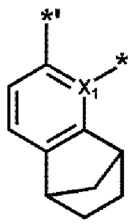
CY1-12

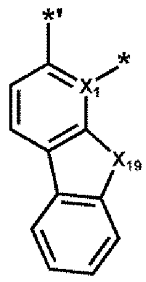
CY1-13

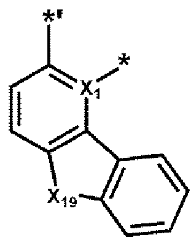
CY1-14

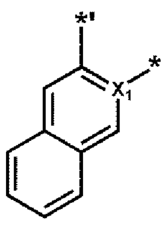
CY1-15

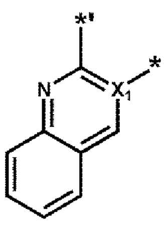
CY1-16

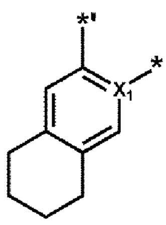
CY1-17

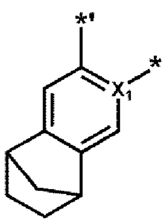
CY1-18

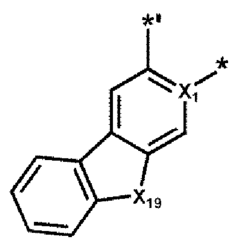
CY1-19

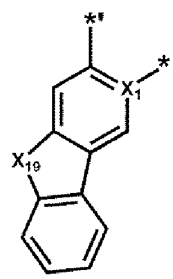
CY1-20

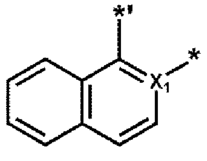
CY1-21

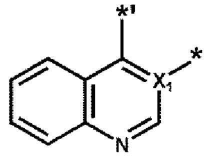
CY1-22

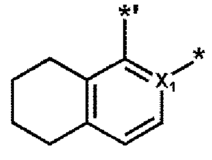
CY1-23

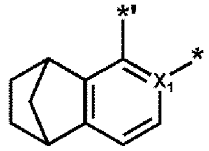
CY1-24

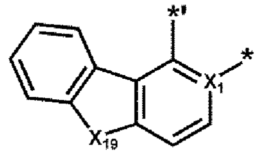
CY1-25

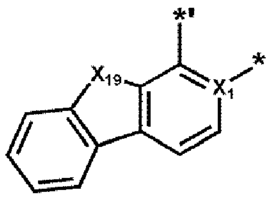
CY1-26

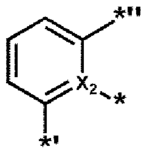
CY2-1

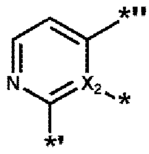
CY2-2

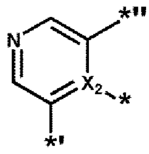
CY2-3

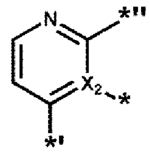
CY2-4

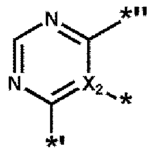
CY2-5

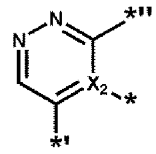
CY2-6

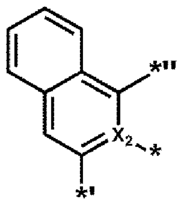
CY2-7

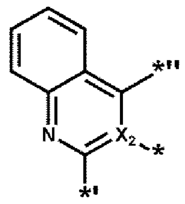
CY2-8

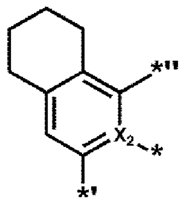
CY2-9

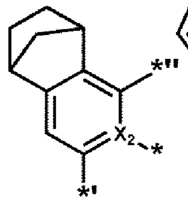
CY2-10

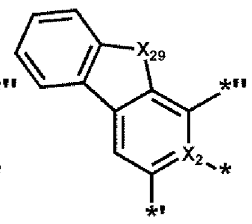
CY2-11

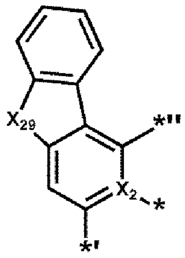
CY2-12

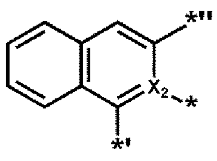
CY2-13

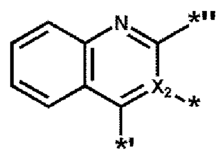
CY2-14

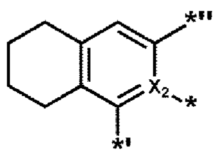
CY2-15

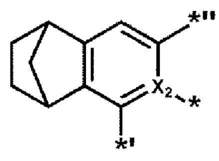
CY2-16

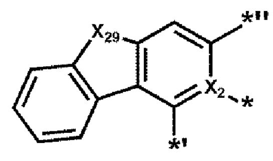
CY2-17

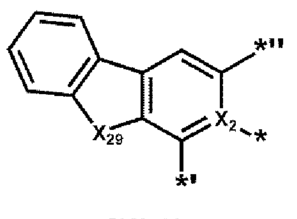
CY2-18

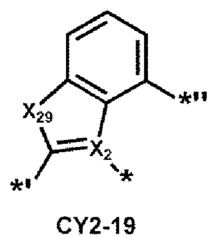
CY2-19

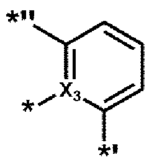
CY3-1

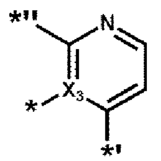
CY3-2

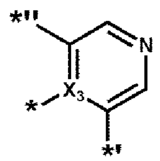
CY3-3

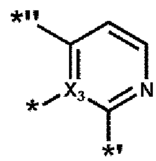
CY3-4

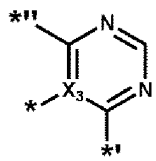
CY3-5

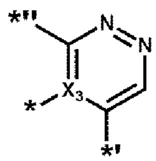
CY3-6

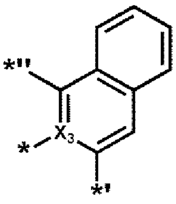
CY3-7

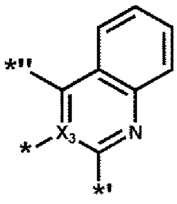
CY3-8

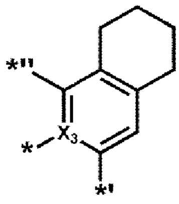
CY3-9

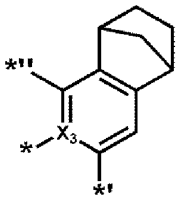
CY3-10

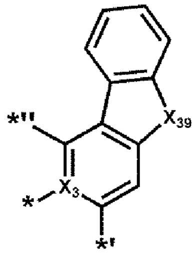
CY3-11

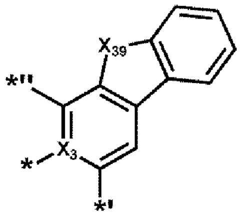
CY3-12

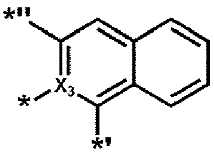
CY3-13

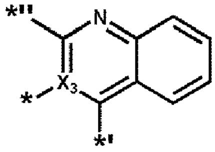
CY3-14

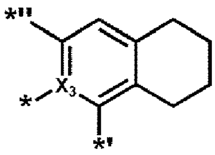
CY3-15

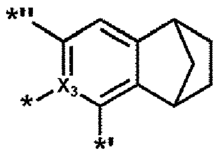
CY3-16

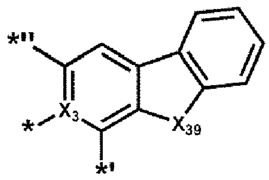
CY3-17

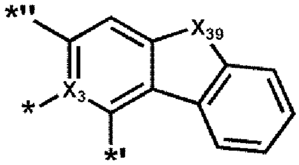
CY3-18

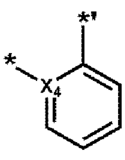
CY4-1

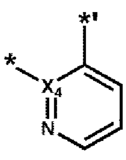
CY4-2

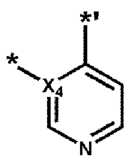
CY4-3

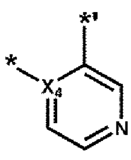
CY4-4

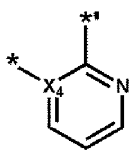
CY4-5

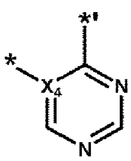
CY4-6

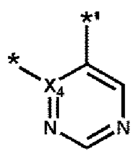
CY4-7

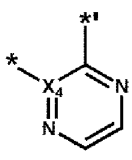
CY4-8

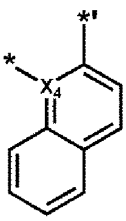
CY4-9

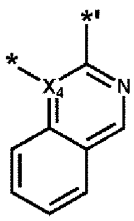
CY4-10

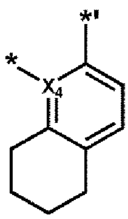
CY4-11

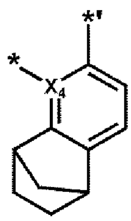
CY4-12

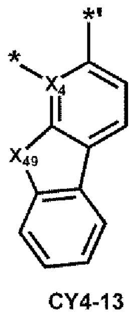
CY4-13

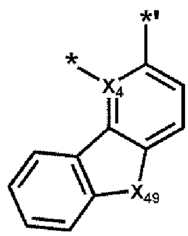
CY4-14

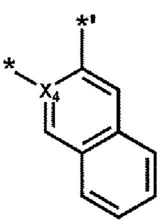
CY4-15

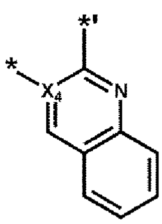
CY4-16

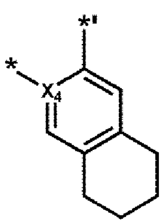
CY4-17

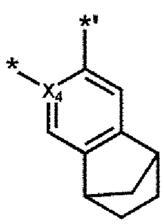
CY4-18

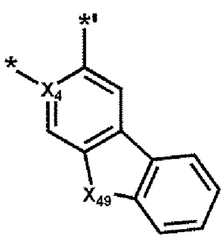
CY4-19

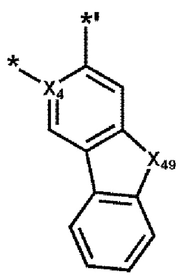
CY4-20

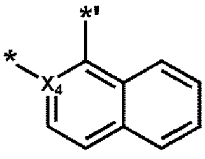

CY4-21

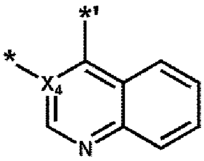

CY4-22

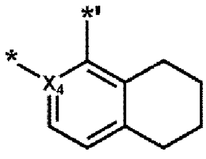

CY4-23

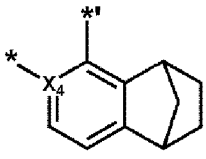

CY4-24

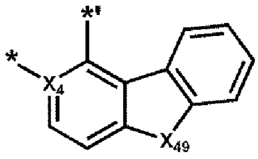

CY4-25

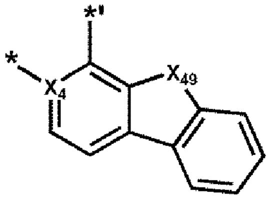

CY4-26

In Formulae CY1-1 to CY1-26, $X_{19}$ may be O, S, $C(R_{17})(R_{18})$, $Si(R_{17})(R_{18})$, or $N-[(L_{19})_{b19}-(R_{19})_{c19}]$, $R_{17}$ to $R_{19}$ may each be the same as defined in connection with $R_1$, $L_{19}$, b19, and c19 may each be the same as defined in connection with $L_1$, b1, and c1, respectively, * indicates a binding site to M or $Y_1$ in Formula 1, and *' indicates a binding site to $T_1$ or ring $CY_2$ in Formula 1.

In Formulae CY2-1 to CY2-19, $X_{29}$ may be O, S, $C(R_{27})(R_{28})$, $Si(R_{27})(R_{28})$, or $N-[(L_{29})_{b29}-(R_{29})_{c29}]$, $R_{27}$ to $R_{29}$ may each be the same as defined in connection with $R_2$, $L_{29}$, b29, and c29 may each be the same as defined in connection with $L_2$, b2, and c2, respectively, * indicates a binding site to M or $Y_2$ in Formula 1, *' indicates a binding site to $T_1$ or ring $CY_1$ in Formula 1, and *" indicates a binding site to $T_2$ or ring $CY_3$ in Formula 1.

In Formulae CY3-1 to CY3-18, $X_{39}$ may be O, S, $C(R_{37})(R_{38})$, $Si(R_{37})(R_{38})$, or $N-[(L_{39})_{b39}-(R_{39})_{c39}]$, $R_{37}$ to $R_{39}$ may each be the same as defined in connection with $R_3$, $L_{39}$, b39, and c39 may each be the same as defined in connection with $L_3$, b3, and c3, respectively, * indicates a binding site to M or $Y_3$ in Formula 1, *" indicates a binding site to $T_2$ or ring $CY_2$ in Formula 1, and *' indicates a binding site to $T_3$ or ring $CY_4$ in Formula 1.

In Formulae CY4-1 to CY4-26, $X_{49}$ may be O, S, $C(R_{47})(R_{48})$, $Si(R_{47})(R_{48})$, or $N-[(L_{49})_{b49}-(R_{49})_{c49}]$, $R_{47}$ to $R_{49}$ may each be the same as defined in connection with $R_4$, $L_{49}$, b49, and c49 may each be the same as defined in connection with $L_4$, b4, and c4, respectively, * indicates a binding site to M or $Y_4$ in Formula 1, and *' indicates a binding site to $T_3$ or ring $CY_3$ in Formula 1.

In Formula 1, $T_1$ may be a single bond, a double bond, $*-N(R_{51})-*'$, $*-B(R_{51})-*'$, $*-P(R_{51})-*'$, $*-C(R_{51})(R_{52})-*'$, $*-Si(R_{51})(R_{52})-*'$, $*-Ge(R_{51})(R_{52})-*'$, *-S-*', *-Se-*', *-O-*', *-C(=O)-*', *-S(=O)-*', $*-S(=O)_2-*'$, $*-C(R_{51})=*'$, $*=C(R_{51})-*'$, $*-C(R_{51})=C(R_{52})-*'$, *-C(=S)-*', or *-C≡C-*', $T_2$ may be a single bond, a double bond, $*-N(R_{53})-*'$, $*-B(R_{53})-*'$, $*-P(R_{53})-*'$, $*-C(R_{53})(R_{54})-*'$, $*-Si(R_{53})(R_{54})-*'$, $*-Ge(R_{53})(R_{54})-*'$, *-S-*', *-Se-*', *-O-*', *-C(=O)-*', *-S(=O)-*', $*-S(=O)_2-*'$, $*-C(R_{53})=*'$, $*=C(R_{53})-*'$, $*-C(R_{53})=C(R_{54})-*'$, *-C(=S)-*', or *-C=C-*', and $T_3$ may be a single bond, a double bond, $*-N(R_{55})-*'$, $*-B(R_{55})-*'$, $*-P(R_{55})-*'$, $*-C(R_{55})(R_{56})-*'$, $*-Si(R_{55})(R_{56})-*'$, $*-Ge(R_{55})(R_{56})-*'$, *-S-*', *-Se-*', *-O-*', *-C(=O)-*', *-S(=O)-*', $*-S(=O)_2-*'$, $*-C(R_{55})=*'$, $*=C(R_{55})-*'$, $*-C(R_{55})=C(R_{56})-*'$, *-C(=S)-*', or *-C≡C-*'.

For example, in Formula 1, ring $CY_2$ may be a benzoxazole group, a benzothiazole group, or a benzimidazole group, and $T_1$ to $T_3$ may each be a single bond.

In one or more embodiments, in Formula 1, ring $CY_2$ may be a pyridine group, a pyrimidine group, a pyridazine group, a pyrazine group, a triazine group, a quinoline group, an isoquinoline group, an azafluorene group, an azacarbazole group, an azadibenzofuran group, or an azadibenzothiophene group, and at least one of $T_1$ to $T_3$ may not be a single bond.

In Formula 2, Het1 may be a π-electron-deficient nitrogen-containing $C_1$-$C_{30}$ cyclic group.

In Formula 3-1, ring $CY_{71}$ and ring $CY_{72}$ are each independently a π-electron-rich $C_3$-$C_{30}$ cyclic group, and ring $CY_{71}$ and ring $CY_{72}$ are optionally linked to each other via a π-electron-rich $C_3$-$C_{30}$ cyclic group.

In the present specification, the term "π-electron-deficient nitrogen-containing cyclic group" refers to a heterocyclic group including *=N-*' as a ring-forming moiety, and may be, for example, i) a third ring, ii) a condensed ring in which two or more third rings are condensed with each other, or iii) a condensed ring in which one or more third rings are condensed with one or more fourth rings. In the present specification, the term "π-electron-deficient nitrogen-containing $C_1$-$C_{30}$ cyclic group" refers to a π-electron-deficient nitrogen-containing cyclic group having 1 to 30 carbon atoms.

In the present specification, the term "π-electron-rich cyclic group" refers to a carbocyclic or heterocyclic group not including *=N-*' as a ring-forming moiety, and may be, for example, i) a fourth ring or ii) a condensed ring in which two or more fourth rings are condensed with each other. In the present specification, the term "π-electron-rich $C_3$-$C_{30}$ cyclic group" refers to a π-electron-rich cyclic group having 3 to 30 carbon atoms.

In the present specification, the "third ring" may be an imidazole group, a pyrazole group, a thiazole group, an

isothiazole group, an oxazole group, an isoxazole group, an azasilole group, a triazole group, a tetrazole group, an oxadiazole group, a thiadiazole group, a pyridine group, a pyrazine group, a pyridazine group, a pyrimidine group, or a triazine group.

In the present specification, the "fourth ring" may be a benzene group, a cyclopentadiene group, a pyrrole group, a furan group, a thiophene group, or a silole group.

The "π-electron-deficient nitrogen-containing cyclic group" may be, for example, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a pyridopyrazine group, a pyrrolophenanthrene group, a furanophenanthrene group, or a thienophenanthrene group, but embodiments of the present disclosure are not limited thereto.

The "π-electron-rich cyclic group" may be, for example, a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphtho pyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, a benzonaphthofuran group, a benzonaphthothiophene group, an (indolo)phenanthrene group, a (benzofurano)phenanthrene group, or a (benzothieno)phenanthrene group, but embodiments of the present disclosure are not limited thereto.

In one or more embodiments, Het1 in Formula 2 may be a group represented by one of Formulae 2-1 to 2-42:

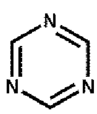
2-1
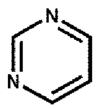
2-2
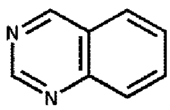
2-3
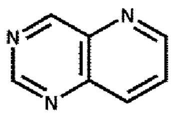
2-4
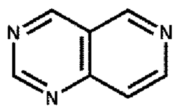
2-5
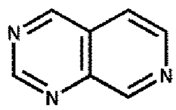
2-6
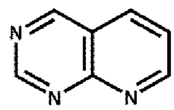
2-7

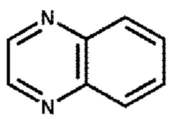
2-8
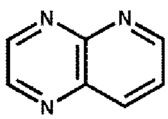
2-9
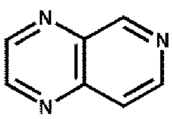
2-10
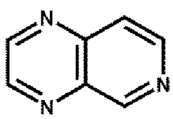
2-11
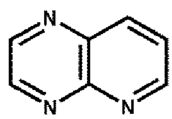
2-12
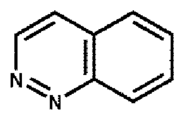
2-13

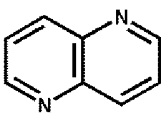
2-14
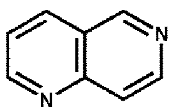
2-15
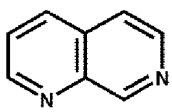
2-16
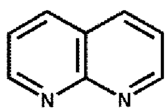
2-17
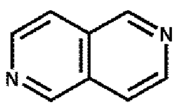
2-18
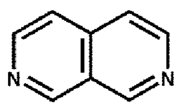
2-19

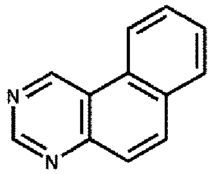
2-20
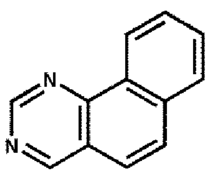
2-21
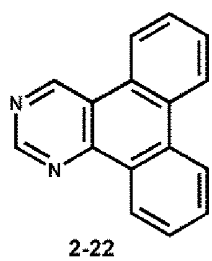
2-22
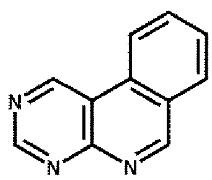
2-23
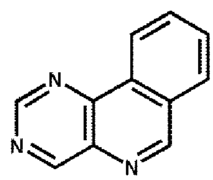
2-24

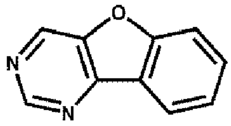
2-25

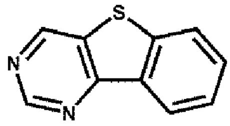
2-26

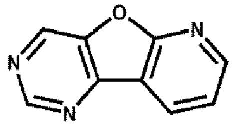
2-27

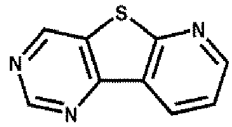
2-28

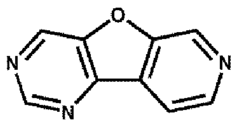
2-29

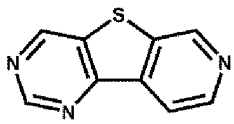
2-30

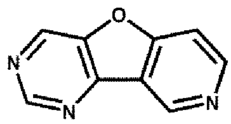
2-31

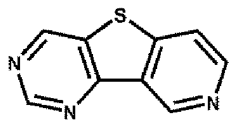
2-32

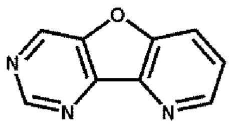
2-33

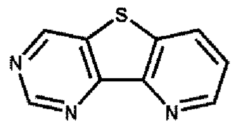
2-34

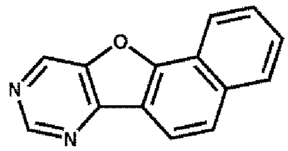
2-35

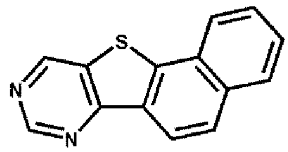
2-36

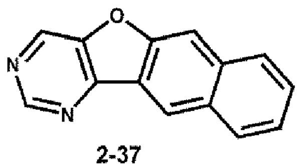
2-37

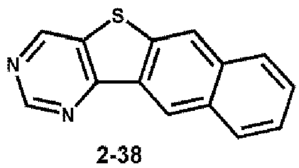
2-38

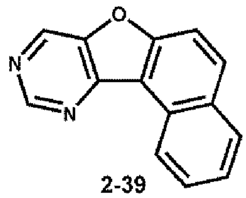
2-39

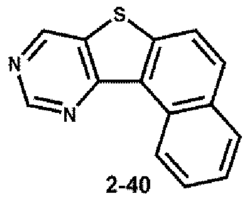
2-40

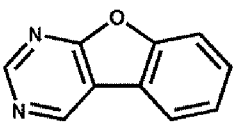
2-41

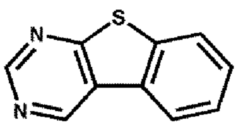
2-42

In one or more embodiments, a group represented by

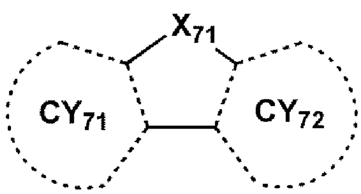

in Formula 3-1 may be a group represented by one of Formulae 3(1) to 3(96):

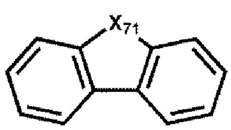
3(1)

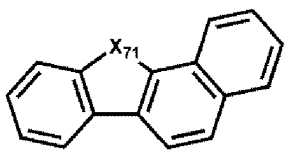
3(2)

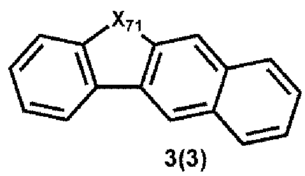
3(3)

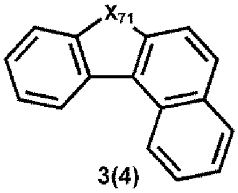
3(4)

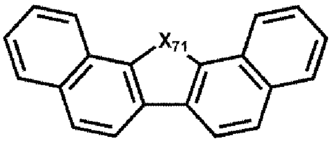
3(5)

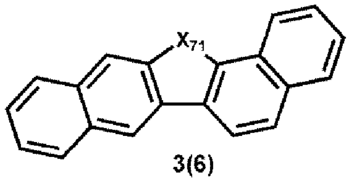
3(6)

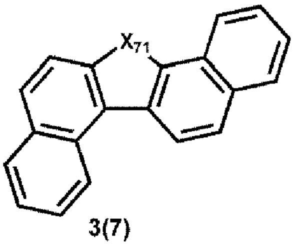
3(7)

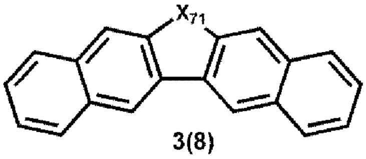
3(8)

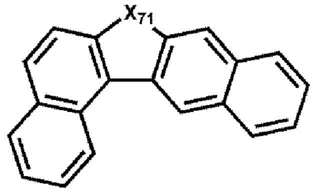
3(9)

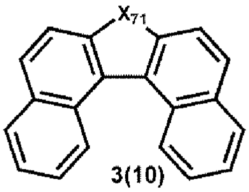
3(10)

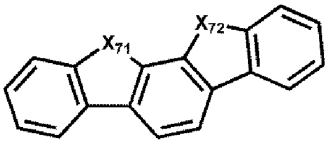
3(11)

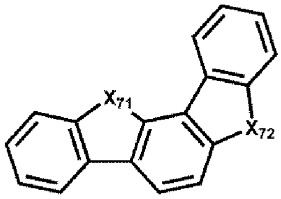
3(12)

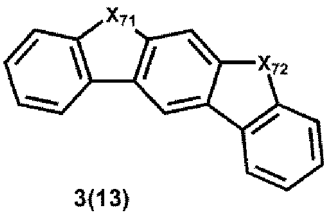
3(13)

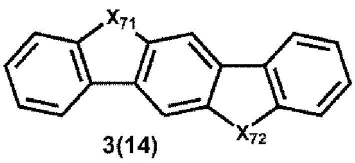
3(14)

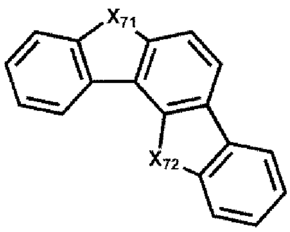
3(15)

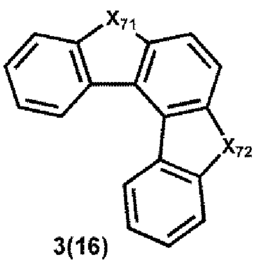
3(16)

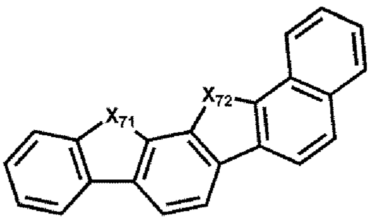
3(17)

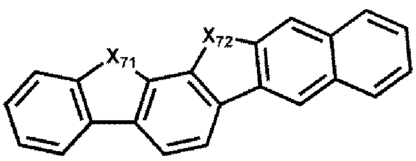
3(18)

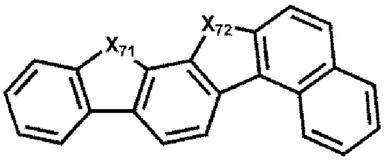
3(19)

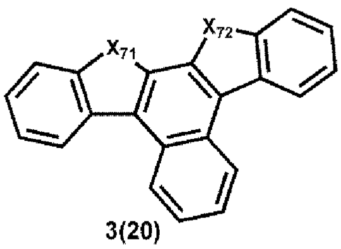
3(20)

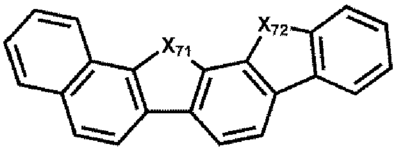
3(21)

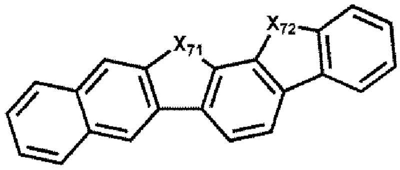

3(22)

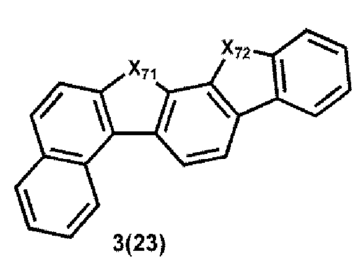

3(23)

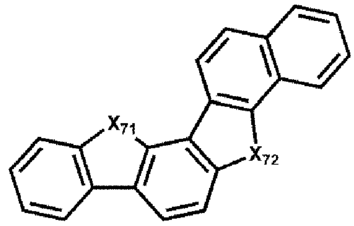

3(24)

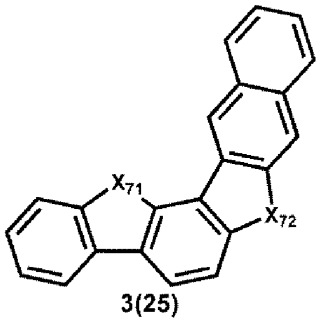

3(25)

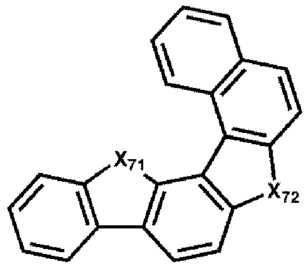

3(26)

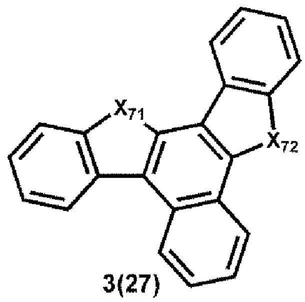

3(27)

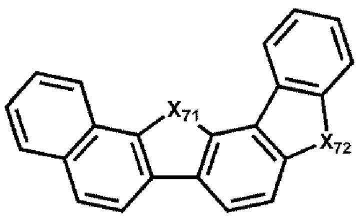

3(28)

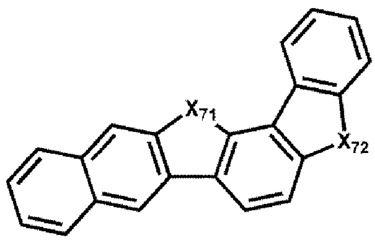

3(29)

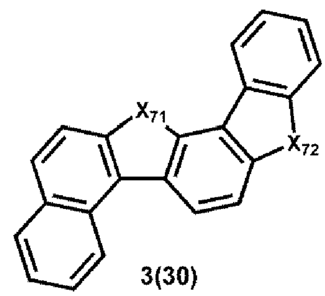

3(30)

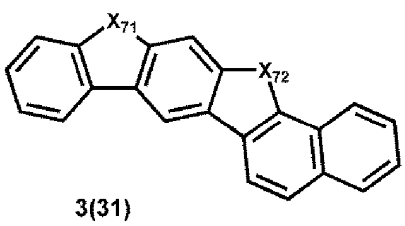

3(31)

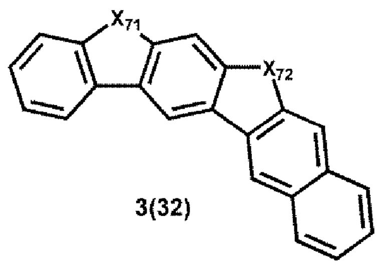

3(32)

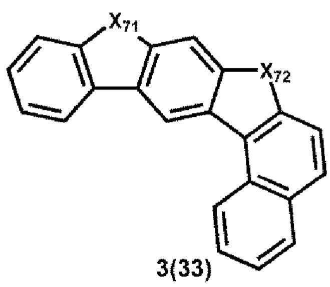

3(33)

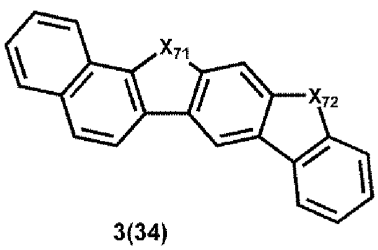

3(34)

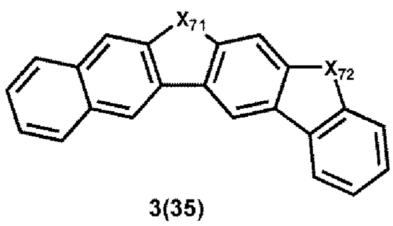

3(35)

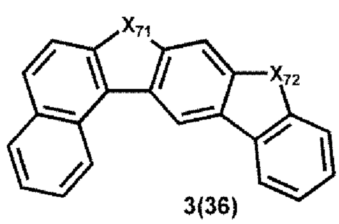

3(36)

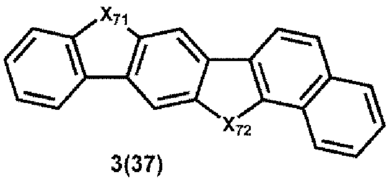
3(37)

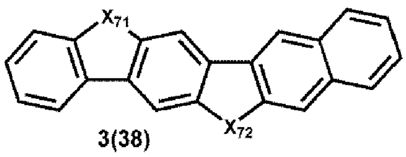
3(38)

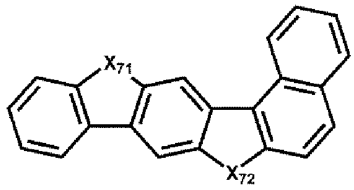
3(39)

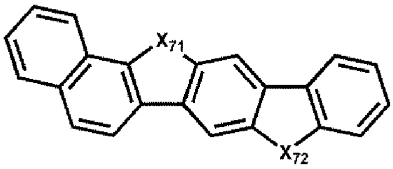
3(40)

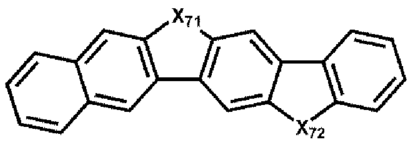
3(41)

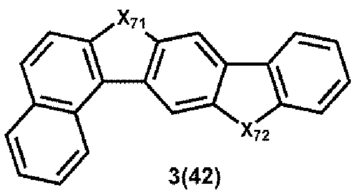
3(42)

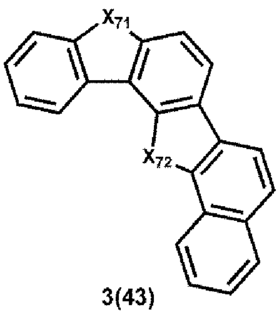
3(43)

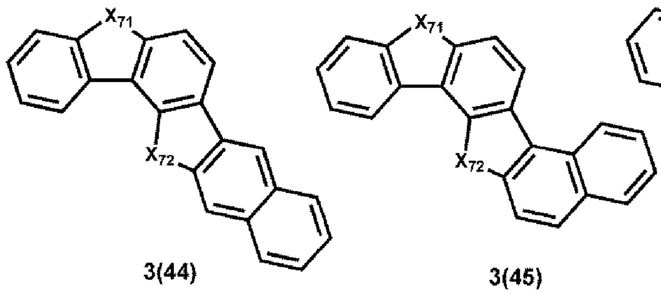
3(44)

3(45)

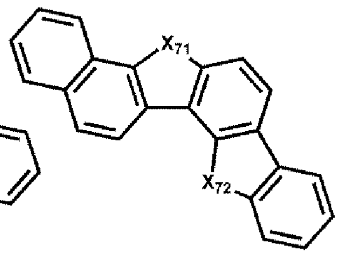
3(46)

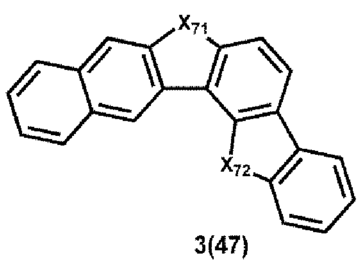
3(47)

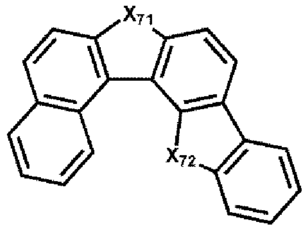
3(48)

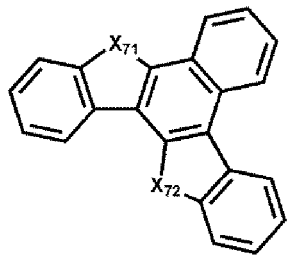
3(49)

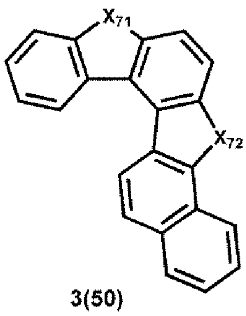
3(50)

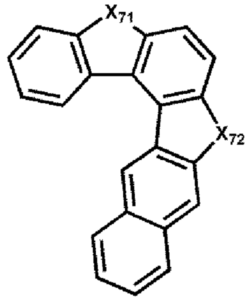
3(51)

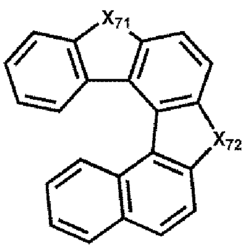
3(52)

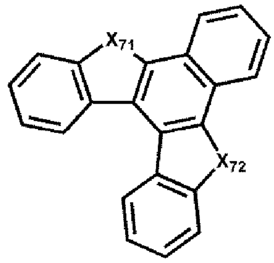
3(53)

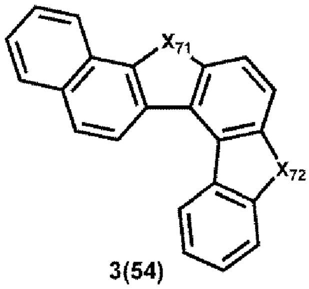

3(54)

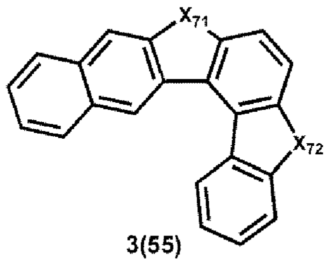

3(55)

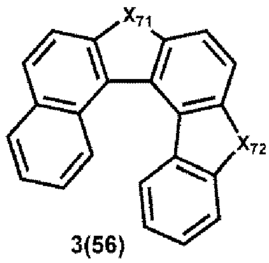

3(56)

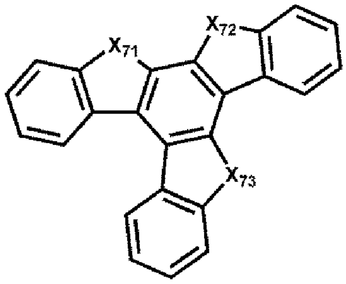

3(57)

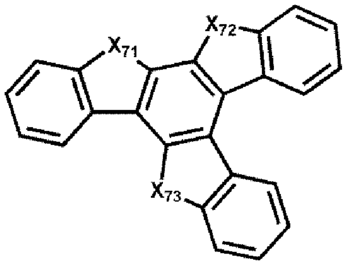

3(58)

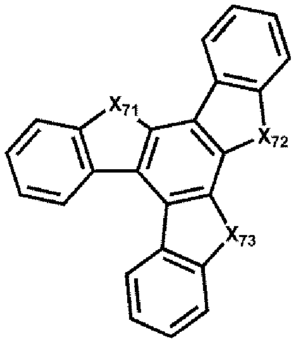

3(59)

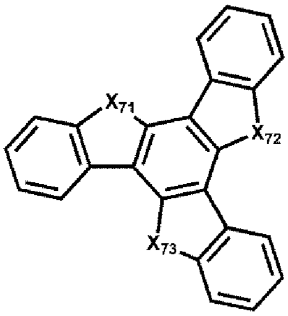

3(60)

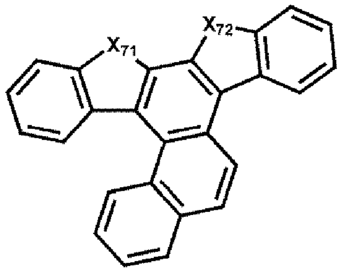

3(61)

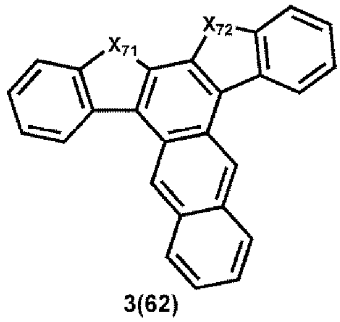

3(62)

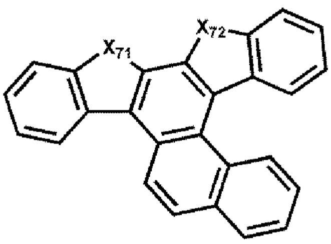

3(63)

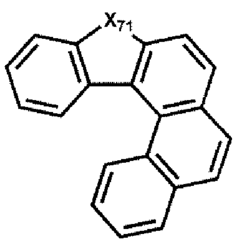

3(64)

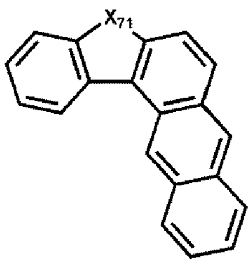

3(65)

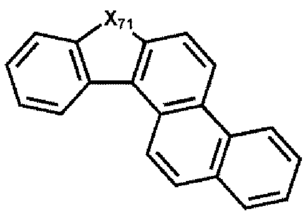

3(66)

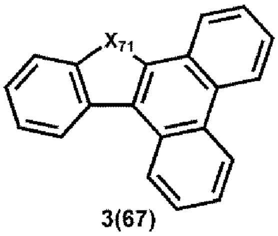

3(67)

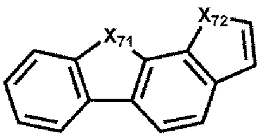

3(68)

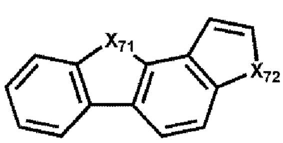

3(69)

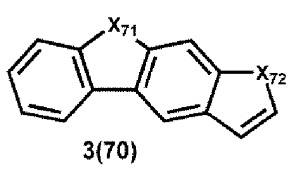

3(70)

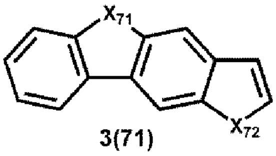
3(71)

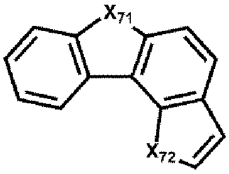
3(72)

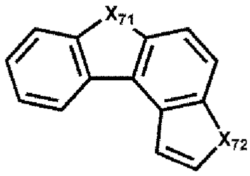
3(73)

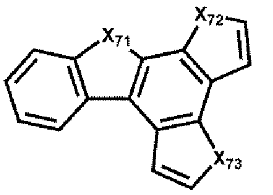
3(74)

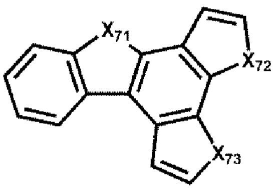
3(75)

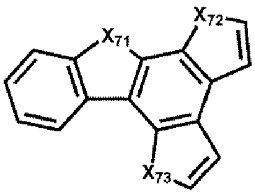
3(76)

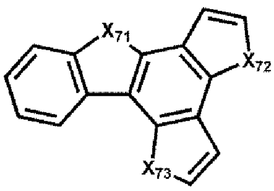
3(77)

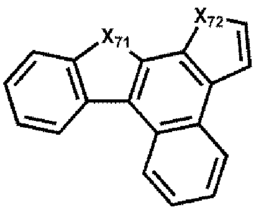
3(78)

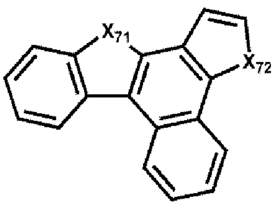
3(79)

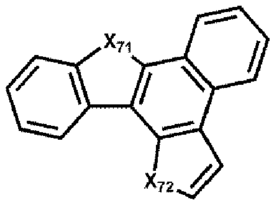
3(80)

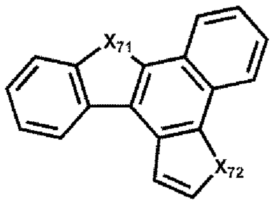
3(81)

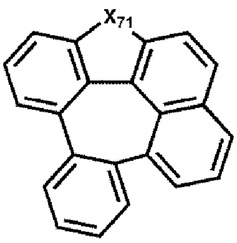
3(82)

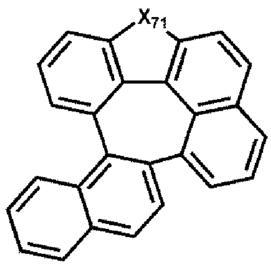
3(83)

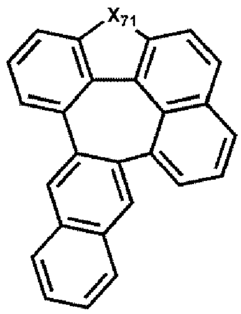
3(84)

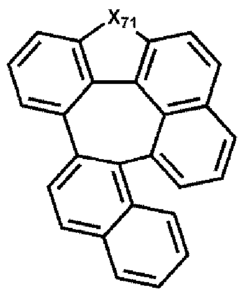
3(85)

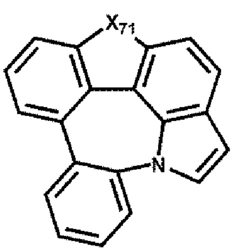
3(86)

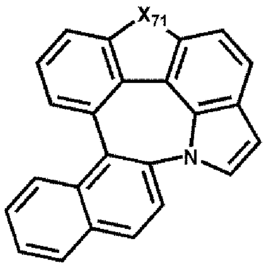
3(87)

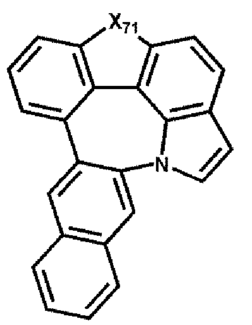
3(88)

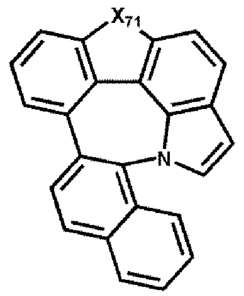
3(89)

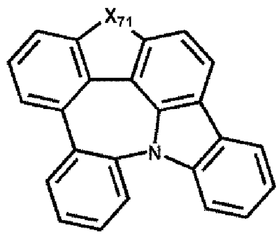

3(90)

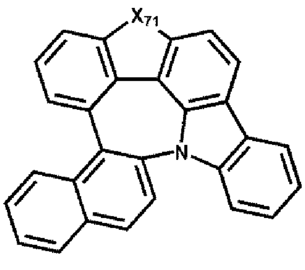

3(91)

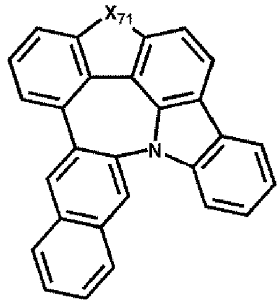

3(92)

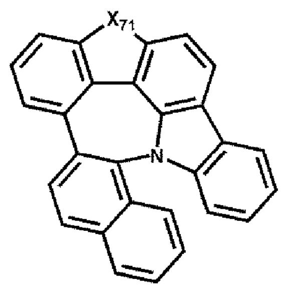

3(93)

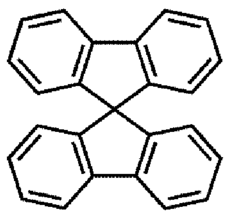

3(94)

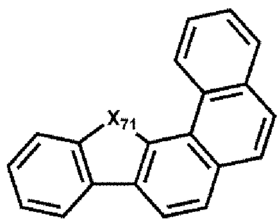

3(95)

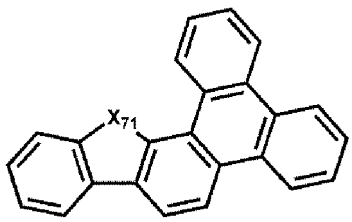

3(96)

.

In Formulae 3(1) to 3(96),

$X_{71}$ may be the same as described below,
$X_{72}$ may be O, S, $N(R_{78a})$, $C(R_{78a})(R_{78b})$, or $Si(R_{78a})(R_{78b})$,
$X_{73}$ may be O, S, $N(R_{79a})$, $C(R_{79a})(R_{79b})$, or $Si(R_{79a})(R_{79b})$, and
$R_{78a}$, $R_{78b}$, $R_{79a}$, and $R_{79b}$ may each be the same as defined in connection with $R_{71}$.

In Formula 3-1, $X_{71}$ is O, S, $N-(L_{75})_{b75}-(R_{75})_{a75}$, $C(R_{75})(R_{76})$, or $Si(R_{75})(R_{76})$.

In Formula 3-1, $L_{79}$ may be a single bond or a $\pi$-electron-rich $C_3$-$C_{30}$ cyclic group.

In Formula 2, n may be an integer from 1 to 10. When n is 2 or more, two or more groups represented by $*-(L_{61})_{b61}-(R_{61})_{a61}$ may be identical to or different from each other. For example, n in Formula 2 may be 1, 2, or 3, but embodiments of the present disclosure are not limited thereto.

In Formula 3-1, m is 1, 2, or 3. When m is 1, $L_{79}$ is absent. For example, m in Formula 3-1 may be 1 or 2.

In Formulae 1 and 2, $L_1$ to $L_4$ and $L_{61}$ may each independently be a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

For example, in Formulae 1 and 2, $L_1$ to $L_4$ and $L_{61}$ may each independently be a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphtho pyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an (indolo)phenanthrene group, a (benzofurano)phenanthrene group, or a (benzothieno)phenanthrene group, each unsubstituted or substituted with at least one $R_{10a}$.

In Formulae 1 and 2, b1 to b4 and b61 each indicate the numbers of $L_1$ to $L_4$ and $L_{61}$, respectively, and may each independently be one of an integer from 1 to 10 (e.g., 1, 2, or 3). In Formulae 3-1 to 3-4, b75 and b81 to b87 each indicate the numbers of $L_{75}$ and $L_{81}$ to $L_{87}$, respectively, and are each independently one of an integer from 1 to 10 (e.g., 1, 2, or 3).

In Formulae 1 and 2, $R_a$, $R_b$, $R_1$ to $R_4$, $R_{51}$ to $R_{56}$, $R_{61}$ and $R_{62}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or $-P(=O)(Q_8)(Q_9)$. $Q_1$ to $Q_9$ may be the same as described below.

In one or more embodiments, $R_a$, $R_b$, $R_1$ to $R_4$, $R_{51}$ to $R_{56}$, $R_{61}$ and $R_{62}$ in Formulae 1 and 2 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof;

a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentylgroup, a bicyclo [2.1.1]a hexyl group, a bicyclo[2.2.1]a heptyl group, a bicyclo[2.2.2]an octyl group, a phenyl group, a ($C_1$-$C_{20}$ alkyl)a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a

benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{33})(Q_{34})(Q_{35})$, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$, and

$Q_1$ to $Q_9$ and $Q_{33}$ to $Q_{35}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

In one or more embodiments, $R_a$, $R_b$, $R_1$ to $R_4$, $R_{51}$ to $R_{56}$, $R_{61}$ and $R_{62}$ in Formulae 1 and 2 may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by one of Formulae 9-1 to 9-66, a group represented by one of Formulae 9-1 to 9-66 in which at least one hydrogen is substituted with deuterium, a group represented by one of Formulae 10-1 to 10-249, a group represented by one of Formulae 10-1 to 10-249 in which at least one hydrogen is substituted with deuterium, $-N(Q_1)(Q_2)$, $-Si(Q_3)(Q_4)(Q_5)$, or $-B(Q_6)(Q_7)$ (wherein $Q_1$ to $Q_7$ may each be the same as described above):

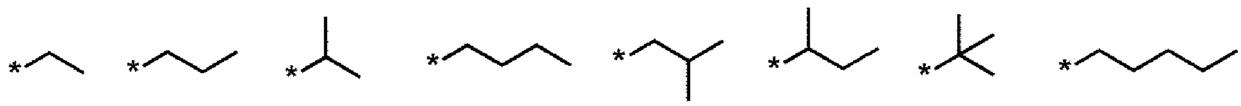

9-1 9-2 9-3 9-4 9-5 9-6 9-7 9-8

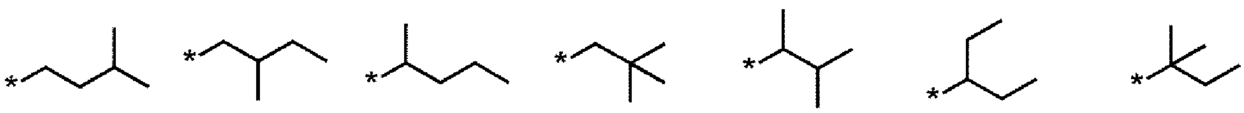

9-9 9-10 9-11 9-12 9-13 9-14 9-15

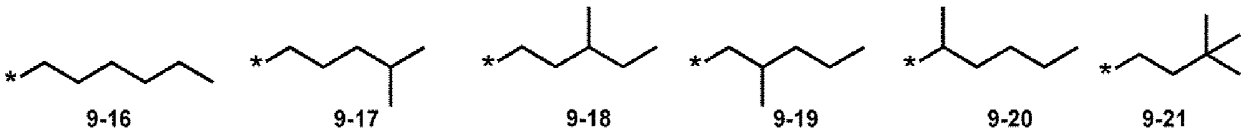

9-16 9-17 9-18 9-19 9-20 9-21

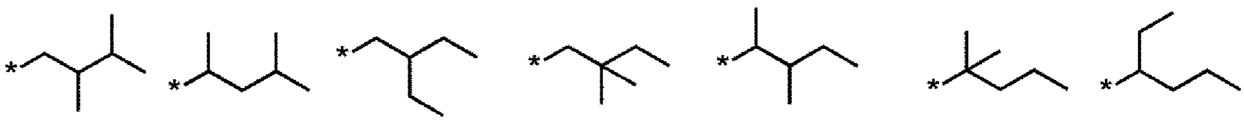

9-22 9-23 9-24 9-25 9-26 9-27 9-28

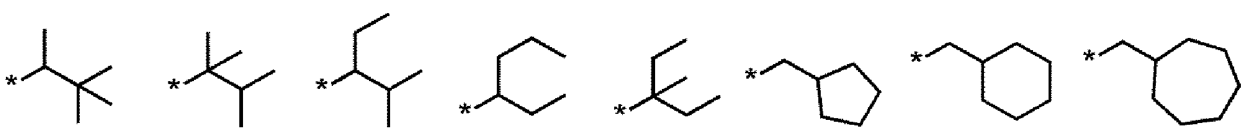

9-29 9-30 9-31 9-32 9-33 9-34 9-35 9-36

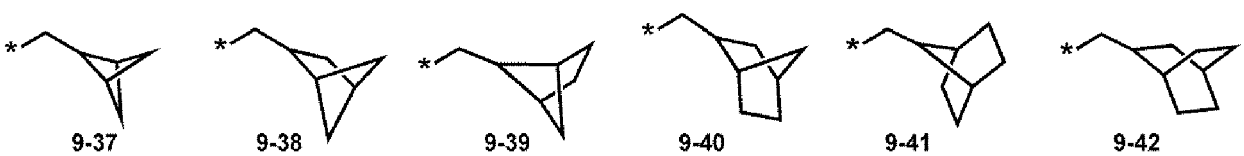

9-37 9-38 9-39 9-40 9-41 9-42

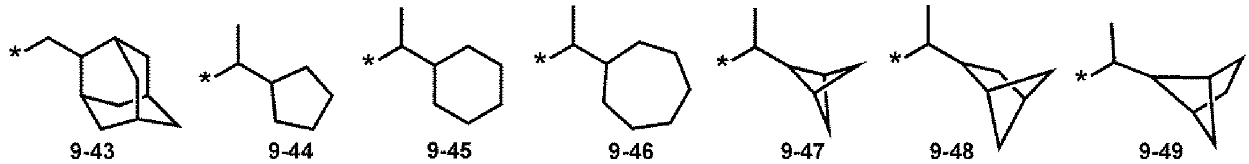

9-43 9-44 9-45 9-46 9-47 9-48 9-49

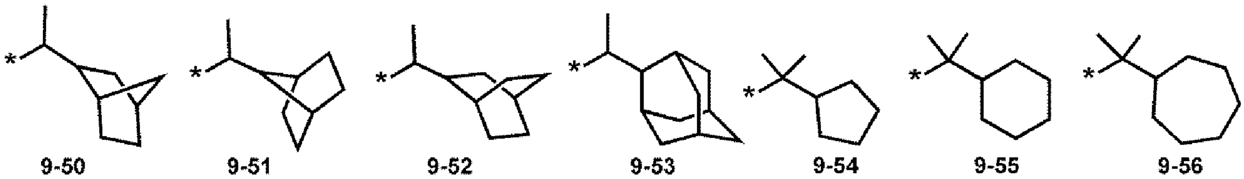

9-50 9-51 9-52 9-53 9-54 9-55 9-56

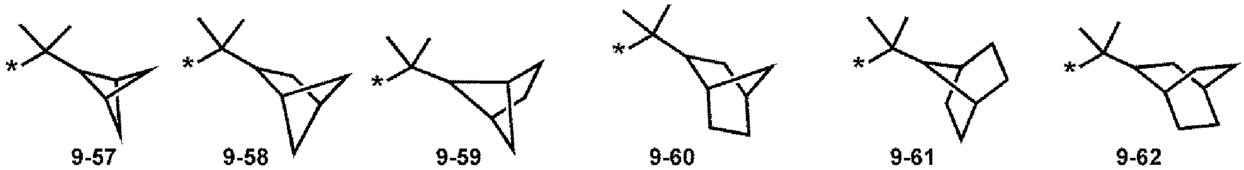

9-57 9-58 9-59 9-60 9-61 9-62

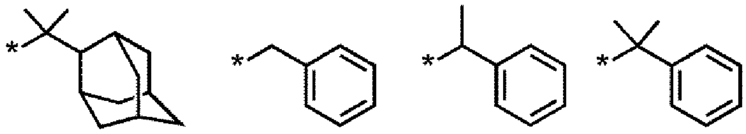

9-63 9-64 9-65 9-66

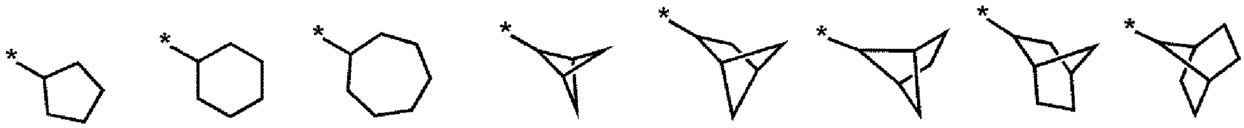

10-1 10-2 10-3 10-4 10-5 10-6 10-7 10-8

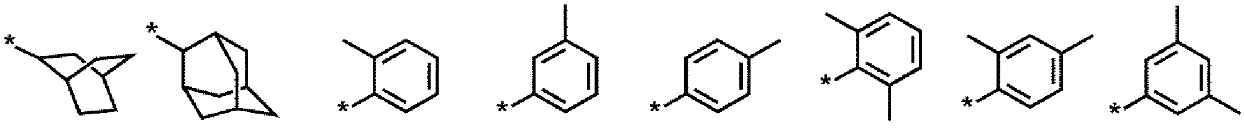

10-9 10-10 10-11 10-12 10-13 10-14 10-15 10-16

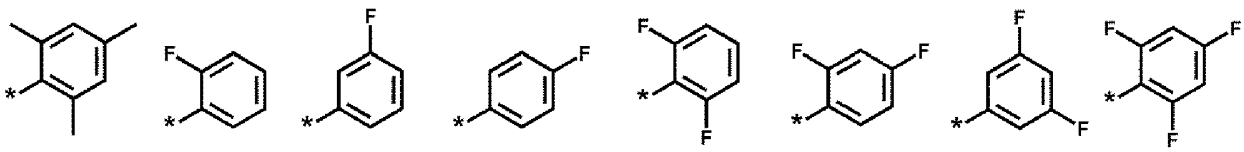

10-17 10-18 10-19 10-20 10-21 10-22 10-23 10-24

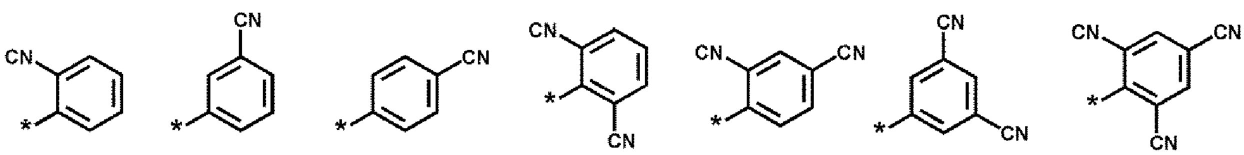

10-25 10-26 10-27 10-28 10-29 10-30 10-31

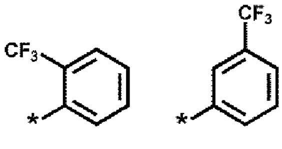

10-32 10-33

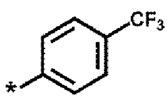

10-34

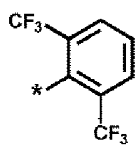

10-35

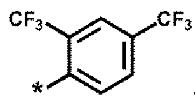

10-36

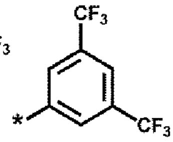

10-37

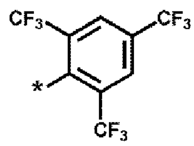

10-38

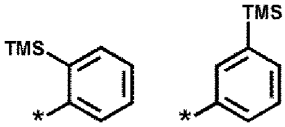

10-39 10-40

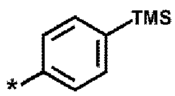

10-41

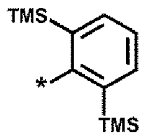

10-42

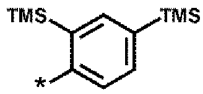

10-43

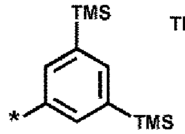

10-44

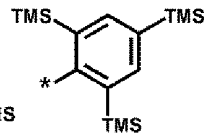

10-45

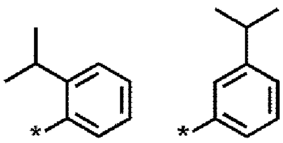

10-46 10-47

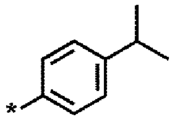

10-48

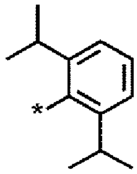

10-49

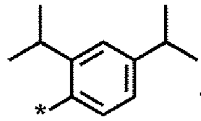

10-50

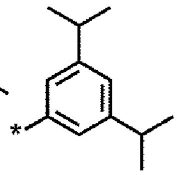

10-51

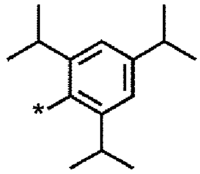

10-52

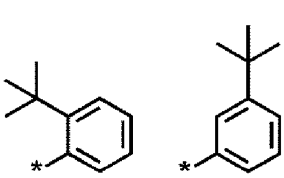

10-53 10-54

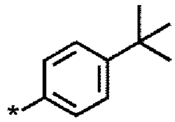

10-55

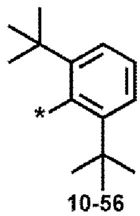

10-56

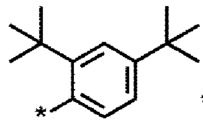

10-57

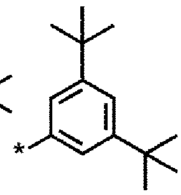

10-58

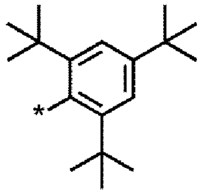

10-59

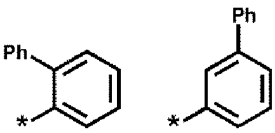

10-60 10-61

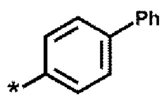

10-62

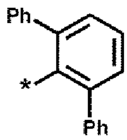

10-63

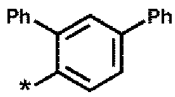

10-64

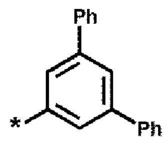

10-65

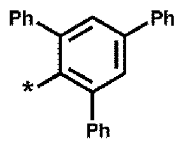

10-66

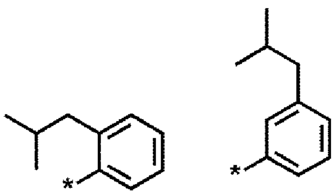

10-67 10-68

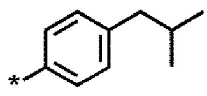

10-69

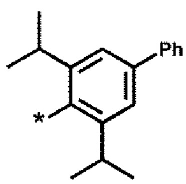

10-70

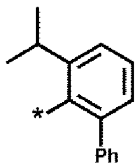

10-71

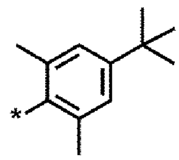

10-72

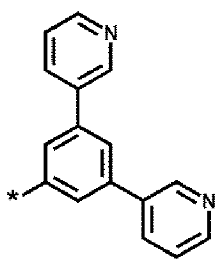

10-73

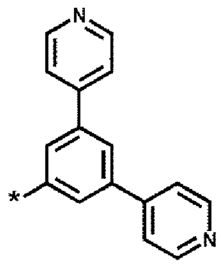

10-74

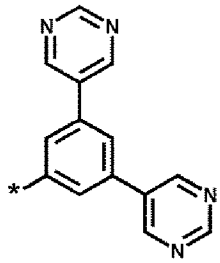

10-75

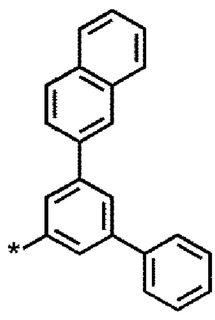

10-76

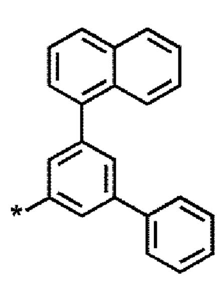

10-77

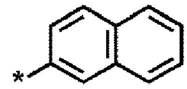
10-78
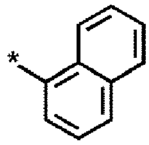
10-79
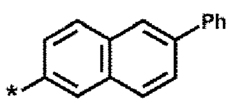
10-80
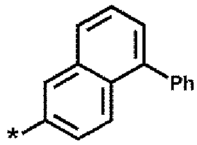
10-81
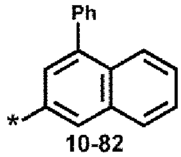
10-82

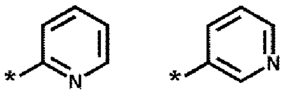
10-83
10-84
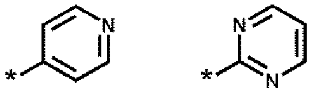
10-85
10-86
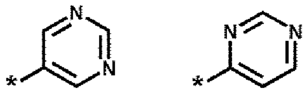
10-87
10-88
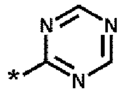
10-89

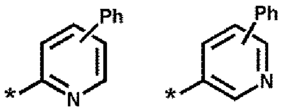
10-90
10-91
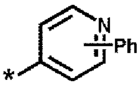
10-92
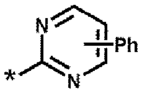
10-93
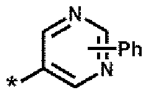
10-94
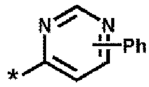
10-95
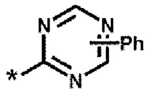
10-96

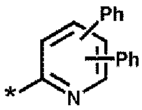
10-97
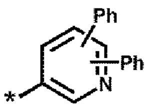
10-98
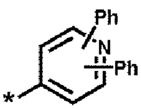
10-99
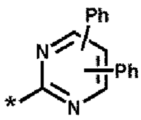
10-100
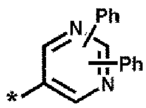
10-101
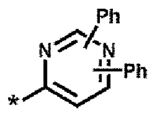
10-102
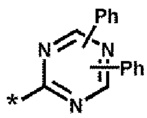
10-103

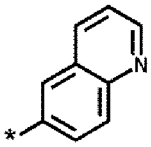
10-104
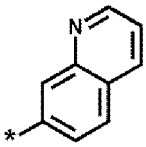
10-105
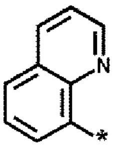
10-106
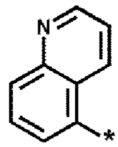
10-107
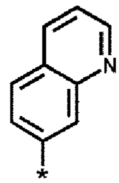
10-108
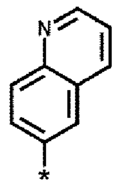
10-109

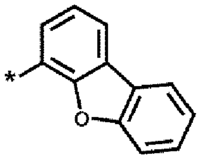
10-110
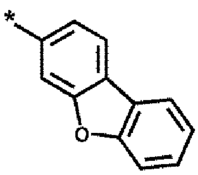
10-111
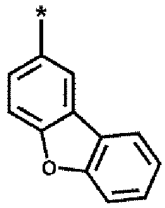
10-112
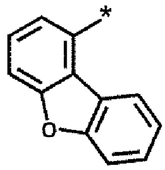
10-113
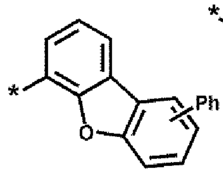
10-114
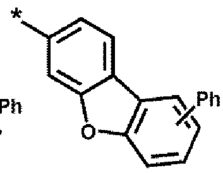
10-115

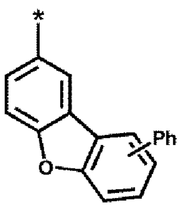
10-116
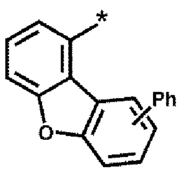
10-117
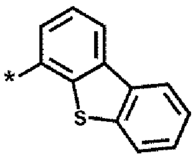
10-118
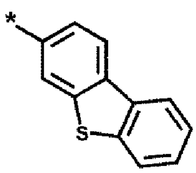
10-119
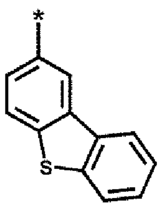
10-120
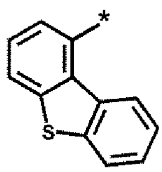
10-121

| | | | | | |
|---|---|---|---|---|---|
| 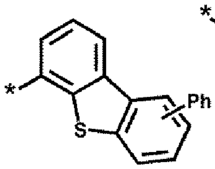 | 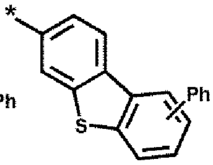 | 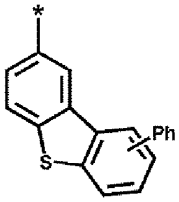 | 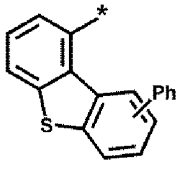 | 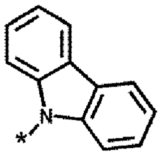 | 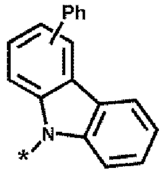 |
| 10-122 | 10-123 | 10-124 | 10-125 | 10-126 | 10-127 |
| 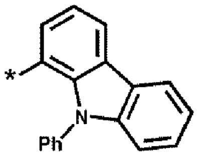 | 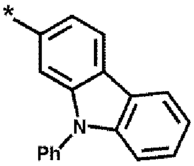 | 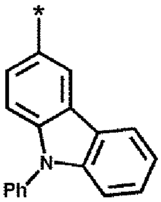 | 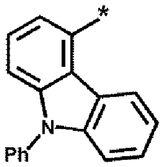 | 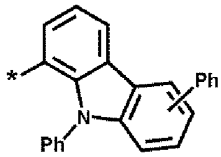 | 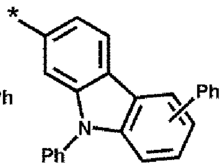 |
| 10-128 | 10-129 | 10-130 | 10-131 | 10-132 | 10-133 |
| 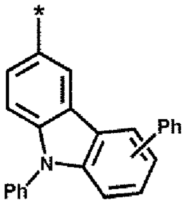 | 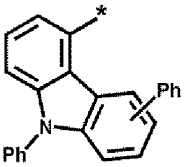 | 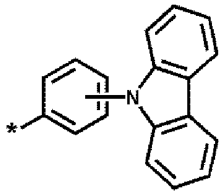 | 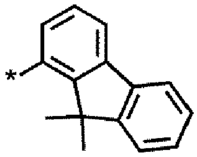 | 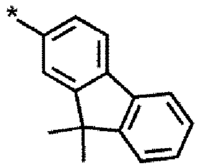 | 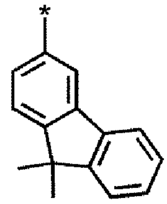 |
| 10-134 | 10-135 | 10-136 | 10-137 | 10-138 | 10-139 |

| | | | | |
|---|---|---|---|---|
| 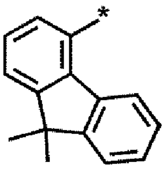 | 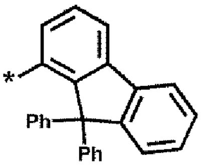 | 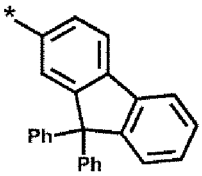 | 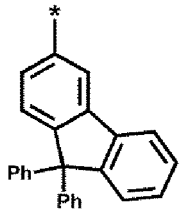 | 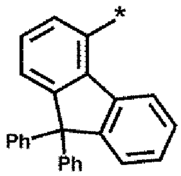 |
| 10-140 | 10-141 | 10-142 | 10-143 | 10-144 |

| | | | | | | |
|---|---|---|---|---|---|---|
| 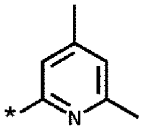 | 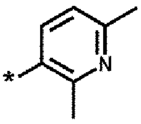 | 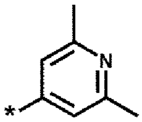 | 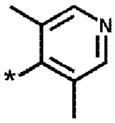 | 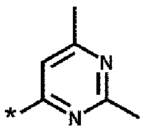 | 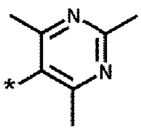 | 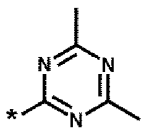 |
| 10-145 | 10-146 | 10-147 | 10-148 | 10-149 | 10-150 | 10-151 |
| 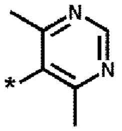 | 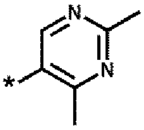 | 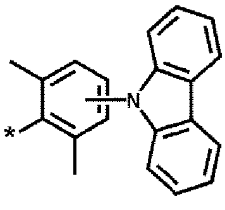 | 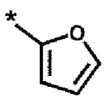 | 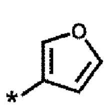 | 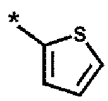 | 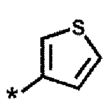 |
| 10-152 | 10-153 | 10-154 | 10-155 | 10-156 | 10-157 | 10-158 |

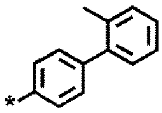
10-159

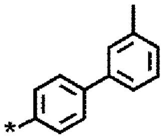
10-160

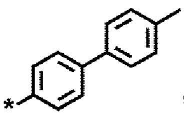
10-161

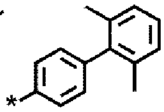
10-162

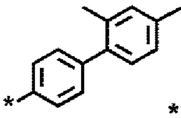
10-163

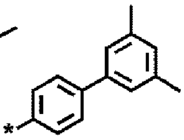
10-164

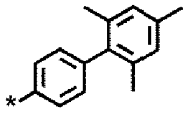
10-165

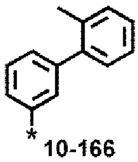
10-166

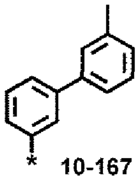
10-167

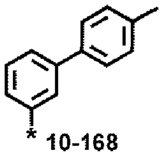
10-168

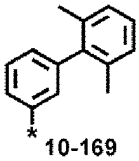
10-169

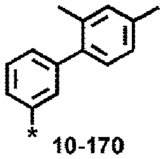
10-170

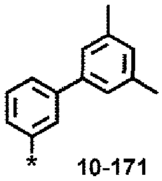
10-171

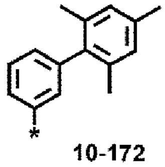
10-172

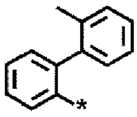
10-173

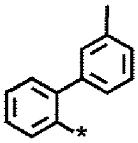
10-174

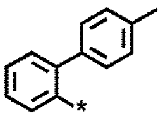
10-175

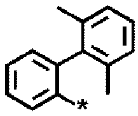
10-176

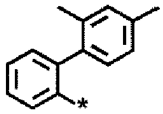
10-177

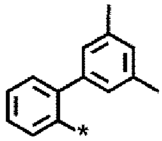
10-178

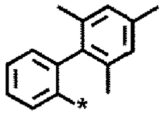
10-179

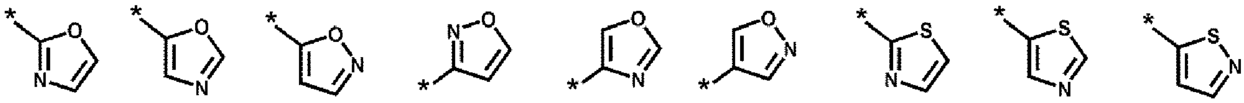
10-180 10-181 10-182 10-183 10-184 10-185 10-186 10-187 10-188

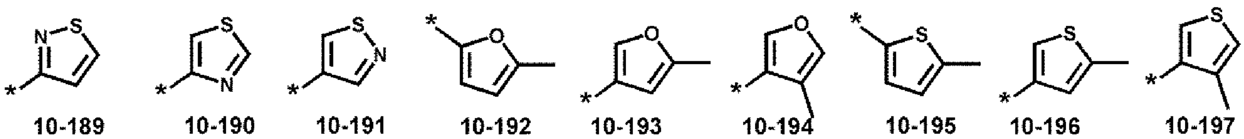
10-189 10-190 10-191 10-192 10-193 10-194 10-195 10-196 10-197

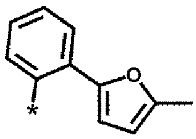
10-198

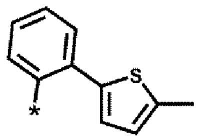
10-199

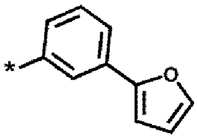
10-200

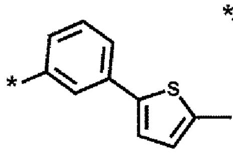
10-201

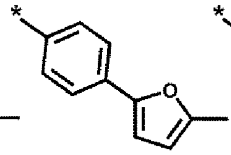
10-202

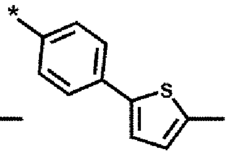
10-203

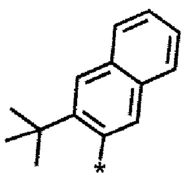
10-204

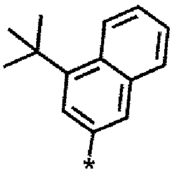
10-205

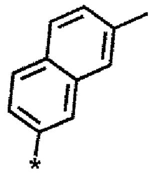
10-206

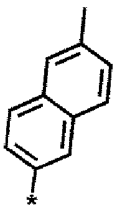
10-207

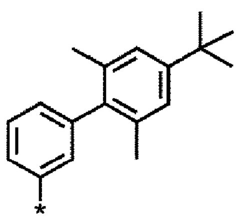
10-208

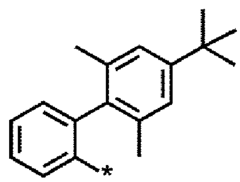
10-209

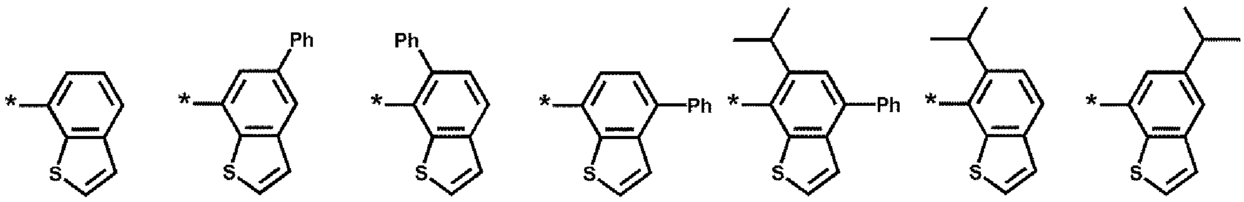
10-210 10-211 10-212 10-213 10-214 10-215 10-216

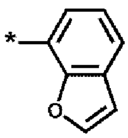 10-217
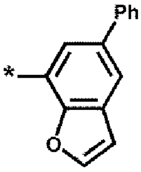 10-218
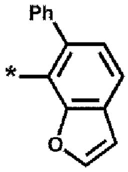 10-219
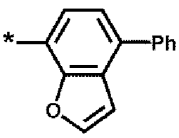 10-220
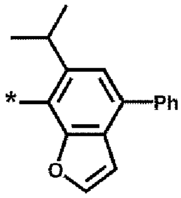 10-221
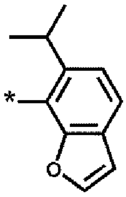 10-222
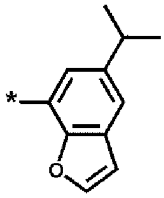 10-223

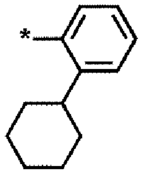 10-224
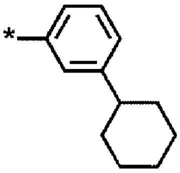 10-225
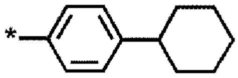 10-226
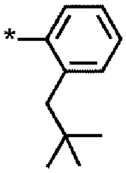 10-227
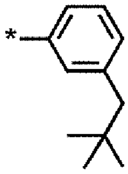 10-228
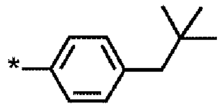 10-229

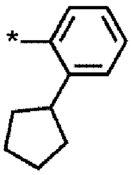 10-230
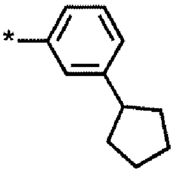 10-231
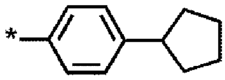 10-232
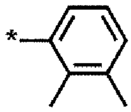 10-233
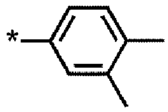 10-234
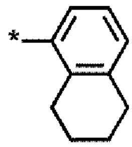 10-235
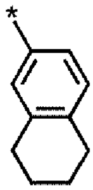 10-236

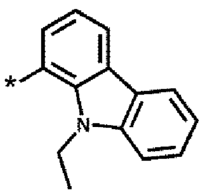 10-237
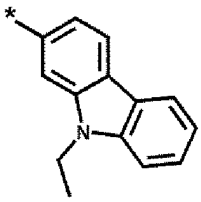 10-238
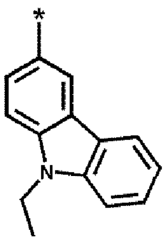 10-239
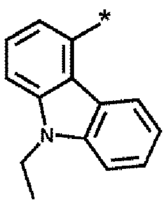 10-240
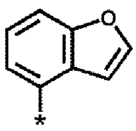 10-241
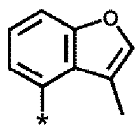 10-242

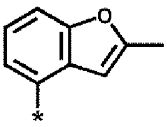 10-243
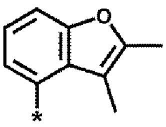 10-244
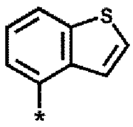 10-245
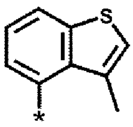 10-246
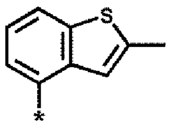 10-247
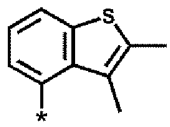 10-248
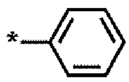 10-249

In Formulae 9-1 to 9-66 and 10-1 to 10-249, * indicates a binding site to a neighboring atom, Ph indicates a phenyl group, and TMS indicates a trimethylsilyl group.

The "group represented by one of Formulae 9-1 to 9-66 in which at least one hydrogen is substituted with deuterium" may be, for example, a group represented by one of Formulae 9-501 to 9-552:

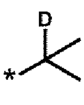 9-501
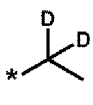 9-502
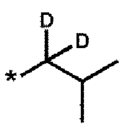 9-503
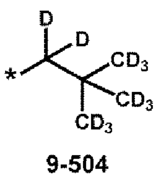 9-504
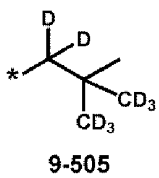 9-505
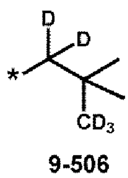 9-506
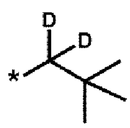 9-507

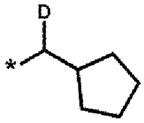
9-508
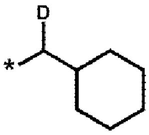
9-509
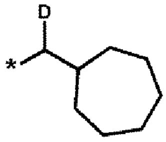
9-510
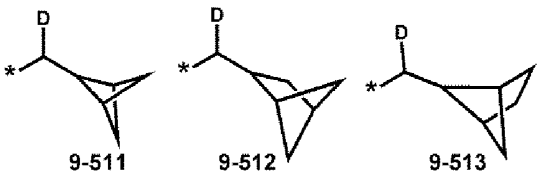
9-511 9-512 9-513
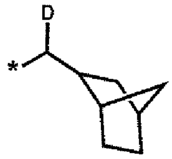
9-514

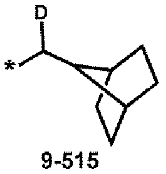
9-515
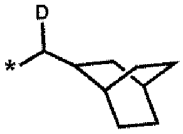
9-516
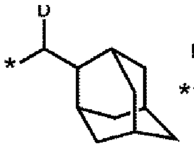
9-517
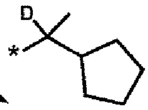
9-518
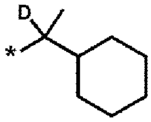
9-519
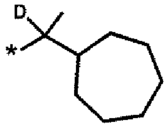
9-520
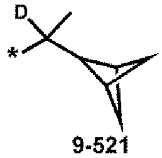
9-521

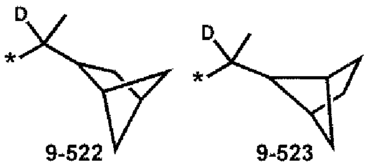
9-522 9-523
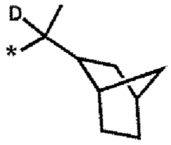
9-524
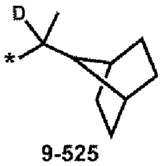
9-525
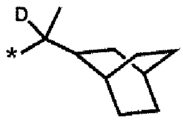
9-526
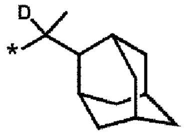
9-527

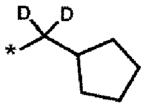
9-528
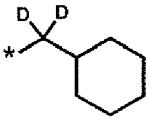
9-529
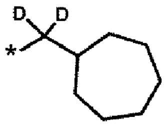
9-530
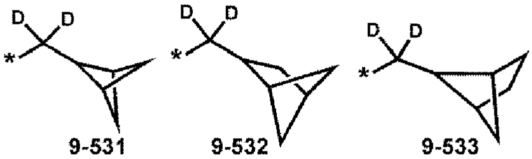
9-531 9-532 9-533
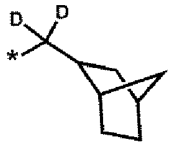
9-534

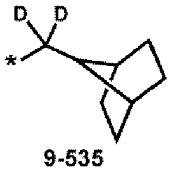
9-535
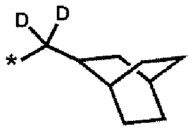
9-536
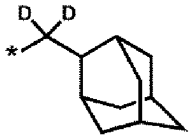
9-537
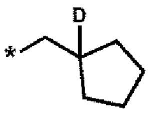
9-538
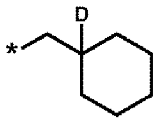
9-539
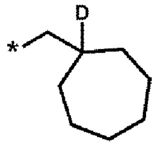
9-540

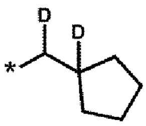
9-541
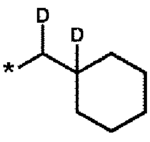
9-542
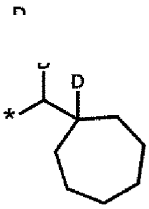
9-543
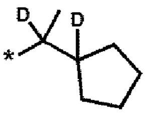
9-544
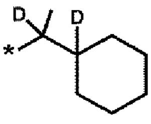
9-545
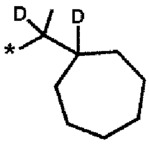
9-546
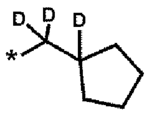
9-547

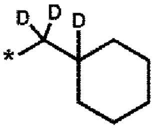
9-548
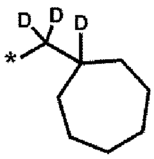
9-549
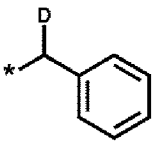
9-550
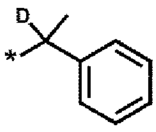
9-551
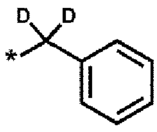
9-552

The "group represented by one of Formulae 10-1 to 10-249 in which at least one hydrogen is substituted with deuterium" may be, for example, a group represented by one of Formulae 10-501 to 10-510:

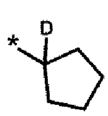
10-501

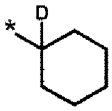
10-502

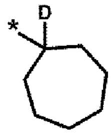
10-503

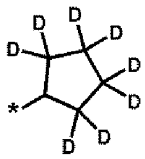
10-504

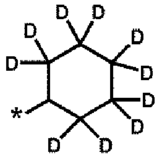
10-505

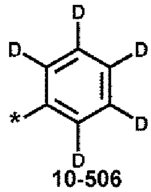
10-506

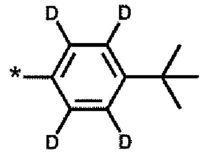
10-507

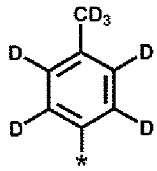
10-508

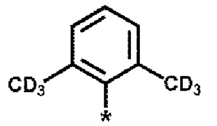
10-509

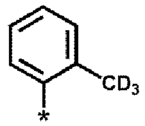
10-510

.

In Formula 1, c1 to c4 each indicate the numbers of $R_1$ to $R_4$, respectively, and may each independently be an integer from 1 to 10.

In Formulae 1 and 2, a1 to a4, a61 and a62 may each independently be one of an integer from 0 to 20. In Formulae 3-1 to 3-4, a71, a72, a75, and a81 to a86 are each independently one of an integer from 0 to 20.

In Formula 1, two or more of $R_a$, $R_b$, $R_1$ to $R_4$, and $R_{51}$ to $R_{56}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

In the present specification, $R_{10a}$ may be the same as defined in connection with $R_1$.

In the present specification, unless otherwise described, *, *', and *" each indicate a binding site to a neighboring atom.

In one or more embodiments, in Formula 1,

a1 to a4 may each independently be one of an integer from 1 to 20, and
at least one of $R_1$ to $R_4$ may each independently be a substituted or unsubstituted $C_1$-$C_{60}$ alkoxy group, a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), or -B($Q_6$)($Q_7$).

In one or more embodiments, in Formula 1,

1) ring $CY_2$ may be a benzoxazole group, a benzothiazole group, a benzimidazole group, a benzazasilole group, or a benzopyrrole group, a1 to a4 may each independently be one of an integer from 1 to 20, and at least one of $R_1$ to $R_4$ may each independently be a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group, or
2) ring $CY_2$ may be a pyridine group, a1 to a4 may each independently be one of an integer from 1 to 20, and at least one of $R_1$ to $R_4$ may each independently be a substituted or unsubstituted $C_1$-$C_{60}$ alkoxy group, a substituted or unsubstituted $C_6$-$C_{60}$ aryloxy group, - N($Q_1$)($Q_2$), -Si($Q_3$)($Q_4$)($Q_5$), or -B($Q_6$)($Q_7$).

$L_{75}$, $L_{79}$, and $L_{81}$ to $L_{87}$ in Formulae 3-1 to 3-4 are each independently a $\pi$-electron-rich $C_3$-$C_{30}$ cyclic group unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl) dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, - N($Q_{31}$)($Q_{32}$), or any combination thereof; or $L_{79}$ in Formula 3-1 is a single bond, and/or

$R_{71}$, $R_{72}$, $R_{75}$, $R_{76}$, and $R_{81}$ to $R_{86}$ in Formulae 3-1 to 3-4 are each independently:

hydrogen or deuterium;
a $C_1$-$C_{20}$ alkyl group unsubstituted or substituted with deuterium, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, -N($Q_{31}$)($Q_{32}$), or any combination thereof;
a $\pi$-electron-rich $C_3$-$C_{30}$ cyclic group unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, - N($Q_{31}$)($Q_{32}$), or any combination thereof; or
-N($Q_1$)($Q_2$).

In one or more embodiments, at least one of the second compound and the third compound (for example, all of the second compound and the third compound) may include a carbazole group.

In one or more embodiments, at least one of the second compound and the third compound may each independently be the compound represented by Formula 3-1, wherein $X_{71}$ in Formula 3-1 may be N-$(L_{75})_{b75}$-$(R_{75})_{a75}$.

In one or more embodiments, at least one of the second compound and the third compound may not include a carbazole group.

In one or more embodiments, at least one of the second compound and the third compound may each independently be the compound represented by one of Formulae 3-2 to 3-4.

In one or more embodiments, at least one of the second compound and the third compound may each independently be the compound represented by one of Formulae 3-2 to 3-4, wherein the compounds represented by Formulae 3-2 to 3-4 may include a carbazole group.

In one or more embodiments, at least one of the second compound and the third compound may each independently be the compound represented by one of Formulae 3-2 to 3-4, and the compounds represented by Formulae 3-2 to 3-4 may not include a carbazole group.

In one or more embodiments, in Formula 3-3, $R_{81}$ and $R_{82}$ may be linked to each other via a single bond or a (dimethyl)methylene group, and/or $R_{83}$ and $R_{84}$ may be linked to each other via a single bond or a (dimethyl)methylene group (for example, see Compound H2-27 below).

In one or more embodiments, in Formula 3-4, $R_{81}$ and $R_{82}$ may be linked to each other via a single bond or a (dimethyl)methylene group, and/or $R_{83}$ and $R_{84}$ may be linked to each other via a single bond or a (dimethyl)methylene group, and/or $R_{85}$ and $R_{86}$ may be linked to each other via a single bond or a (dimethyl)methylene group.

In one or more embodiments, the Pt-containing organometallic compound may be a compound represented by Formula 1-1 or 1-2:

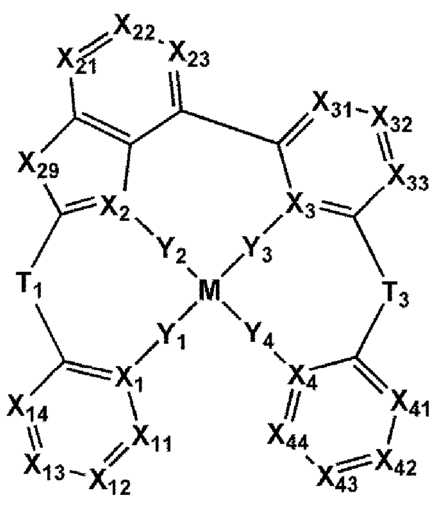

1-1

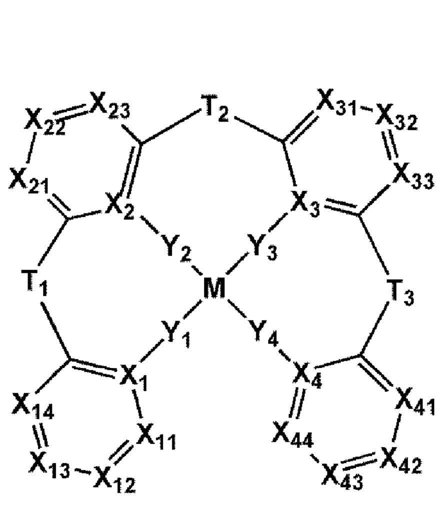

1-2

In Formulae 1-1 and 1-2,

M, $Y_1$ to $Y_4$, $X_1$ to $X_4$, and $T_1$ to $T_3$ may each be the same as described above,
$X_{11}$ may be N or C-[$(L_{11})_{b11}$-$(R_{11})_{c11}$], $X_{12}$ may be N or C-[$(L_{12})_{b12}$-$(R_{12})_{c12}$], $X_{13}$ may be N or C-[$(L_{13})_{b13}$-$(R_{13})_{c13}$], and $X_{14}$ may be N or C-[$(L_{14})_{b14}$-$(R_{14})_{c14}$],
$L_{11}$ to $L_{14}$, b11 to b14, $R_{11}$ to $R_{14}$, and c11 to c14 may each be the same as defined in connection with $L_1$, b1, $R_1$, and c1, respectively,
$X_{21}$ may be N or C-[$(L_{21})_{b21}$-$(R_{21})_{c21}$], $X_{22}$ may be N or C-[$(L_{22})_{b22}$-$(R_{22})_{c22}$], and $X_{23}$ may be N or C-[$(L_{23})_{b23}$-$(R_{23})_{c23}$],
$L_{21}$ to $L_{23}$, b21 to b23, $R_{21}$ to $R_{23}$, and c21 to c23 may each be the same as defined in connection with $L_2$, b2, $R_2$, and c2, respectively,
$X_{29}$ may be O, S, C($R_{27}$)($R_{28}$), Si($R_{27}$)($R_{28}$), or N-[$(L_{29})_{b29}$-$(R_{29})_{c29}$],
$R_{27}$ to $R_{29}$ may each be the same as defined in connection with $R_2$, and $L_{29}$, b29, and c29 may each be the same as defined in connection with $L_2$, b2, and c2, respectively,
$X_{31}$ may be N or C-[$(L_{31})_{b31}$-$(R_{31})_{c31}$], $X_{32}$ may be N or C-[$(L_{32})_{b32}$-$(R_{32})_{c32}$], and $X_{33}$ may be N or C-[$(L_{33})_{b33}$-$(R_{33})_{c33}$],
$L_{31}$ to $L_{33}$, b31 to b33, $R_{81}$ to $R_{33}$, and c31 to c33 may each be the same as defined in connection with $L_3$, b3, $R_3$, and c3, respectively,
$X_{41}$ may be N or C-[$(L_{41})_{b41}$-$(R_{41})_{c41}$], $X_{42}$ may be N or C-[$(L_{42})_{b42}$-$(R_{42})_{c42}$], $X_{43}$ may be N or C-[$(L_{43})_{b43}$-$(R_{43})_{c43}$], and $X_{44}$ may be N or C-[$(L_{44})_{b44}$-$(R_{44})_{c44}$],
$L_{41}$ to $L_{44}$, b41 to b44, $R_{41}$ to $R_{44}$, and c41 to c44 may each be the same as defined in connection with $L_4$, b4, $R_4$, and c4, respectively,
two of $R_{11}$ to $R_{14}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
two of $R_{21}$ to $R_{23}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
two of $R_{31}$ to $R_{33}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, and
two of $R_{41}$ to $R_{44}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

In the present specification, examples of "the $C_5$-$C_{30}$ carbocyclic group unsubstituted or substituted with at least one $R_{1a}$" and "the $C_1$-$C_{30}$ heterocyclic group unsubstituted or substituted with at least one at least one $R_{1a}$" include a cyclopentane group, a cyclohexane group, a cycloheptane group, a cyclooctane group, an adamantane group, a norbornene group, a cyclopentene group, a cyclohexene group, a cycloheptane group, a cyclooctene group, a bicyclo [1.1.1]pentane group, a bicyclo[2.1.1]hexane group, a bicyclo[2.2.1]heptane group, a bicyclo[2.2.2]octane group, a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, a benzofuran group, a benzothiophene group, a benzosilole group, a naphtho pyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a pyrrolophenanthrene group, a furanophenanthrene group, a thienophenanthrene group, a benzonaphthofuran group, a benzonaphthothiophene group, an (indolo)phenanthrene group, a (benzofurano)phenanthrene group, and a (benzothieno)phenanthrene group, each unsubstituted or substituted with at least one at least one $R_{1a}$, but embodiments of the present disclosure are not limited thereto.

In the present specification, examples of "the $C_1$-$C_{60}$ alkyl group" include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl

group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group, but embodiments of the present disclosure are not limited thereto.

In the present specification, examples of "the $C_3$-$C_{10}$ cycloalkyl group" include a cyclopentyl group, a cyclohexyl group, a cycloheptyl group, a cyclooctyl group, an adamantyl group, a bicyclo[1.1.1]pentyl group, a bicyclo[2.1.1]hexyl group, a bicyclo[2.2.1]heptyl group, and a bicyclo[2.2.2]octyl group, but embodiments of the present disclosure are not limited thereto.

The Pt-containing organometallic compound may be one of Compounds 1-1 to 1-88, 2-1 to 2-47, 3-1 to 3-591, and D1 to D24, but embodiments of the present disclosure are not limited thereto:

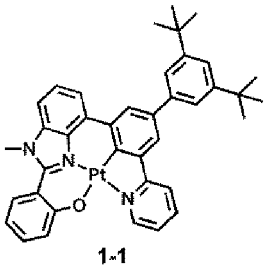
1-1

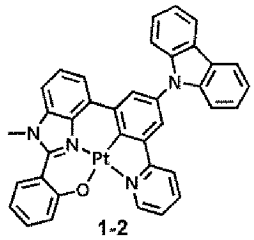
1-2

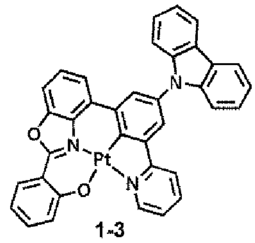
1-3

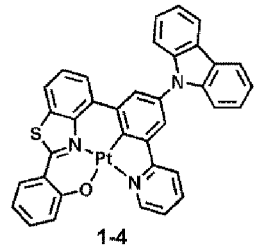
1-4

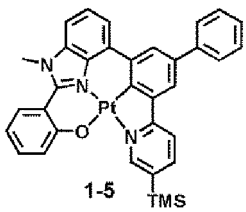
1-5

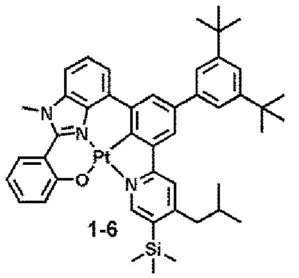
1-6

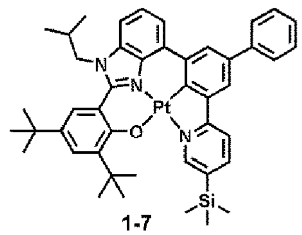
1-7

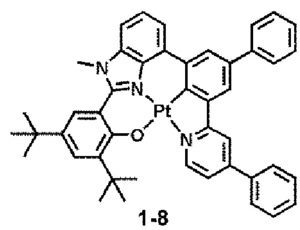
1-8

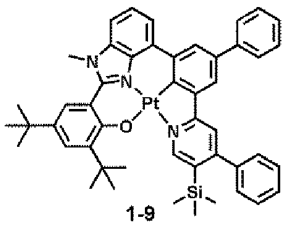
1-9

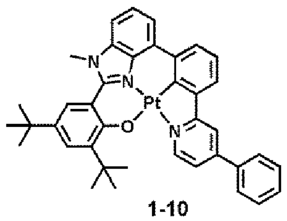
1-10

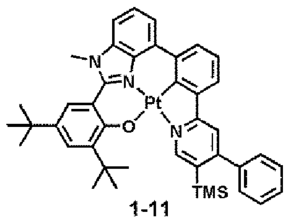
1-11

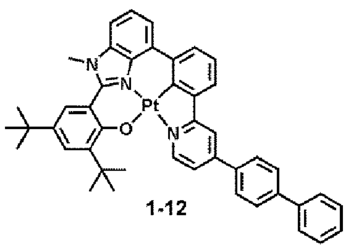
1-12

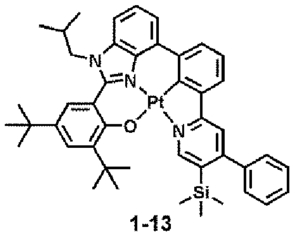
1-13

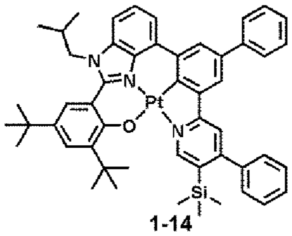
1-14

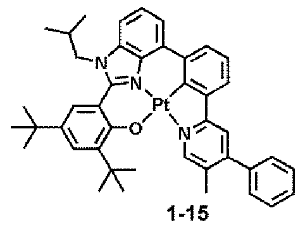
1-15

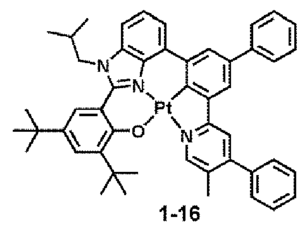
1-16

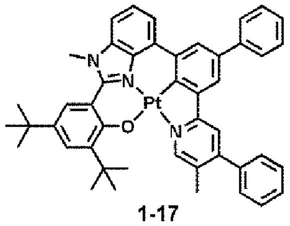
1-17

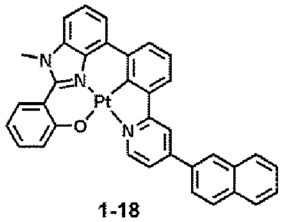
1-18

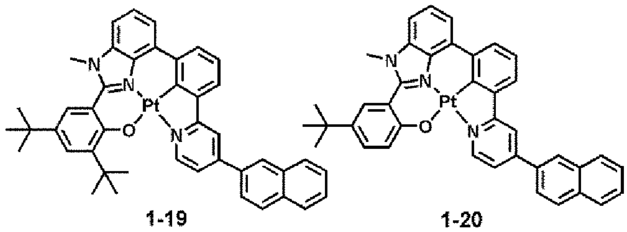
1-19

1-20

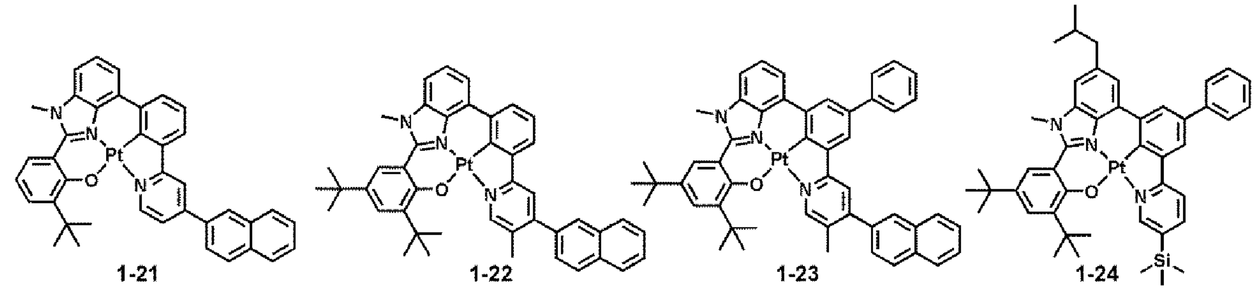

1-21 1-22 1-23 1-24

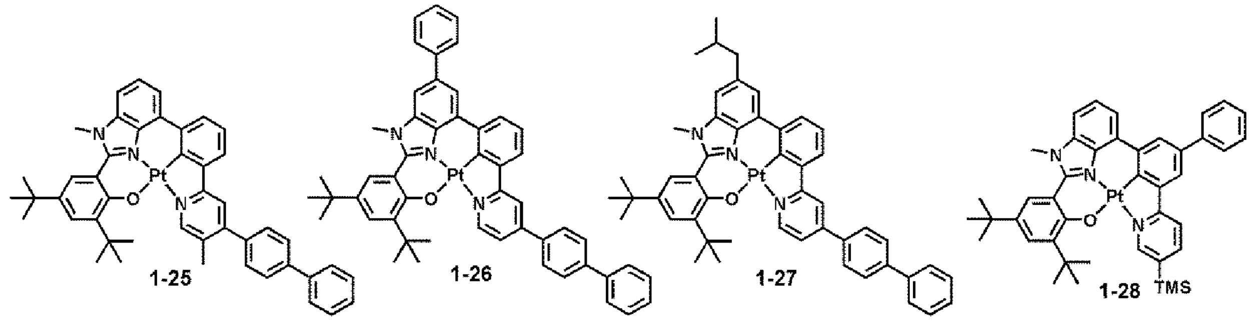

1-25 1-26 1-27 1-28

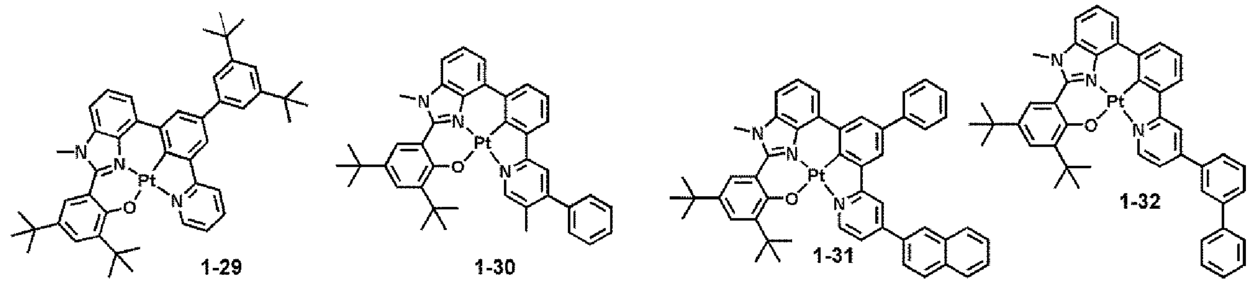

1-29 1-30 1-31 1-32

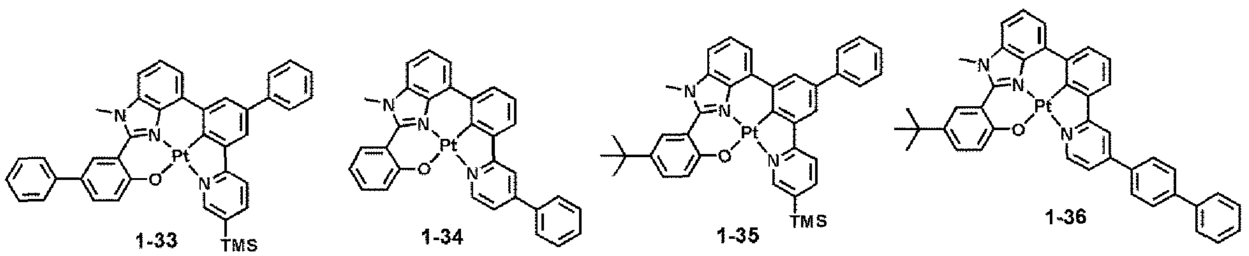

1-33 1-34 1-35 1-36

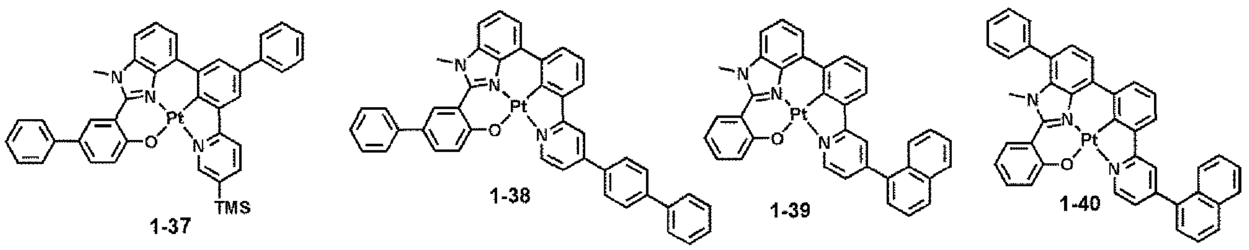

1-37 1-38 1-39 1-40

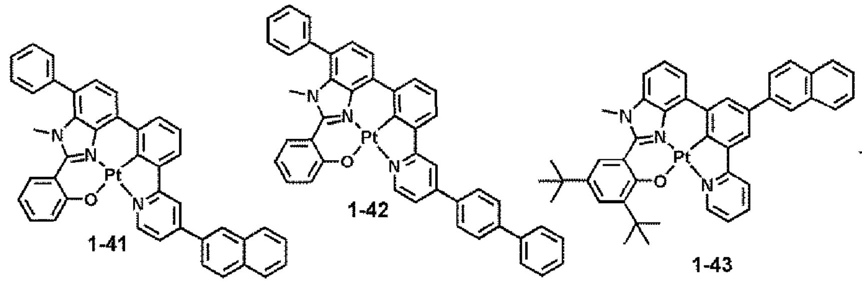

1-41 1-42 1-43

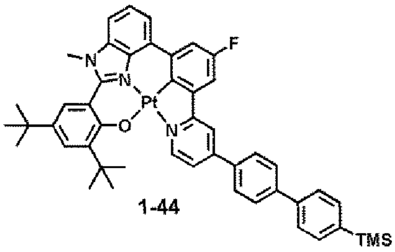

1-44

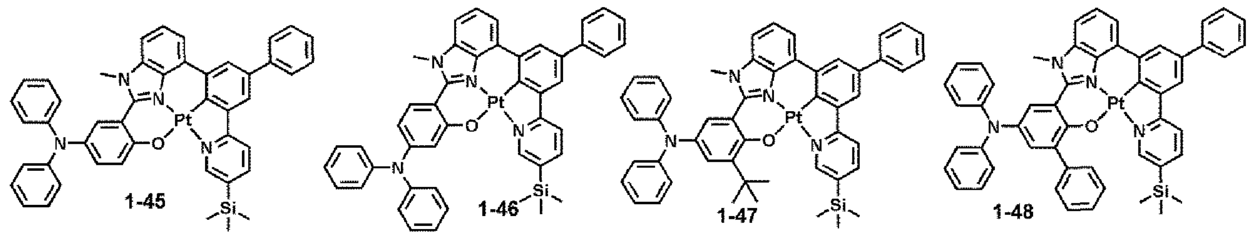

1-45 1-46 1-47 1-48

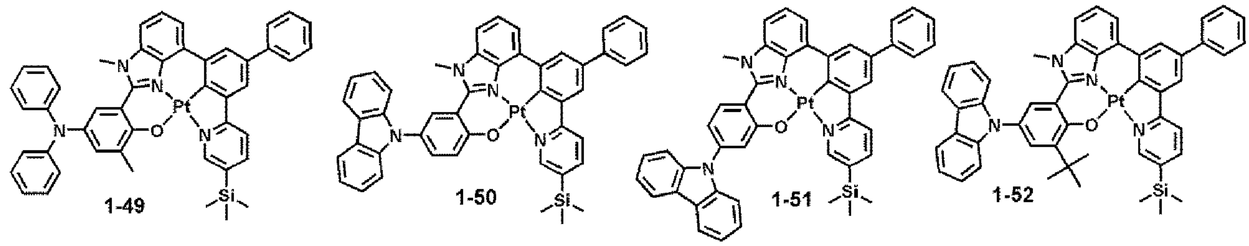

1-49 1-50 1-51 1-52

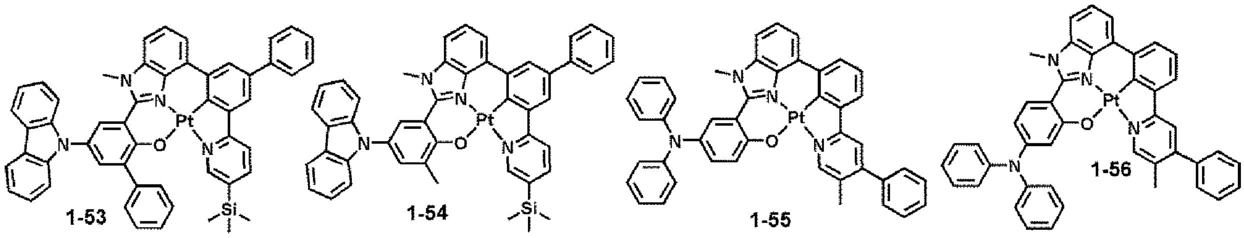

1-53 1-54 1-55 1-56

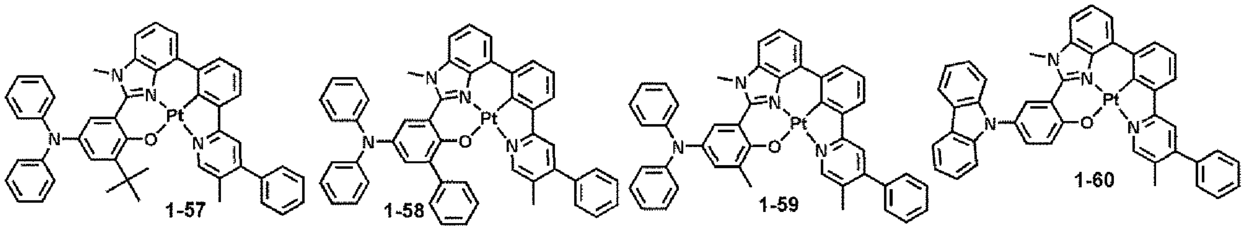

1-57 1-58 1-59 1-60

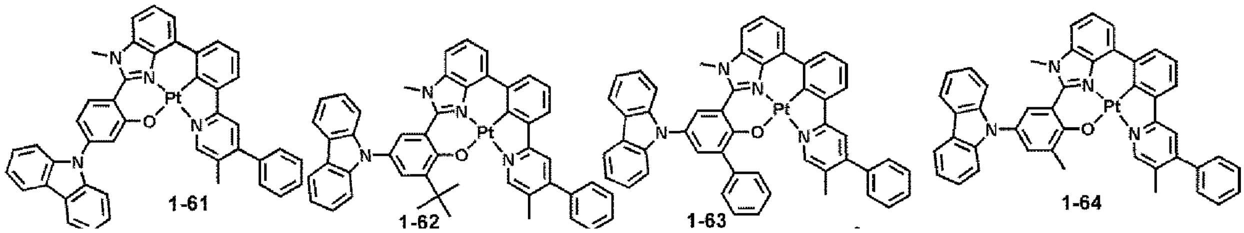

1-61 1-62 1-63 1-64

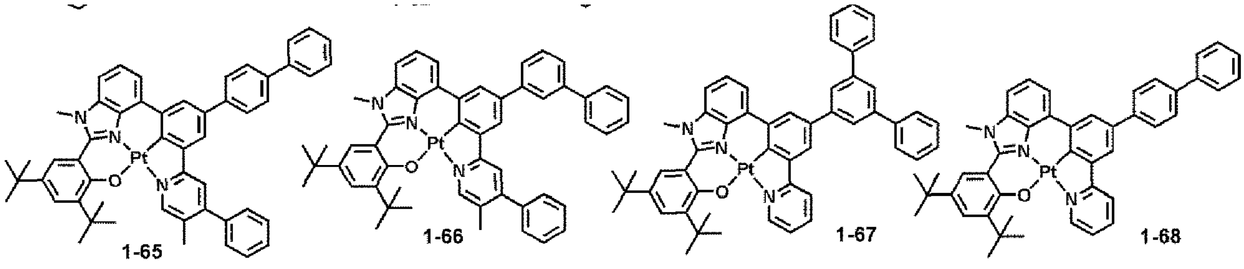

1-65 1-66 1-67 1-68

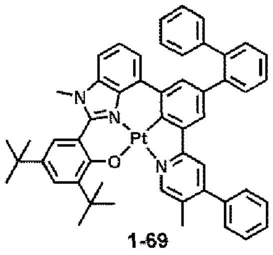

1-69

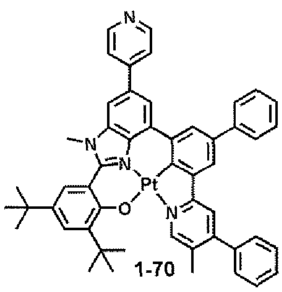

1-70

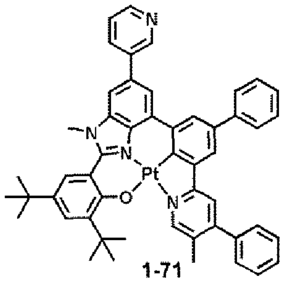

1-71

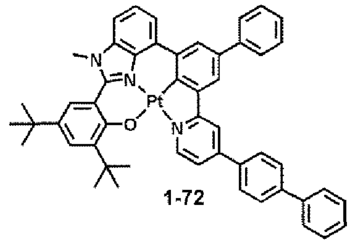

1-72

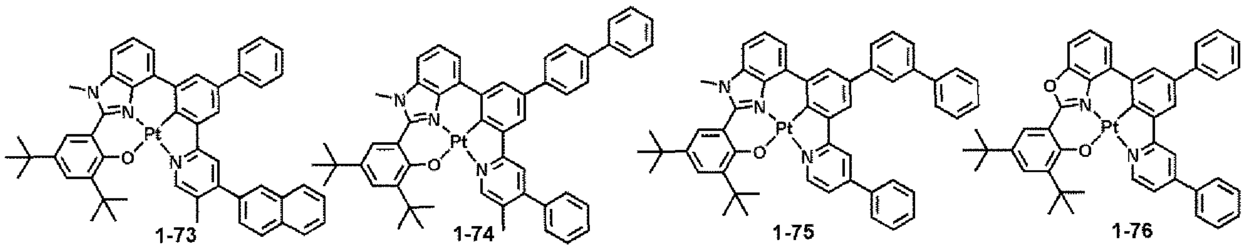

1-73 1-74 1-75 1-76

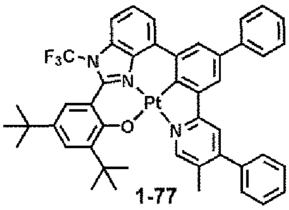

1-77

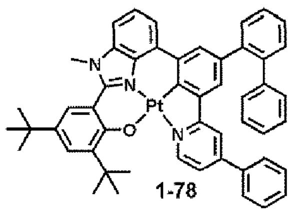

1-78

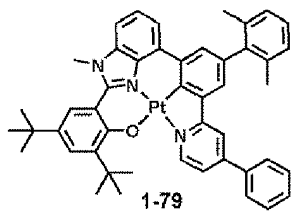

1-79

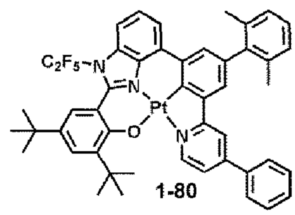

1-80

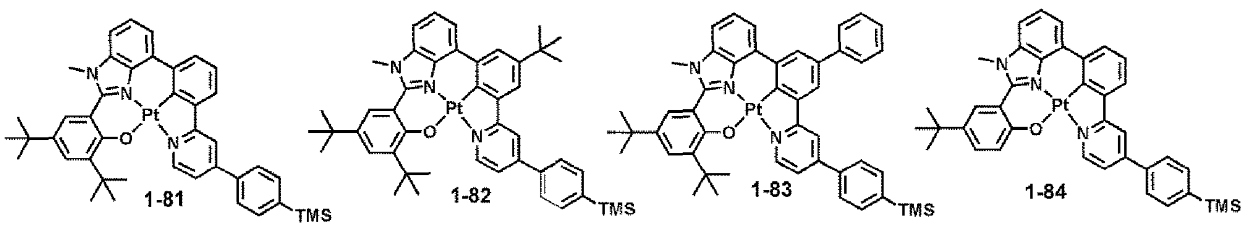

1-81 1-82 1-83 1-84

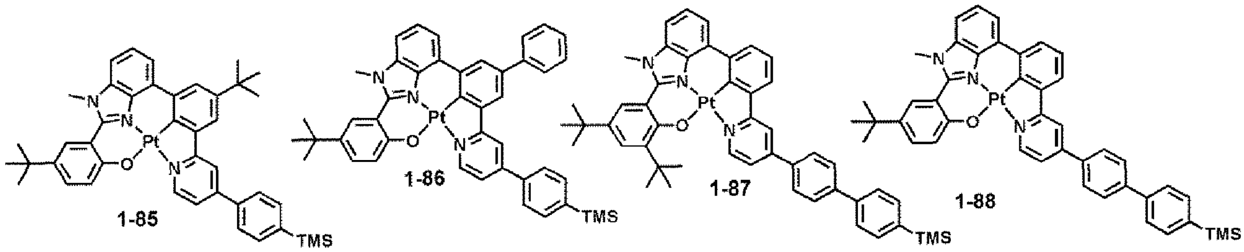

1-85 1-86 1-87 1-88

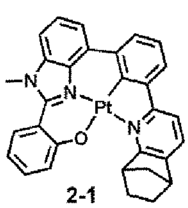
2-1

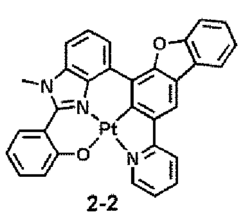
2-2

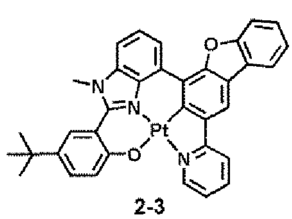
2-3

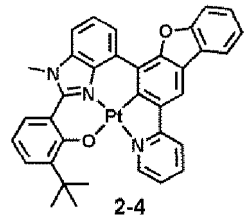
2-4

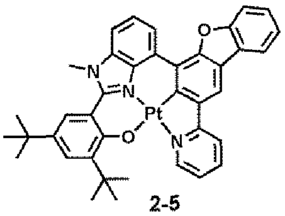
2-5

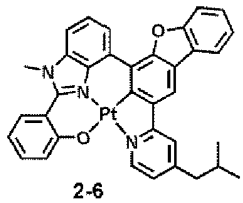
2-6

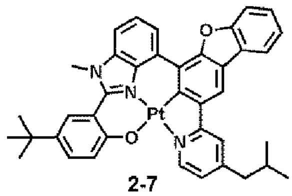
2-7

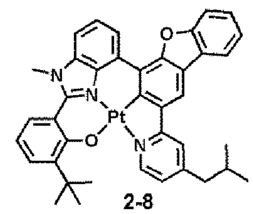
2-8

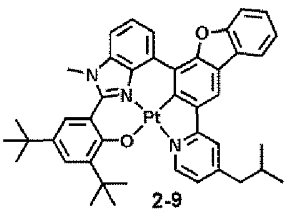
2-9

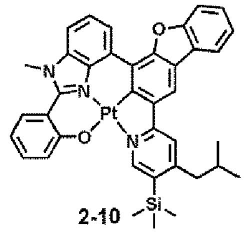
2-10

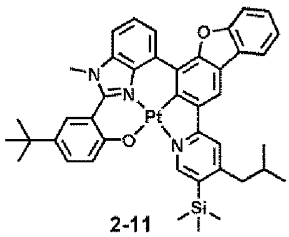
2-11

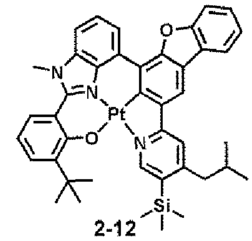
2-12

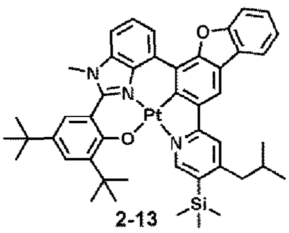
2-13

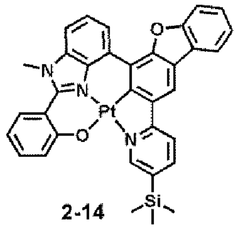
2-14

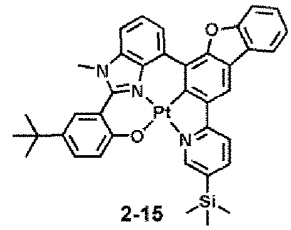
2-15

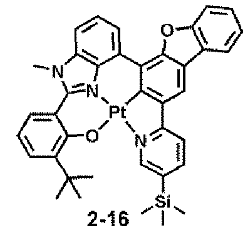
2-16

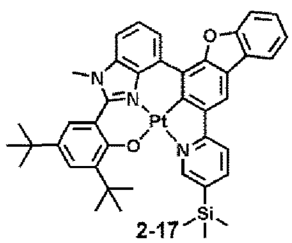
2-17

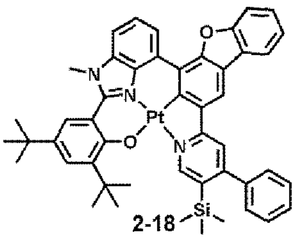
2-18

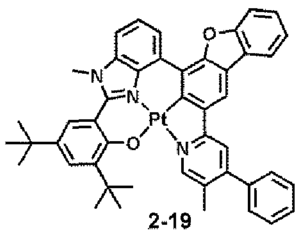
2-19

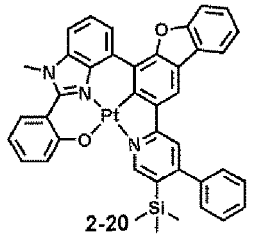
2-20

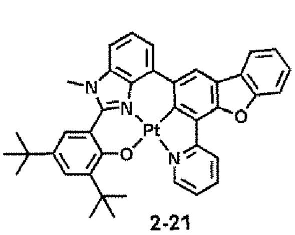
2-21

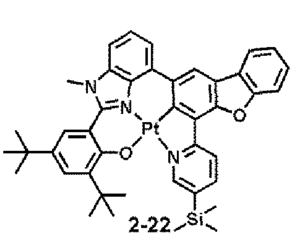
2-22

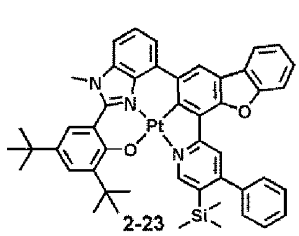
2-23

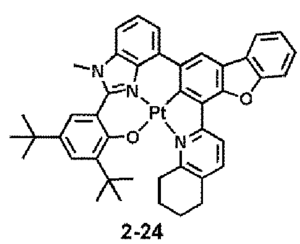
2-24

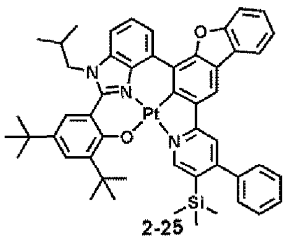
2-25

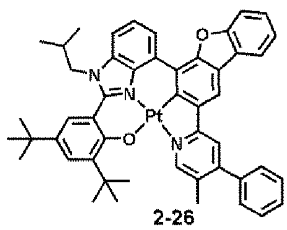
2-26

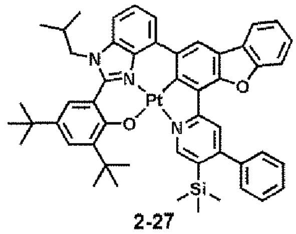
2-27

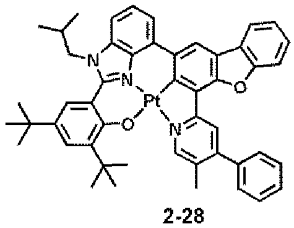
2-28

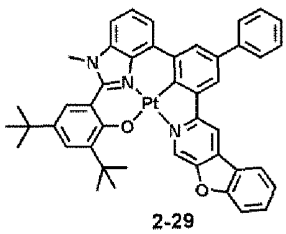
2-29

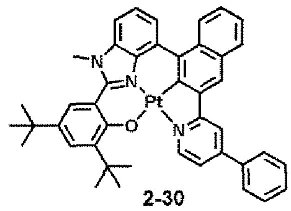
2-30

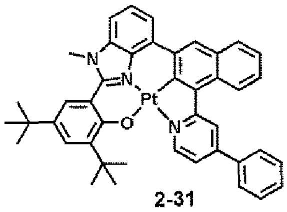
2-31

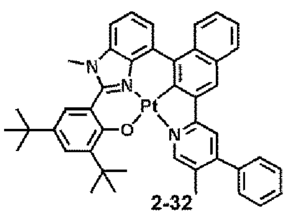
2-32

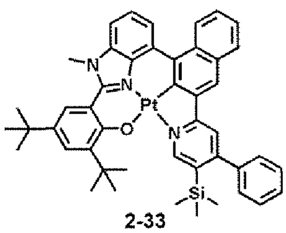
2-33

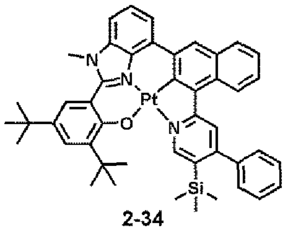
2-34

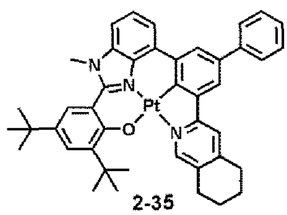
2-35

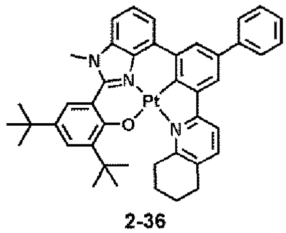
2-36

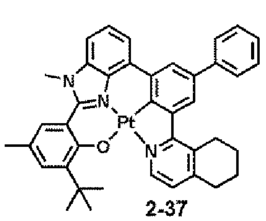
2-37

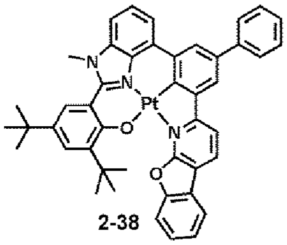
2-38

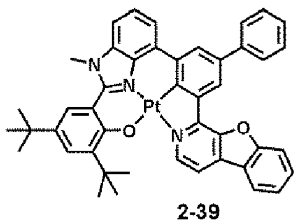
2-39

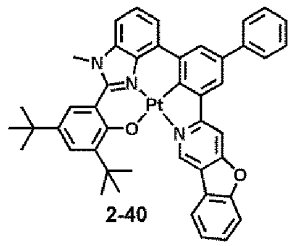
2-40

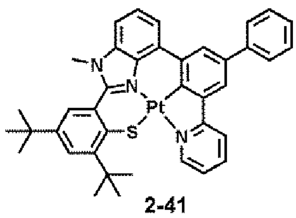
2-41

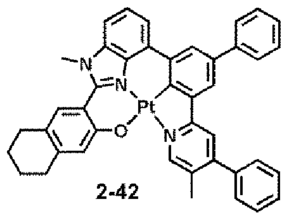
2-42

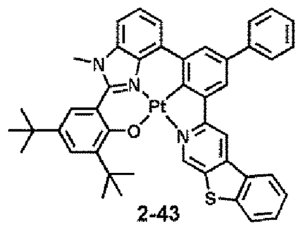
2-43

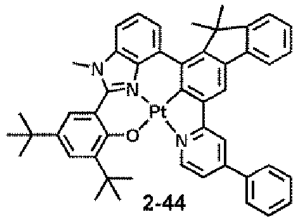
2-44

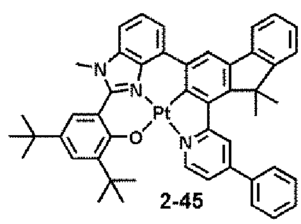
2-45

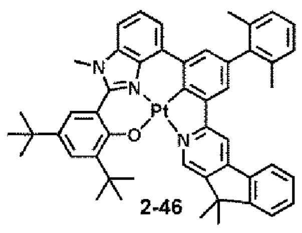
2-46

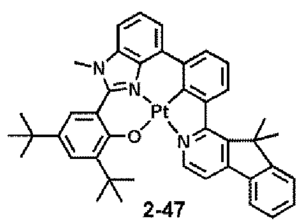
2-47

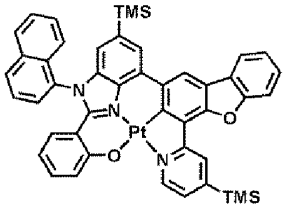
3-1

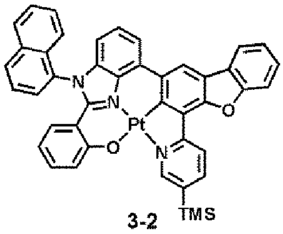
3-2

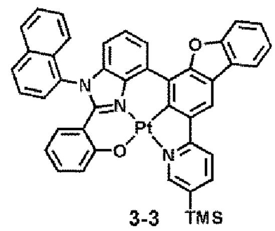
3-3

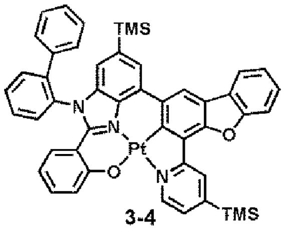
3-4

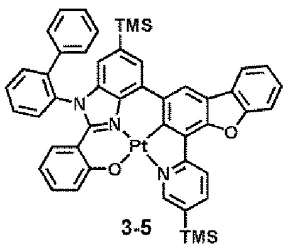
3-5

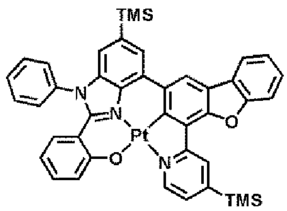
3-6

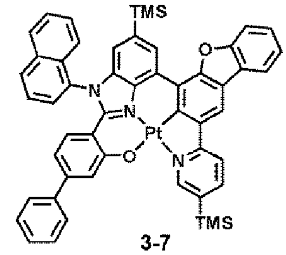
3-7

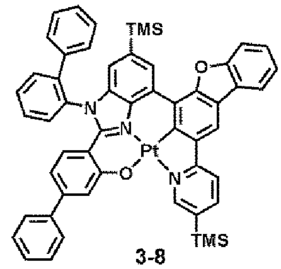
3-8

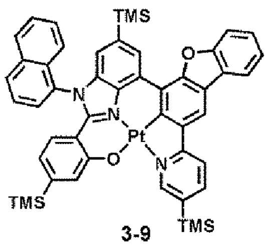
3-9

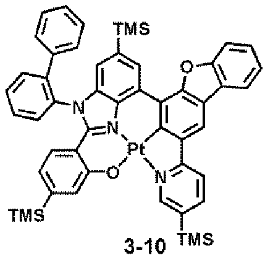
3-10

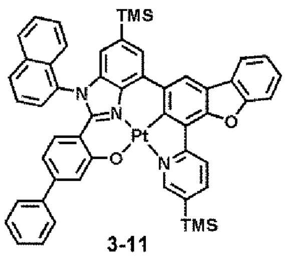
3-11

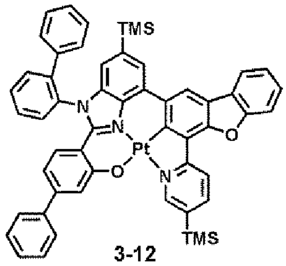
3-12

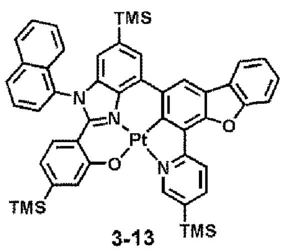
3-13

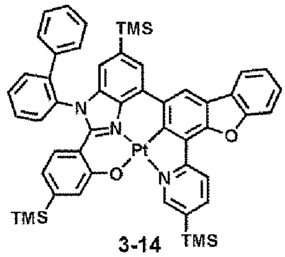
3-14

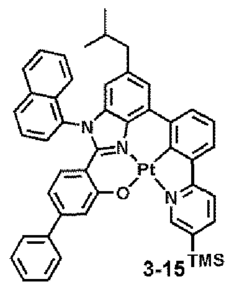
3-15

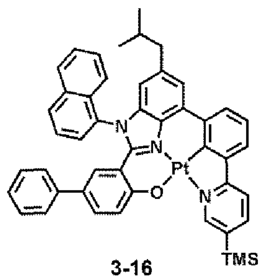
3-16

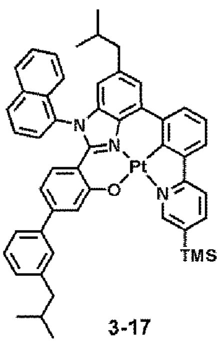
3-17

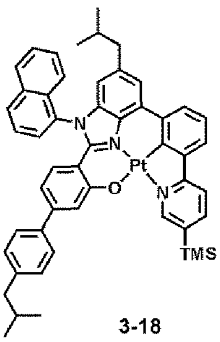
3-18

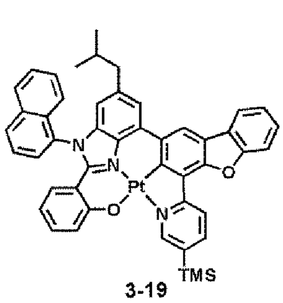
3-19

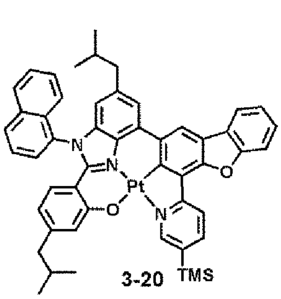
3-20

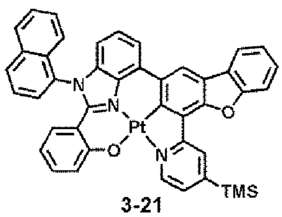
3-21

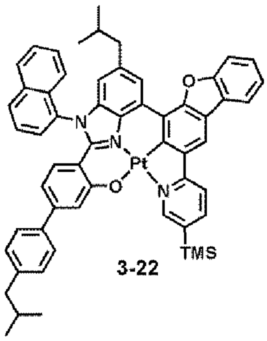
3-22

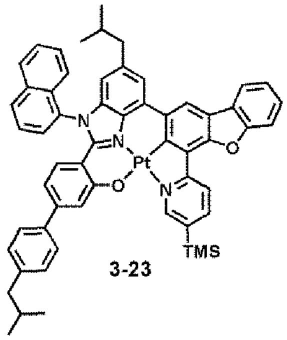
3-23

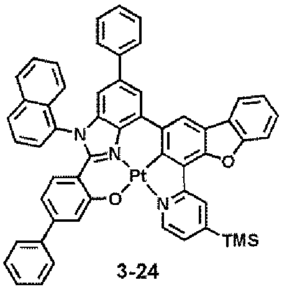
3-24

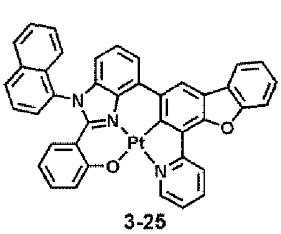
3-25

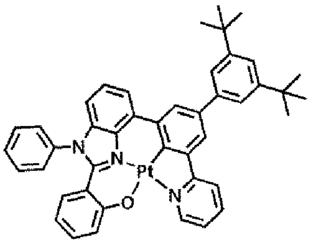
3-26

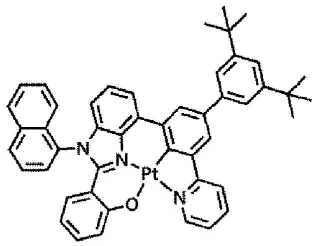
3-27

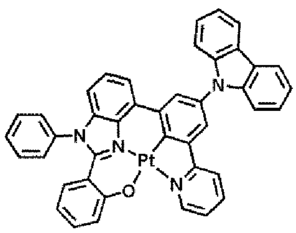
3-28

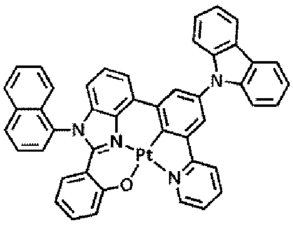
3-29

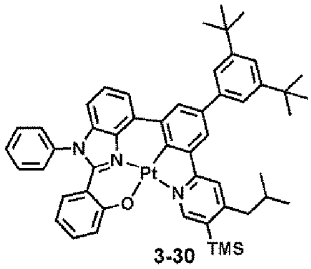
3-30

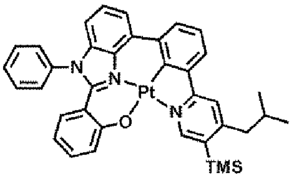
3-31

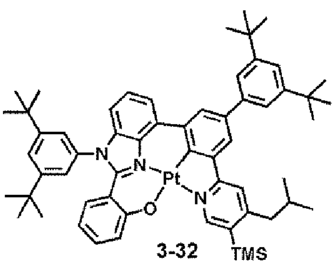
3-32

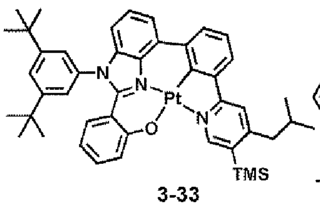
3-33

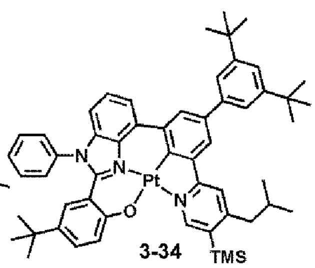
3-34

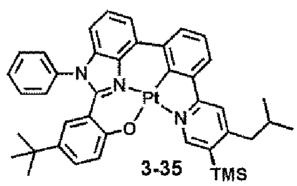
3-35

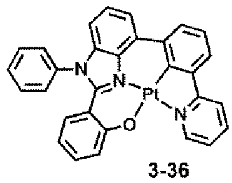
3-36

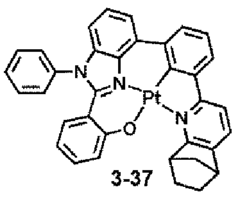
3-37

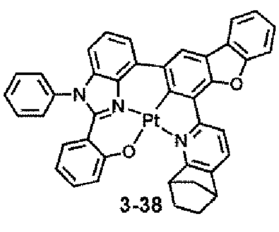
3-38

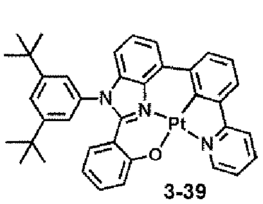
3-39

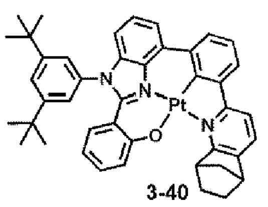
3-40

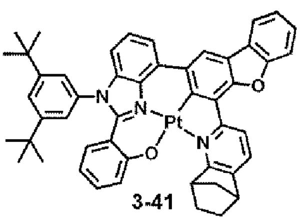
3-41

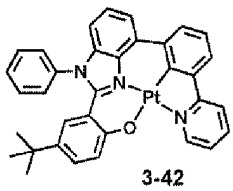
3-42

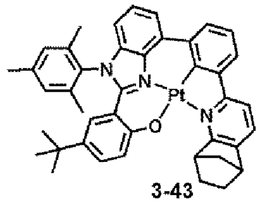
3-43

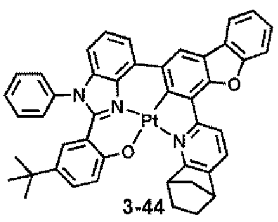
3-44

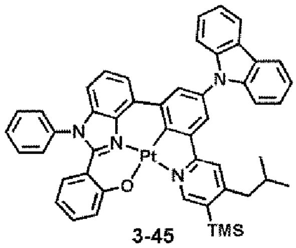
3-45

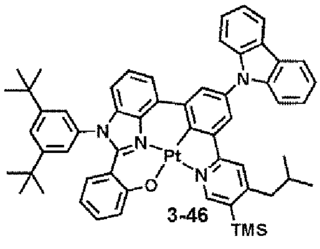
3-46

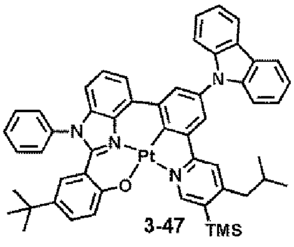
3-47

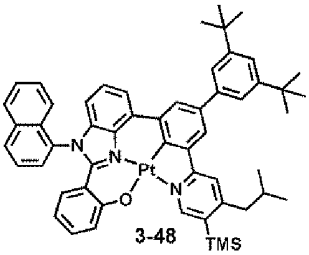
3-48

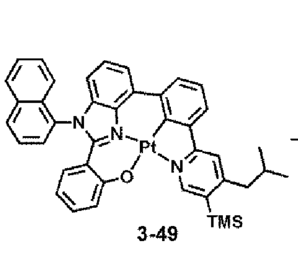
3-49

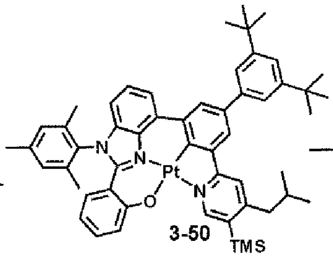
3-50

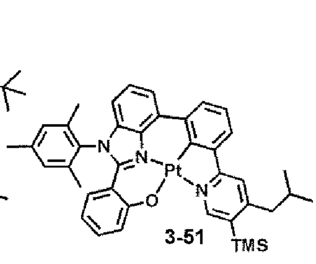
3-51

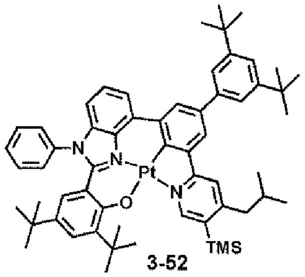
3-52

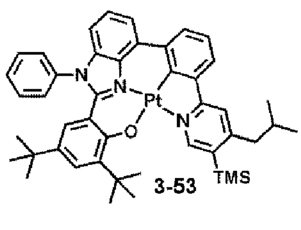
3-53

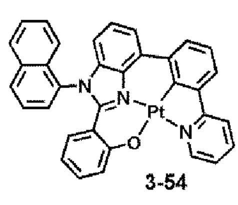
3-54

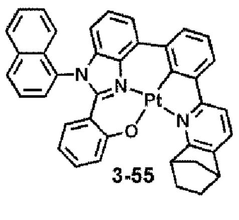
3-55

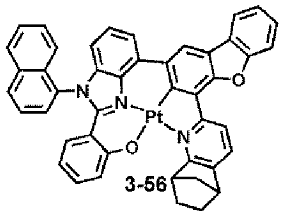
3-56

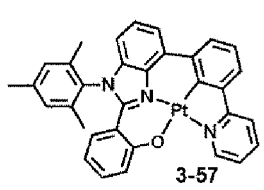
3-57

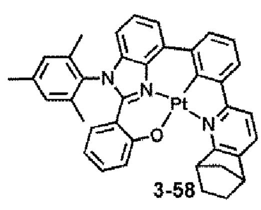
3-58

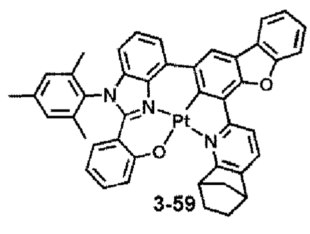
3-59

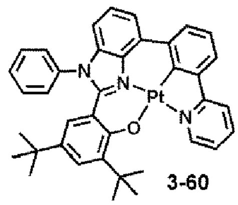
3-60

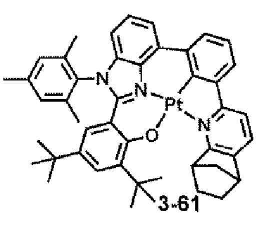
3-61

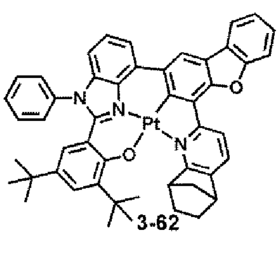
3-62

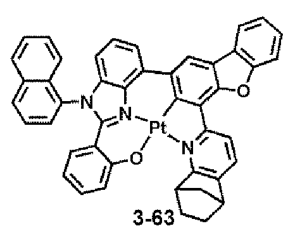
3-63

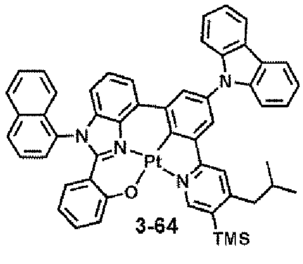
3-64

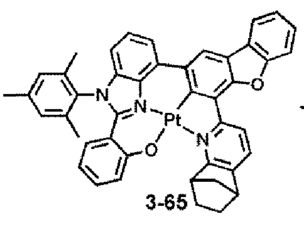
3-65

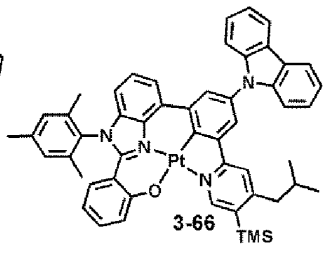
3-66

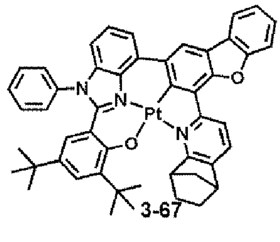
3-67

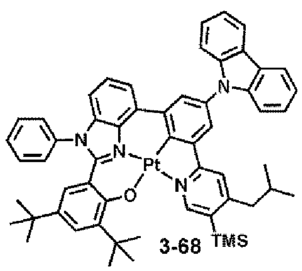
3-68

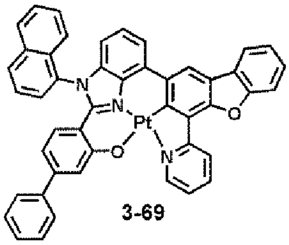
3-69

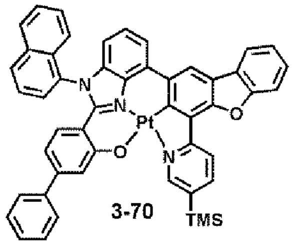
3-70

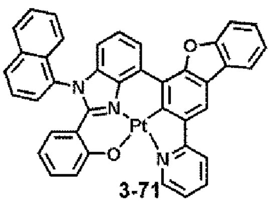
3-71

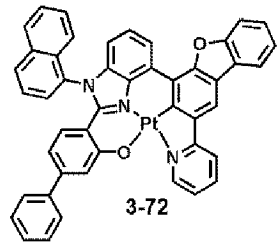
3-72

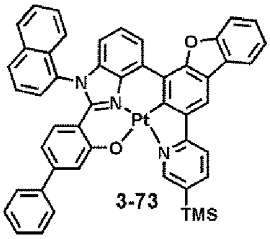
3-73

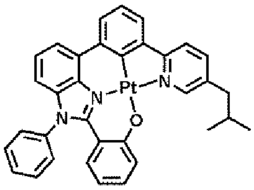
3-74

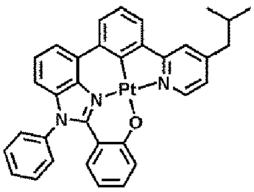
3-75

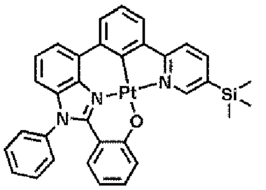
3-76

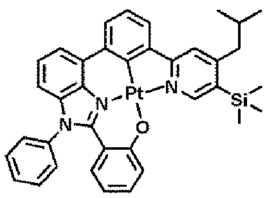
3-77

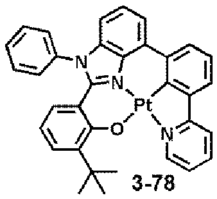
3-78

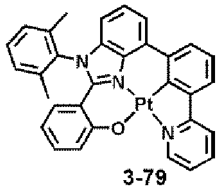
3-79

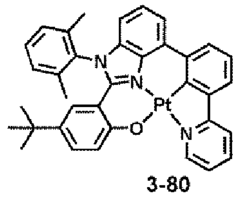
3-80

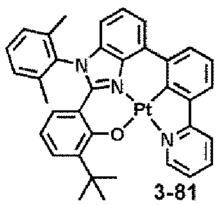
3-81

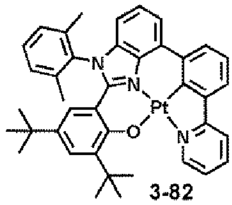
3-82

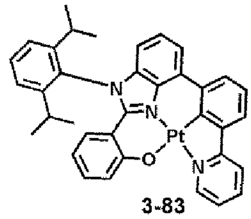
3-83

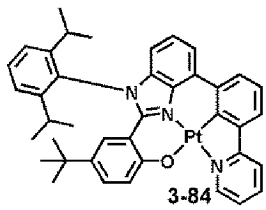
3-84

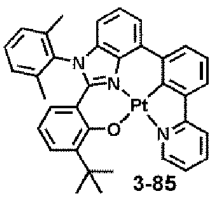
3-85

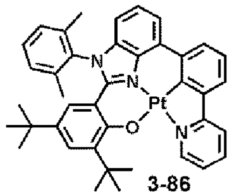
3-86

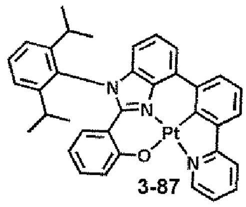
3-87

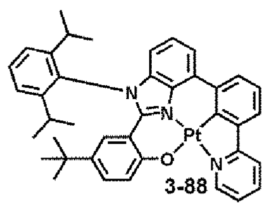
3-88

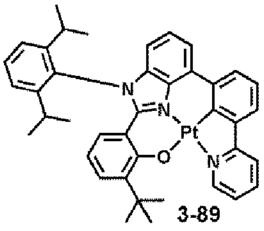
3-89

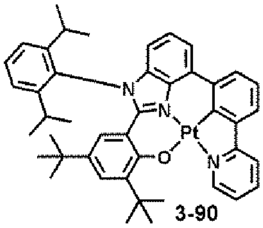
3-90

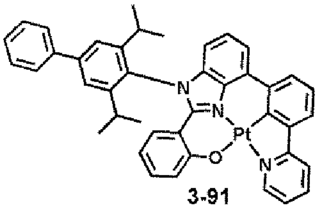
3-91

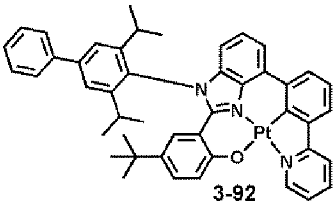
3-92

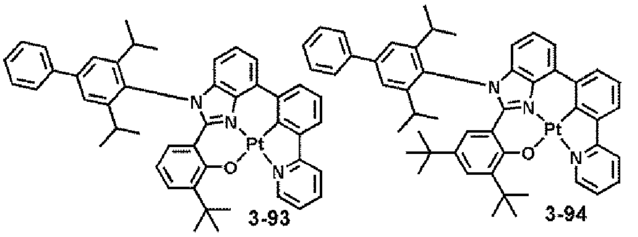

3-93 3-94

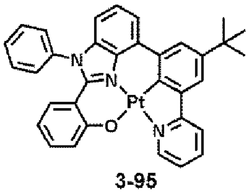

3-95

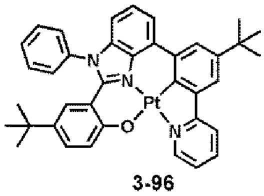

3-96

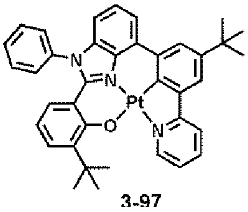

3-97

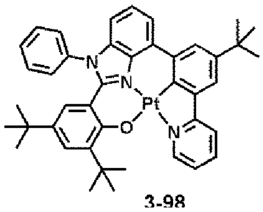

3-98

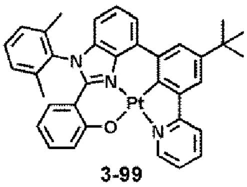

3-99

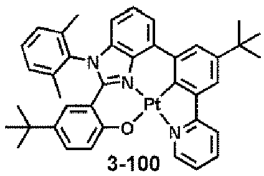

3-100

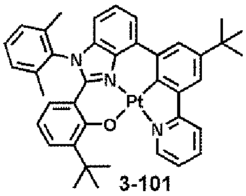

3-101

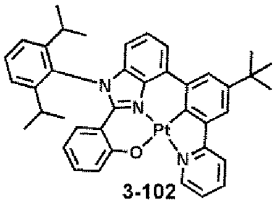

3-102

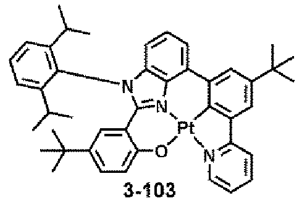

3-103

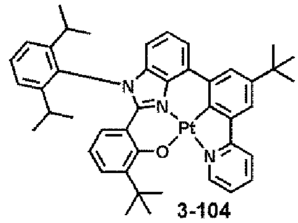

3-104

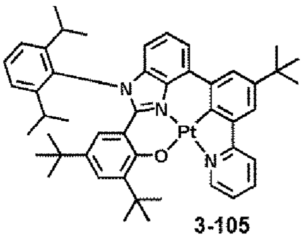

3-105

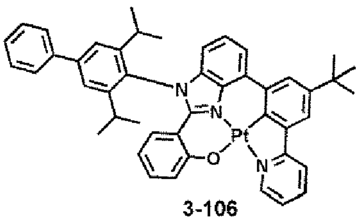

3-106

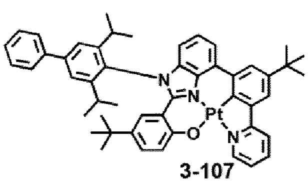

3-107

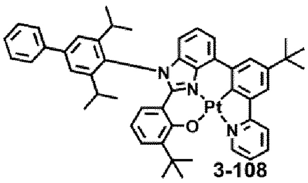

3-108

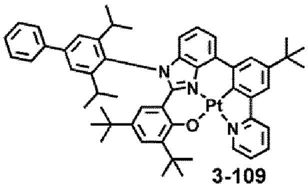

3-109

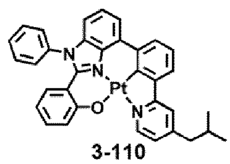

3-110

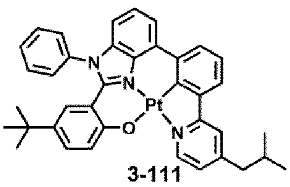

3-111

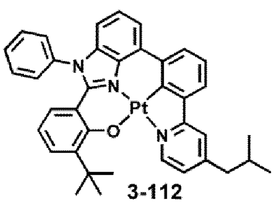

3-112

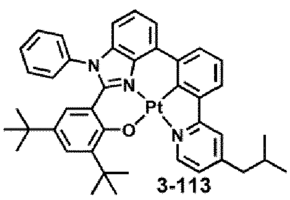

3-113

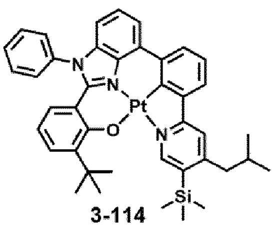

3-114

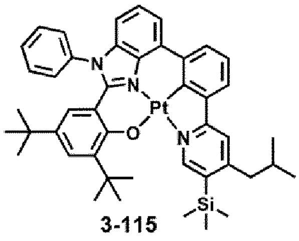

3-115

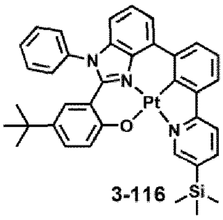

3-116

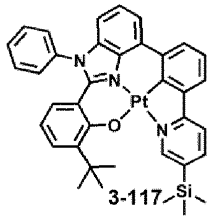

3-117

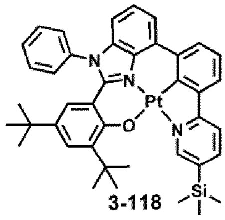

3-118

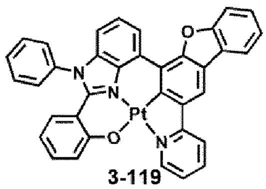

3-119

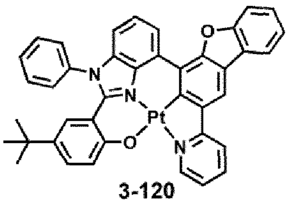

3-120

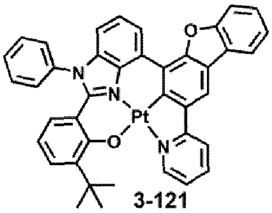

3-121

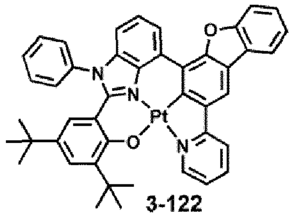

3-122

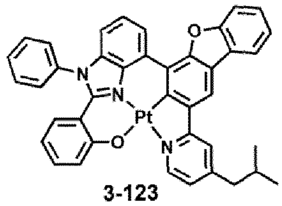

3-123

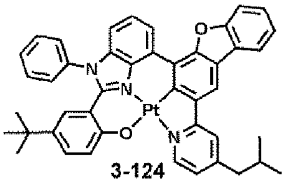

3-124

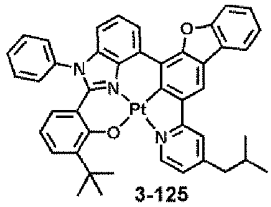

3-125

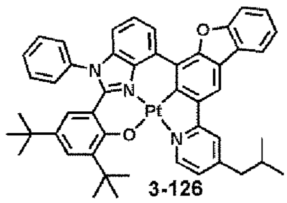

3-126

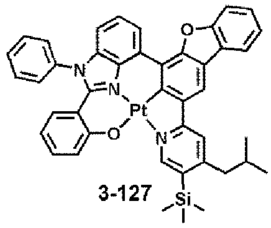

3-127

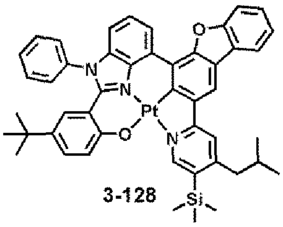

3-128

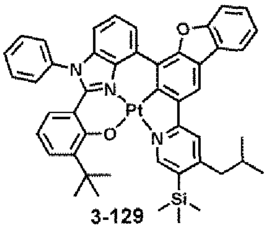

3-129

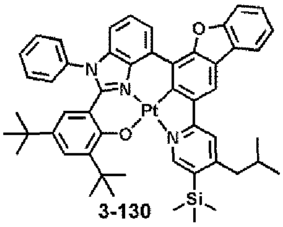

3-130

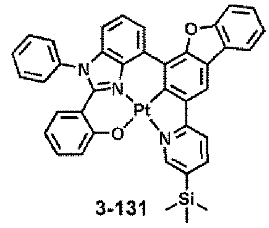

3-131

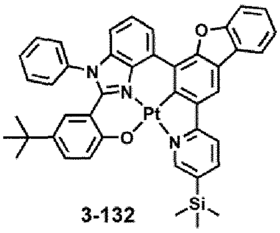

3-132

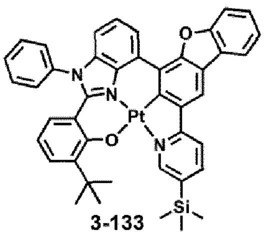

3-133

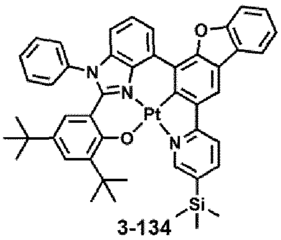

3-134

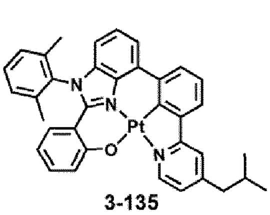

3-135

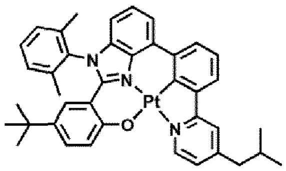

3-136

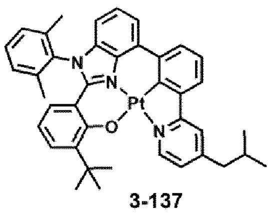

3-137

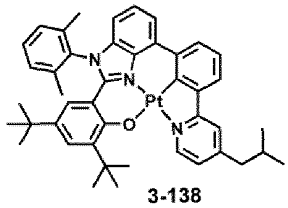

3-138

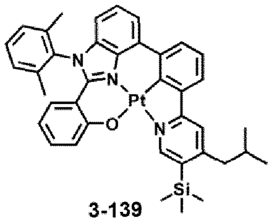

3-139

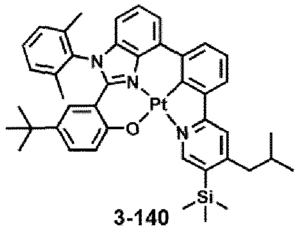

3-140

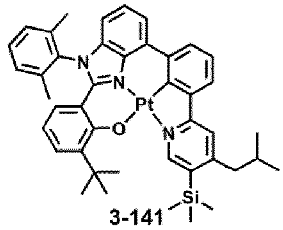

3-141

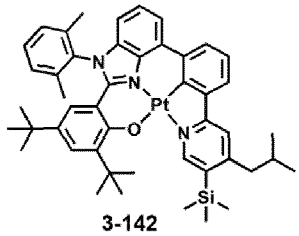

3-142

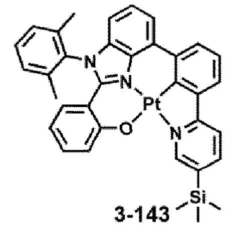

3-143

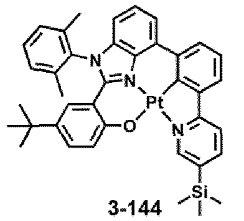

3-144

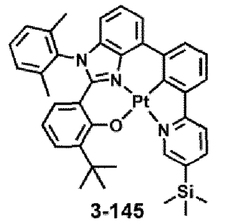

3-145

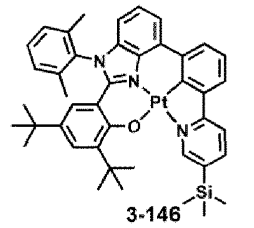

3-146

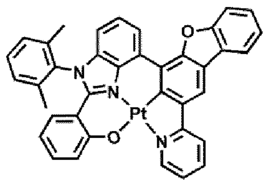

3-147

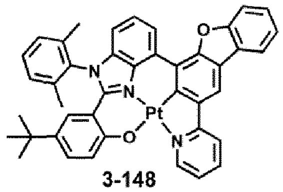

3-148

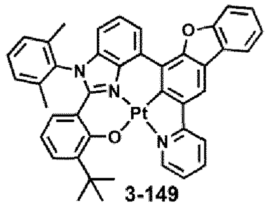

3-149

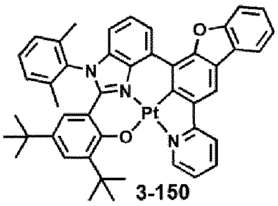

3-150

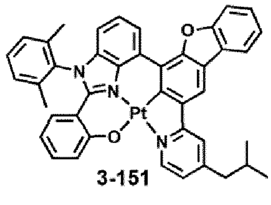

3-151

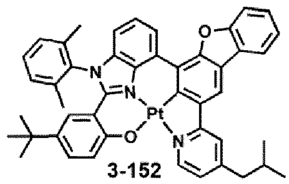

3-152

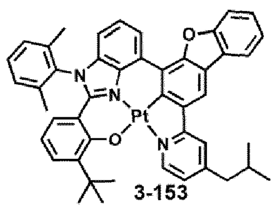

3-153

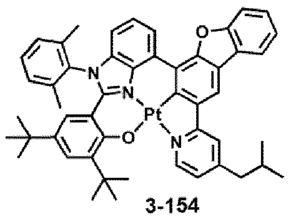

3-154

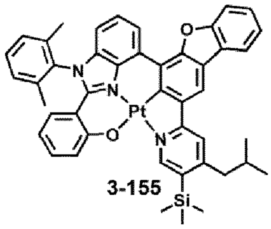

3-155

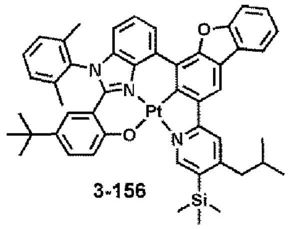

3-156

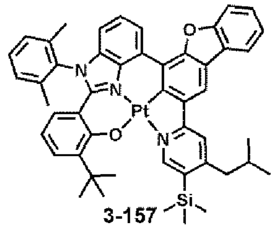

3-157

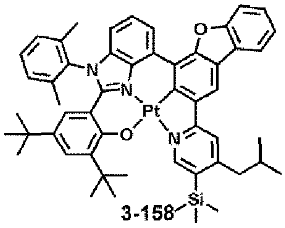

3-158

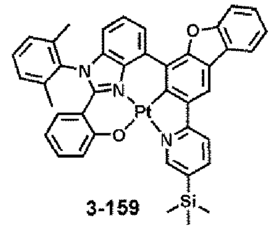

3-159

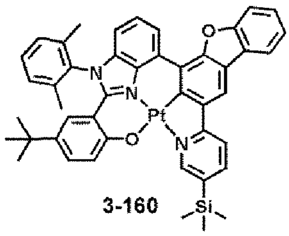
3-160

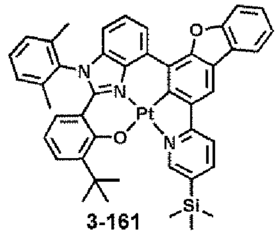
3-161

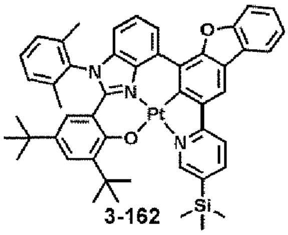
3-162

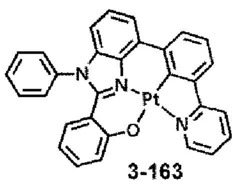
3-163

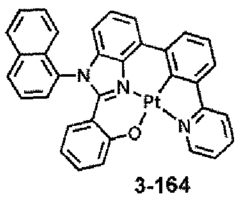
3-164

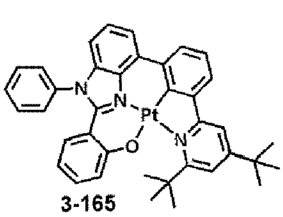
3-165

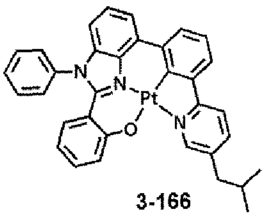
3-166

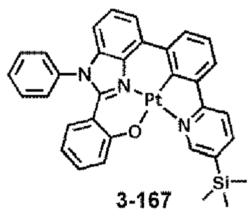
3-167

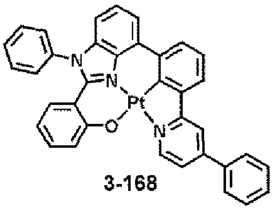
3-168

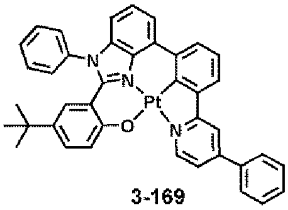
3-169

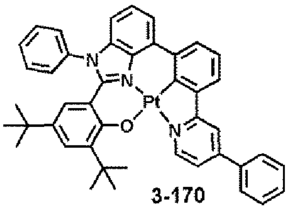
3-170

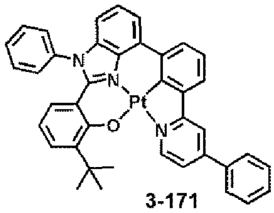
3-171

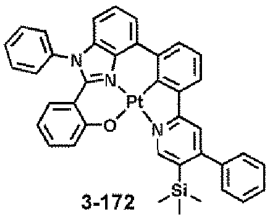
3-172

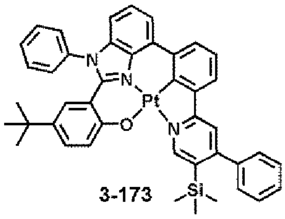
3-173

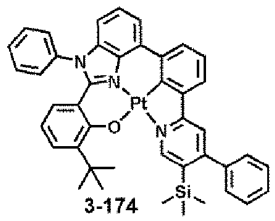
3-174

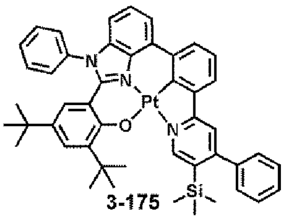
3-175

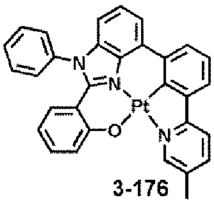
3-176

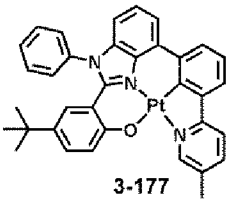
3-177

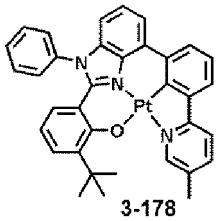
3-178

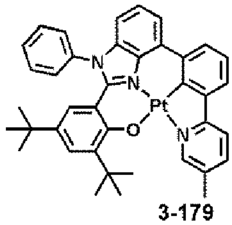
3-179

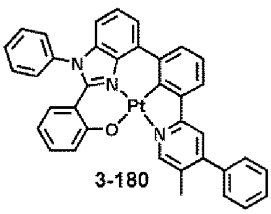
3-180

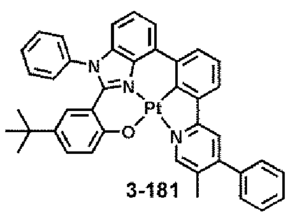
3-181

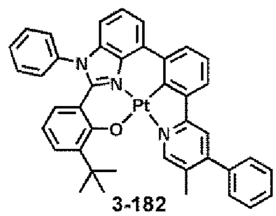
3-182

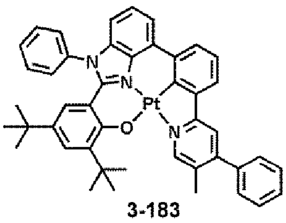
3-183

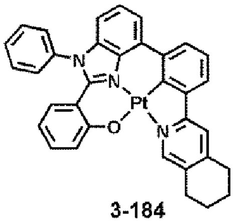
3-184

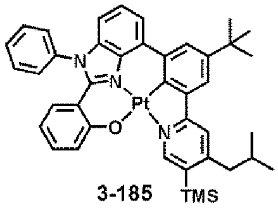
3-185

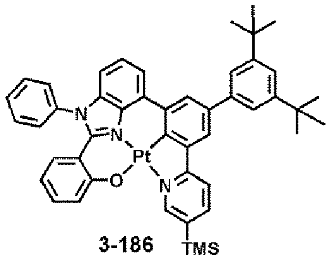
3-186

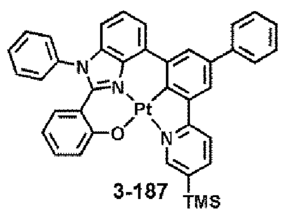
3-187

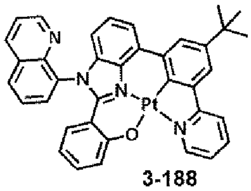
3-188

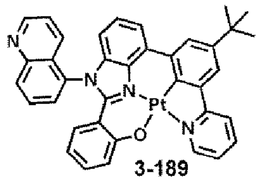
3-189

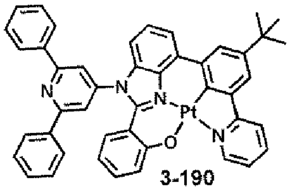
3-190

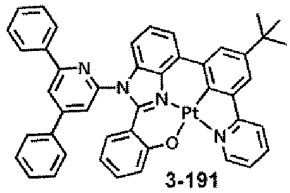
3-191

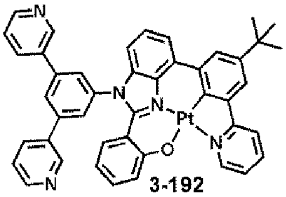
3-192

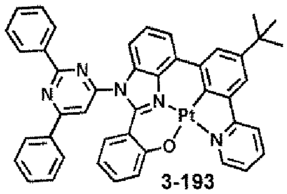
3-193

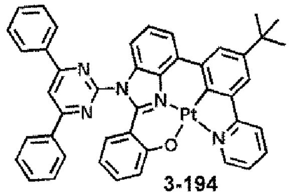
3-194

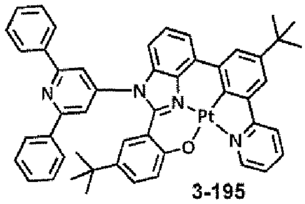
3-195

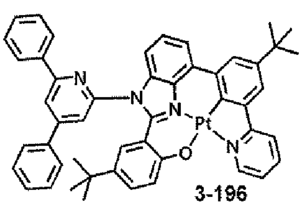
3-196

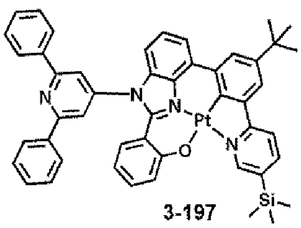
3-197

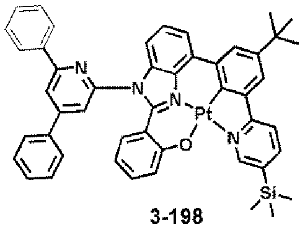
3-198

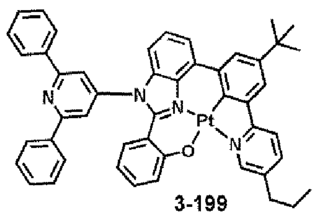
3-199

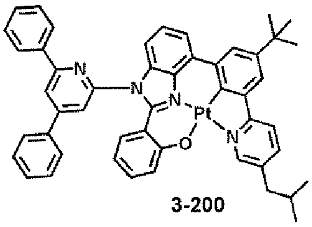
3-200

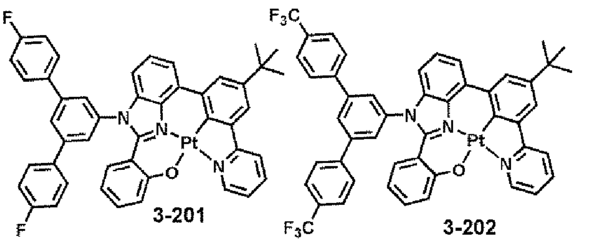
3-201

3-202

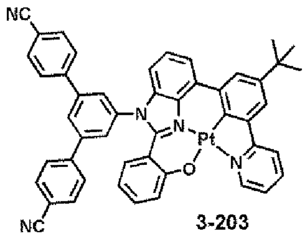
3-203

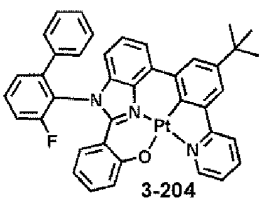
3-204

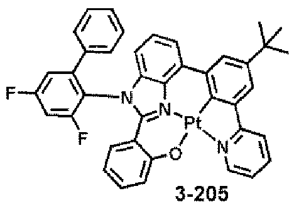
3-205

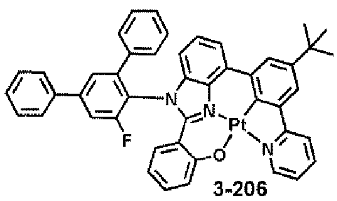
3-206

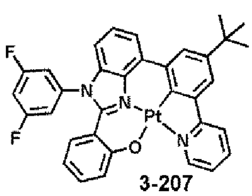
3-207

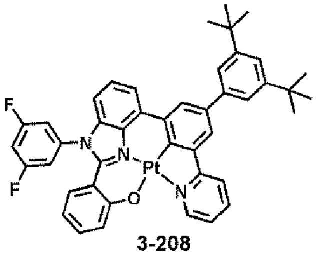
3-208

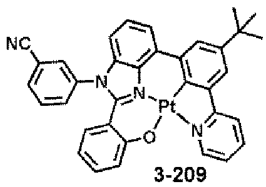
3-209

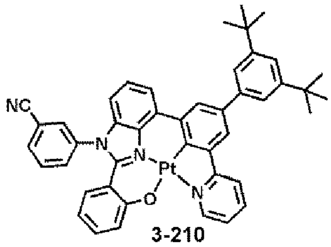
3-210

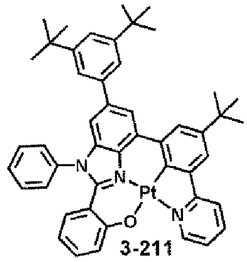
3-211

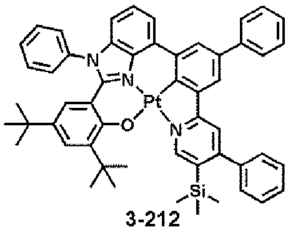
3-212

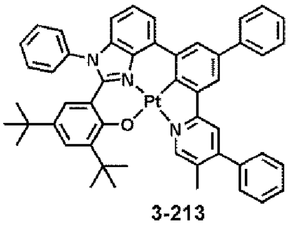
3-213

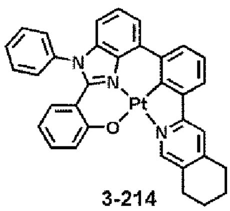
3-214

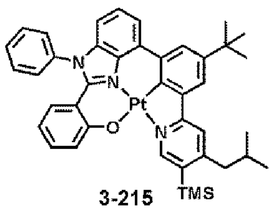
3-215

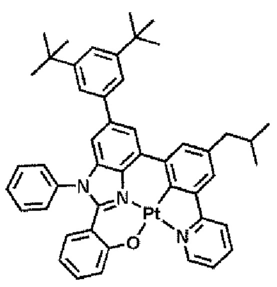
3-216

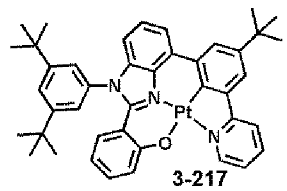
3-217

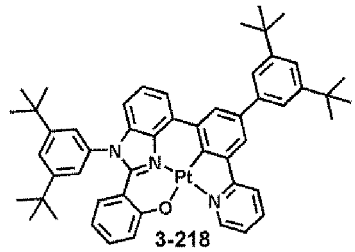
3-218

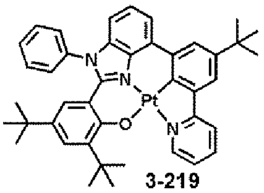
3-219

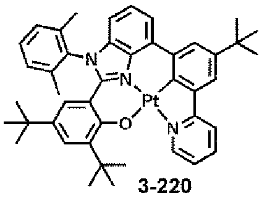
3-220

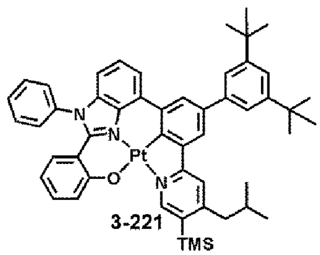
3-221

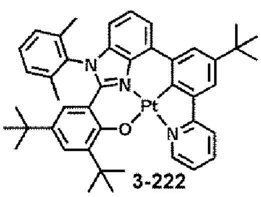
3-222

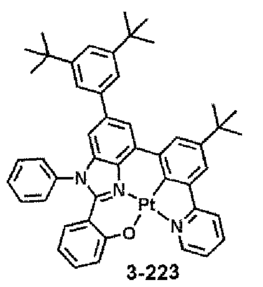
3-223

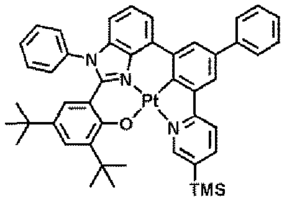
3-224

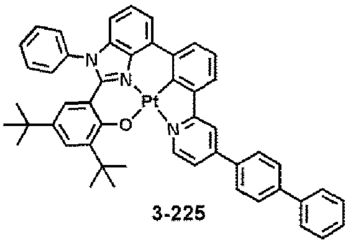
3-225

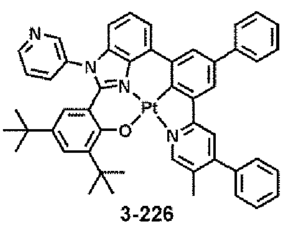
3-226

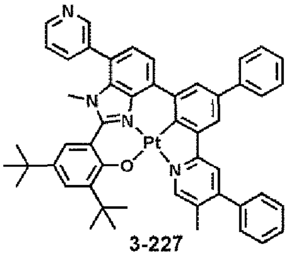
3-227

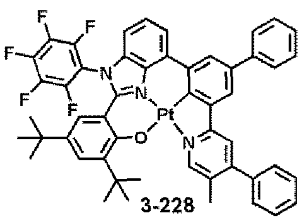
3-228

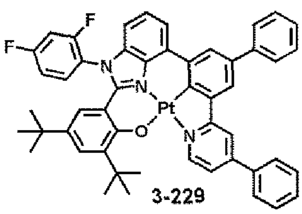
3-229

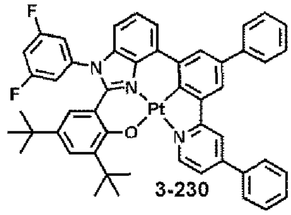
3-230

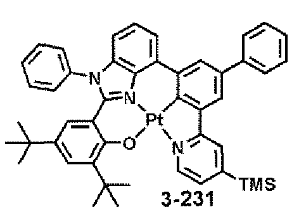
3-231

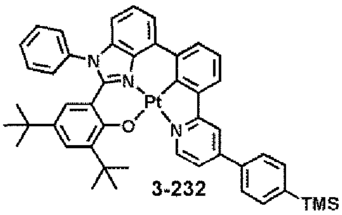
3-232

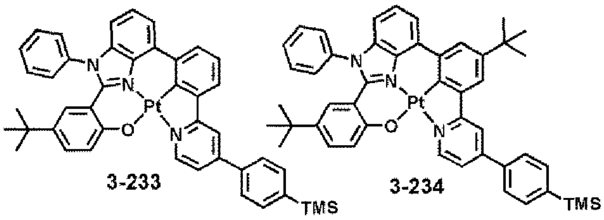
3-233

3-234

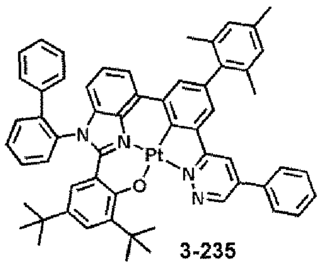
3-235

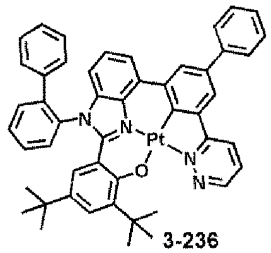
3-236

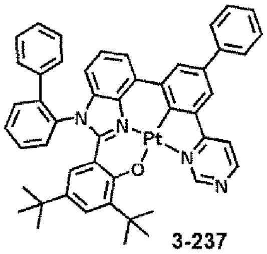
3-237

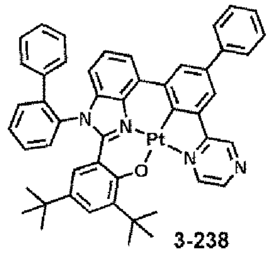
3-238

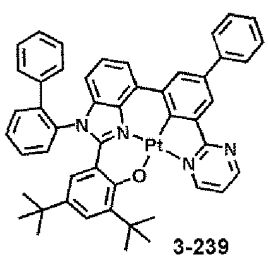
3-239

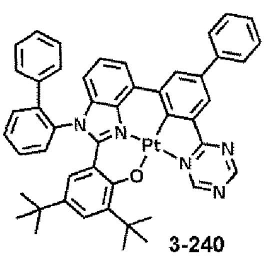
3-240

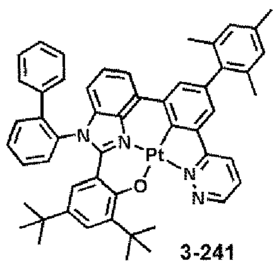
3-241

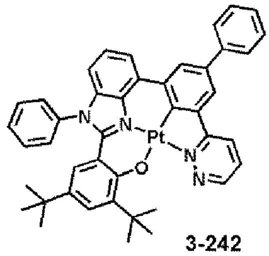
3-242

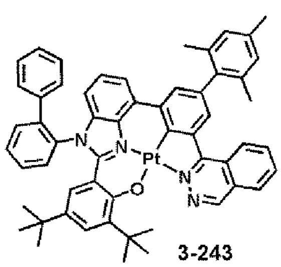
3-243

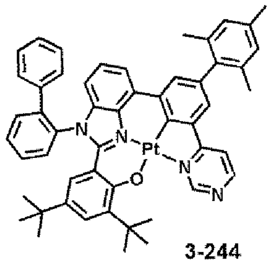
3-244

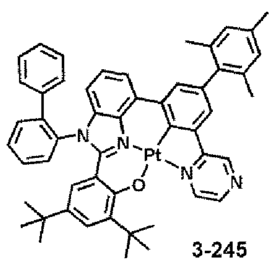
3-245

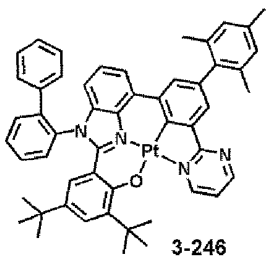
3-246

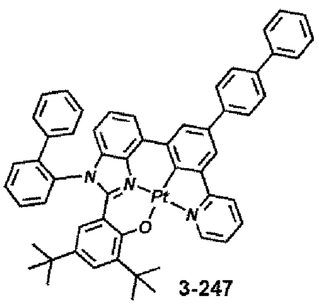
3-247

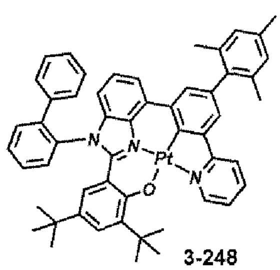
3-248

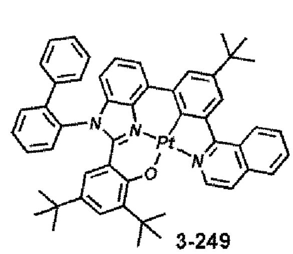
3-249

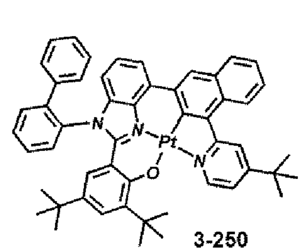
3-250

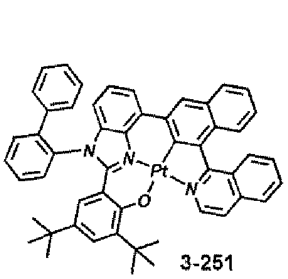
3-251

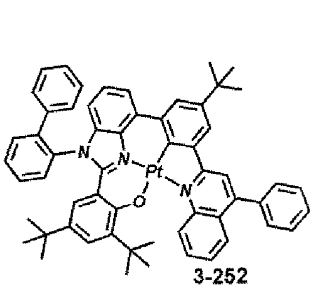
3-252

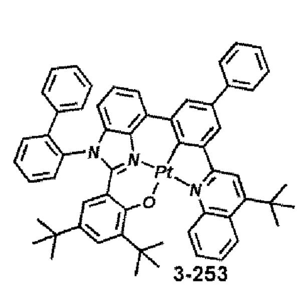
3-253

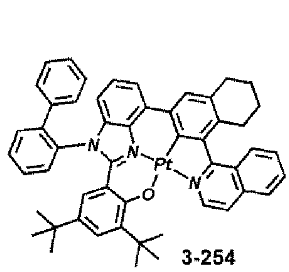
3-254

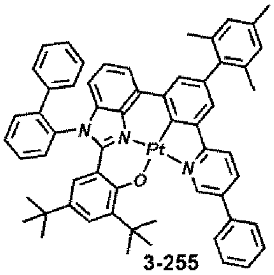
3-255

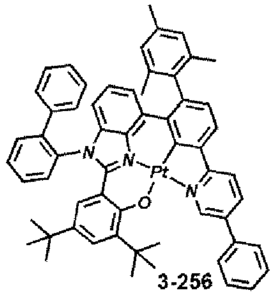
3-256

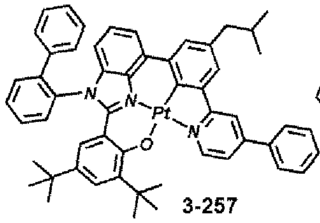
3-257

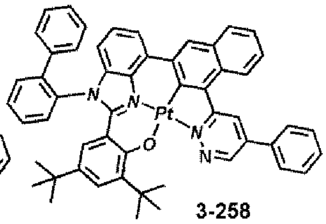
3-258

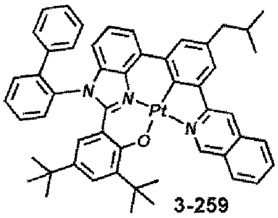
3-259

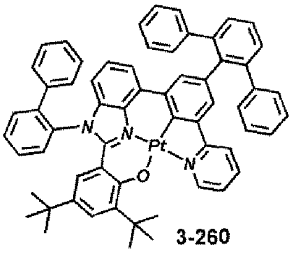
3-260

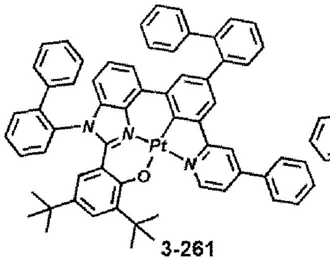
3-261

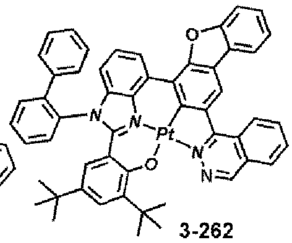
3-262

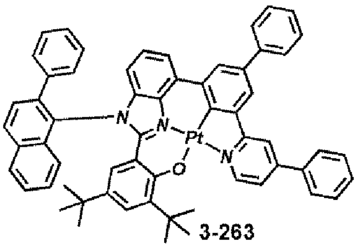
3-263

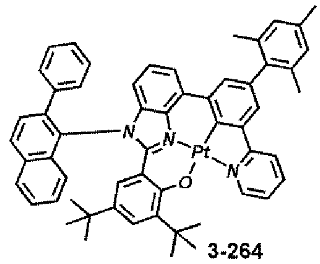
3-264

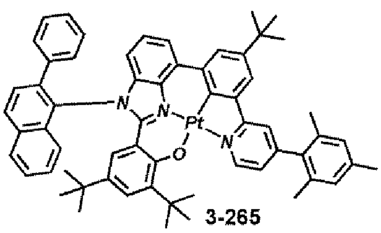
3-265

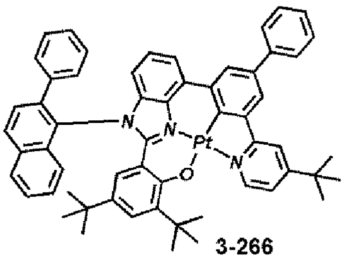
3-266

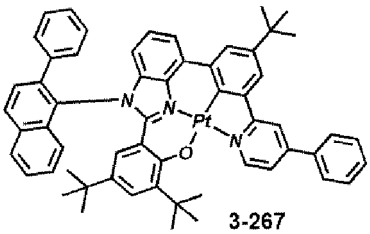
3-267

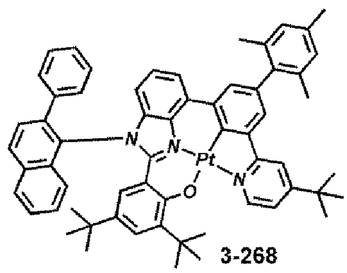
3-268

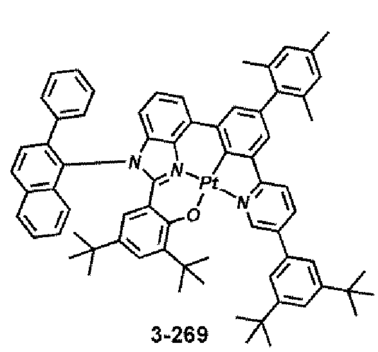
3-269

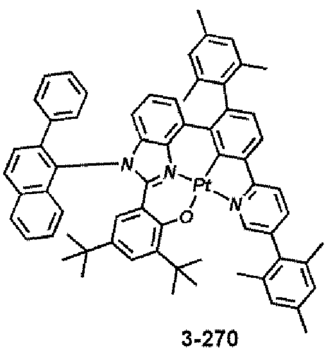
3-270

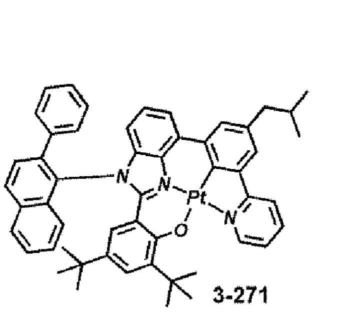
3-271

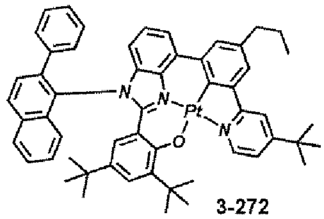
3-272

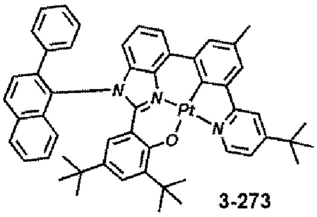
3-273

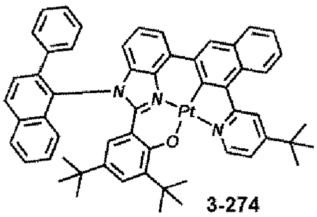
3-274

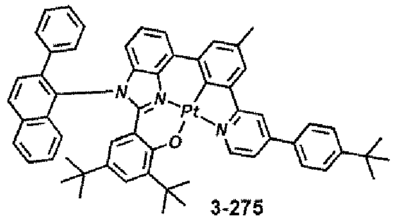
3-275

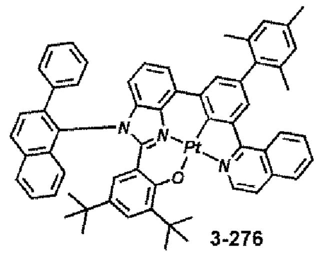
3-276

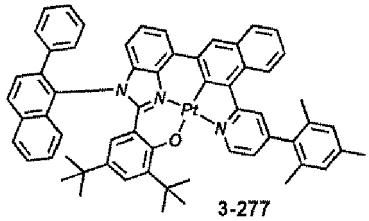
3-277

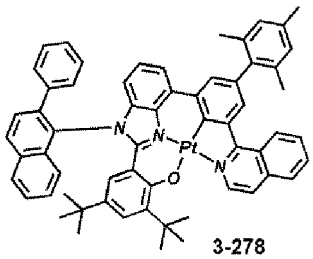
3-278

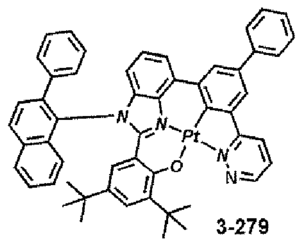
3-279

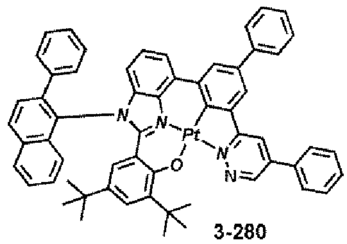
3-280

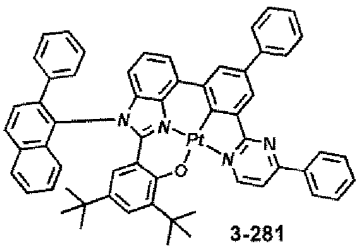
3-281

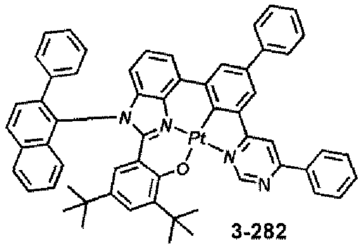
3-282

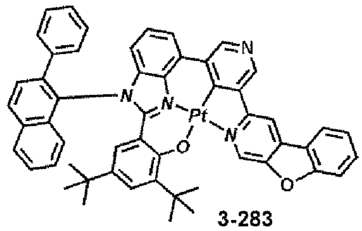
3-283

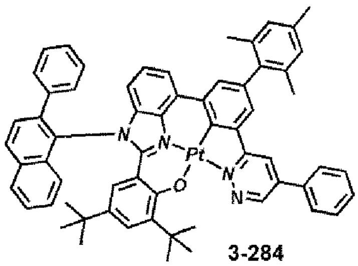
3-284

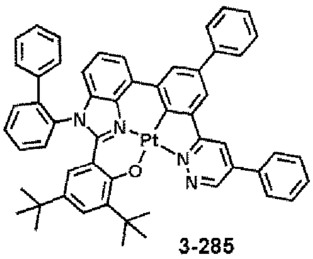
3-285

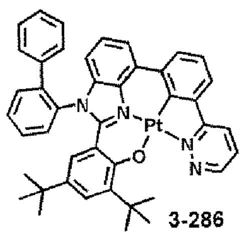
3-286

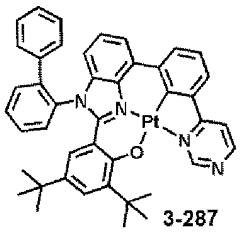
3-287

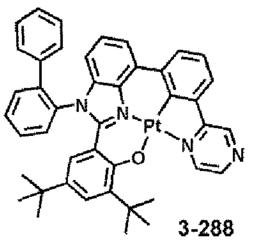
3-288

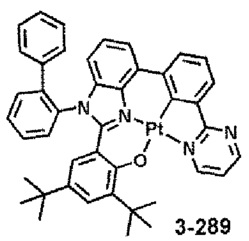
3-289

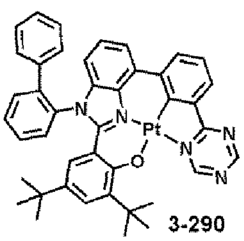
3-290

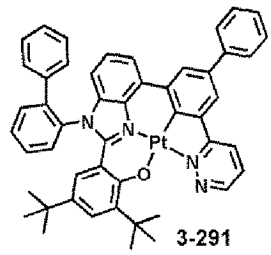
3-291

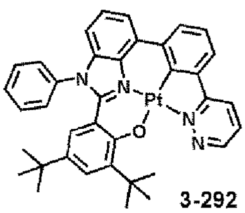
3-292
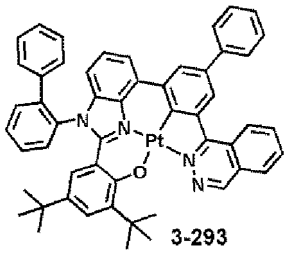
3-293
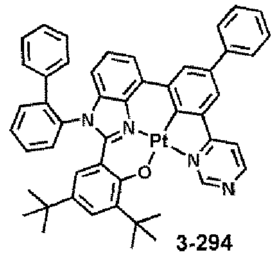
3-294
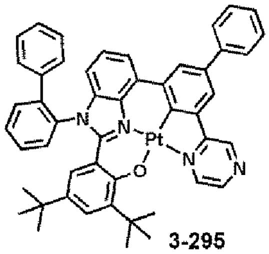
3-295

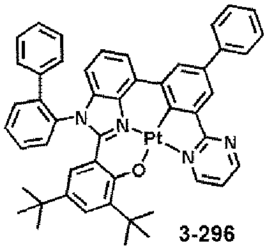
3-296
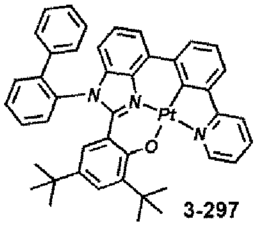
3-297
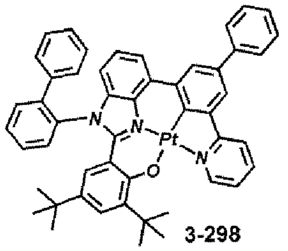
3-298
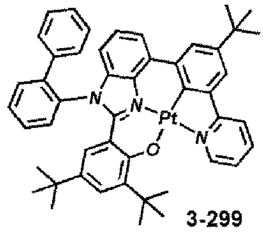
3-299

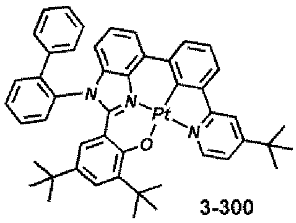
3-300
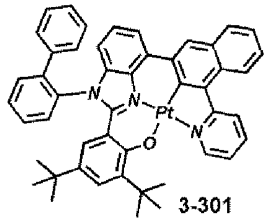
3-301
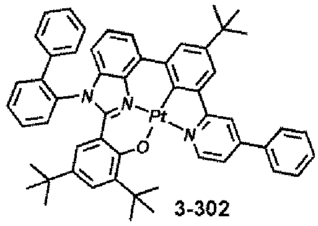
3-302
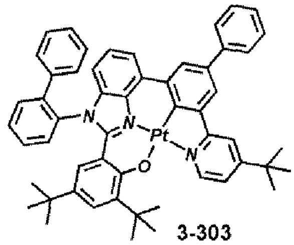
3-303

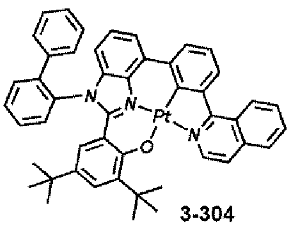
3-304
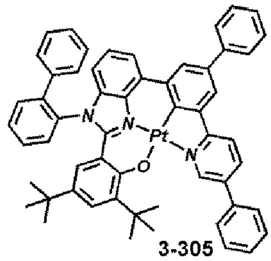
3-305
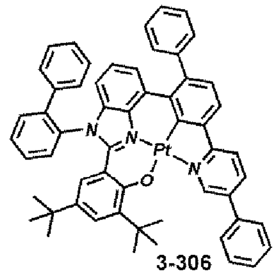
3-306
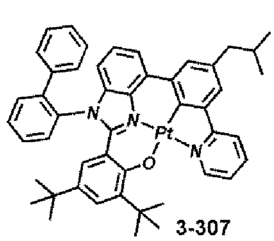
3-307

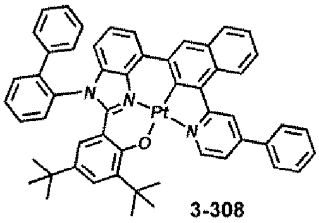
3-308
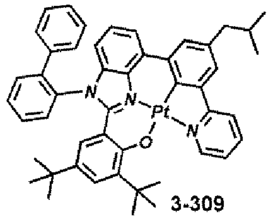
3-309
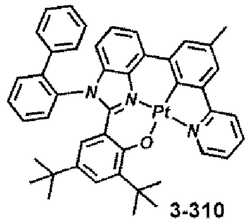
3-310
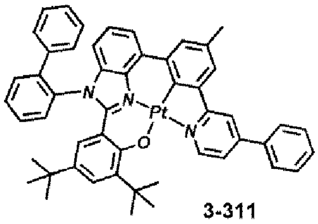
3-311

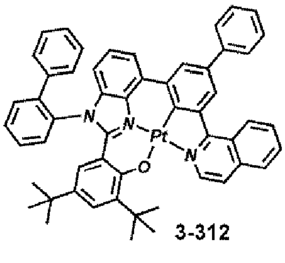
3-312
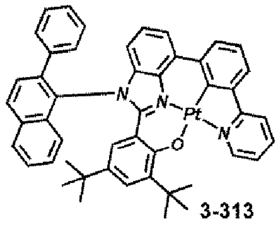
3-313
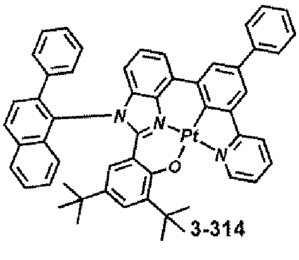
3-314
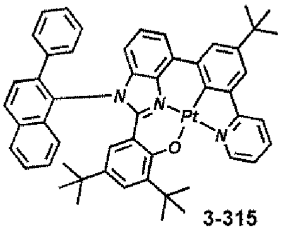
3-315

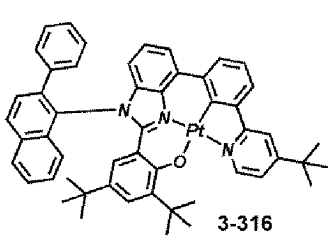
3-316

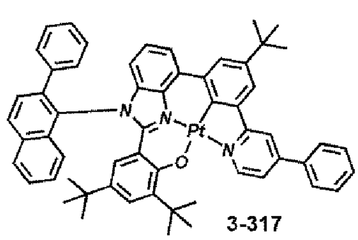
3-317

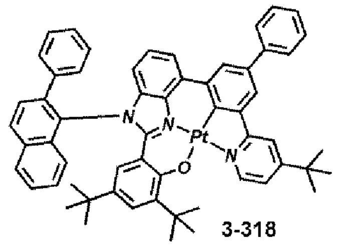
3-318

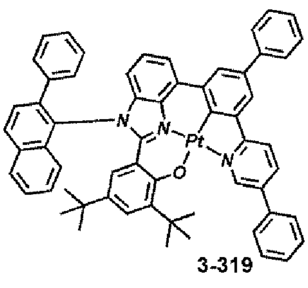
3-319

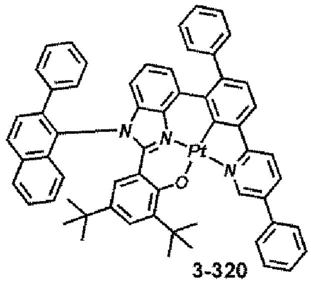
3-320

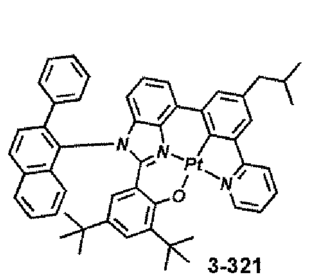
3-321

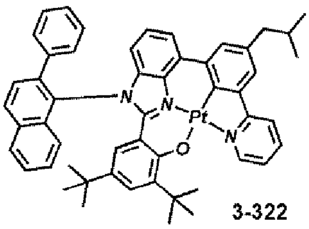
3-322

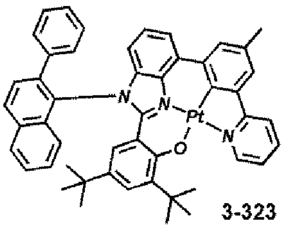
3-323

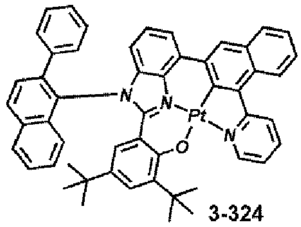
3-324

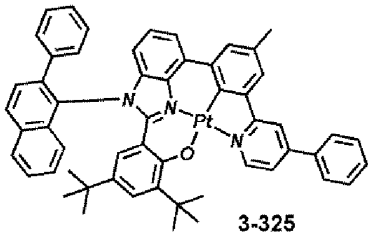
3-325

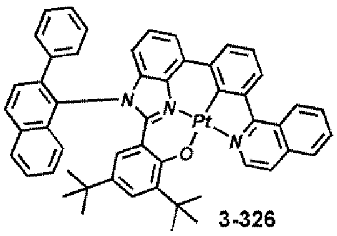
3-326

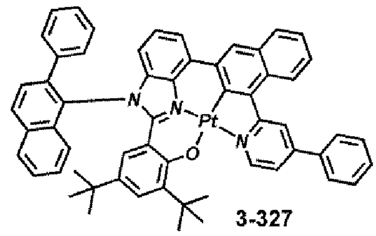
3-327

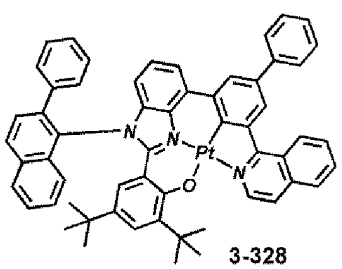
3-328

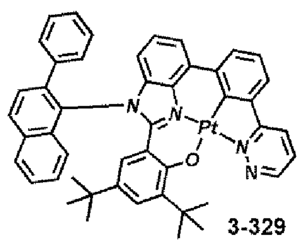
3-329

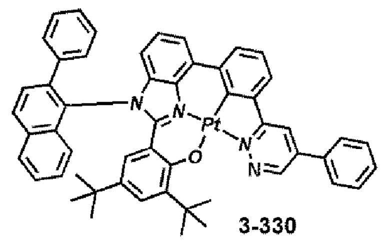
3-330

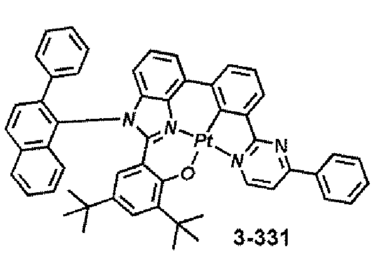
3-331

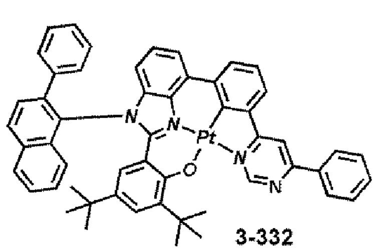
3-332

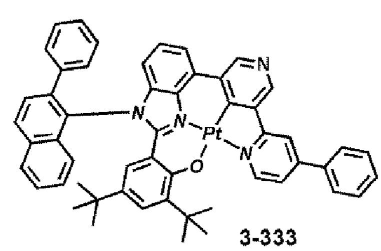
3-333

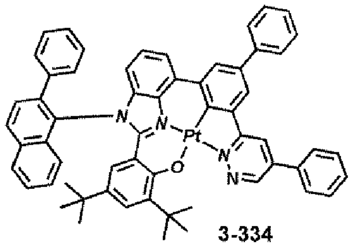
3-334

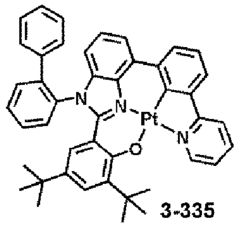
3-335

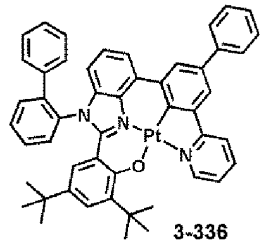
3-336

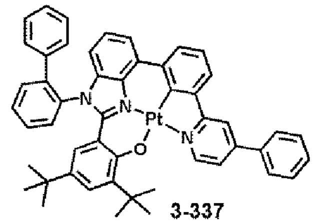
3-337

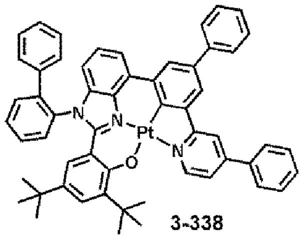
3-338

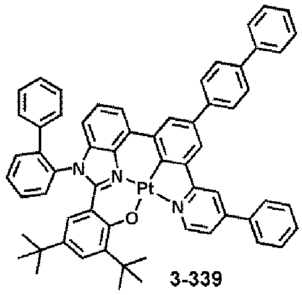
3-339

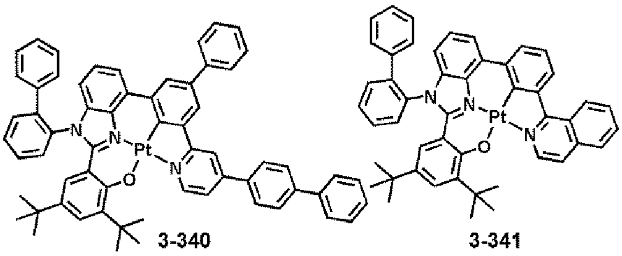
3-340

3-341

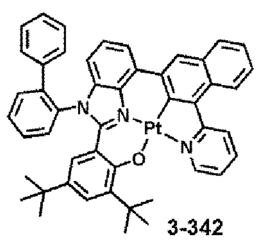
3-342

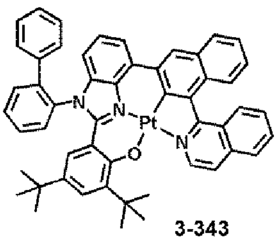
3-343

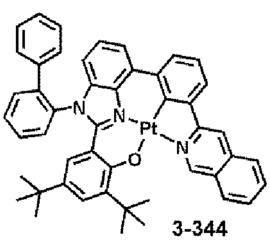
3-344

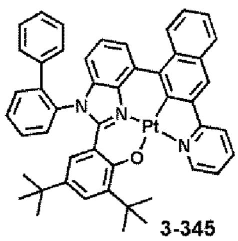
3-345

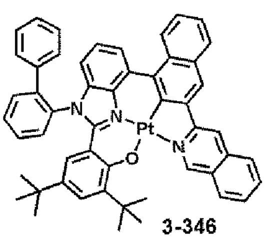
3-346

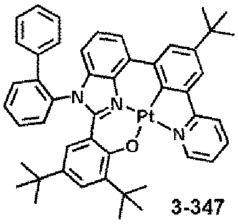
3-347

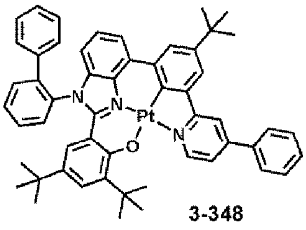
3-348

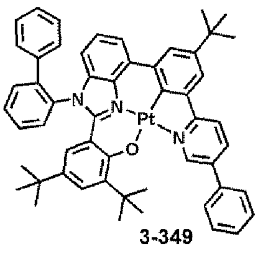
3-349

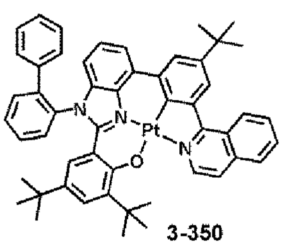
3-350

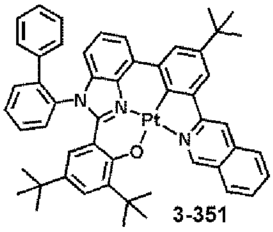
3-351

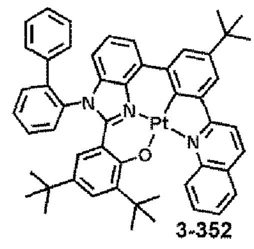
3-352

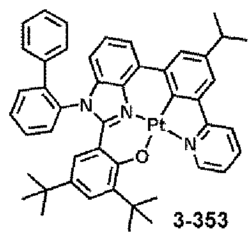
3-353

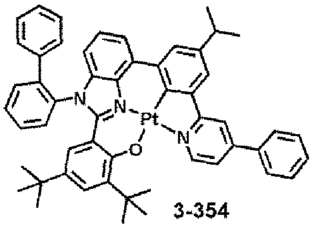
3-354

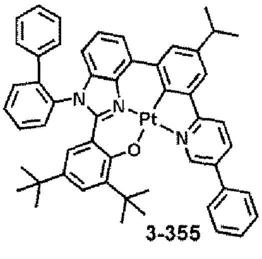
3-355

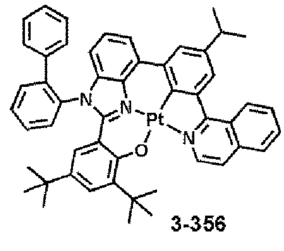
3-356

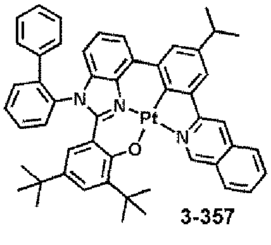
3-357

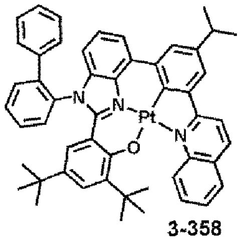
3-358

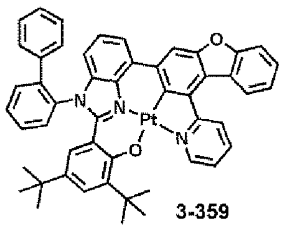
3-359

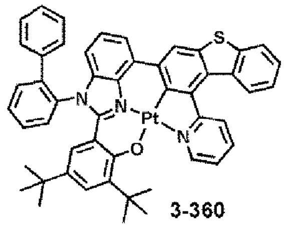
3-360

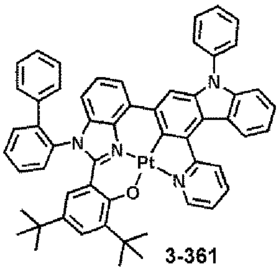
3-361

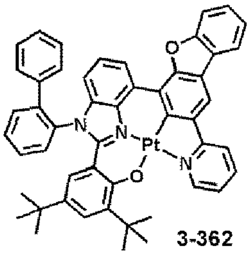
3-362

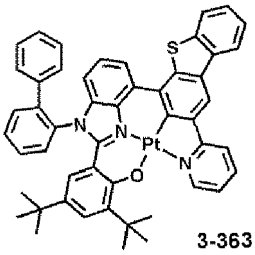
3-363

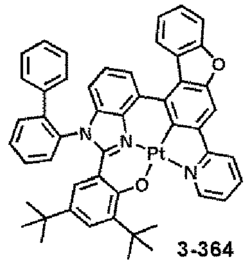
3-364

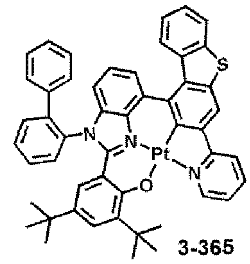
3-365

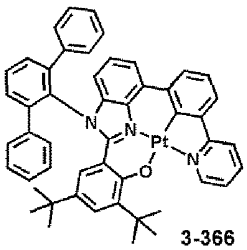
3-366

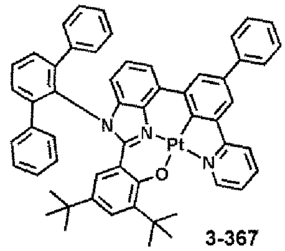
3-367

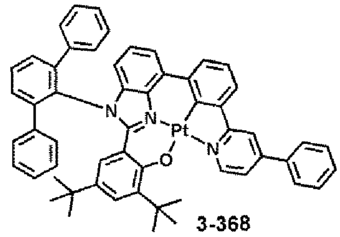
3-368

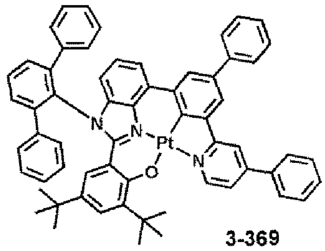
3-369

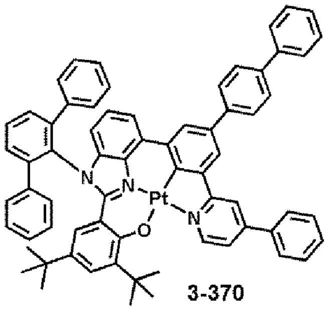
3-370

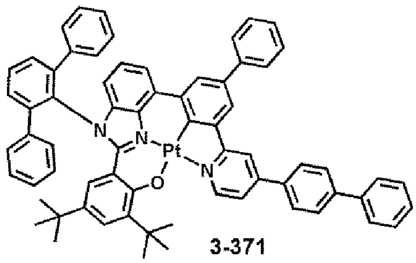
3-371

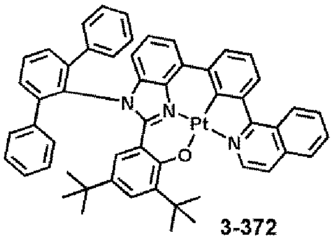
3-372

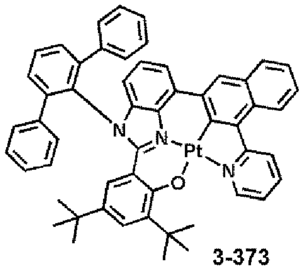
3-373

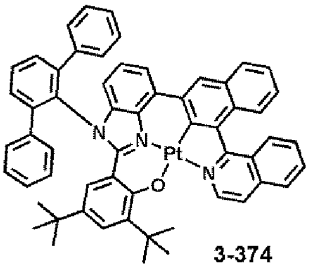
3-374

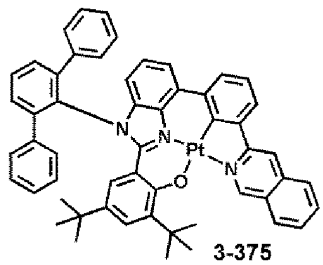
3-375

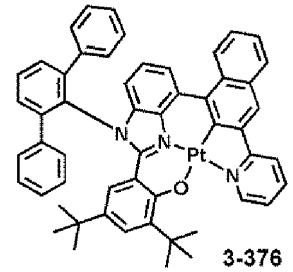
3-376

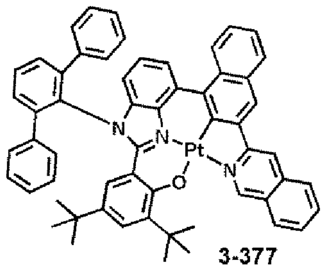
3-377

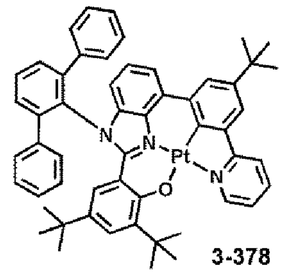
3-378

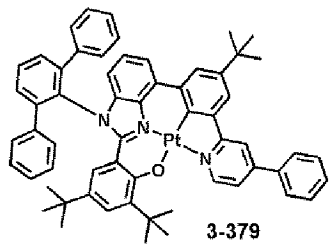
3-379

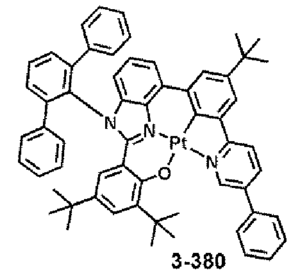
3-380

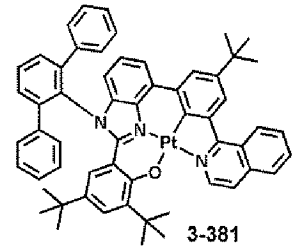
3-381

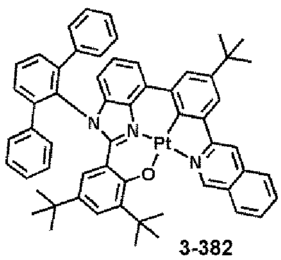
3-382

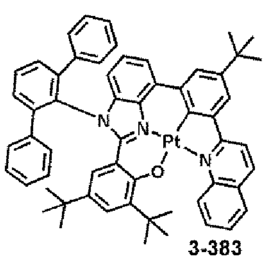
3-383

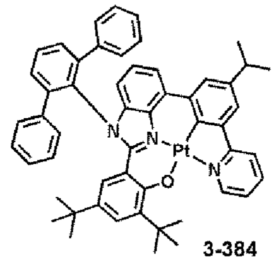
3-384

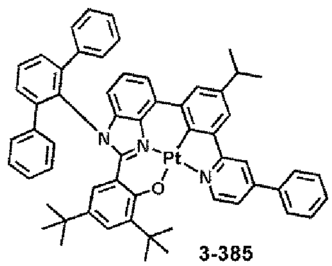
3-385

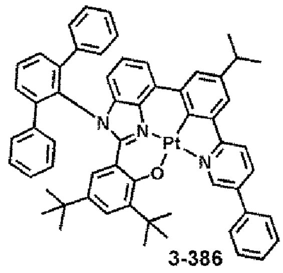
3-386

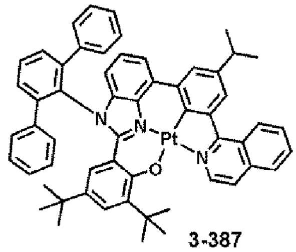
3-387

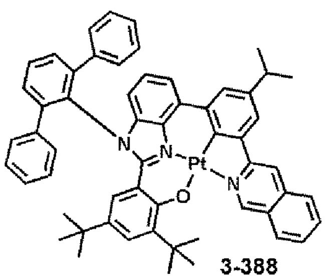
3-388

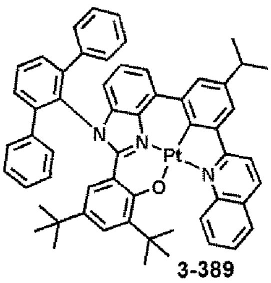
3-389

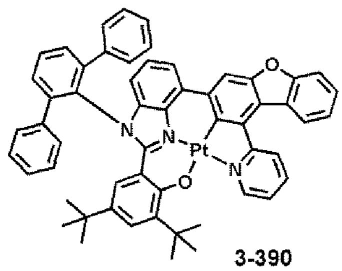
3-390

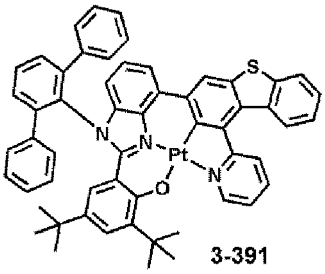
3-391

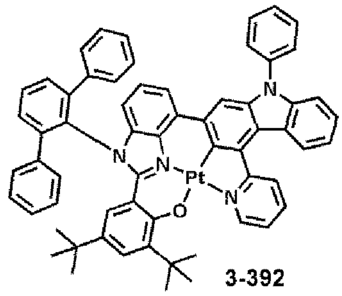
3-392

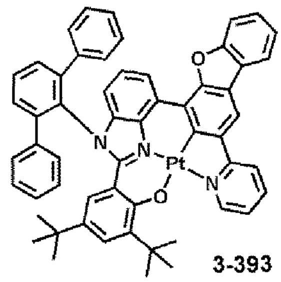
3-393

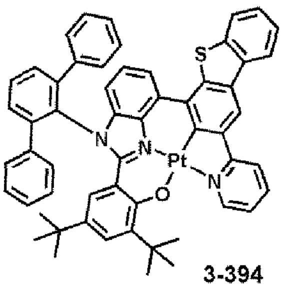
3-394

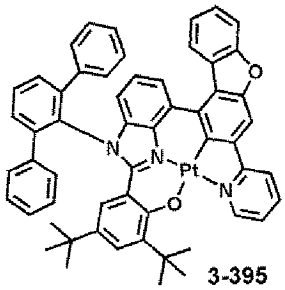
3-395

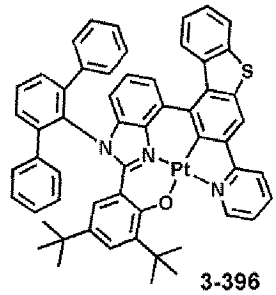
3-396

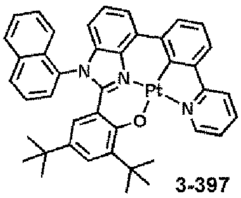
3-397

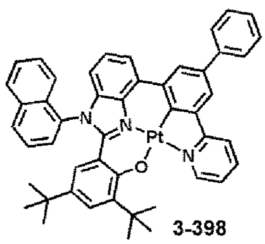
3-398

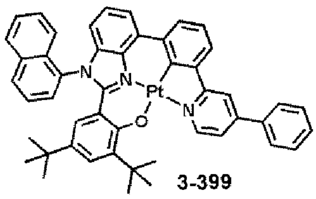
3-399

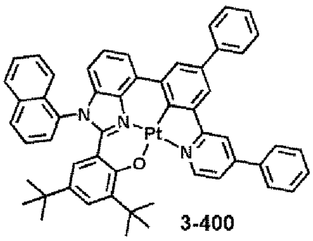
3-400

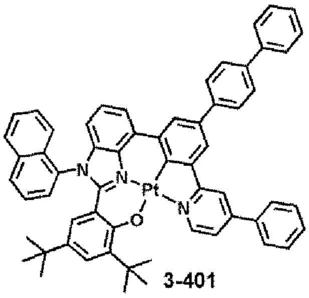
3-401

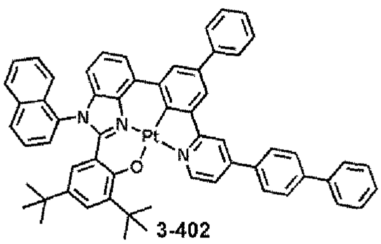
3-402

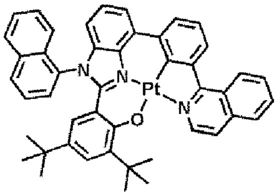
3-403

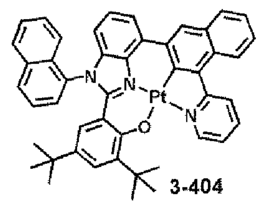
3-404

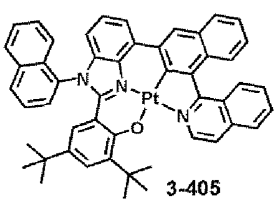
3-405

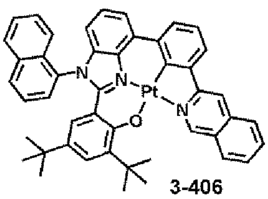
3-406

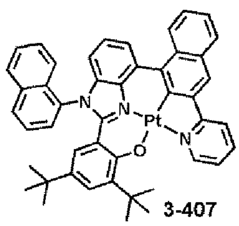
3-407

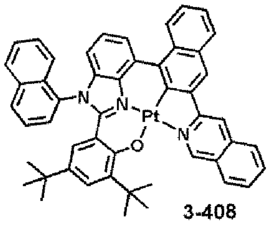
3-408

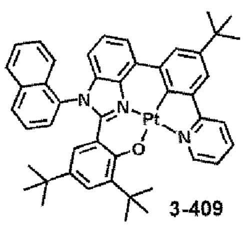
3-409

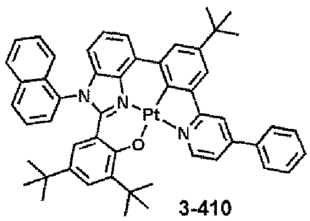
3-410

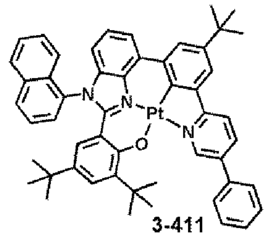
3-411

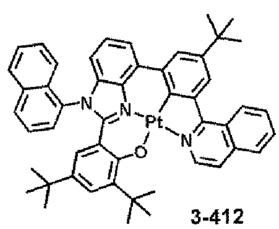
3-412

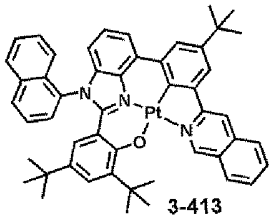
3-413

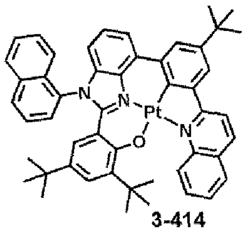
3-414

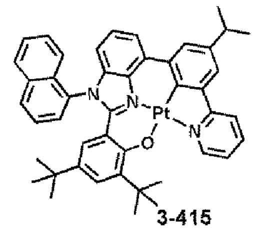
3-415

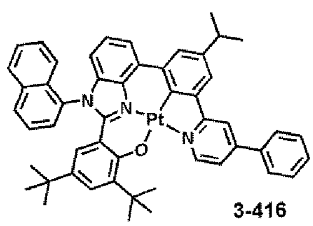
3-416

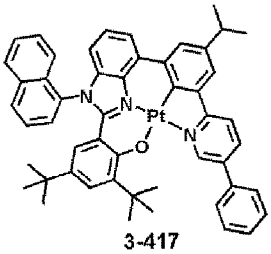
3-417

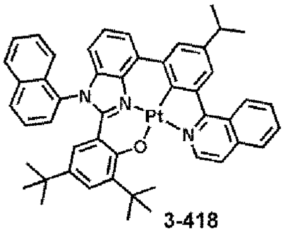
3-418

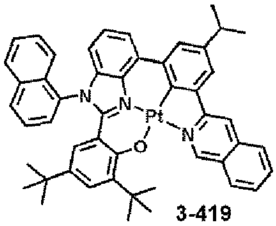
3-419

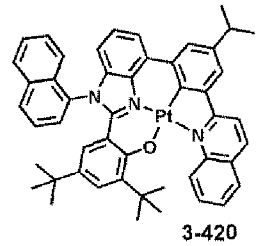
3-420

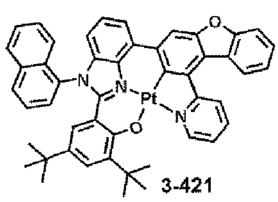
3-421

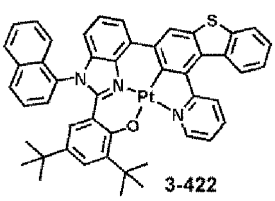
3-422

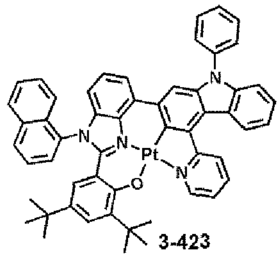
3-423

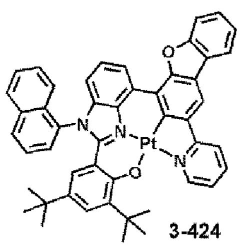
3-424

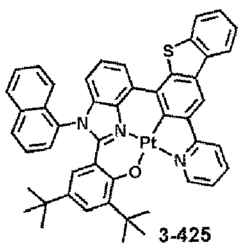
3-425

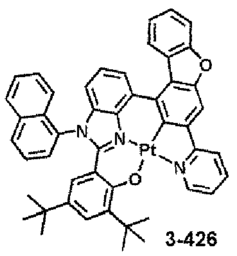
3-426

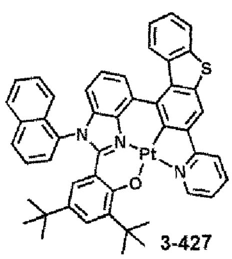
3-427

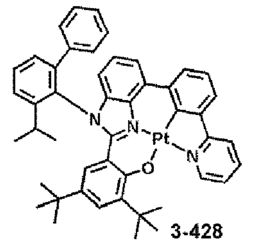
3-428

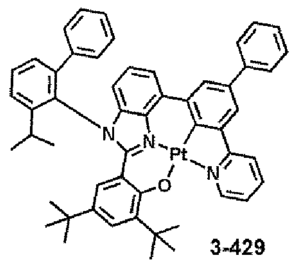
3-429

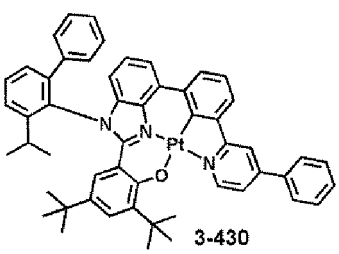
3-430

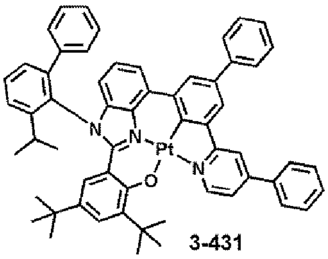
3-431

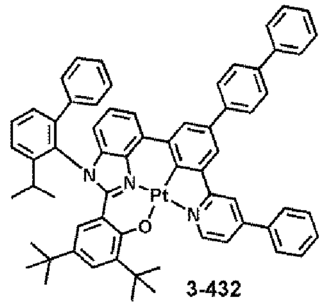
3-432

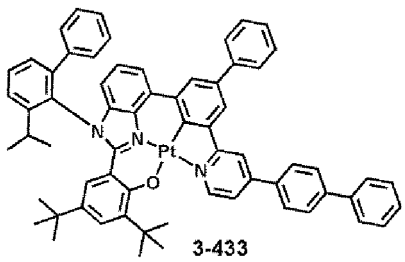
3-433

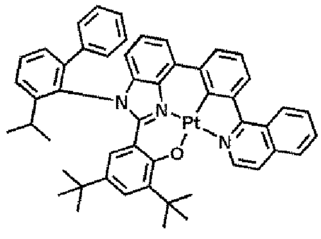
3-434

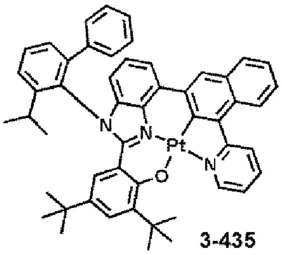
3-435

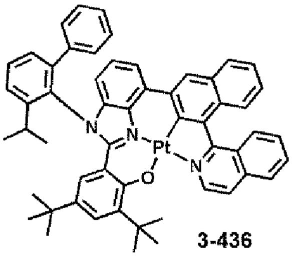
3-436

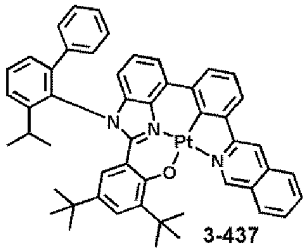
3-437

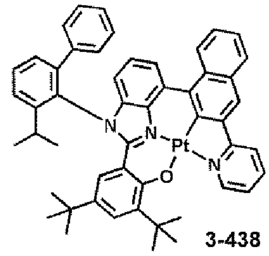
3-438

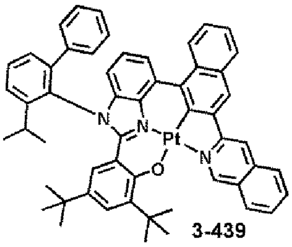
3-439

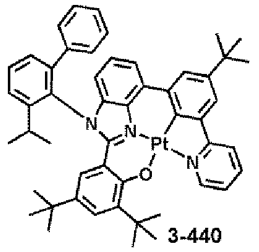
3-440

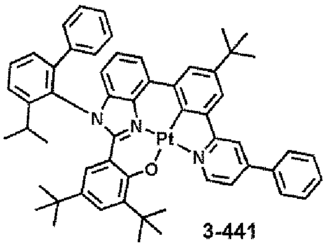
3-441

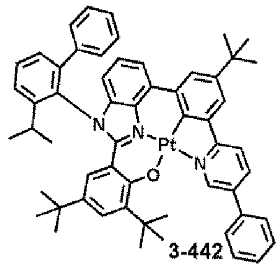
3-442

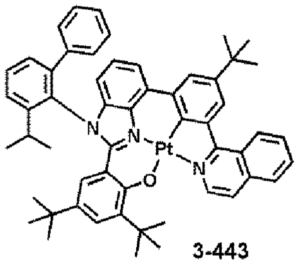
3-443

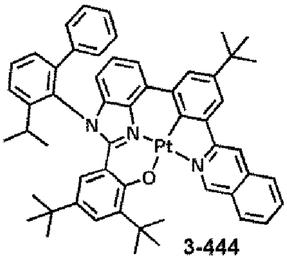
3-444

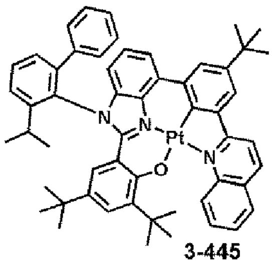
3-445

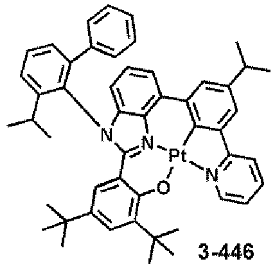
3-446

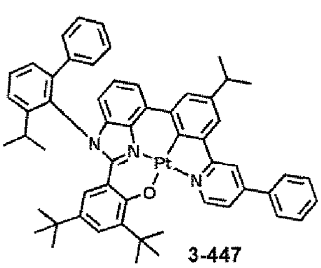
3-447

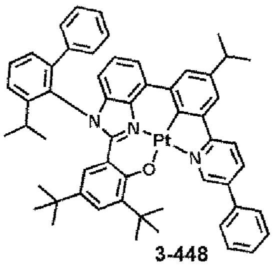
3-448

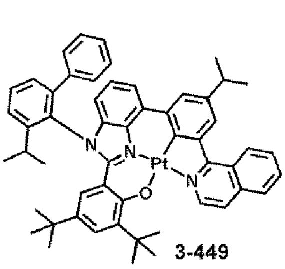
3-449

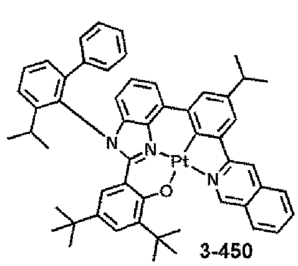
3-450

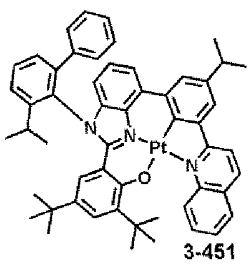
3-451

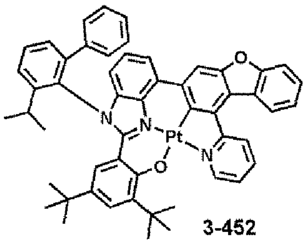
3-452

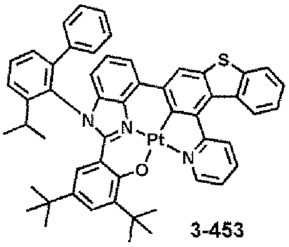
3-453

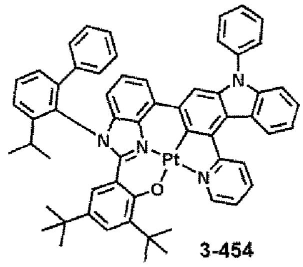
3-454

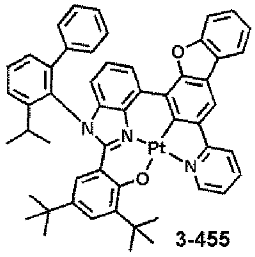
3-455

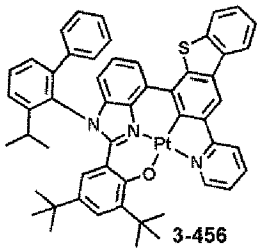
3-456

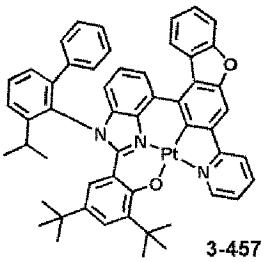
3-457

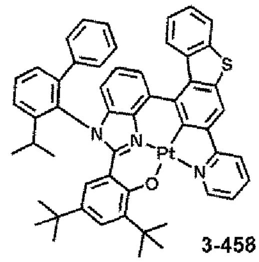
3-458

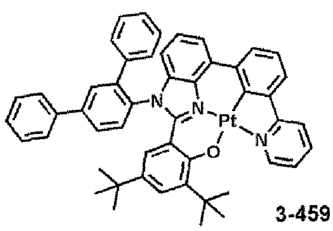
3-459

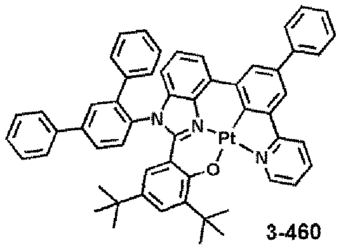
3-460

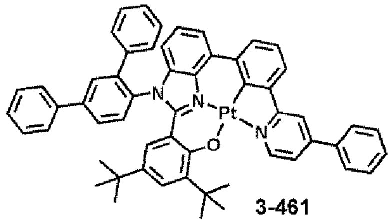
3-461

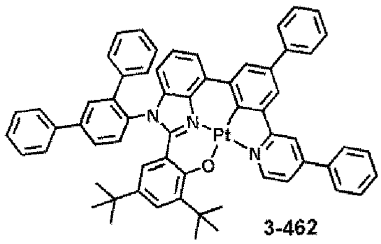
3-462

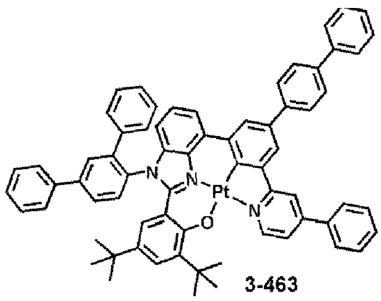
3-463

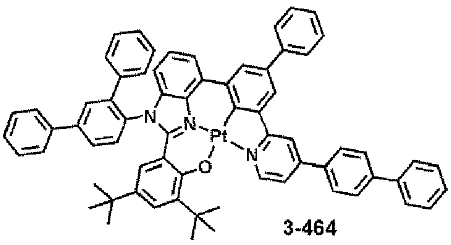
3-464

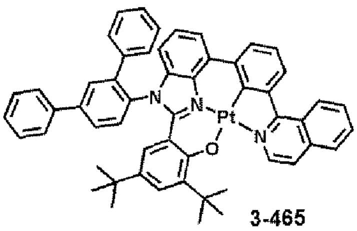
3-465

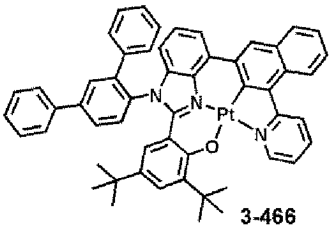
3-466

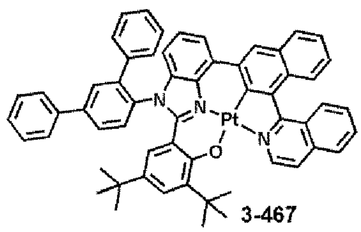
3-467

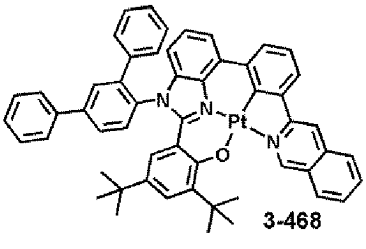
3-468

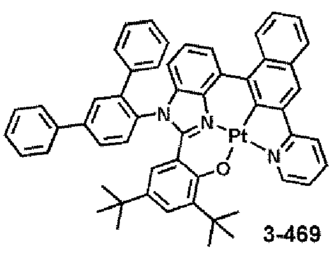
3-469

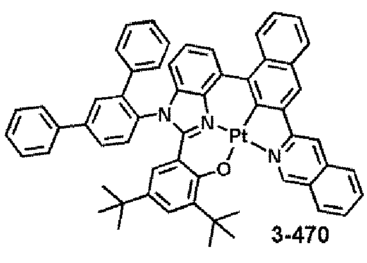
3-470

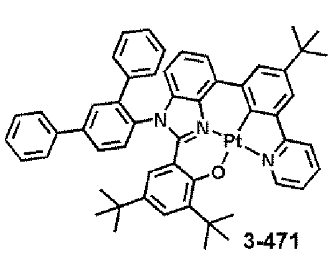
3-471

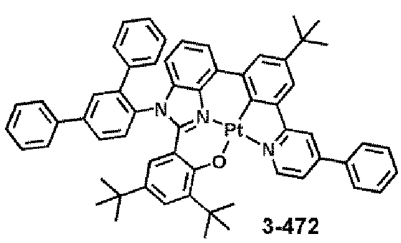
3-472

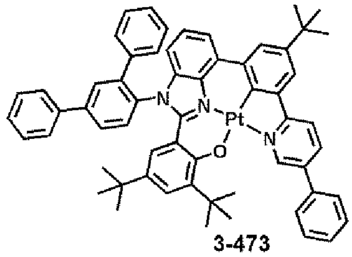
3-473

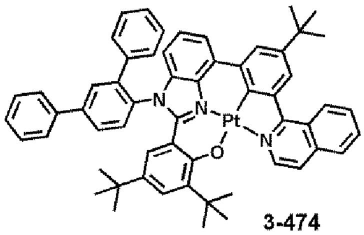
3-474

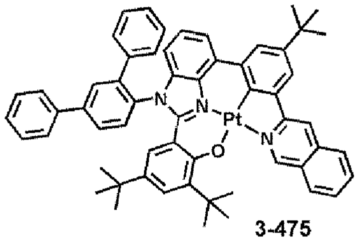
3-475

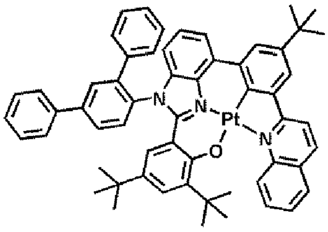
3-476

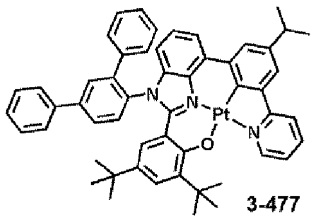
3-477

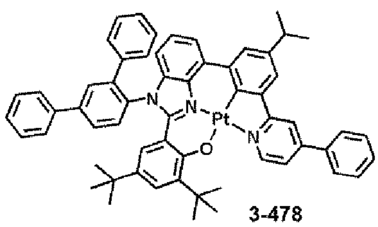
3-478

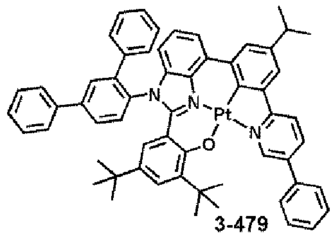
3-479

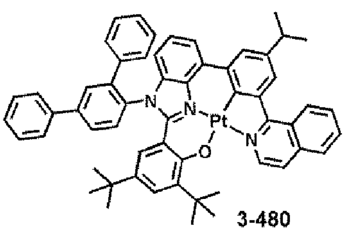
3-480

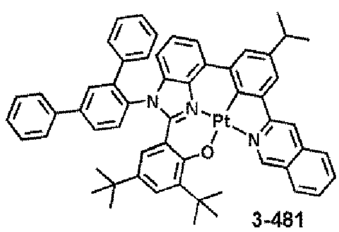
3-481

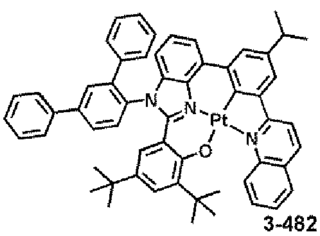
3-482

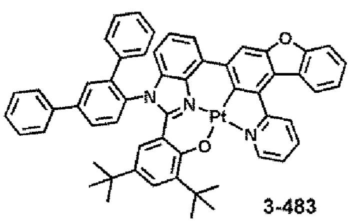
3-483

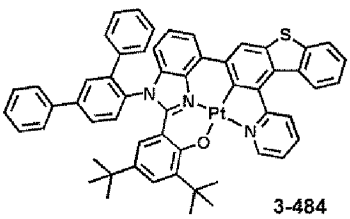
3-484

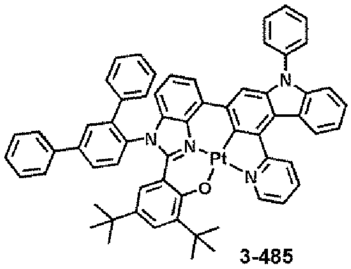
3-485

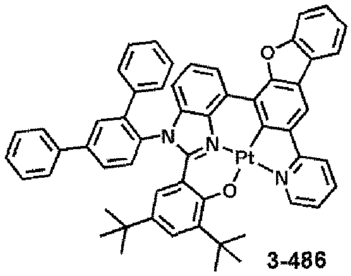
3-486

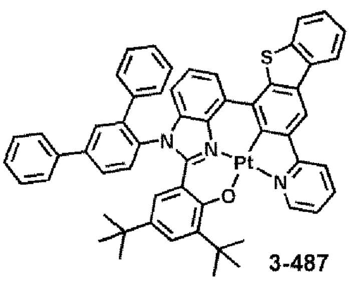
3-487

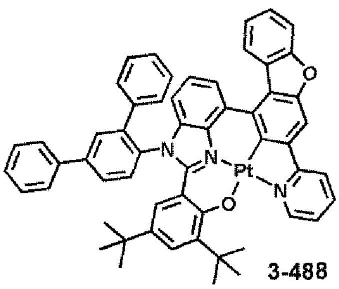
3-488

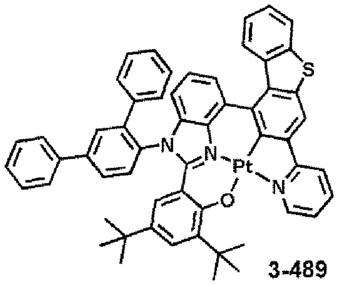 3-489
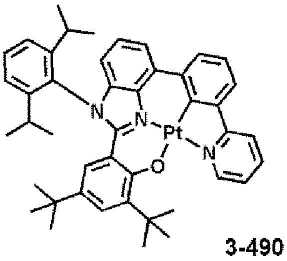 3-490
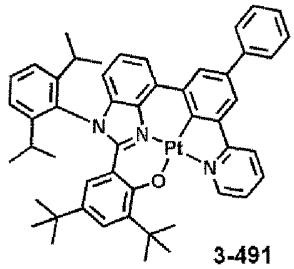 3-491

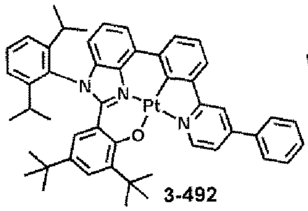 3-492
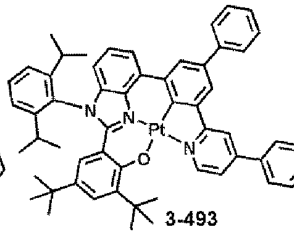 3-493
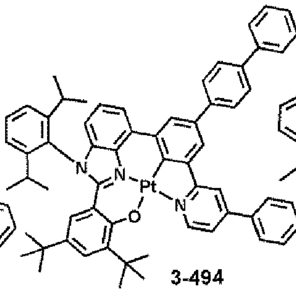 3-494
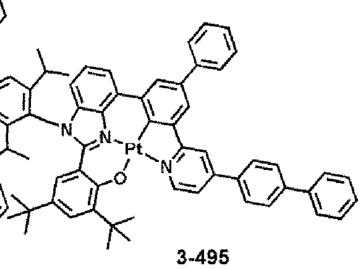 3-495

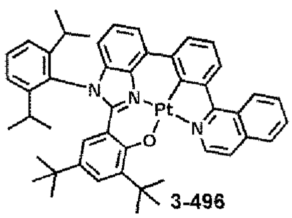 3-496
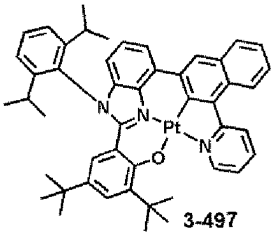 3-497
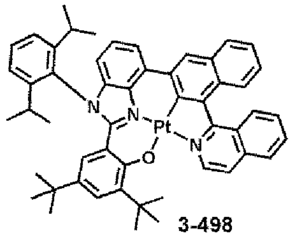 3-498
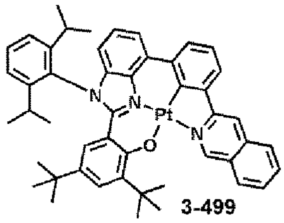 3-499

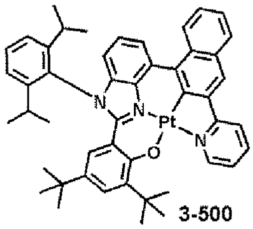 3-500
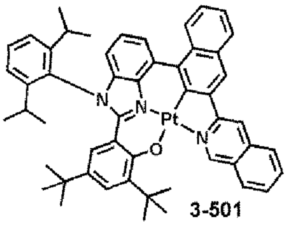 3-501
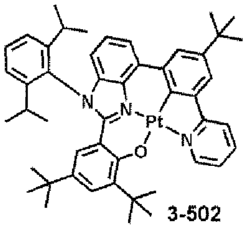 3-502
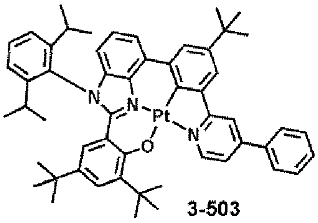 3-503

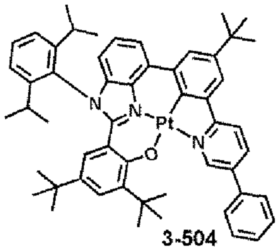 3-504
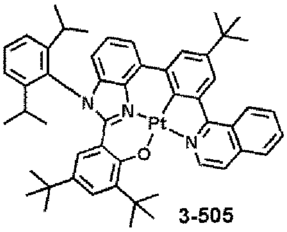 3-505
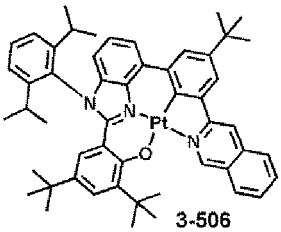 3-506
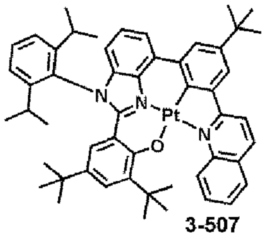 3-507

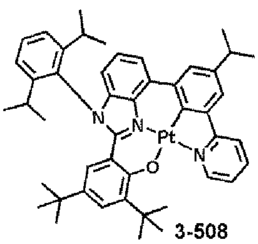 3-508
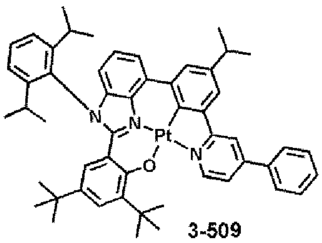 3-509
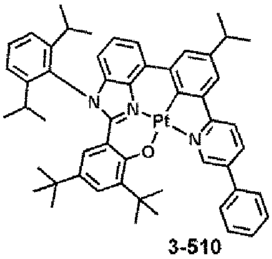 3-510
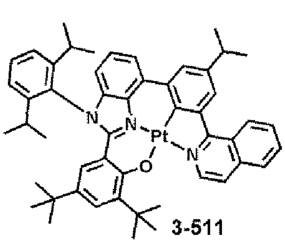 3-511

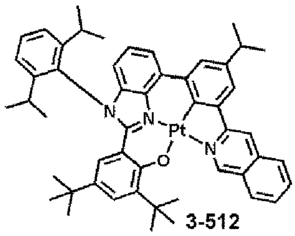
3-512

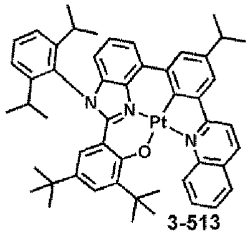
3-513

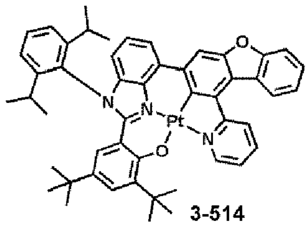
3-514

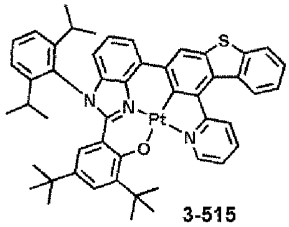
3-515

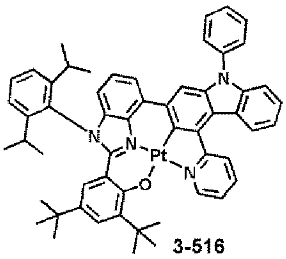
3-516

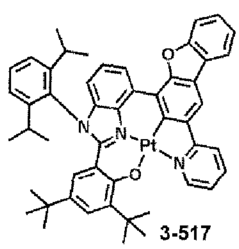
3-517

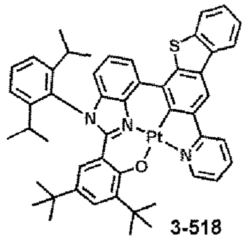
3-518

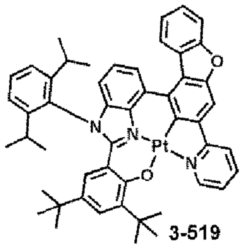
3-519

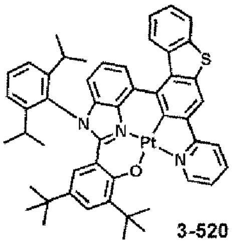
3-520

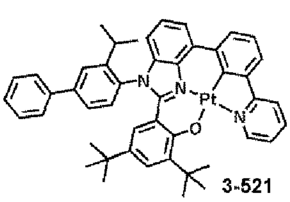
3-521

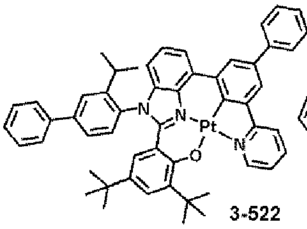
3-522

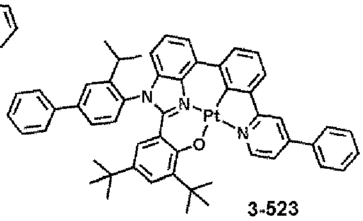
3-523

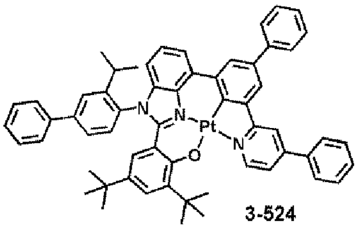
3-524

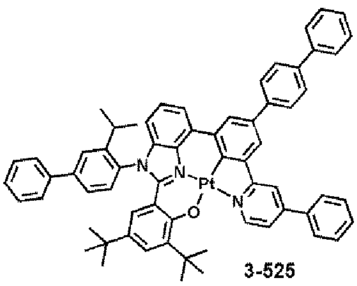
3-525

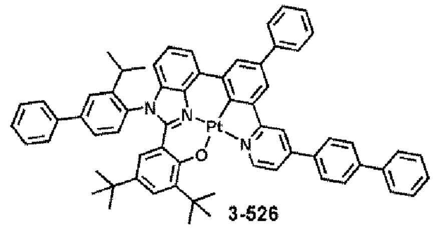
3-526

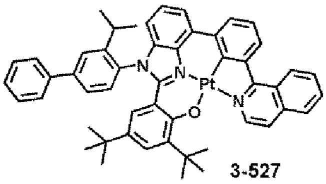
3-527

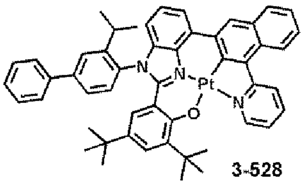
3-528

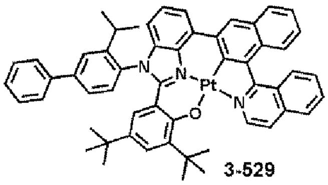
3-529

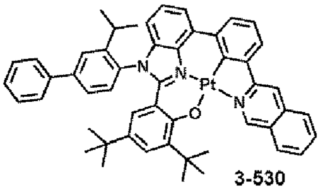
3-530

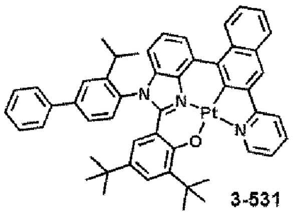
3-531

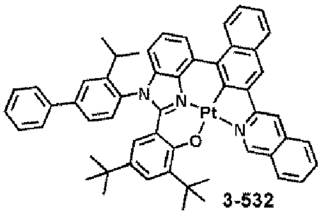
3-532

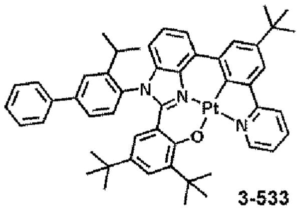
3-533

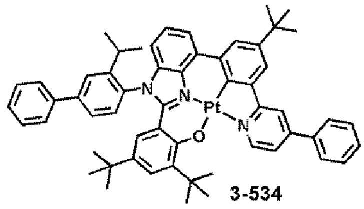
3-534

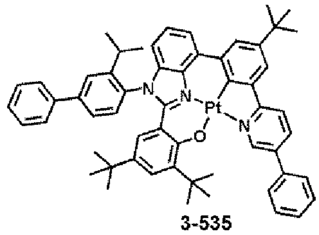
3-535

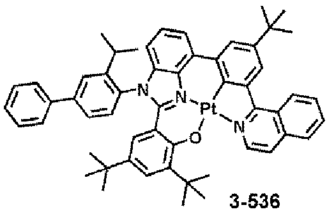
3-536

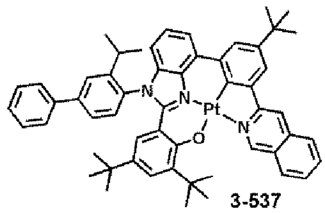
3-537

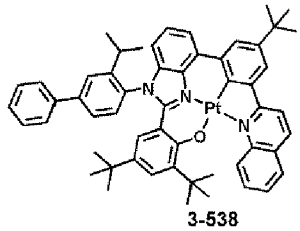
3-538

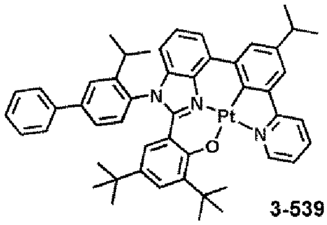
3-539

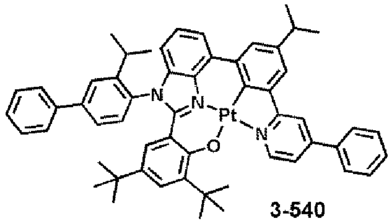
3-540

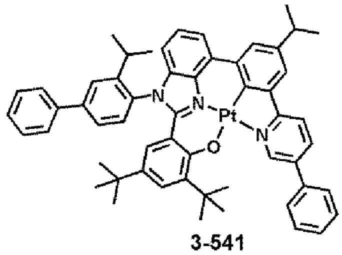
3-541

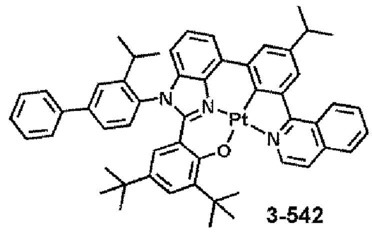
3-542

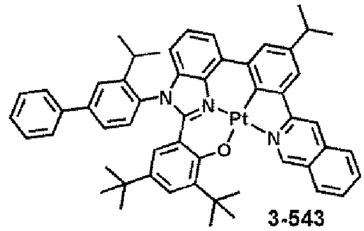
3-543

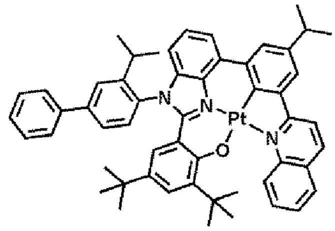
3-544

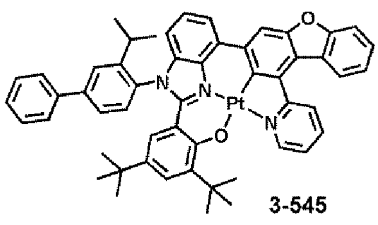
3-545

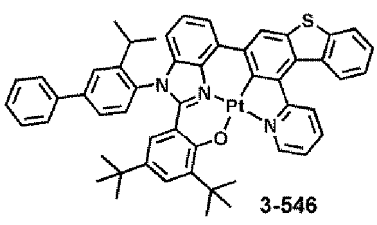
3-546

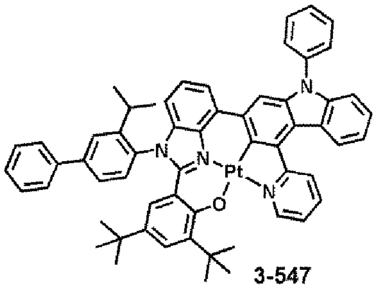
3-547

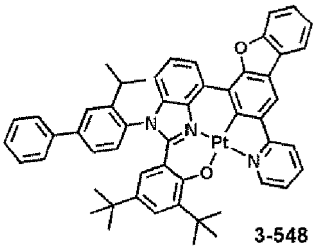
3-548

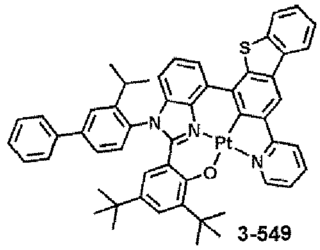
3-549

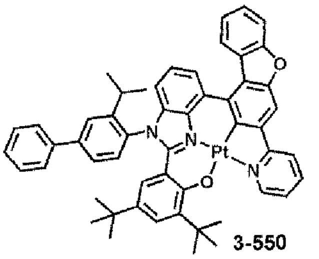
3-550

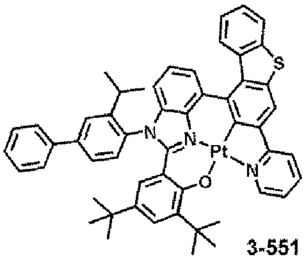
3-551

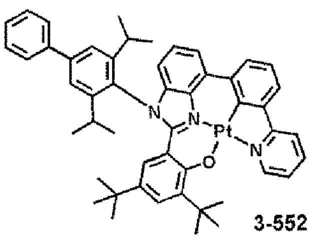
3-552

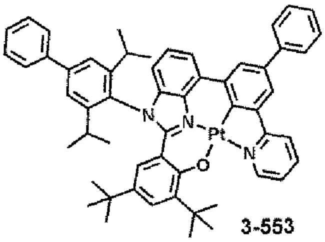
3-553

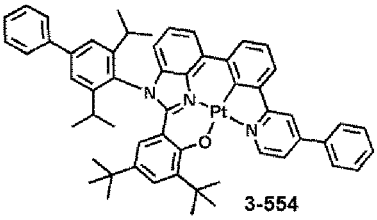
3-554

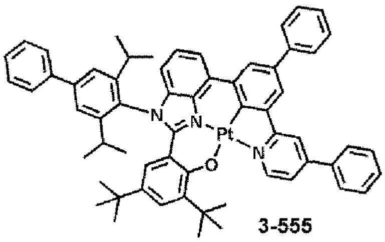
3-555

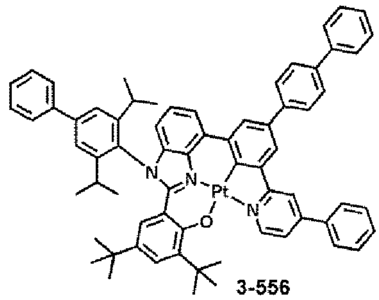
3-556

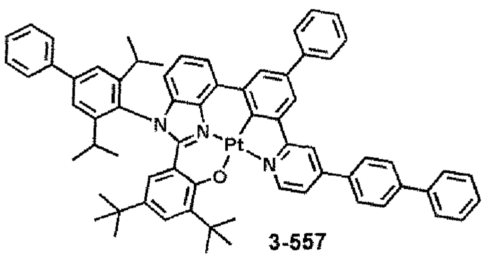
3-557

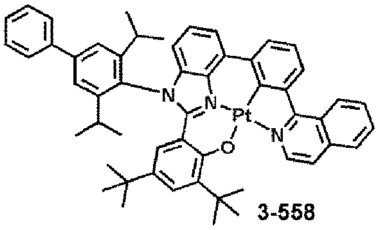
3-558

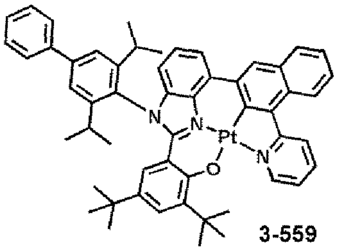
3-559

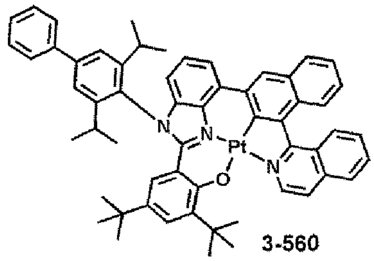
3-560

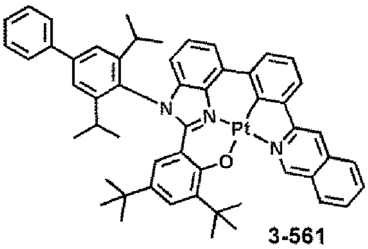
3-561

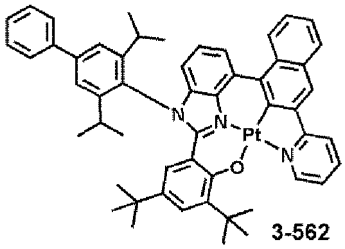
3-562

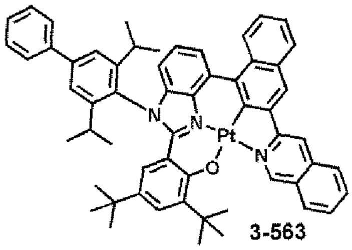
3-563

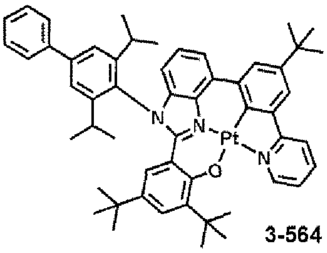
3-564

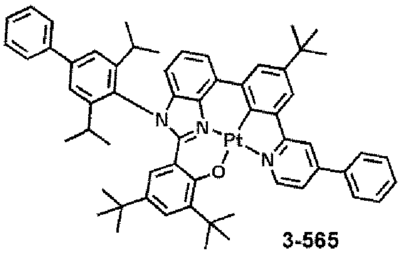
3-565

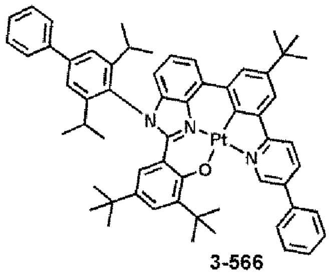
3-566

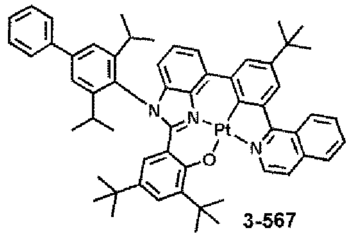
3-567

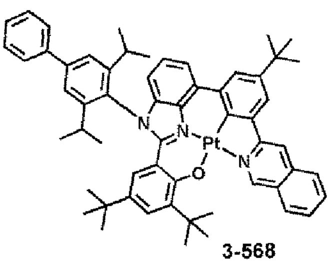
3-568

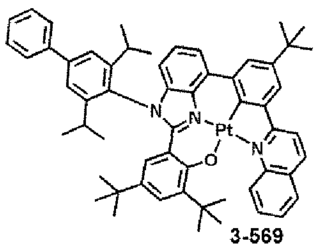
3-569

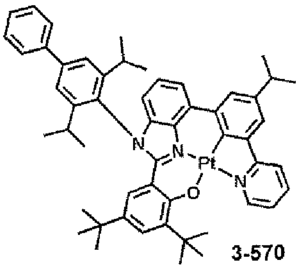
3-570

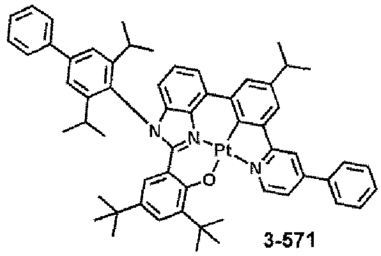
3-571

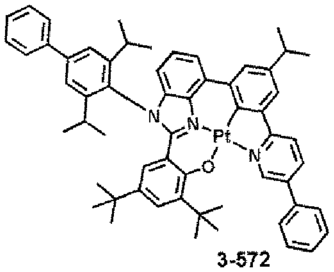
3-572

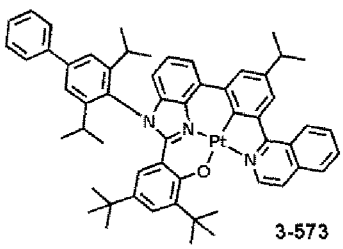
3-573

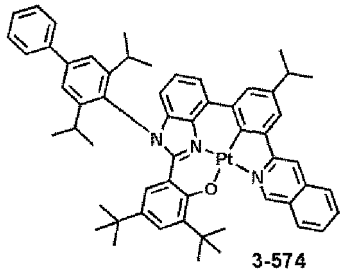
3-574

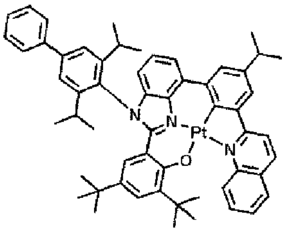
3-575

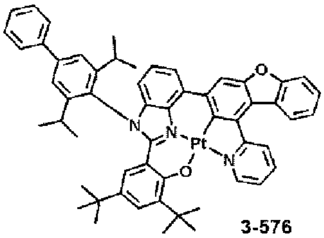
3-576

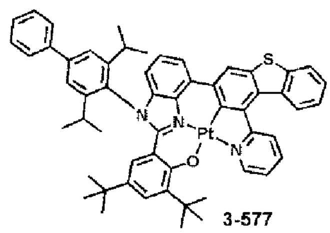
3-577

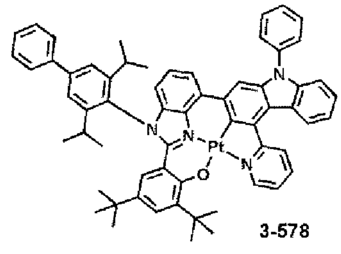
3-578

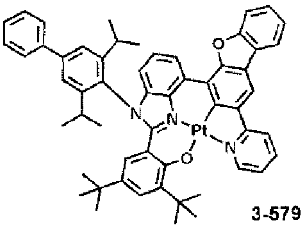
3-579

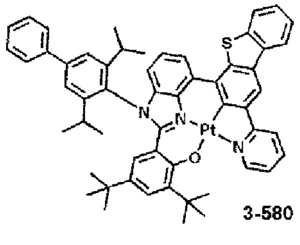
3-580

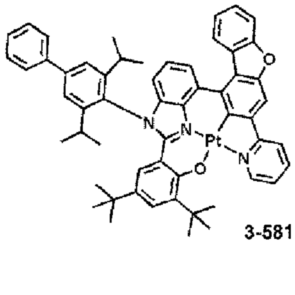
3-581

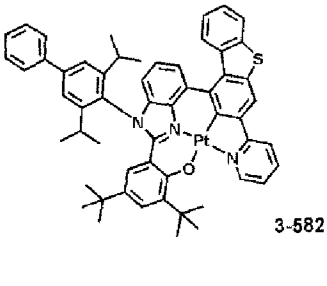
3-582

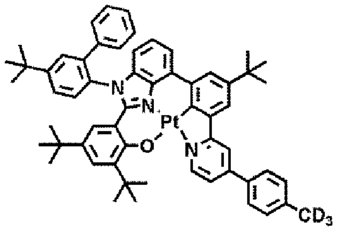

3-583

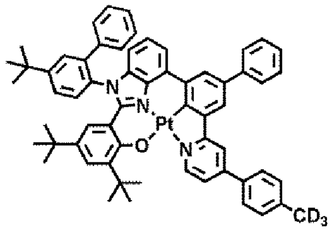

3-584

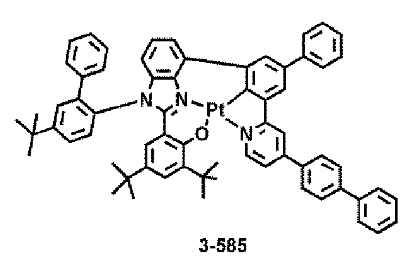

3-585

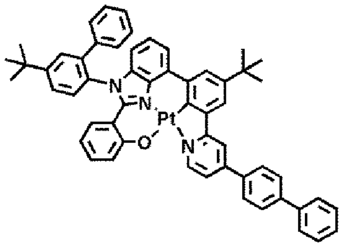

3-586

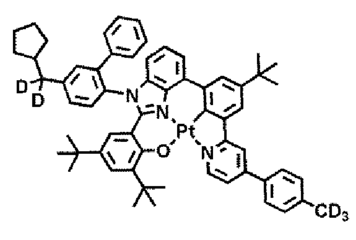

3-587

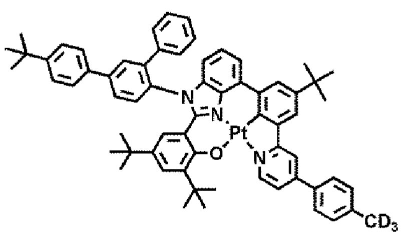

3-588

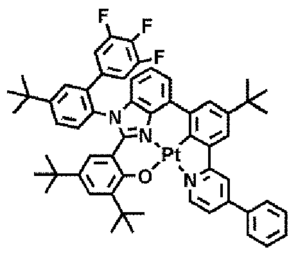

3-589

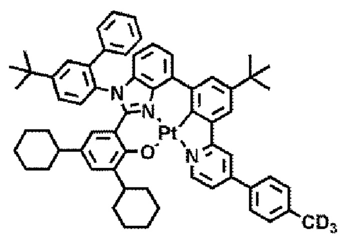

3-590

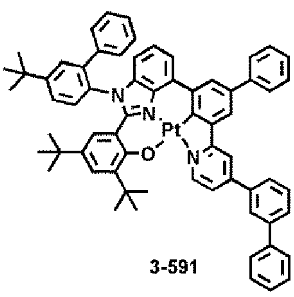

3-591

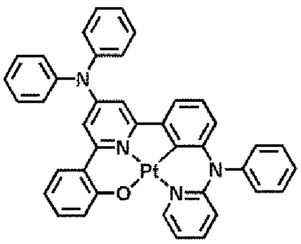

D1

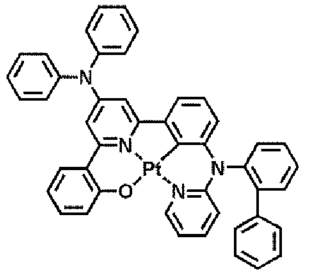

D2

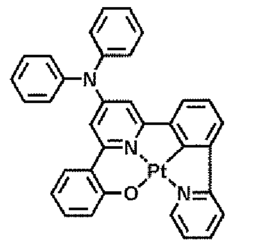

D3

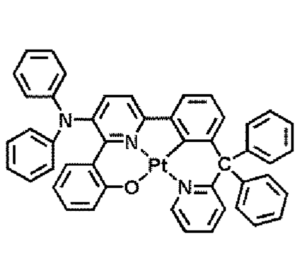

D4

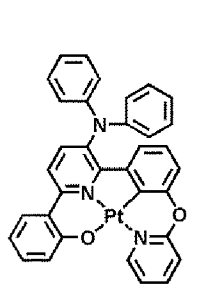

D5

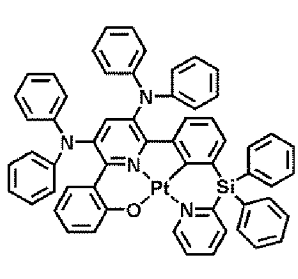

D6

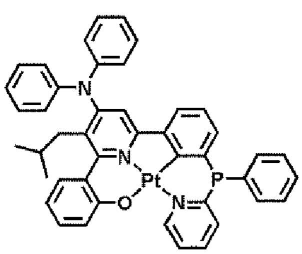

D7

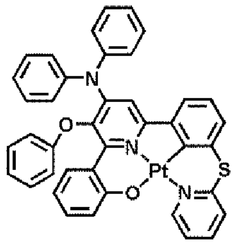

D8

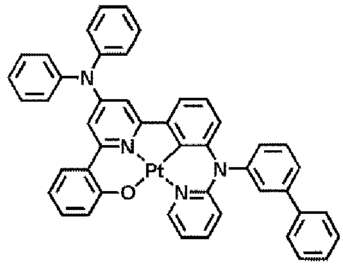

D9

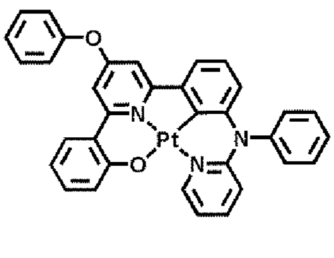

D10

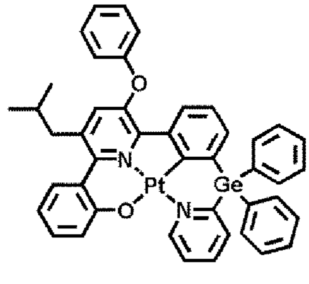

D11

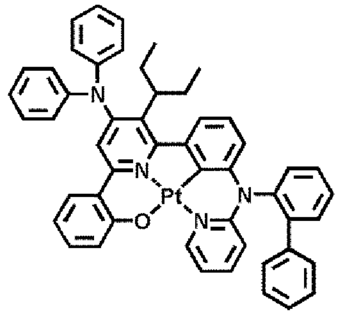

D12

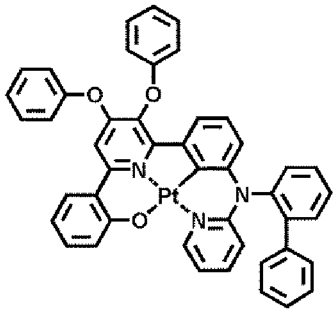

D13

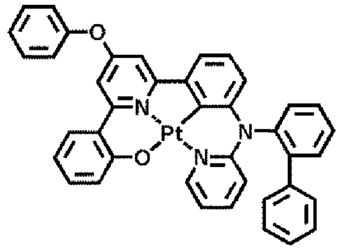

D14

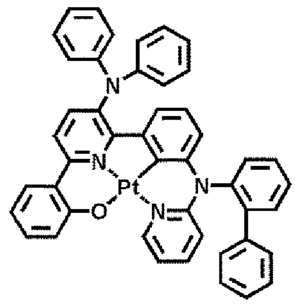

D15

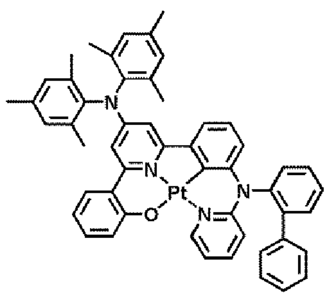

D16

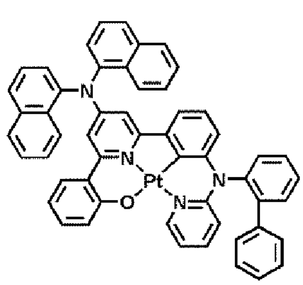

D17

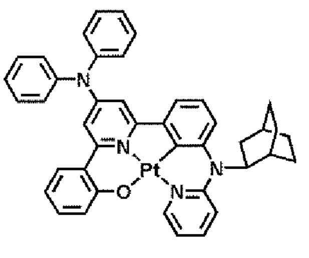

D18

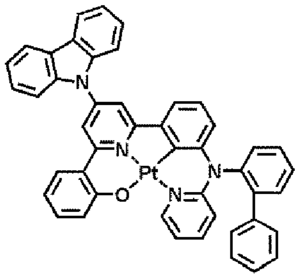
D19

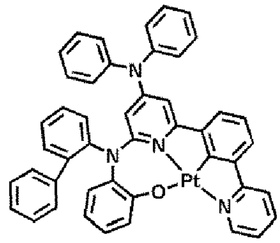
D20

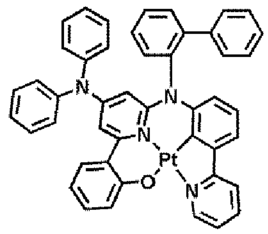
D21

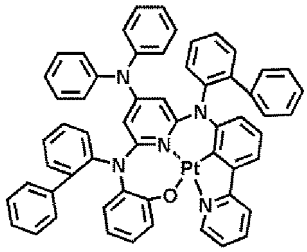
D22

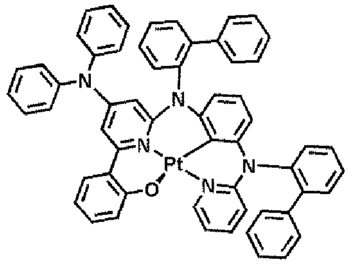
D23

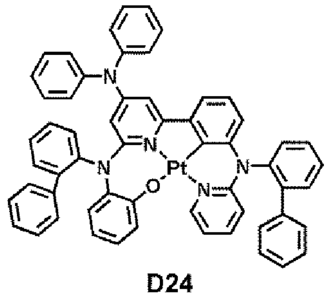
D24

The first compound may be one of Compounds H1-1 to H1-75, but embodiments of the present disclosure are not limited thereto:

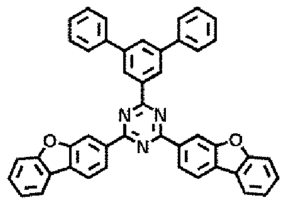
H1-1

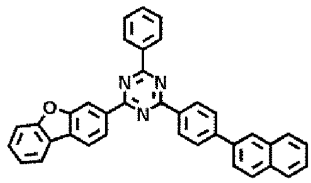
H1-2

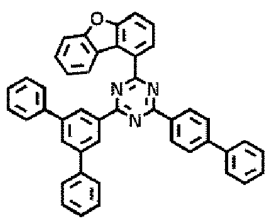
H1-3

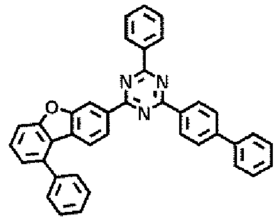
H1-4

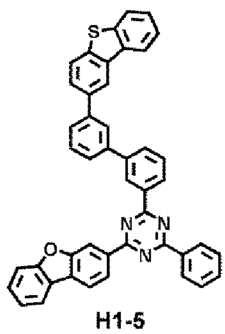
H1-5

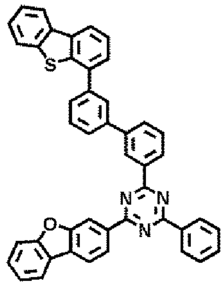
H1-6

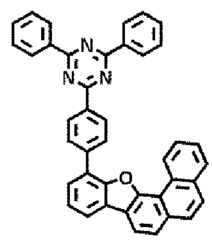
H1-7

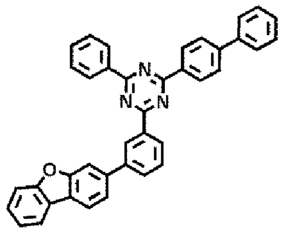
H1-8

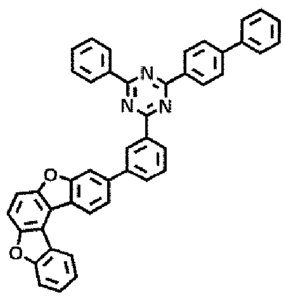
H1-9

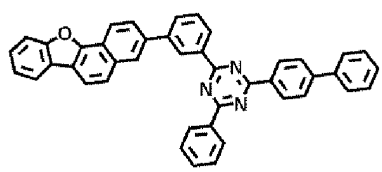
H1-10

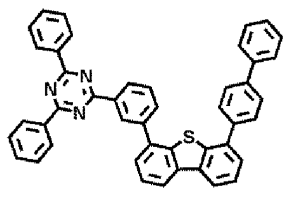
H1-11

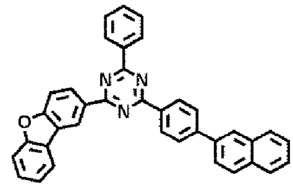

H1-12

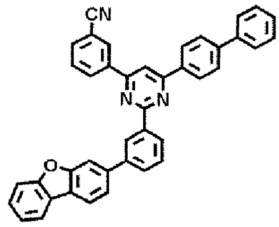

H1-13

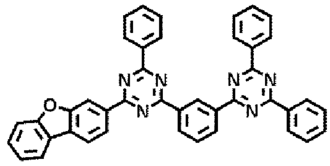

H1-14

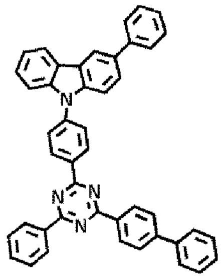

H1-15

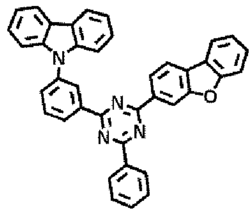

H1-16

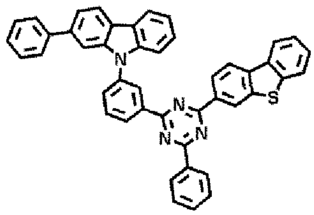

H1-17

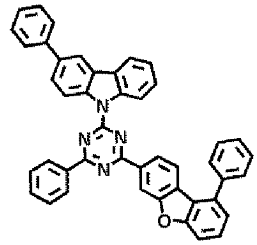

H1-18

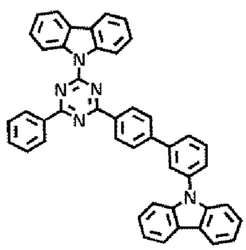

H1-19

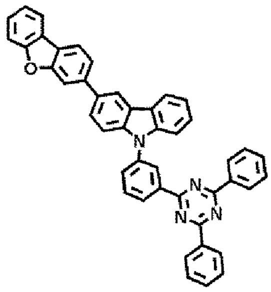

H1-20

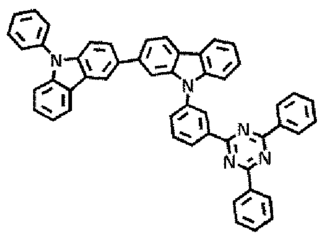

H1-21

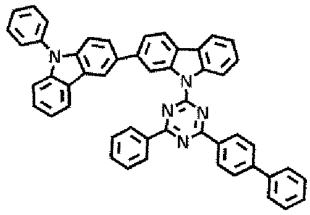

H1-22

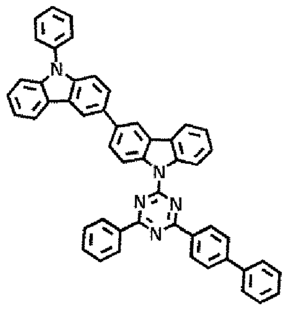

H1-23

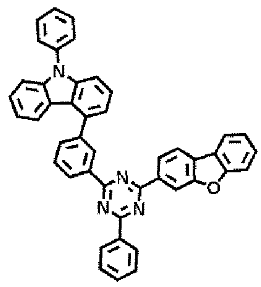

H1-24

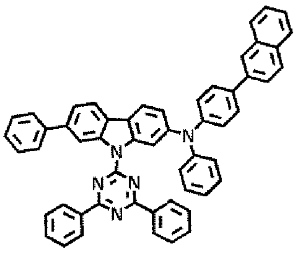

H1-25

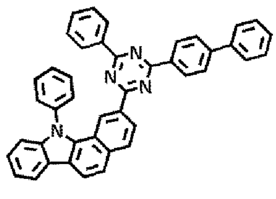

H1-26

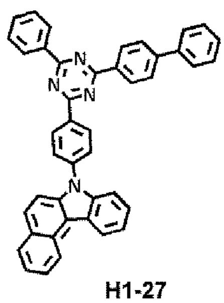

H1-27

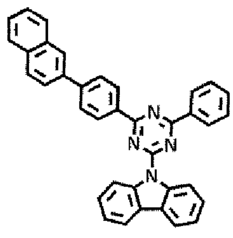

H1-28

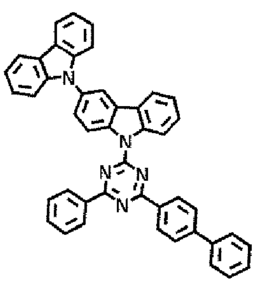

H1-29

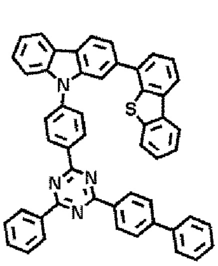

H1-30

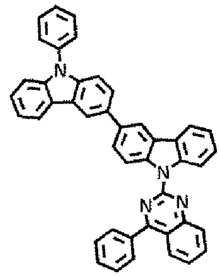

H1-31

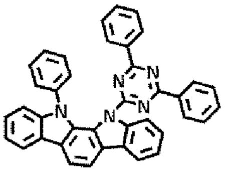

H1-32

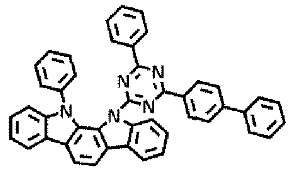

H1-33

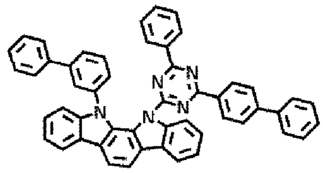

H1-34

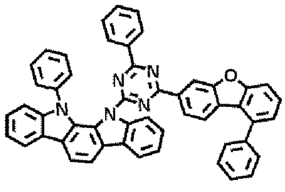

H1-35

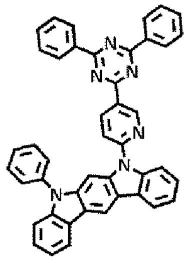

H1-36

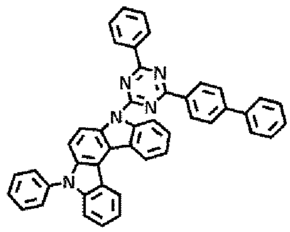

H1-37

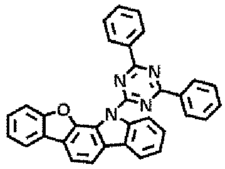

H1-38

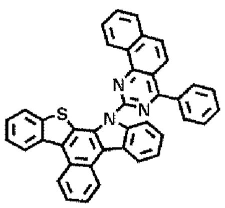

H1-39

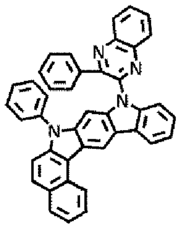

H1-40

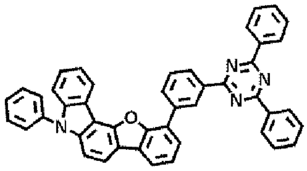

H1-41

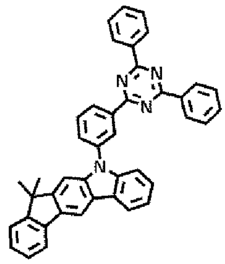

H1-42

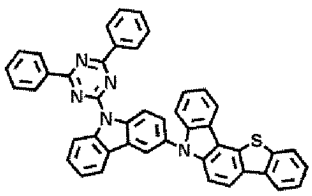

H1-43

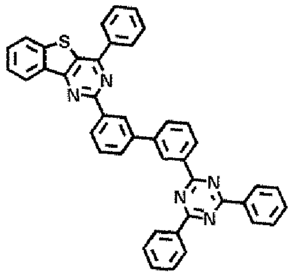

H1-44

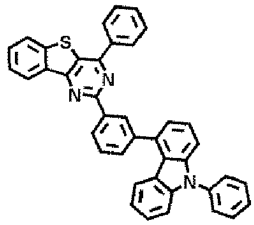

H1-45

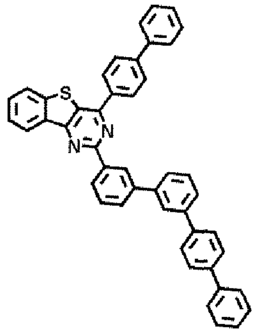

H1-46

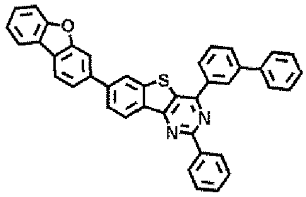

H1-47

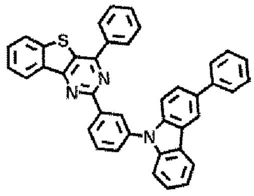

H1-48

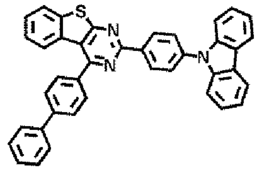

H1-49

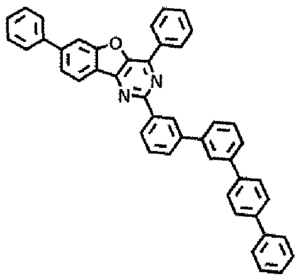

H1-50

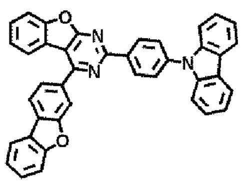
H1-51

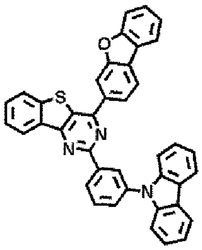
H1-52

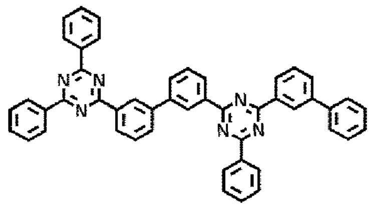
H1-53

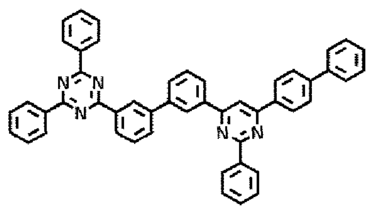
H1-54

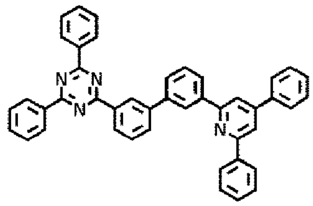
H1-55

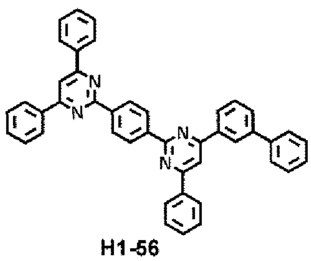
H1-56

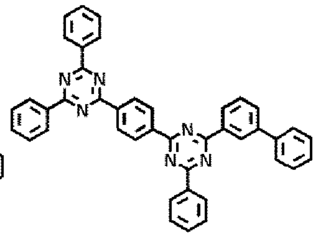
H1-57

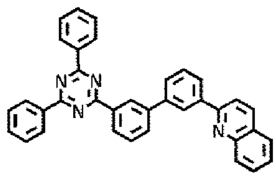
H1-58

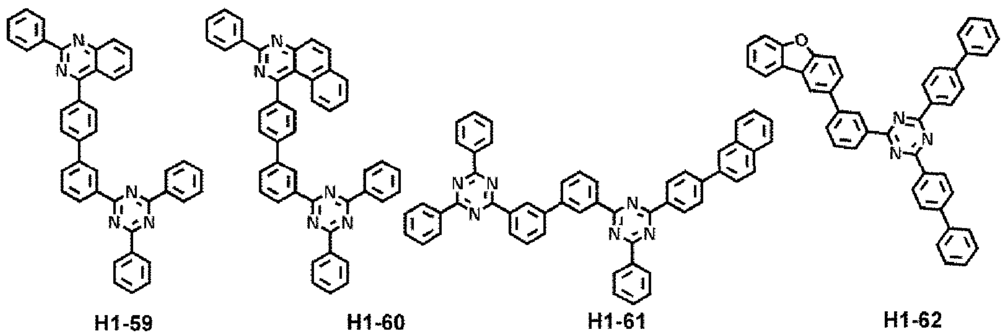
H1-59

H1-60

H1-61

H1-62

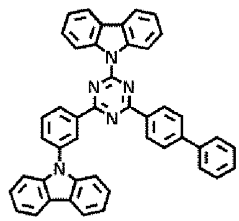
H1-63

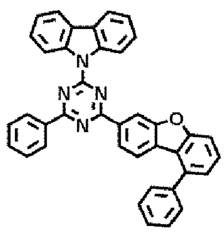
H1-64

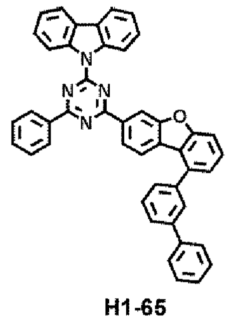
H1-65

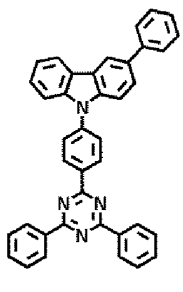
H1-66

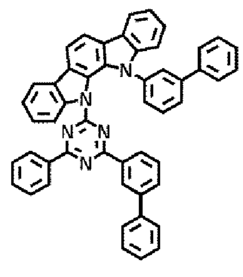
H1-67

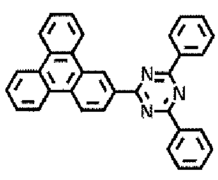
H1-68

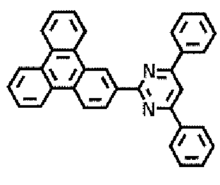
H1-69

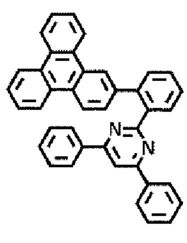
H1-70

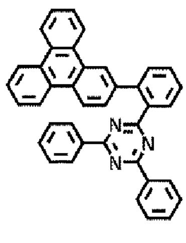
H1-71

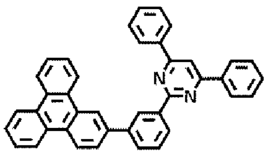
H1-72

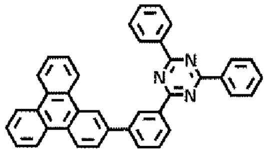
H1-73

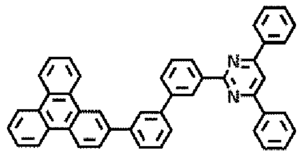
H1-74

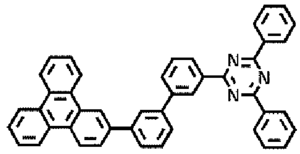
H1-75

The second compound and the third compound may each independently be one of Compounds H2-1 to H2-73, but embodiments of the present disclosure are not limited thereto:

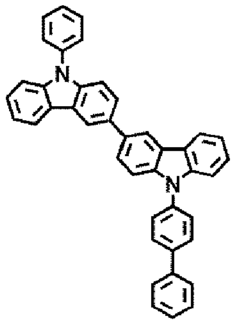
H2-1

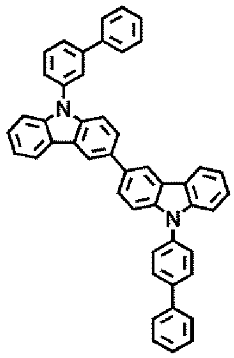
H2-2

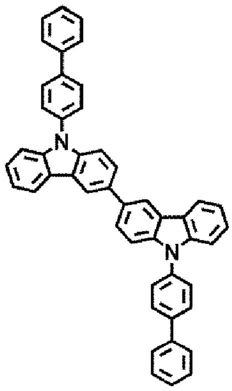
H2-1

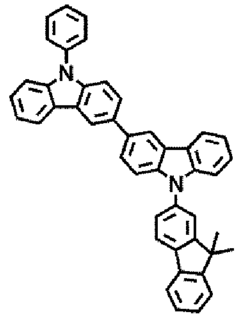
H2-4

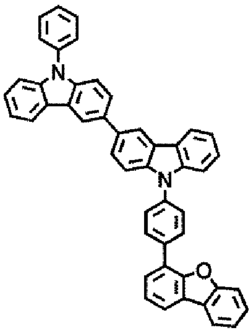
H2-5

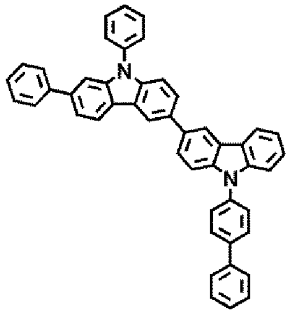
H2-6

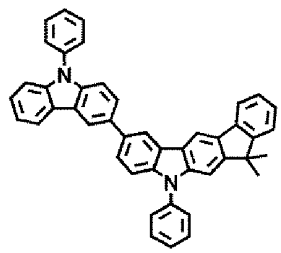
H2-7

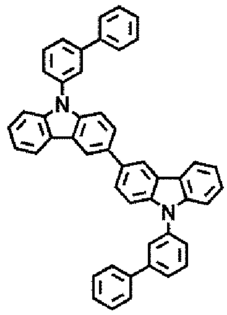
H2-8

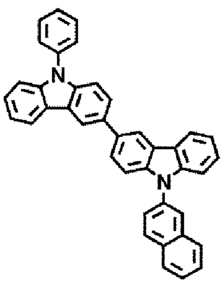
H2-9

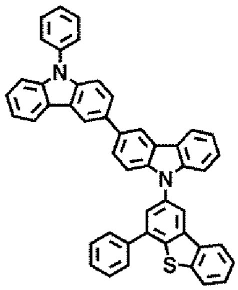
H2-10

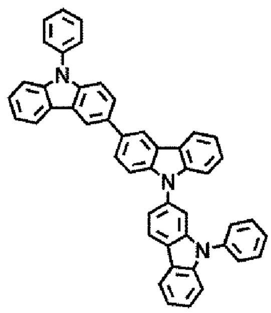
H2-11

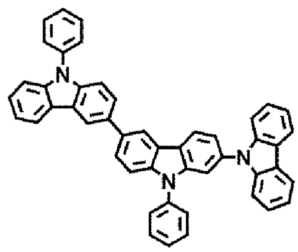
H2-12

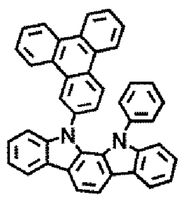
H2-13

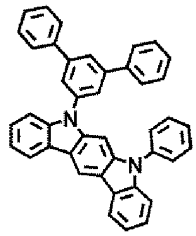
H2-14

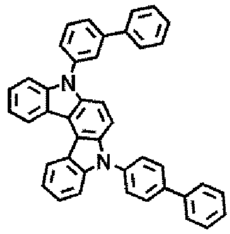
H2-15

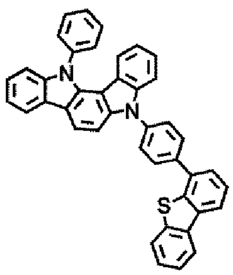
H2-16

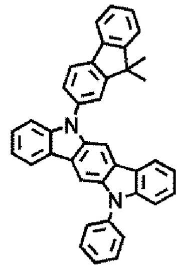
H2-17

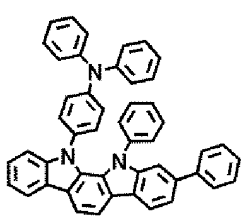
H2-18

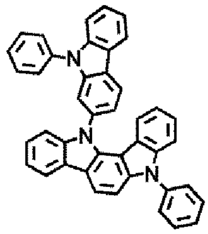
H2-19

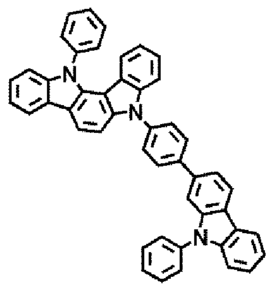
H2-20

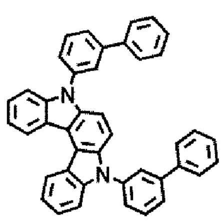
H2-21

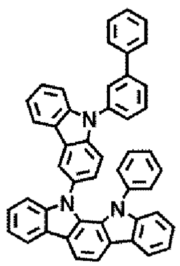
H2-22

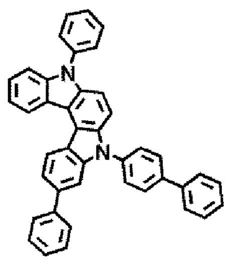
H2-23

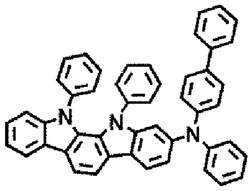
H2-24

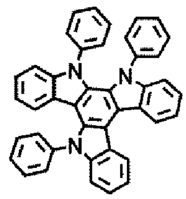
H2-25

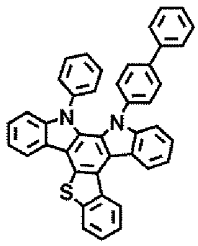
H2-26

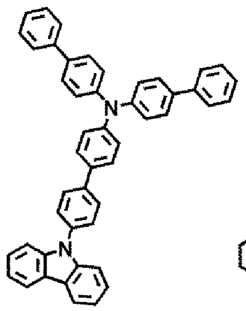
H2-27

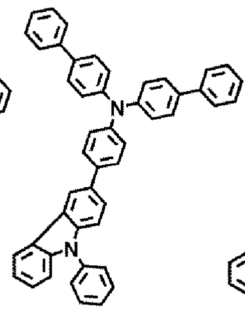
H2-28

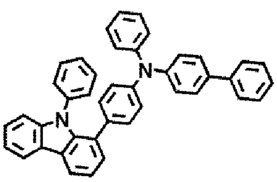
H2-29

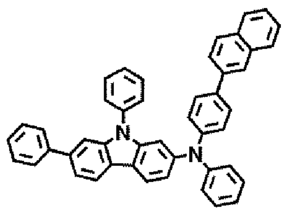
H2-30

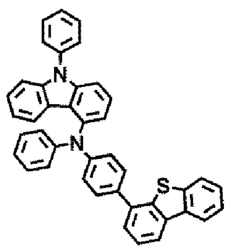
H2-31

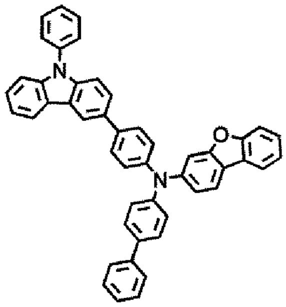
H2-32

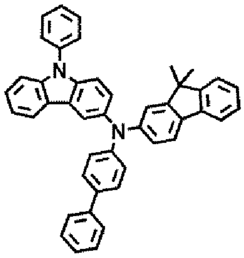
H2-33

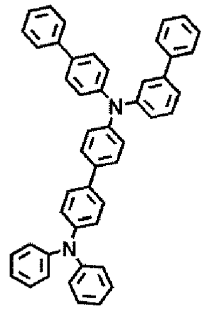
H2-34

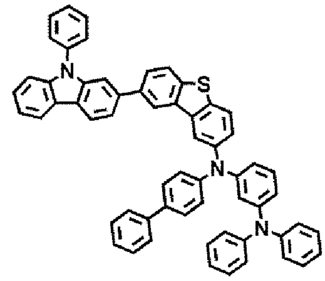
H2-35

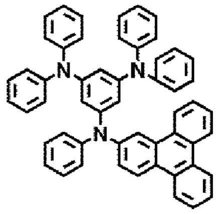
H2-36

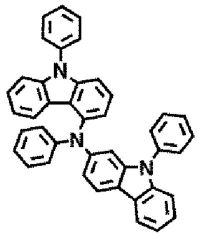
H2-37

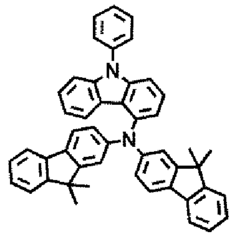
H2-38

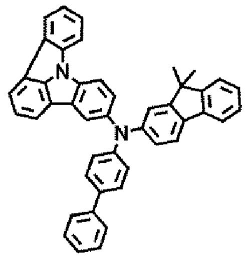
H2-39

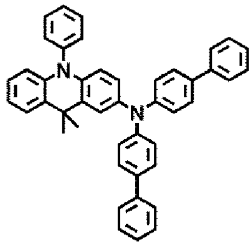
H2-40

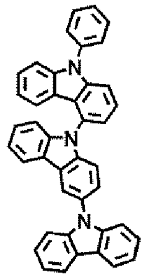
H2-41

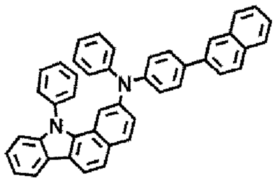
H2-42

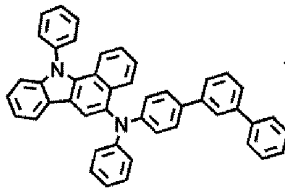
H2-43

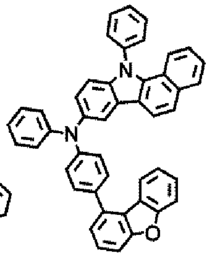
H2-44

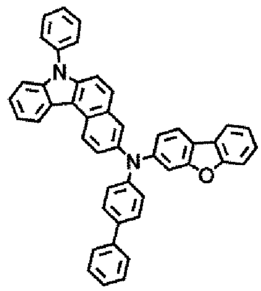
H2-45

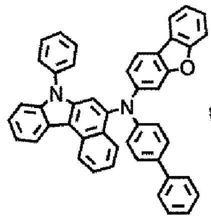
H2-46

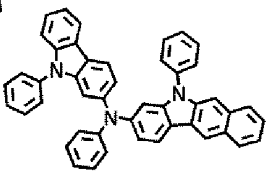
H2-47

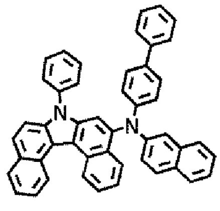
H2-48

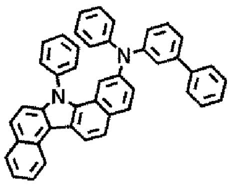
H2-49

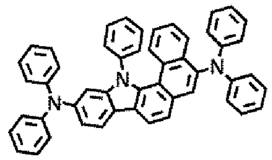
H2-50

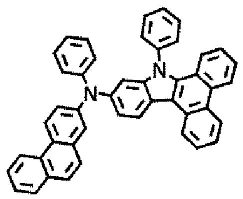
H2-51

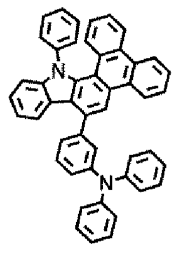
H2-52

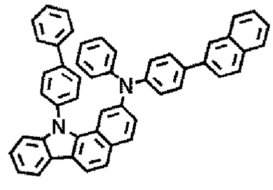
H2-53

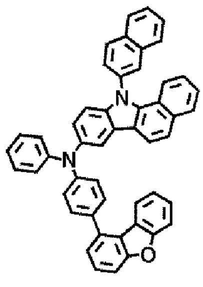
H2-54

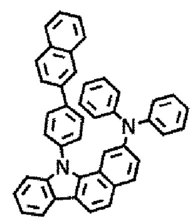
H2-55

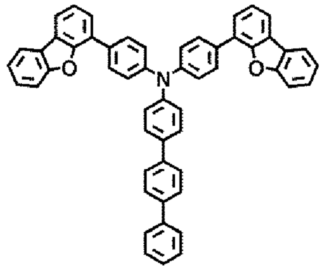 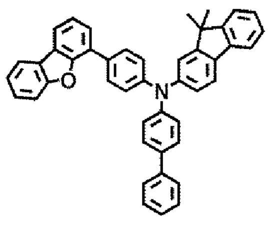 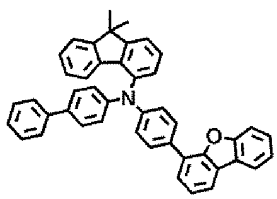 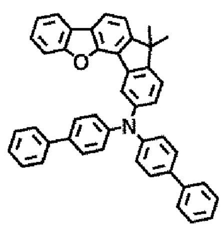

H2-56 H2-57 H2-58 H2-59

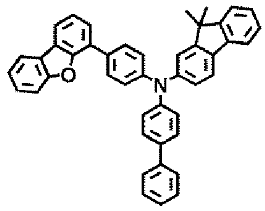 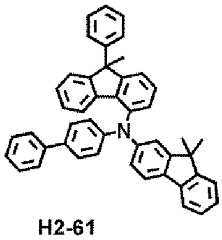 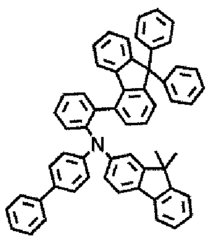 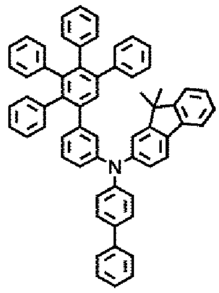 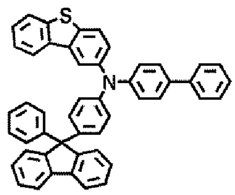

H2-60 H2-61 H2-62 H2-63 H2-64

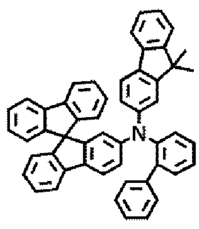 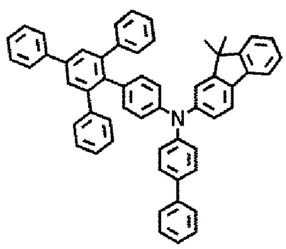 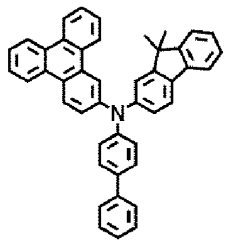 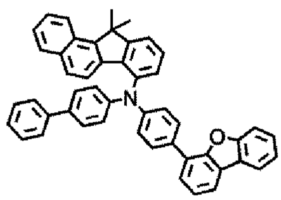

H2-65 H2-66 H2-67 H2-68

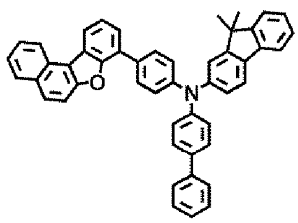 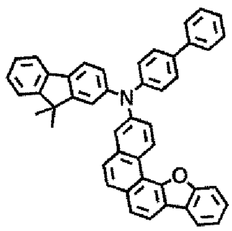 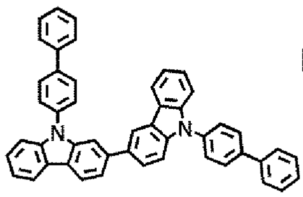 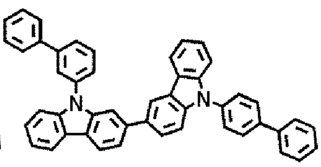

H2-69 H2-70 H2-71 H2-72

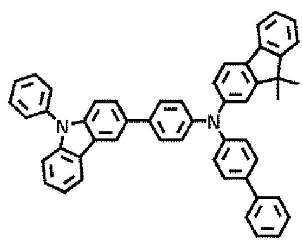

H2-73 .

In one or more embodiments, the composition may satisfy Equation 1 and Equation 2:

Equation 1

$$HOMO\ (H2) > HOMO\ (D)$$

Equation 2

$$HOMO\ (H3) > HOMO\ (D).$$

In Equations 1 and 2,

HOMO (H2) is an absolute value of the HOMO energy level of the second compound,
HOMO (H3) is an absolute value of the HOMO energy level of the third compound, and
HOMO (D) is an absolute value of the HOMO energy level of the Pt-containing organometallic compound.

In one or more embodiments, the difference between the absolute value of the HOMO energy level of the second compound and the absolute value of the HOMO energy level of the Pt-containing organometallic compound may be 0.05 eV to 0.6 eV, for example, 0.05 eV to 0.3 eV, and the difference between the absolute value of the HOMO energy level of the third compound and the absolute value of the HOMO energy level of the Pt-containing organometallic compound may be 0.05 eV to 0.6 eV, for example, 0.05 eV to 0.3 eV.

A weight ratio of the second compound to the third compound may be 9: 1 to 1 : 9, for example, 2 : 7 to 7 : 2, but embodiments of the present disclosure are not limited thereto.

The composition including the Pt-containing organometallic compound, the first compound, the second compound, and the third compound may be suitably used for an organic layer, for example, an emission layer, in the organic light-emitting device. Another aspect of the present disclosure provides an organic light-emitting device including: a first electrode; a second electrode; and an organic layer disposed between the first electrode and the second electrode and including an emission layer, wherein the organic layer includes the composition.

The organic light-emitting device includes the composition including the Pt-containing organometallic compound, the first compound, the second compound, and the third compound so that the organic light-emitting device may have improved external quantum luminescence efficiency, improved driving voltage, and improved lifespan characteristics.

The composition may be used between a pair of electrodes of the organic light-emitting device. For example, the emission layer may include the composition. Here, the Pt-containing organometallic compound may serve as a dopant, and the first compound, the second compound, and the third compound may each serve as a host.

The organic light-emitting device including the composition may emit red light, green light, or blue light. For example, the organic light-emitting device including the composition may emit green light, but embodiments of the present disclosure are not limited thereto.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region includes a hole injection layer, a hole transport layer, an electron blocking layer, or any combination thereof, and the electron transport region includes a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including a metal.

The FIGURE is a schematic cross-sectional view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability,

transparency, surface smoothness, ease of handling, and water resistance.

The first electrode 11 may be formed by, for example, depositing or sputtering a material for forming the first electrode 11 on the substrate. The first electrode 11 may be an anode. The material for forming the first electrode 11 may comprise a material with a high work function to facilitate hole injection. The first electrode 11 may be a reflective electrode, a semi-reflective electrode, or a transmissive electrode. The material for forming the first electrode 11 may be, for example, indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only a hole injection layer or only a hole transport layer. In one or more embodiments, the hole transport region may have a hole injection layer/hole transport layer structure or a hole injection layer/hole transport layer/electron blocking layer structure, which are sequentially stacked in this stated order from the first electrode 11. For example, the hole transport layer comprises at least two layer.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When the hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or any combination thereof:

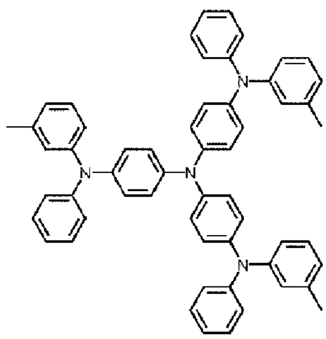

m-MTDATA

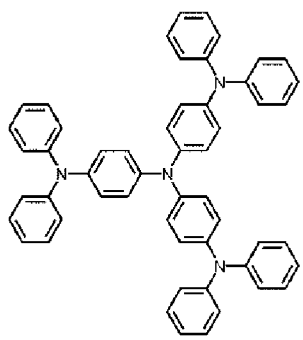

TDATA

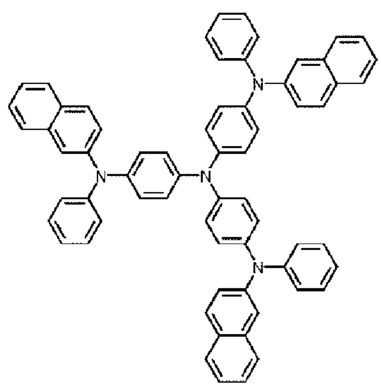

2-TNATA

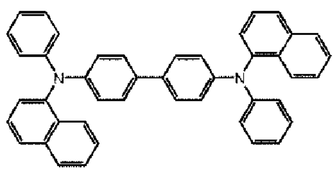
NPB

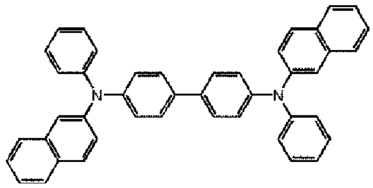
β-NPB

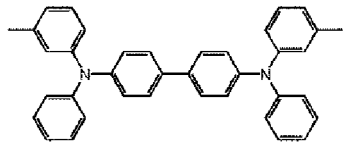
TPD

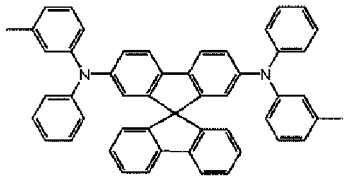
Spiro-TPD

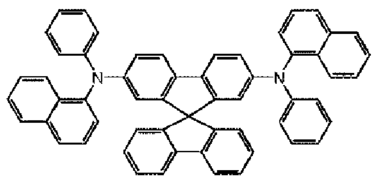
Spiro-NPB

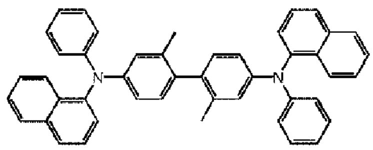
methylated NPB

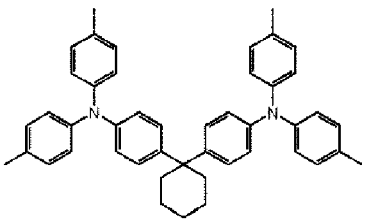
TAPC

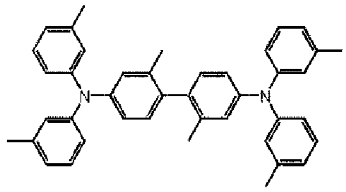
HMTPD

Formula 201

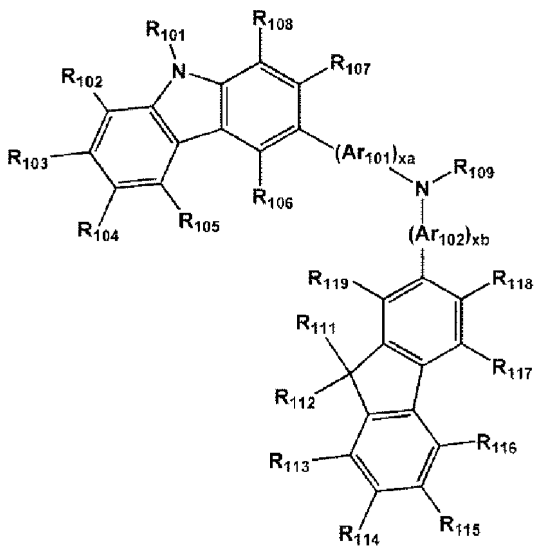

Formula 202

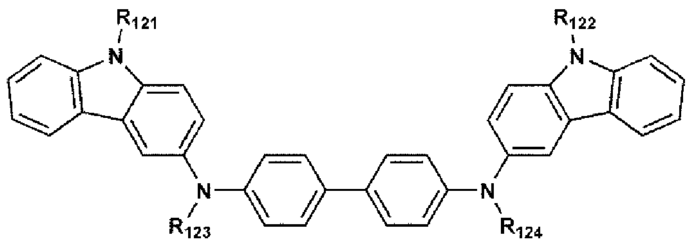
.

In Formula 201, $Ar_{101}$ and $Ar_{102}$ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_2$-$C_{10}$ heterocycloalkyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5, or may be 0, 1, or 2. For example, xa may be 1 and xb may be 0, but xa and xb are not limited thereto.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and the like), or a $C_1$-$C_{10}$ alkoxy group (for example, a methoxy group, an ethoxy group, a propoxy group, a butoxy group, a pentoxy group, and the like);

a $C_1$-$C_{10}$ alkyl group or a $C_1$-$C_{10}$ alkoxy group, each substituted with deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group, or a salt thereof, or any combination thereof; or

a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or any combination thereof,

but embodiments of the present disclosure are not limited thereto.

In Formula 201, $R_{109}$ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or any combination thereof.

In one or more embodiments, the compound represented by Formula 201 may be represented by Formula 201A, but embodiments of the present disclosure are not limited thereto:

Formula 201A

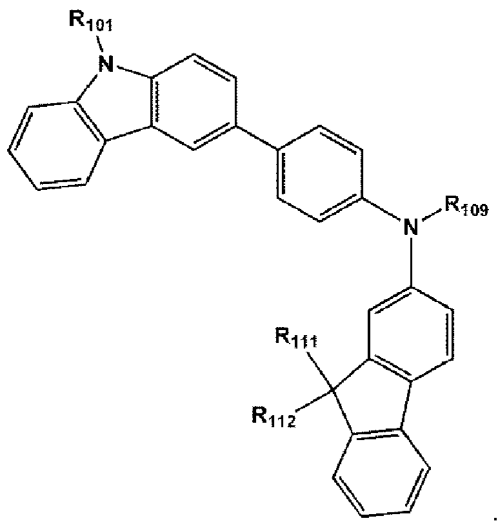

In Formula 201A, $R_{101}$, $R_{111}$, $R_{112}$, and $R_{109}$ may each be the same as described above.

For example, the compound represented by Formula 201 and the compound represented by Formula 202 may each be one of Compounds HT1 to HT20 or any combination thereof, but embodiments of the present disclosure are not limited thereto:

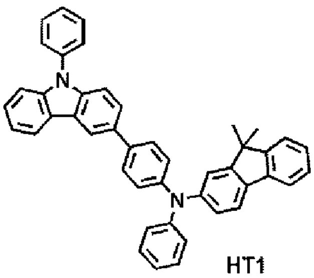
HT1

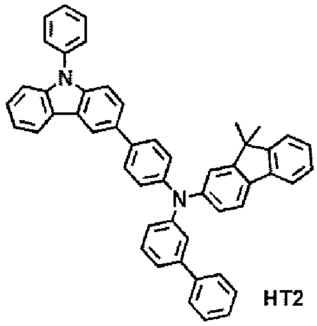
HT2

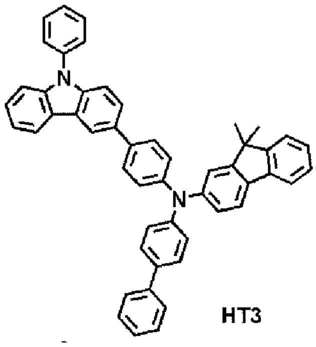
HT3

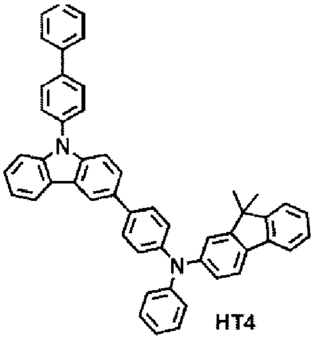
HT4

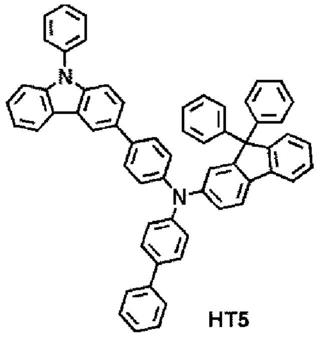
HT5

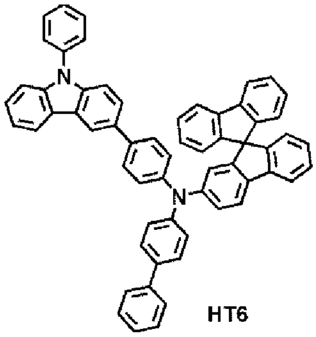
HT6

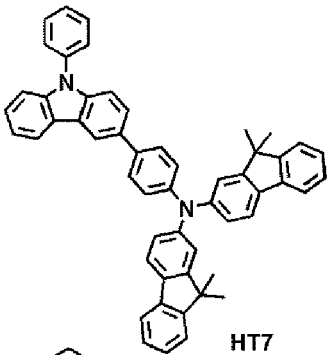
HT7

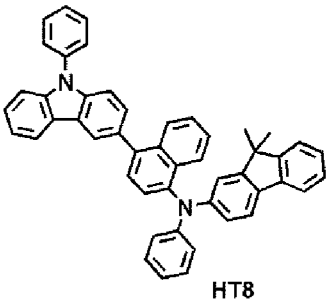
HT8

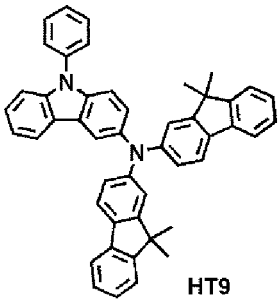
HT9

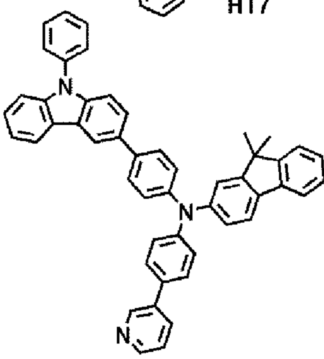
HT10

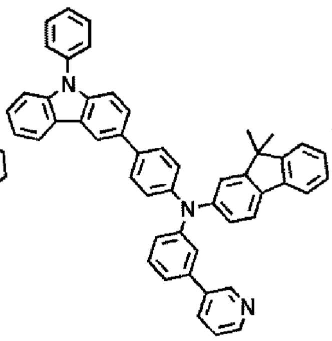
HT11

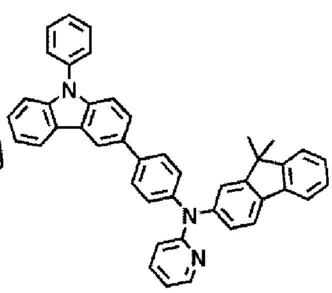
HT12

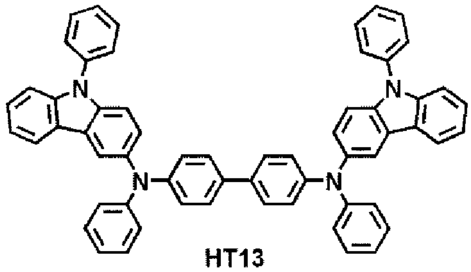
HT13

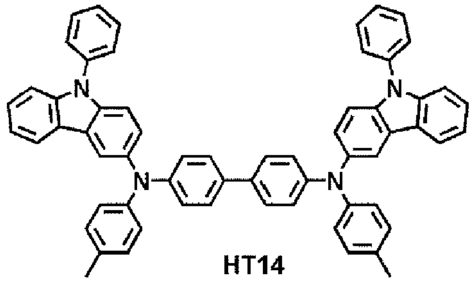
HT14

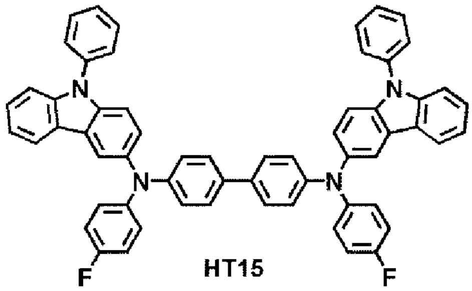
HT15

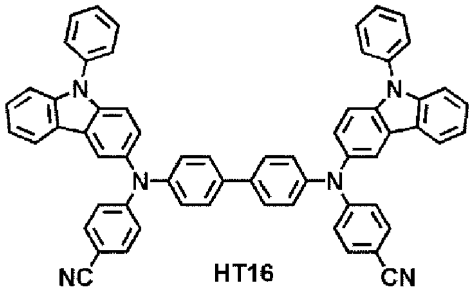
HT16

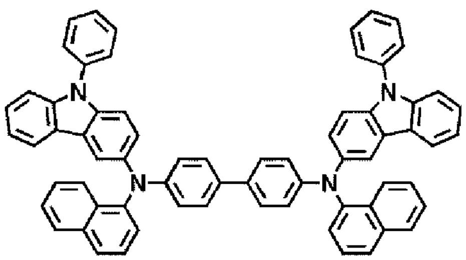
HT17

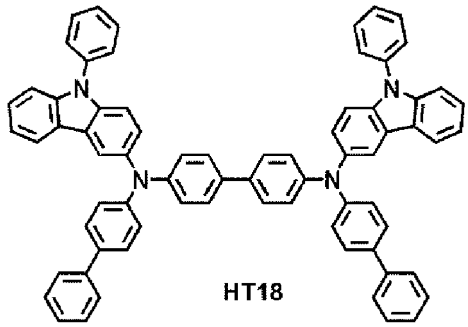
HT18

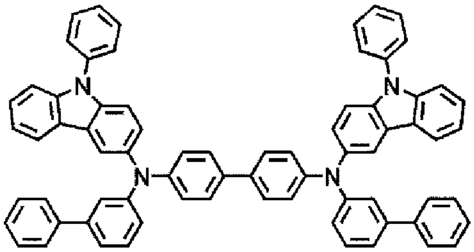
HT19

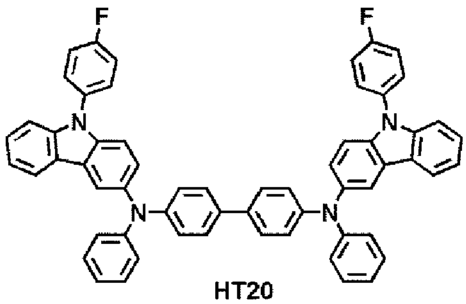
HT20

A thickness of the hole transport region may be from about 100 Å to about 10,000 Å, for example, about 100 Å to about 3,000 Å. When the hole transport region includes a hole injection layer, a hole transport layer, or any combination thereof, a thickness of the hole injection layer may be in a range of about 100 Å to about 10000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may comprise a quinone derivative, a metal oxide, a cyano group-containing compound, or any combination thereof, but embodiments of the present disclosure are not limited thereto. Nonlimiting examples of the p-dopant are a quinone derivative, such as tetracyanoquinodimethane (TCNQ), 2,3,5,6-tetrafluoro-tetracyano-1,4-benzoquinonedimethane (F4-TCNQ) or F6-TCNNQ; a metal oxide, such as a tungsten oxide or a molybdenum oxide; and a cyano group-containing compound, such as Compound HT-D1 below, but are not limited thereto:

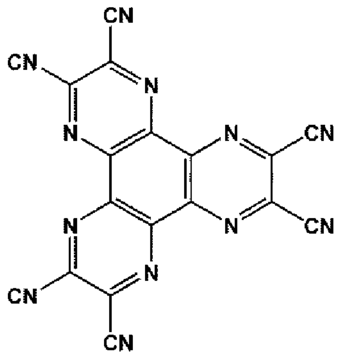

HT-D1

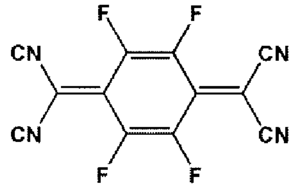

F4-TCNQ

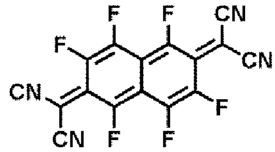

F6-TCNNQ .

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for the electron blocking layer may comprise a material for the hole transport region described above, a material for a host to be explained later, or any combination thereof. However, the material for the electron blocking layer is not limited thereto. For example, when the hole transport region includes an electron blocking layer, a material for the electron blocking layer may be mCP, which will be explained later.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

The emission layer may include the composition including the Pt-containing organometallic compound, the first compound, the second compound, and the third compound.

For example, the emission layer may include a dopant and a host, wherein the dopant includes the Pt-containing organometallic compound, and the host includes the first compound, the second compound, and the third compound.

Meanwhile, the emission layer may further include, in addition to the composition, another dopant and/or another host.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 20 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

An electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAlq, or any combination thereof, but embodiments of the present disclosure are not limited thereto:

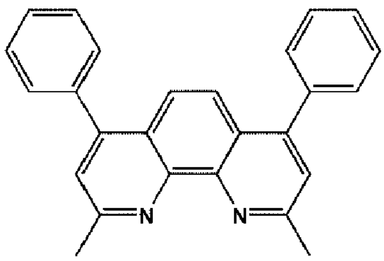
BCP

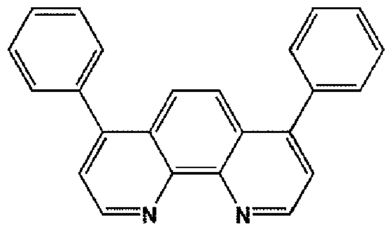
Bphen

.

A thickness of the hole blocking layer may be from about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may include BCP, Bphen, $Alq_3$, BAlq, TAZ, NTAZ, or any combination thereof:

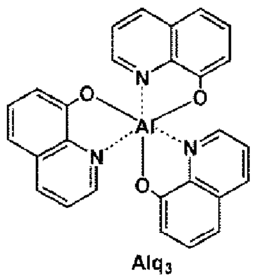
$Alq_3$

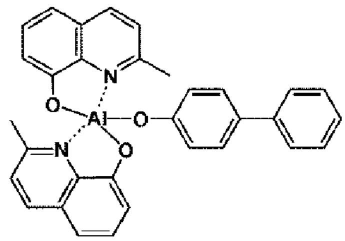
BAlq

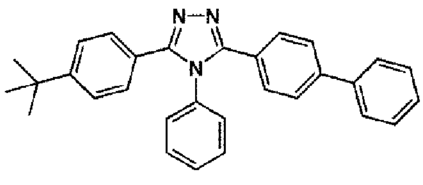
TAZ

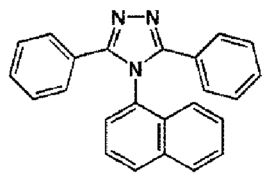
NTAZ

.

In one or more embodiments, the electron transport layer may include one of ET1 and ET25, or any combination thereof, but are not limited thereto:

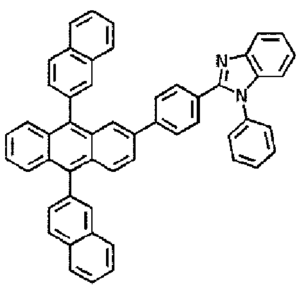
ET1

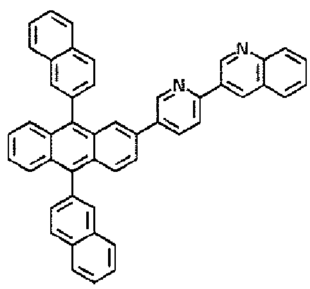
ET2

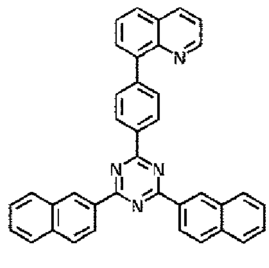
ET3

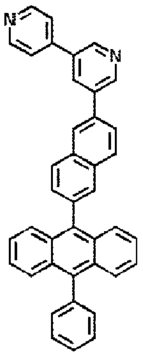

ET4

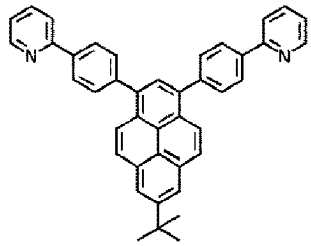

ET5

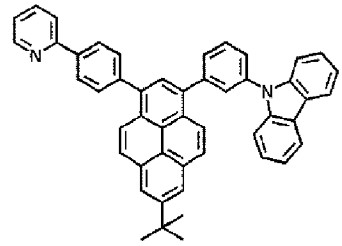

ET6

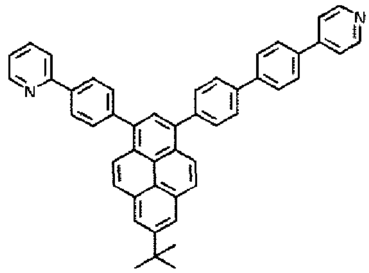

ET7

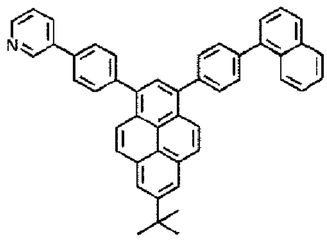

ET8

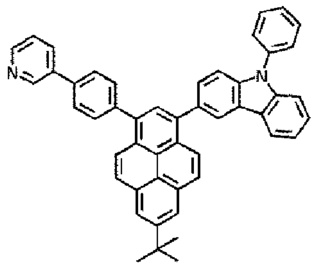

ET9

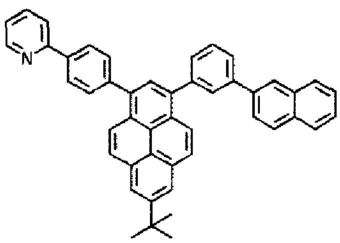

ET10

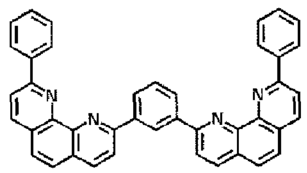

ET11

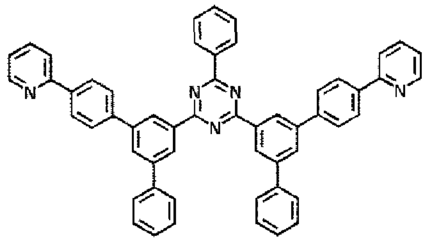

ET12

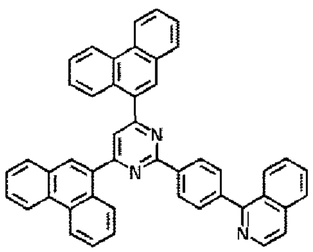

ET13

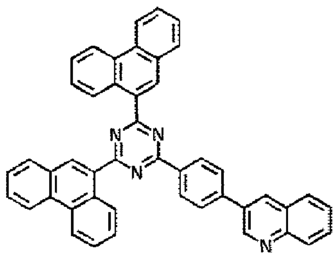

ET14

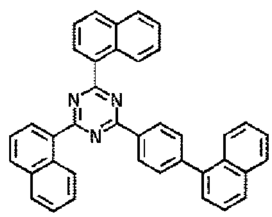

ET15

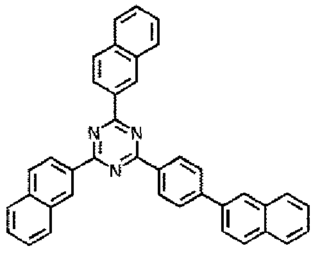

ET16

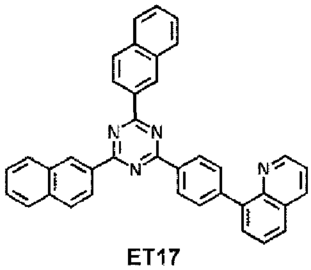

ET17

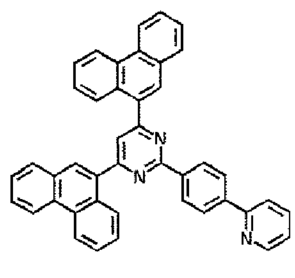

ET18

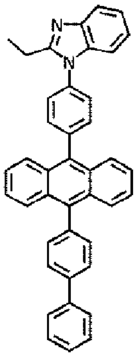

ET19

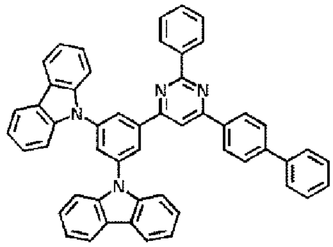

ET20

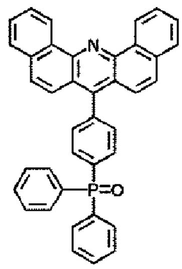

ET21

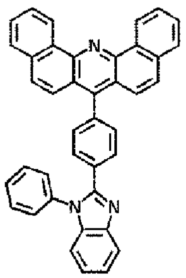

ET22

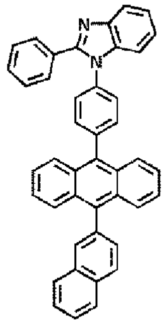

ET23

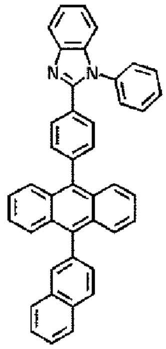

ET24

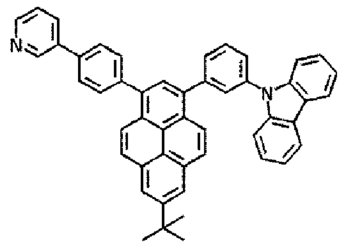

ET25

.

A thickness of the electron transport layer may be from about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. For example, the Li complex may comprise ET-D1(Liq), ET-D2, or any combination thereof:

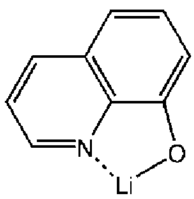

ET-D1

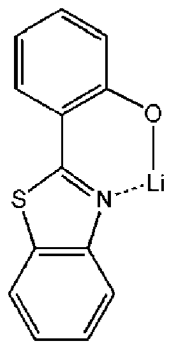

ET-D2

.

The electron transport region may include an electron injection layer that promotes flow of electrons from the second electrode 19 thereinto.

The electron injection layer may include LiF, a NaCl, CsF, $Li_2O$, BaO, or any combination thereof.

A thickness of the electron injection layer may be from about 1 Å to about 100 Å, for example, about 3 Å to about 90 Å. When a thickness of the electron injection layer is within these ranges, satisfactory electron injection characteristics may be obtained without substantial increase in driving voltage.

The second electrode 19 is disposed on the organic layer 15. The second electrode 19 may be a cathode. A material for forming the second electrode 19 may comprise a metal, an alloy, an electrically conductive compound, or a combination thereof, which have a relatively low work function. For example, lithium (Li), magnesium (Mg), aluminum (Al),

aluminum-lithium (Al-Li), calcium (Ca), magnesium-indium (Mg-In), or magnesium-silver (Mg-Ag) may be used as the material for forming the second electrode 19. To manufacture a top-emission type light-emitting device, a transmissive electrode formed using ITO or IZO may be used as the second electrode 19.

Hereinbefore, the organic light-emitting device according to an embodiment has been described in connection with the FIGURE.

The term "$C_1$-$C_{60}$ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_2$-$C_{60}$ alkenyl group" as used herein refers to a hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group having at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_2$-$C_{10}$ heterocycloalkyl group" as used herein refers to a monovalent saturated monocyclic group having at least one N, O, P, Si, Se, Ge, B, or S as a ring-forming atom and 2 to 10 carbon atoms, and non-limiting examples thereof include a tetrahydrofuranyl group, and a tetrahydrothiophenyl group. The term "$C_2$-$C_{10}$ heterocycloalkylene group" as used herein refers to a divalent group having the same structure as the $C_2$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_2$-$C_{10}$ heterocycloalkenyl group" as used herein refers to a monovalent monocyclic group that has at least one N, O, P, Si, Se, Ge, B, or S as a ring-forming atom, 2 to 10 carbon atoms, and at least one double bond in its ring. Examples of the $C_2$-$C_{10}$ heterocycloalkenyl group are a 2,3-dihydrofuranyl group, and a 2,3-dihydrothiophenyl group. The term "$C_2$-$C_{10}$ heterocycloalkenylene group" as used herein refers to a divalent group having the same structure as the $C_2$-$C_{10}$ heterocycloalkenyl group.

The term "($C_1$-$C_{10}$ alkyl)carbazolyl group," as used herein refers to a carbazole group substituted with a $C_1$-$C_{10}$ alkyl group.

The term "di($C_1$-$C_{10}$ alkyl)'X' group" as used herein refers to a 'X' group substituted with two $C_1$-$C_{10}$ alkyl groups.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a cyclic aromatic system that has at least one **N,** O, P, Si, Se, Ge, B, or S as a ring-forming atom, in addition to 1 to 60 carbon atoms. The term "$C_1$-$C_{60}$ heteroarylene group" as used herein refers to a divalent group having a cyclic aromatic system that has at least one **N,** O, P, Si, Se, Ge, B, or S as a ring-forming atom, in addition to 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" used herein indicates $-OA_{102}$ (wherein $A_{102}$ is the $C_6$-$C_{60}$ aryl group), and a $C_6$-$C_{60}$ arylthio group used herein indicates $-SA_{103}$ (wherein $A_{103}$ is the $C_6$-$C_{60}$ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein

refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom **N,** O, P, Si, Se, Ge, B, or S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from **N,** O, Si, P, Se, Ge, B, or S other than 1 to 30 carbon atoms. The $C_1$-$C_{30}$ heterocyclic group may be a monocyclic group or a polycyclic group.

A substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_2$-$C_{10}$ heterocycloalkyl group, the substituted $C_3$-$C_{10}$ cycloalkenyl group, the substituted $C_2$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, - $Si(Q_{13})(Q_{14})(Q_{15})$, $-B(Q_{16})(Q_{17})$, $-P(=O)(Q_{18})(Q_{19})$, or any combination thereof;

a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-B(Q_{26})(Q_{27})$, $-P(=O)(Q_{28})(Q_{29})$, or any combination thereof;

$-N(Q_{31})(Q_{32})$**,** $-Si(Q_{33})(Q_{34})(Q_{35})$, $-B(Q_{36})(Q_{37})$**,** or $-P(=O)(Q_{38})(Q_{39})$; or

any combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_2$-$C_{10}$ heterocycloalkyl group; a $C_3$-$C_{10}$ cycloalkenyl group; a $C_2$-$C_{10}$ heterocycloalkenyl group; a ; $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

Hereinafter, the compound and the organic light-emitting device according to embodiments are described in detail with reference to Synthesis Example and Examples, but are not limited thereto. The wording "'B' was used instead of

'A"' as used in describing Synthesis Example means that an amount of 'A' used was identical to an amount of 'B' used, in terms of a molar equivalent.

Examples

Synthesis Example 1(Synthesis of Compound 3-348)

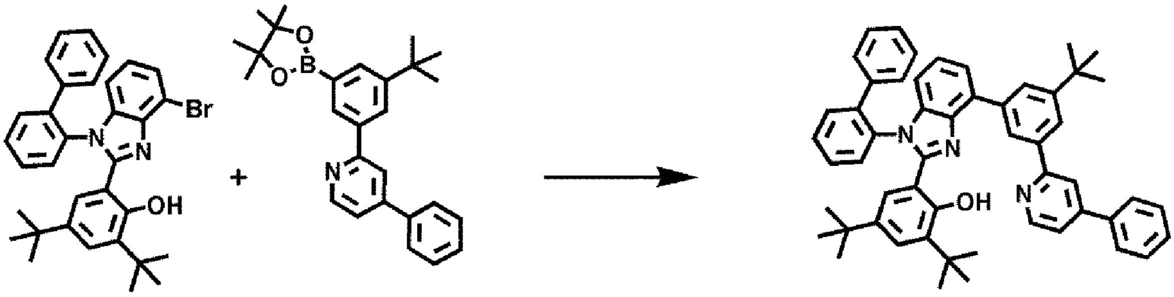

3-348A 3-348B 3-348C

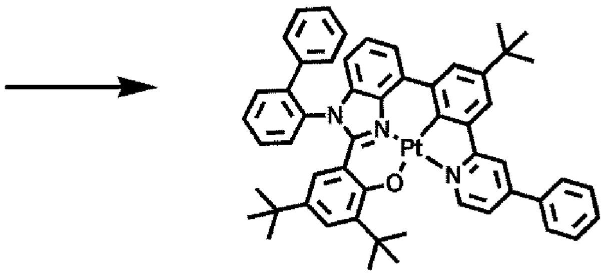

3-348

Synthesis of Ligand 3-348C

2.1 g (0.005 mmol, 1.2 equiv.) of Intermediate 3-348B, 2.2 g (0.004 mol, 1 equiv.) of Intermediate 3-348A (i.e., 2-(1-([1,1'-biphenyl]-2-yl)-4-bromo-1H-benzo[d]imidazol-2-yl)-4,6-di-tert-butylphenol), 1.2 g (0.001 mmol, 0.07 equiv.) of tetrakis(triphenylphosphine)palladium (0), and 1.7 g (0.012 mmol, 3 equiv.) of potassium carbonate were dissolved in 20 mL of a solvent in which tetrahydrofuran (THF) and distilled water ($H_2O$) were mixed at a volume ratio of 3:1, and the mixed solution was refluxed for 12 hours. A temperature of the product obtained therefrom was cooled down to room temperature, and a precipitate was filtered. A resulting filtrate was washed with ethylene acetate (EA) / $H_2O$, and then, subjected to column chromatography (while increasing a volume rate of EA/ hexane (Hex) to between 20% and 35%), thereby obtaining 2.0 g (yield: 72 %) of Ligand 3-348C. The product was identified by Mass Spectrum and HPLC.
HRMS(MALDI) calcd for $C_{64}H_{63}N_3O$: m/z 759.4189, Found: 759.4182

Synthesis of Compound 3-348

2.0 g (2.38 mmol) of Ligand 3-348C and 0.98 g (2.38 mmol, 1.0 equiv.) of $K_2PtCl_4$ were dissolved in 80 mL of a solvent in which 60 mL of acetic acid (AcOH) was mixed with 20 mL of $H_2O$, and the mixed solution was refluxed for 16 hours. A temperature of the product obtained therefrom was cooled down to room temperature, and a precipitate was filtered and dissolved again in methylene chloride (MC). A resulting filtrate was washed with $H_2O$, and then, subjected to column chromatography (MC 40 %, EA 1 %, Hex 59 %), thereby obtaining 1.1 g (purity: 99 % or more, actual yield: 71 %) of Compound 3-348. The product was identified by Mass Spectrum and HPLC.
HRMS(MALDI) calcd for $C_{54}H_{51}N_3OPt$: m/z 952.3680, Found: 952.3678

Synthesis Example 2(Synthesis of Compound 3-583)

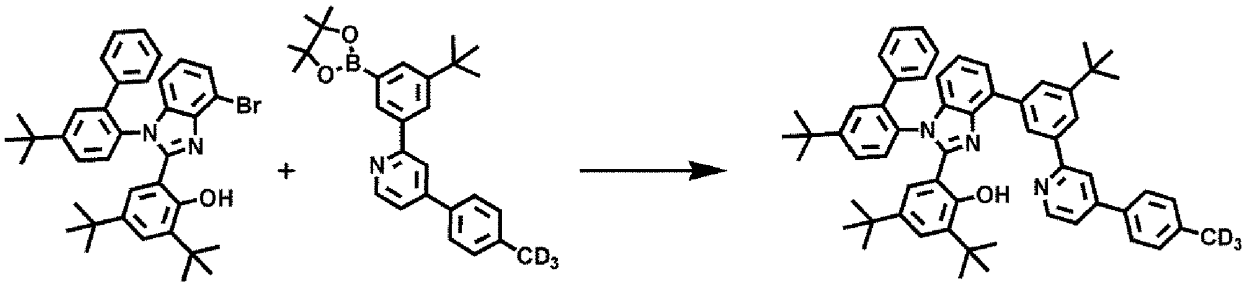

3-583A 3-583B 3-583C

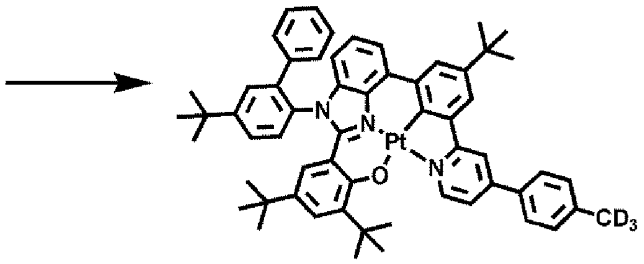

3-583

Synthesis of Ligand 3-583C

2.2 g (0.005 mmol, 1.2 equiv.) of Intermediate 3-583B, 2.4 g (0.004 mol, 1equiv.) of Intermediate 3-583A (i.e., 2-(4-bromo-1-(5-(tert-butyl)-[1,1'-biphenyl]-2-yl)-1H-benzo[d]imidazol-2-yl)-4,6-di-tert-butylphenol), 1.2 g (0.001 mol, 0.07 equiv.) of tetrakis(triphenylphosphine)palladium (0), and 2.0 g (0.015 mol, 3.7 equiv.) of potassium carbonate were dissolved in 80 mL of a solvent in which THF and distilled water ($H_2O$) were mixed at a ratio of 3:1, and the mixed solution was refluxed for 12 hours. A temperature of the product obtained therefrom was cooled down to room temperature, and a precipitate was filtered. A resulting filtrate was washed with EA / $H_2O$, and then, subjected to column chromatography (gradient elution with EA / Hex 20 %-35 %), thereby obtaining 2.2 g (yield: 68 %) of Ligand 3-583C. The product was identified by Mass Spectrum and HPLC.
HRMS(MALDI) calcd for $C_{59}H_{60}D_3N_3O$: m/z 832.5159, Found: 832.5161

Synthesis of Compound 3-583

2.2 g (2.26 mmol) of Ligand 3-583C and 1.1 g (2.26 mmol, 1.0 equiv.) of $K_2PtCl_4$ were dissolved in 80 mL of a solvent in which 60 mL of AcOH was mixed with 20 mL of $H_2O$, and the mixed solution was refluxed for 16 hours. A temperature of the product obtained therefrom was cooled down to room temperature, and a precipitate was filtered and dissolved again in MC. A resulting filtrate was washed with $H_2O$, and then, subjected to column chromatography (MC 40 %, EA 1 %, Hex 59 %), thereby obtaining 1.0 g (purity: 99 % or more, actual yield: 68 %) of Compound 3-583. The product was identified by Mass Spectrum and HPLC.
HRMS(MALDI) calcd for $C_{59}H_{58}D_3N_3OPt$: m/z 1025.4651, Found: 1025.4653

Evaluation Example 1

HOMO energy levels of the compounds below were measured using a photoelectron spectrometer (for example, AC3 manufactured by RIKEN KEIKI Co., Ltd.) in air, and the results are shown in Table 1.

Table 1

| Compound | Actual measurement of HOMO energy level (eV) |
|---|---|
| 3-348 | -5.45 |
| 3-583 | -5.43 |
| H1-15 | -5.95 |
| H1-63 | -6.07 |
| H1-65 | -6.12 |
| H1-75 | -6.07 |
| HA1 | -5.71 |
| H2-2 | -5.58 |
| H2-71 | -5.69 |
| H2-72 | -5.65 |
| HA2 | -5.35 |
| HA3 | -6.00 |

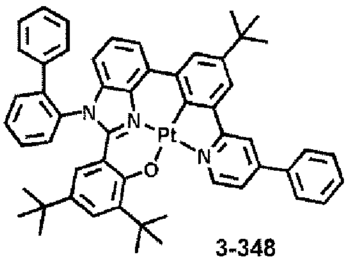

**3-348**

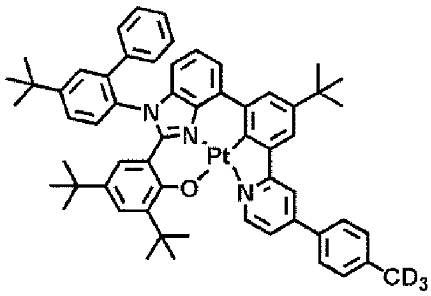

**3-583**

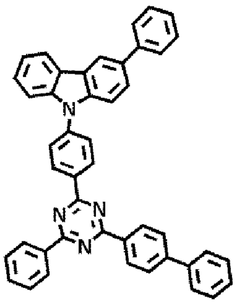

**H1-15**

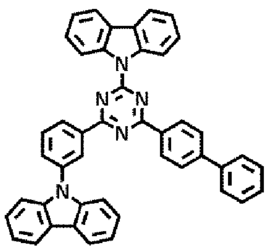

**H1-63**

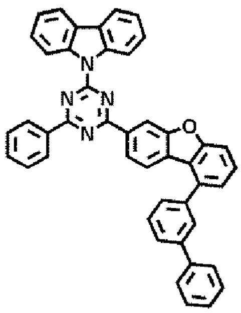

**H1-65**

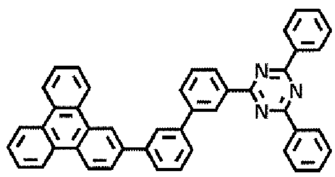

**H1-75**

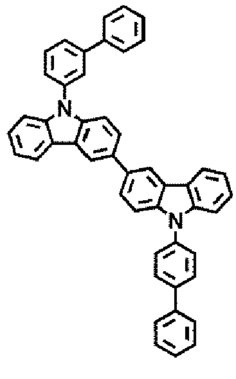

H2-2

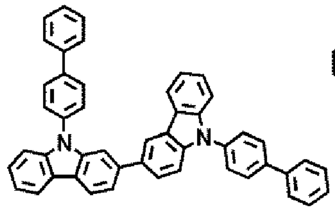

H2-71

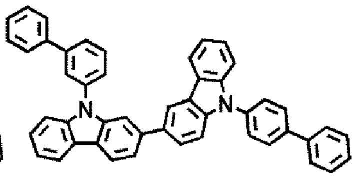

H2-72

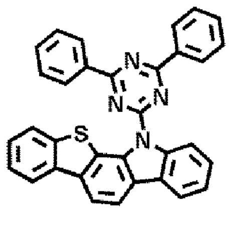

HA1

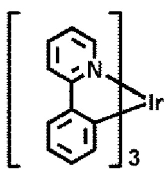

HA2

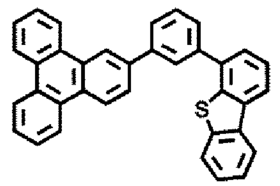

HA3

Example 1

A glass substrate on which an ITO electrode was prepared, was cut to a size of 50 mm x 50 mm x 0.5 mm, sonicated with acetone, isopropyl alcohol and pure water each for 15 minutes, and then, cleaned by exposure to ultraviolet rays and ozone for 30 minutes. Next, F6-TCNNQ was deposited on the ITO electrode (i.e., an anode) of the glass substrate to form a hole injection layer having a thickness of 100 Å, HT3 was deposited on the hole injection layer to form a first hole transport layer having a thickness of 1,260 Å, F6-TCNNQ and HT3 were co-deposited at a weight ratio of 5 : 95 on the first hole transport layer to form a second hole transport layer having a thickness of 100 Å, and HT3 was deposited on the second hole transport layer to form a third hole transport layer having a thickness of 300 Å.

Then, a host and a dopant were co-deposited at a weight ratio of 85 : 15 on the third hole transport layer to form an emission layer having a thickness of 400 Å. Here, as the host, a first compound (e.g., Compound H1-63), a second compound (e.g., Compound H2-2), and a third compound (e.g., Compound H2-72) (wherein a weight ratio of the first compound, the second compound, and the third compound was 3 : 3.5 : 3.5), and as the dopant, Compound 3-348 was used.

Next, Compounds ET1 and ET-D1 were co-deposited at a weight ratio of 5:5 on the emission layer to form an electron transport layer having a thickness of 360 Å, LiF was deposited on the electron transport layer to form an electron injection layer having a thickness of 5 Å, Al was vacuum-deposited on the electron injection layer to form a second electrode (i.e., a cathode) having a thickness of 800 Å, thereby completing the manufacture of an organic light-emitting device having a structure of ITO / F6-TCNNQ (100 Å) / HT3 (1260 Å) / HT3 : F6-TCNNQ (5 wt%) (100 Å) / HT3 (300 Å) / host : dopant (15 wt%) (400 Å) / ET1 : ET-D1 (50 wt%) (360 Å) / LiF (5 Å) / Al (800 Å):

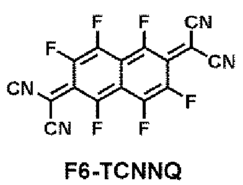

F6-TCNNQ

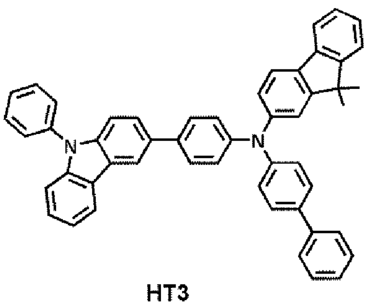

HT3

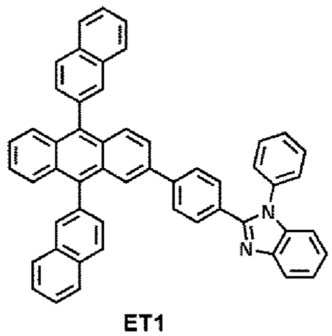

ET1

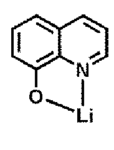

ET-D1

Example 2 and Comparative Examples 1 to 4

Organic light-emitting devices were manufactured in the same manner as in Example 1, except that compounds listed in Table 2 were each used as a host and a dopant in forming an emission layer.

Evaluation Example 2

The external quantum luminescence efficiency (EQE), driving voltage, and lifespan ($T_{95}$) of the organic light-emitting devices manufactured according to Examples 1 and 2 and Comparative Examples 1 to 4 were evaluated, and the results are shown in Table 2. Here, as a device used for the evaluation, a current-voltage meter (Keithley 2400) and a luminance meter (Minolta Cs-1000A) were used. The lifespan ($T_{95}$) (at 16,000 nit) was obtained by evaluating time (hr) that lapsed when luminance was 95 % of initial luminance (100 %). The EQE and the lifespan ($T_{95}$) were both measured at luminance of 16,000 cd/$m^2$.

Table 2

| | Dopan t | Host | | | | EQE (%) | Drivin 9 volta ge (V) | Lifespan ($T_{95}$ at 16,000nit ) (hr) |
|---|---|---|---|---|---|---|---|---|
| | | First compo und | Secon d compo und | Third compo und | Difference (eV) between absolute value of HOMO energy level of second compound and absolute value of HOMO energy level of third compound | | | |
| Exam ple 1 | 3-348 | H1-63 | H2-2 | H2-72 | 0.07 | 24.1 | 3.9 | 380 |
| | | Weight ratio = 3 : 3.5 : 3.5 | | | | | | |
| Exam ple 2 | 3-348 | H1-63 | H2-2 | H2-71 | 0.11 | 23.4 | 4.0 | 375 |
| | | Weight ratio = 3 : 3 : 4 | | | | | | |
| Comparative Exam ple 1 | 3-348 | H1-63 | H2-2 | - | - | 23.8 | 3.9 | 250 |
| | | Weight ratio = 4 : 6 | | | | | | |
| Comp arative Exam ple 2 | 3-348 | H1-63 | - | H2-72 | - | 23.1 | 4.4 | 365 |
| | | Weight ratio = 2.5 : 7.5 | | | | | | |
| Comp arative Exam ple 3 | 3-348 | H1-65 | H2-2 | - | - | 23.6 | 4.0 | 280 |
| | | Weight ratio = 4 : 6 | | | | | | |
| Comp arative Exam ple 4 | 3-348 | HA1 | HA2 | HA3 | 0.65 | 19.5 | 4.3 | 20 |
| | | Weight ratio = 4 : 2: 4 | | | | | | |

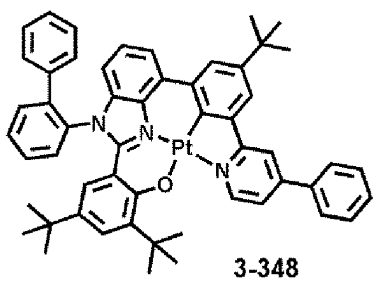

3-348

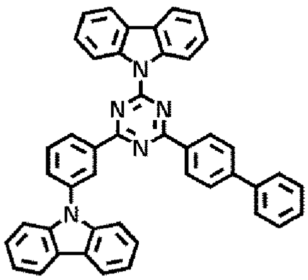

H1-63

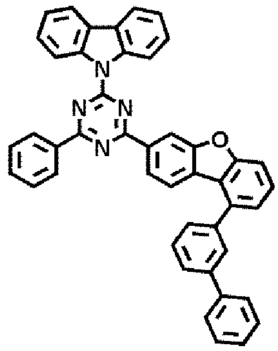

H1-65

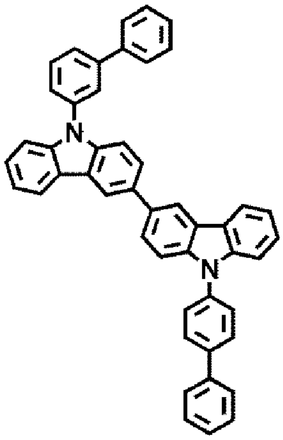

H2-2

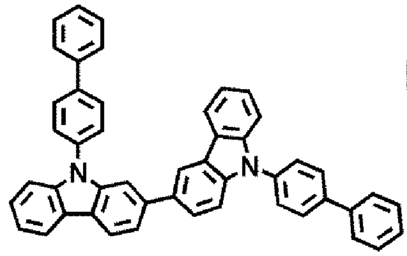

H2-71

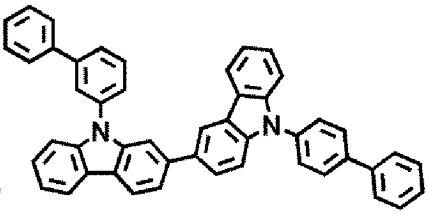

H2-72

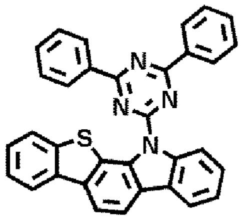

HA1

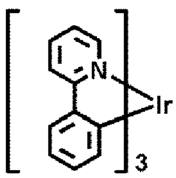

HA2

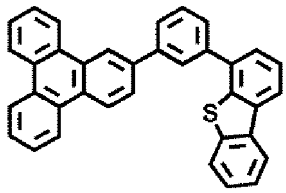

HA3

Referring to Table 2, it was confirmed that the organic light-emitting devices of Examples 1 and 2 had high EQE, low driving voltage, and long lifespan characteristics, as compared with the organic light-emitting devices of Comparative Examples 1 to 4.

Examples 3 and 4

Organic light-emitting devices were manufactured in the same manner as in Examples 1 and 2, respectively, except that, Compound 3-583 was used instead of Compound 3-348 as a dopant in forming an emission layer.

Evaluation Example 3

The EQE, driving voltage, and lifespan ($T_{95}$) of the organic light-emitting devices of Examples 3 and 4 were evaluated in the same manner as in Evaluation Example 2, and the results are shown in Table 3.

Table 3

| | Dopant | Host | | | | EQE (%) | Driving voltage (V) | Lifespan ($T_{95}$ at 16,000nit ) (hr) |
|---|---|---|---|---|---|---|---|---|
| | | First compound | Second compound | Third compound | Difference (eV) between absolute value of HOMO energy level of second compound and absolute value of HOMO energy level of third compound | | | |
| Example 3 | 3-583 | H1-63 | H2-2 | H2-72 | 0.07 | 25.5 | 3.8 | 500 |
| | | Weight ratio = 3 : 3.5 : 3.5 | | | | | | |
| Example 4 | 3-583 | H1-63 | H2-2 | H2-71 | 0.11 | 24.4 | 3.9 | 510 |
| | | Weight ratio = 3 : 3 : 4 | | | | | | |

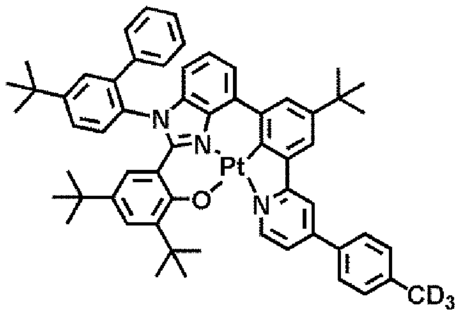

**3-583**

Referring to Table 3, it was confirmed that the organic light-emitting devices of Examples 3 and 4 had excellent EQE, excellent driving voltage, and excellent lifespan characteristics.

According to the one or more embodiments, the composition has excellent electric characteristics and excellent stability, and thus, an electronic device, for example, an organic light-emitting device, including the composition may have improved external quantum luminescence efficiency, improved driving voltage, and improved lifespan characteristics.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. A composition comprising a platinum-containing organometallic compound, a first compound, a second compound, and a third compound,

    wherein the composition does not comprise iridium,
    the Pt-containing organometallic compound, the first compound, the second compound, and the third compound are different from each other,
    the first compound comprises at least one electron transport moiety,
    the second compound and the third compound do not include a metal and the second compound and the third compound are each independently represented by one of Formulae 3-1 to 3-4,
    each of an absolute value of a HOMO energy level of the second compound and an absolute value of a HOMO energy level of the third compound is 5.30 eV to 5.85 eV,
    the difference between the absolute value of the HOMO energy level of the second compound and the absolute value of the HOMO energy level of the third compound is 0.01 eV to 0.30 eV, and

each of the HOMO energy level of the second compound and the HOMO energy level of the third compound is measured using a photoelectron spectrometer in air:

Formula 3-1

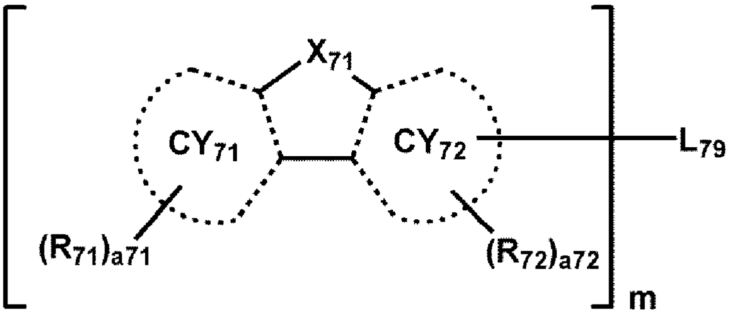

Formula 3-2

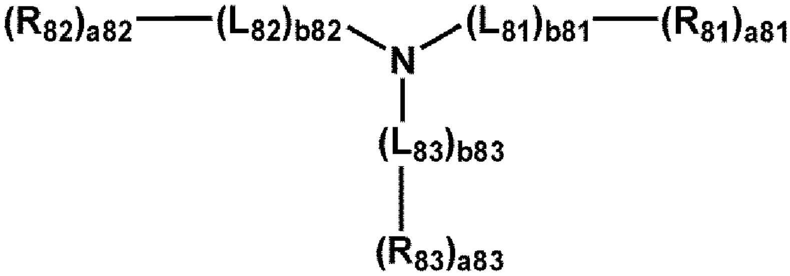

Formula 3-3

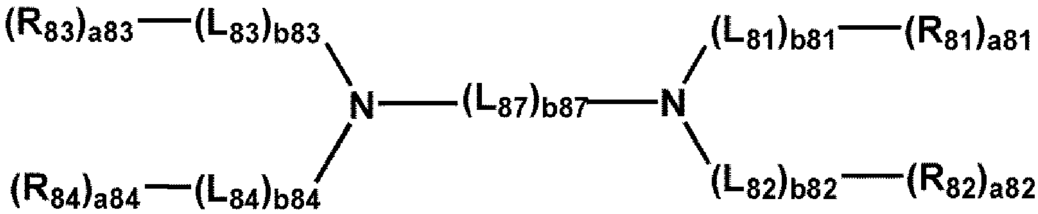

Formula 3-4

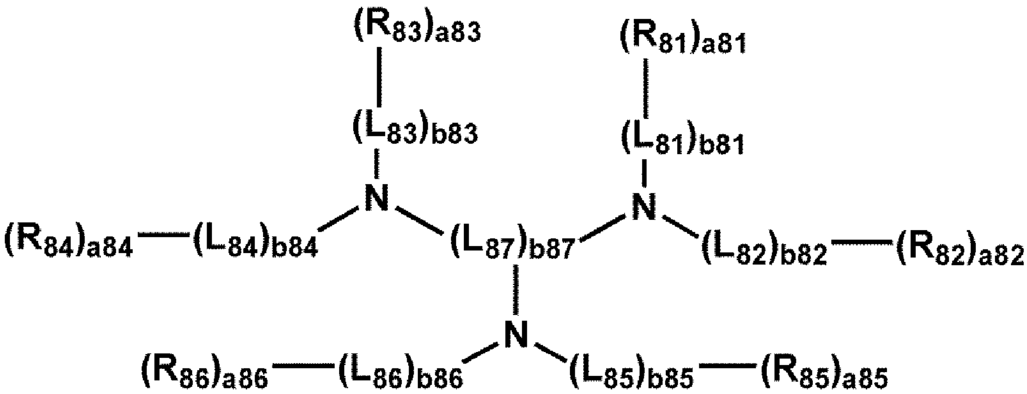

,

wherein,
ring $CY_{71}$ and ring $CY_{72}$ in Formula 3-1 are each independently a π-electron-rich $C_3$-$C_{30}$ cyclic group, and ring $CY_{71}$ and ring $CY_{72}$ in Formula 3-1 are optionally linked to each other via a π-electron-rich $C_3$-$C_{30}$ cyclic group,

$X_{71}$ in Formula 3-1 is O, S, N-$(L_{75})_{b75}$-$(R_{75})_{a75}$, C($R_{75}$)($R_{76}$), or Si($R_{75}$)($R_{76}$),
m in Formula 3-1 is 1, 2, or 3, wherein, when m is 1, $L_{79}$ is absent,
i) $L_{75}$, $L_{79}$, and $L_{81}$ to $L_{87}$ in Formulae 3-1 to 3-4 are each independently a $\pi$-electron-rich $C_3$-$C_{30}$ cyclic group unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl) dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, -N($Q_{31}$)($Q_{32}$), or any combination thereof, or ii) $L_{79}$ in Formula 3-1 is a single bond,
$b_{75}$, and $b_{81}$ to $b_{87}$ in Formulae 3-1 to 3-4 are each independently an integer from 1 to 10,
$R_{71}$, $R_{72}$, $R_{75}$, $R_{76}$, and $R_{81}$ to $R_{86}$ in Formulae 3-1 to 3-4 are each independently: hydrogen or deuterium;
a $C_1$-$C_{20}$ alkyl group unsubstituted or substituted with deuterium, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, -N($Q_{31}$)($Q_{32}$), or any combination thereof;
a $\pi$-electron-rich $C_3$-$C_{30}$ cyclic group unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, a tetraphenyl group, -N($Q_{31}$)($Q_{32}$), or any combination thereof; or
-N($Q_1$)($Q_2$),
a71, a72, a75, and a81 to a86 in Formulae 3-1 to 3-4 are each independently an integer from 0 to 20,
wherein $Q_1$, $Q_2$, $Q_{31}$ and $Q_{32}$ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_2$-$C_{10}$ heterocycloalkyl group; a $C_3$-$C_{10}$ cycloalkenyl group; a $C_2$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

**2.** The composition of claim 1, wherein

the Pt-containing organometallic compound comprises Pt and a tetradentate organic ligand, wherein the Pt and the tetradentate organic ligand form 3 or 4 cyclometallated rings;
preferably wherein
the tetradentate organic ligand comprises a benzimidazole group and a pyridine group.

**3.** The composition of claim 1 or 2, wherein

an absolute value of the HOMO energy level of the Pt-containing organometallic compound is 5.25 eV to 5.55 eV, and
the HOMO energy level of the Pt-containing organometallic compound is measured using a photoelectron spectrometer in air.

**4.** The composition of any of claims 1-3, wherein

the electron transport moiety is a cyano group, a fluoro group, a $\pi$-electron-deficient nitrogen-containing cyclic group, a group represented by one of the following formulae, or any combination thereof:

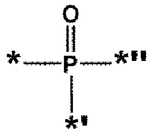 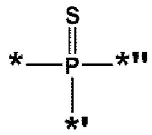 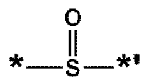 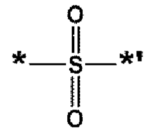 ,

wherein, in the formulae above, *, *', and *" each indicate a binding site to a neighboring atom.

**5.** The composition of any of claims 1-4, wherein at least one of the second compound and the third compound does not include an electron transport moiety.

**6.** The composition of any of claims 1-5, wherein

at least one of the second compound and the third compound independently comprises:

i) a condensed ring in which one or more fifth rings and one or more sixth rings are condensed with each other,
ii) a group represented by

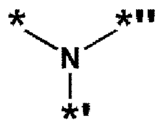

,

or
iii) any combination thereof,

the fifth ring is a cyclopentadiene group, a pyrrole group, a furan group, a thiophene group, or a silole group,
the sixth ring is a $\pi$-electron-rich $C_3$-$C_{30}$ cyclic group, and
*, *', and *" each indicate a binding site to a neighboring atom.

**7.** The composition of any one of claims 1-6, wherein

the Pt-containing organometallic compound is an organometallic compound represented by Formula 1,
the first compound is a compound represented by Formula 2:

Formula 1

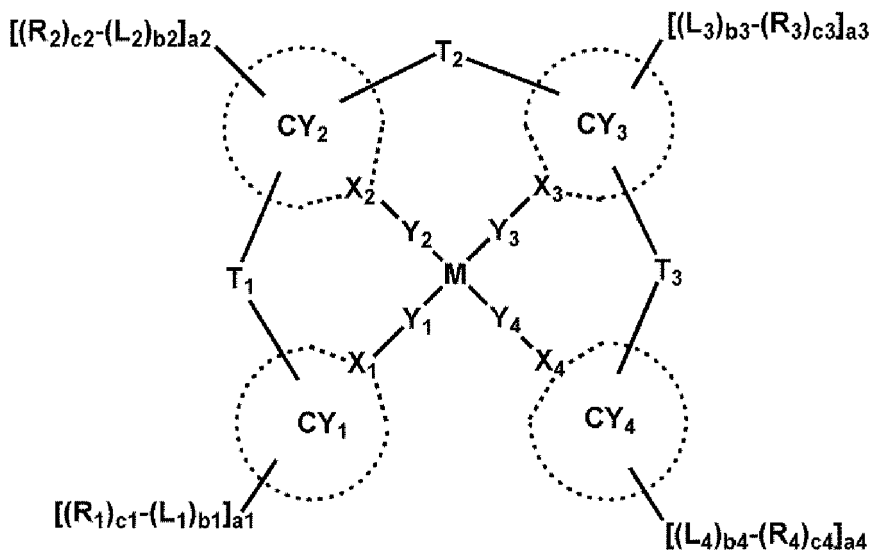

Formula 2

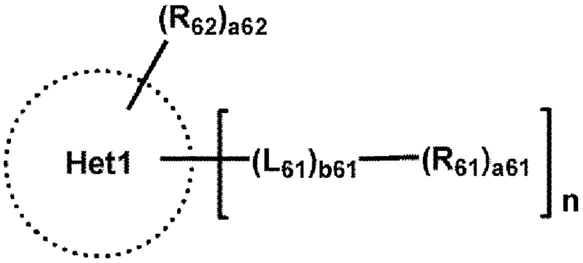

,

wherein,
M in Formula 1 is Pt,
$Y_1$ to $Y_4$ in Formula 1 are each independently a chemical bond, O, S, $N(R_a)$, $C(R_a)(R_b)$, or $Si(R_a)(R_b)$,
$X_1$ to $X_4$ in Formula 1 are each independently C or N,
ring $CY_1$ to ring $CY_4$ in Formula 1 are each independently a $C_5$-$C_{30}$ carbocyclic group or a $C_1$-$C_{30}$ heterocyclic group,
$T_1$ in Formula 1 is a single bond, a double bond, *-$N(R_{51})$-*', *-$B(R_{51})$-*', *-$P(R_{51})$-*', *-$C(R_{51})(R_{52})$-*', *-$Si(R_{51})(R_{52})$-*', *-$Ge(R_{51})(R_{52})$-*', *-S-*', *-Se-*', *-O-*', *-C(=O)-*', *-S(=O)-*', *-$S(=O)_2$-*', *-$C(R_{51})$=*', *=$C(R_{51})$-*', *-$C(R_{51})$=$C(R_{52})$-*', *-C(=S)-*', or *-C≡C-*',
$T_2$ in Formula 1 is a single bond, a double bond, *-$N(R_{53})$-*', *-$B(R_{53})$-*, *-$P(R_{53})$-*', *-$C(R_{53})(R_{54})$-*', *-$Si(R_{53})(R_{54})$-*', *-$Ge(R_{53})(R_{54})$-*', *-S-*', *-Se-*', *-O-*', *-C(=O)-*', *-S(=O)-*', *-$S(=O)_2$-*', *-$C(R_{53})$=*', *=$C(R_{53})$-*', *-$C(R_{53})$=$C(R_{54})$-*', *-C(=S)-*', or *-C=C-*',
$T_3$ in Formula 1 is a single bond, a double bond, *-$N(R_{55})$-*', *-$B(R_{55})$-*', *-$P(R_{55})$-*', *-$C(R_{55})(R_{56})$-*', *-$Si(R_{55})(R_{56})$-*', *-$Ge(R_{55})(R_{56})$-*', *-S-*', *-Se-*', *-O-*', *-C(=O)-*', *-S(=O)-*', *-$S(=O)_2$-*', *-$C(R_{55})$=*', *=$C(R_{55})$-*', *-$C(R_{55})$=$C(R_{56})$-*', *-C(=S)-*', or *-C≡C-*',
Het1 in Formula 2 is a $\pi$-electron-deficient nitrogen-containing $C_1$-$C_{30}$ cyclic group,
n in Formula 2 is one of an integer from 1 to 10,
$L_1$ to $L_4$, and $L_{61}$ in Formulae 1 and 2 are each independently a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$b_1$ to $b_4$, and $b_{61}$ in Formulae 1 and 2 are each independently an integer from 1 to 10,
$R_a$, $R_b$, $R_1$ to $R_4$, $R_{51}$ to $R_{56}$, $R_{61}$, and $R_{62}$ in Formulae 1 and 2 are each independently hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, -$B(Q_6)(Q_7)$, or - $P(=O)(Q_8)(Q_9)$,
c1 to c4 in Formula 1 are each independently an integer from 1 to 10,
a1 to a4, a61, and a62 in Formulae 1 and 2 are each independently an integer from 0 to 20,
two or more of $R_a$, $R_b$, $R_1$ to $R_4$, and $R_{51}$ to $R_{56}$ in Formula 1 are optionally linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$R_{10a}$ is the same as defined in connection with $R_1$,
* and *' each indicate a binding site to a neighboring atom,
a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_2$-$C_{10}$ heterocycloalkyl group, the substituted $C_3$-$C_{10}$ cycloalkenyl group, the substituted $C_2$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed

polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-B(Q_{16})(Q_{17})$, $-P(=O)(Q_{18})(Q_{19})$, or any combination thereof;

a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, - $P(=O)(Q_{28})(Q_{29})$, or any combination thereof;

$-N(Q_{31})(Q_{32})$, $-Si(Q_{33})(Q_{34})(Q_{35})$, $-B(Q_{36})(Q_{37})$, or $-P(=O)(Q_{38})(Q_{39})$; or

any combination thereof, and

$Q_1$ to $Q_9$, $Q_{11}$ to $Q_{19}$, $Q_{21}$ to $Q_{29}$, and $Q_{31}$ to $Q_{39}$ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_2$-$C_{10}$ heterocycloalkyl group; a $C_3$-$C_{10}$ cycloalkenyl group; a $C_2$-$C_{10}$ heterocycloalkenyl group; a ; $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

**8.** The composition of claim 7, wherein

in Formula 1, $Y_1$ is O or S, $Y_2$ to $Y_4$ are each a chemical bond, $X_1$ and $X_3$ are each C, and $X_2$ and $X_4$ are each N; and/or

wherein

Het1 in Formula 2 is a group represented by one of Formulae 2-1 to 2-42:

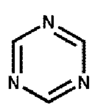
2-1

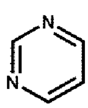
2-2

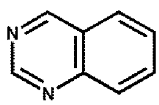
2-3

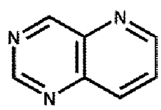
2-4

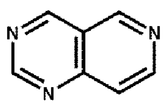
2-5

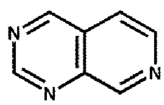
2-6

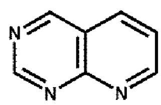
2-7

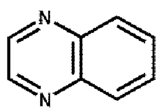
2-8

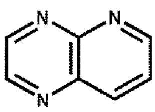
2-9

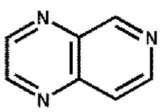
2-10

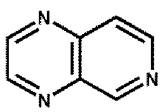
2-11

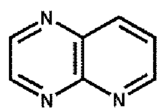
2-12

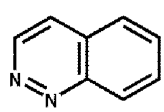
2-13

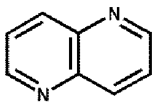
2-14

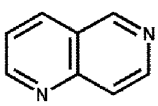
2-15

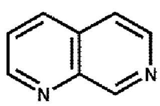
2-16

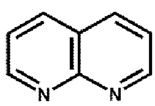
2-17

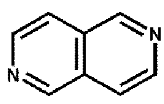
2-18

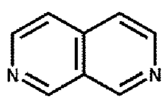
2-19

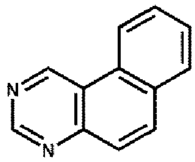
2-20

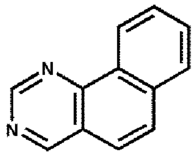
2-21

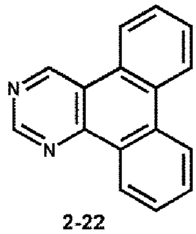
2-22

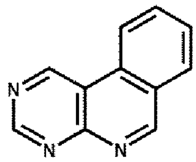
2-23

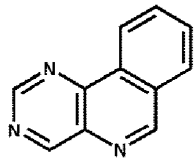
2-24

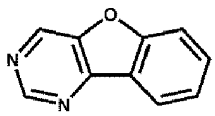
2-25

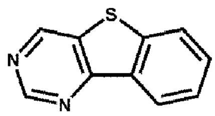
2-26

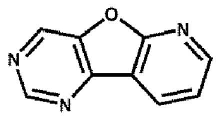
2-27

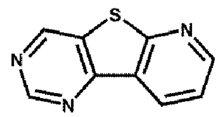
2-28

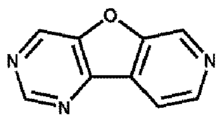
2-29

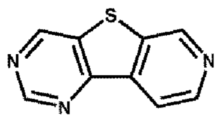
2-30

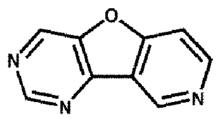
2-31

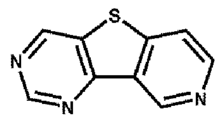
2-32

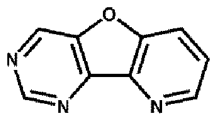
2-33

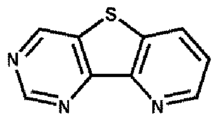
2-34

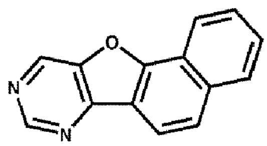
2-35

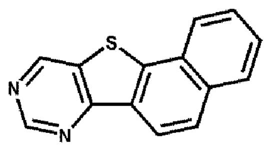
2-36

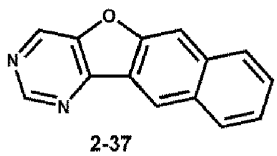
2-37

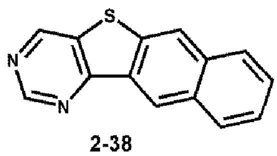
2-38

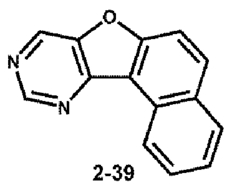
2-39

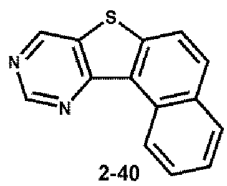
2-40

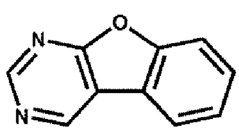
2-41

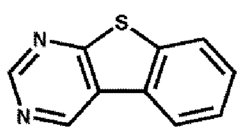
2-42

.

**9.** The composition of claim any one of 1-8, wherein

a group represented by

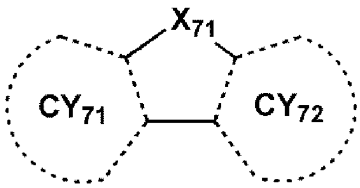

in Formula 3-1 is a group represented by one of Formulae 3(1) to 3(96):

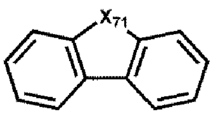
3(1)

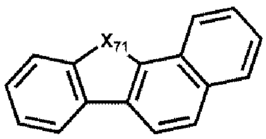
3(2)

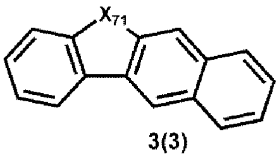
3(3)

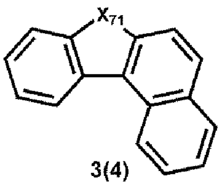
3(4)

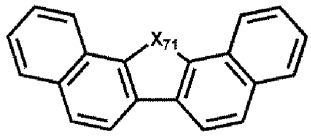
3(5)

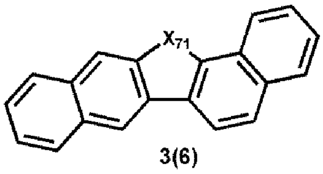
3(6)

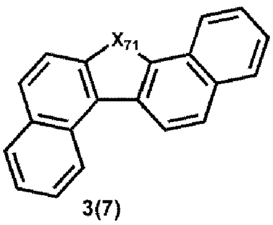
3(7)

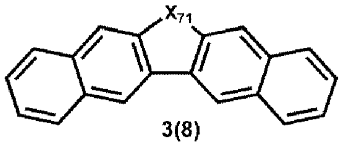
3(8)

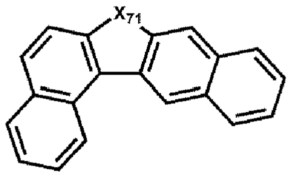
3(9)

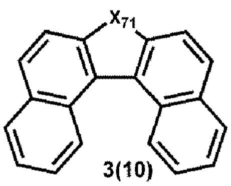
3(10)

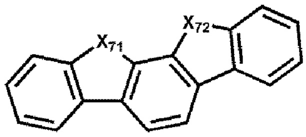
3(11)

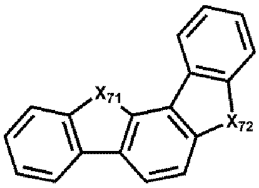
3(12)

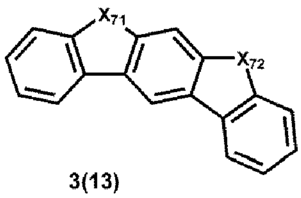
3(13)

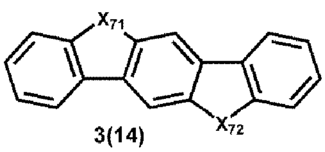
3(14)

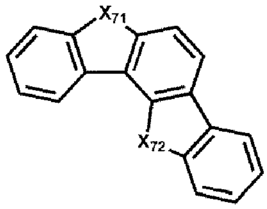
3(15)

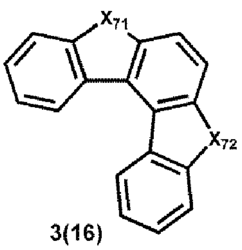
3(16)

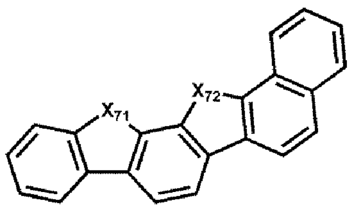
3(17)

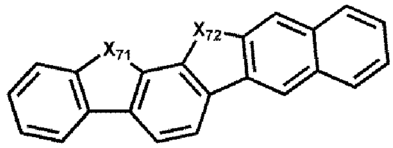
3(18)

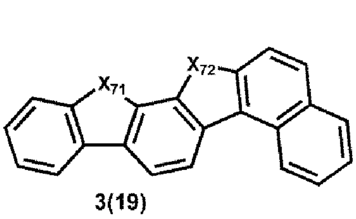

3(19)

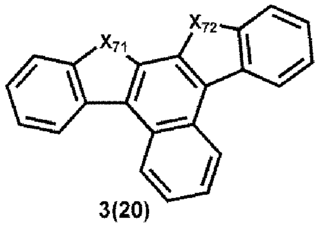

3(20)

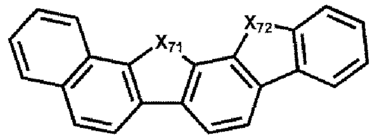

3(21)

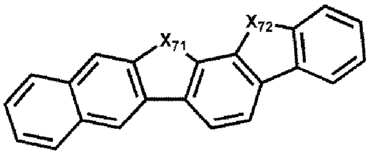

3(22)

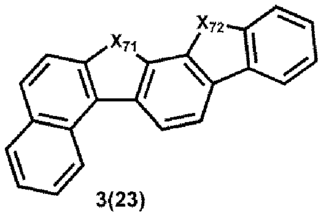

3(23)

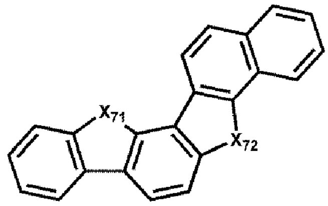

3(24)

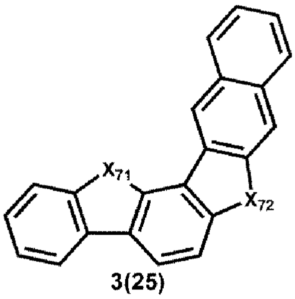

3(25)

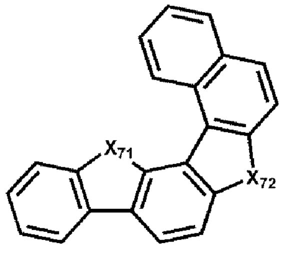

3(26)

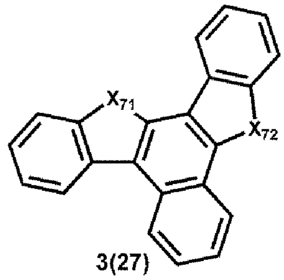

3(27)

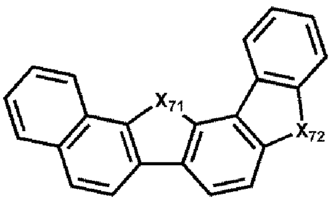

3(28)

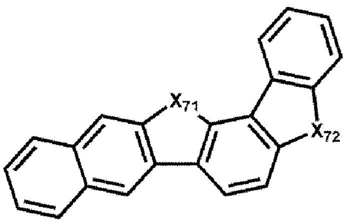

3(29)

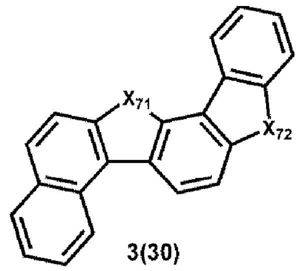

3(30)

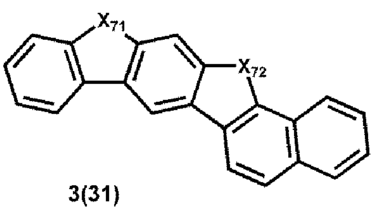

3(31)

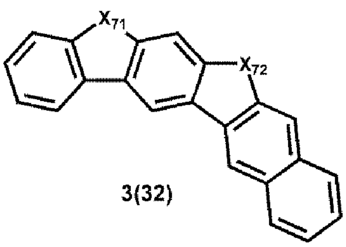

3(32)

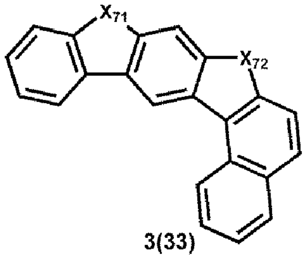

3(33)

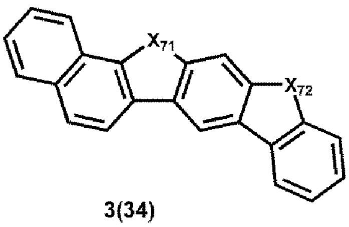

3(34)

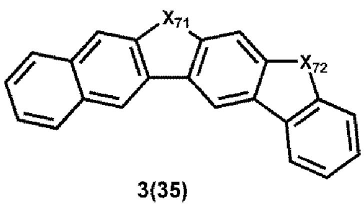

3(35)

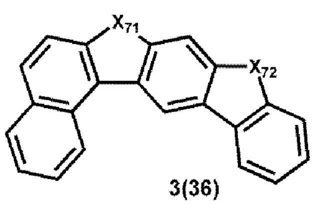

3(36)

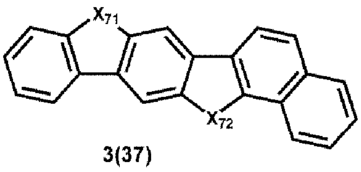
3(37)

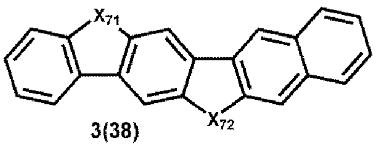
3(38)

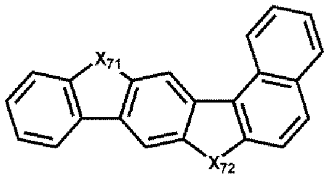
3(39)

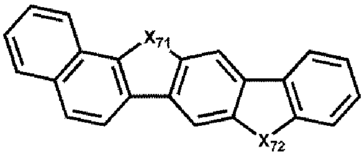
3(40)

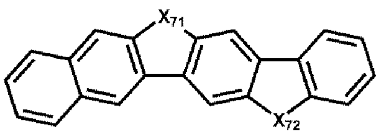
3(41)

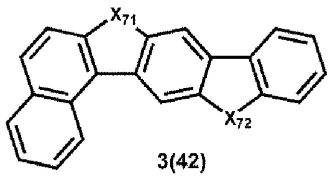
3(42)

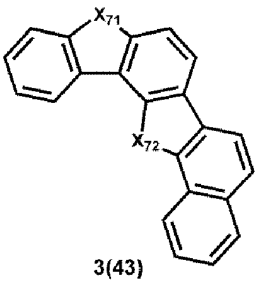
3(43)

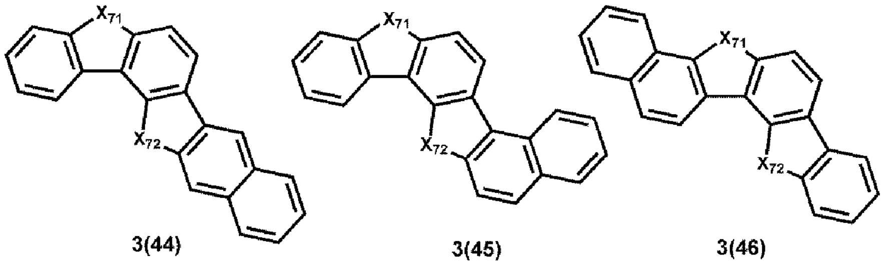
3(44)

3(45)

3(46)

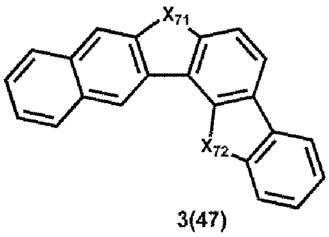
3(47)

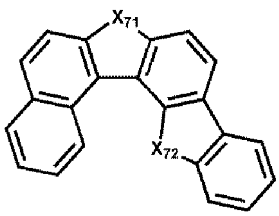
3(48)

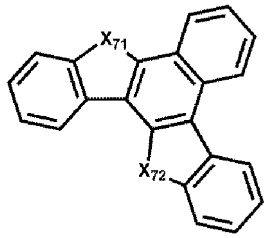
3(49)

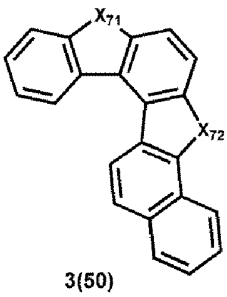
3(50)

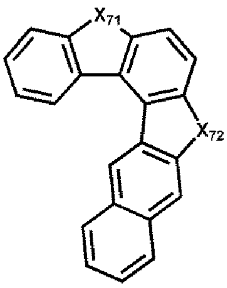
3(51)

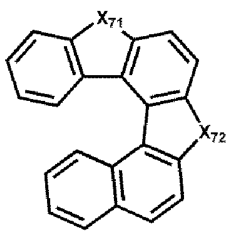
3(52)

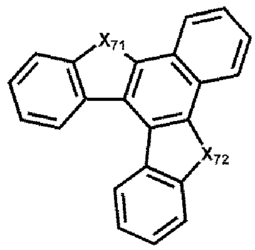
3(53)

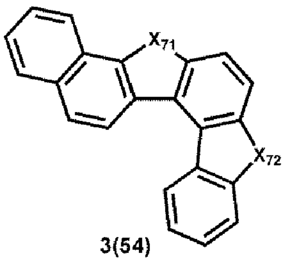
3(54)

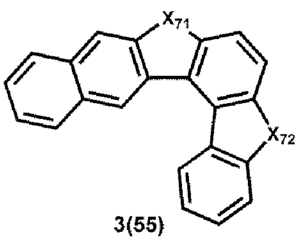
3(55)

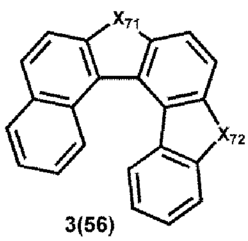
3(56)

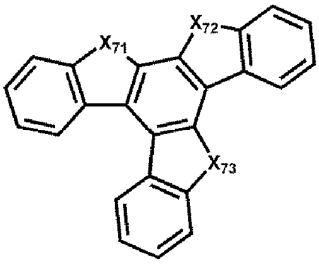

3(57)

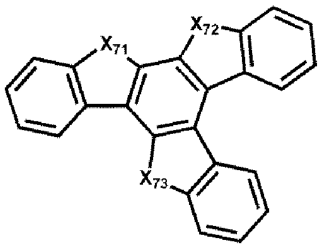

3(58)

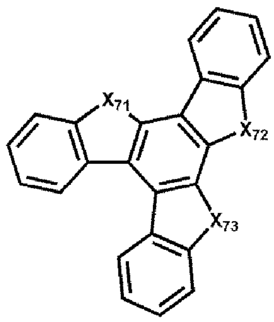

3(59)

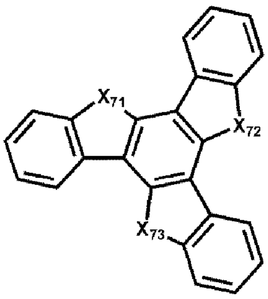

3(60)

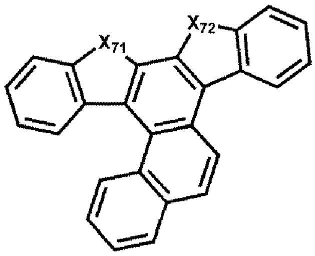

3(61)

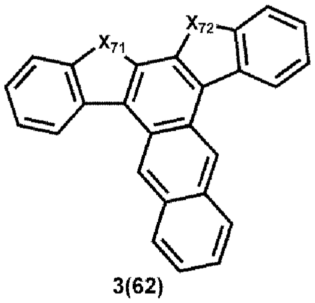

3(62)

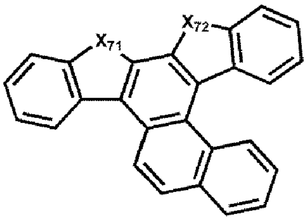

3(63)

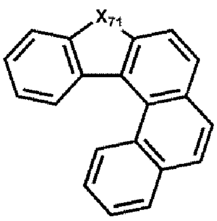

3(64)

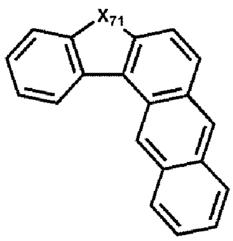

3(65)

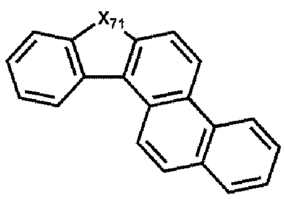

3(66)

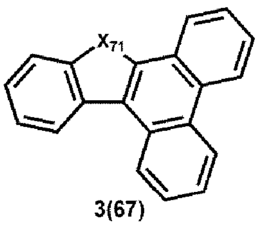

3(67)

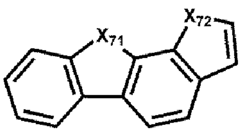

3(68)

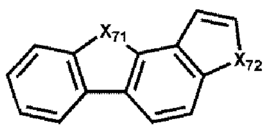

3(69)

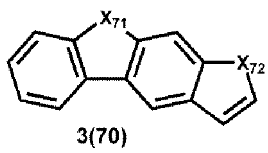

3(70)

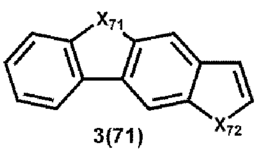

3(71)

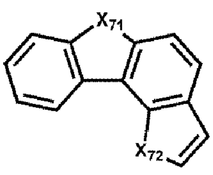

3(72)

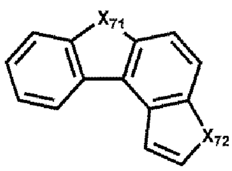

3(73)

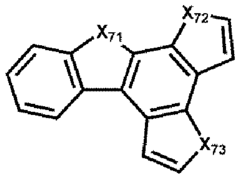
3(74)

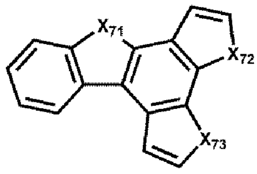
3(75)

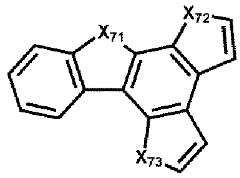
3(76)

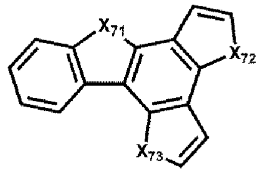
3(77)

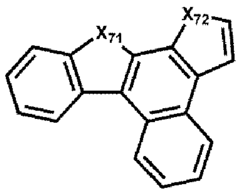
3(78)

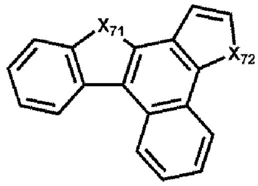
3(79)

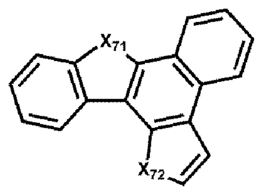
3(80)

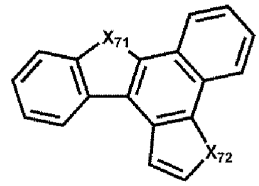
3(81)

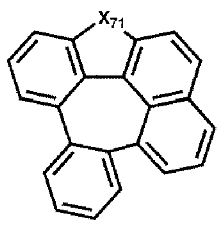
3(82)

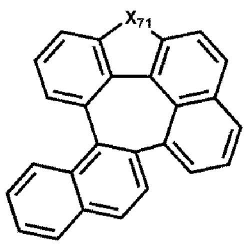
3(83)

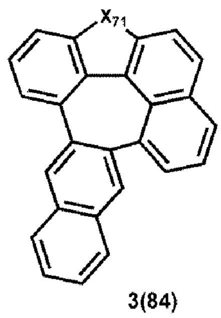
3(84)

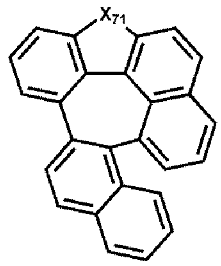
3(85)

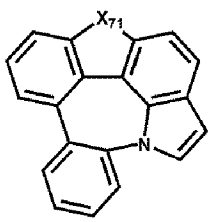
3(86)

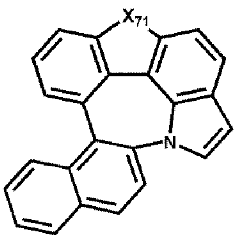
3(87)

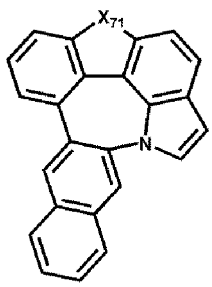
3(88)

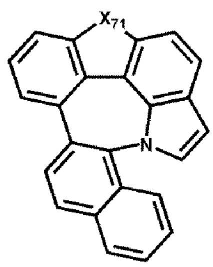
3(89)

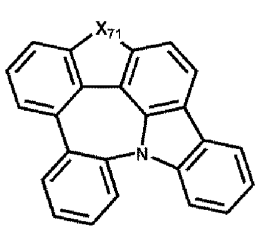
3(90)

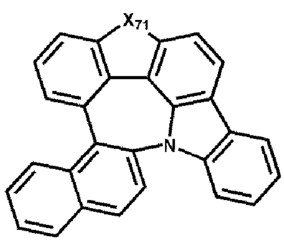
3(91)

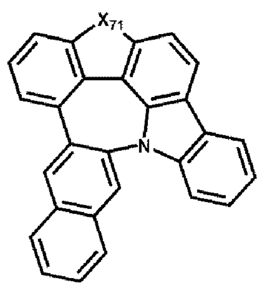
3(92)

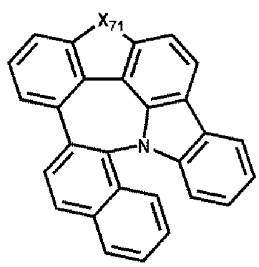
3(93)

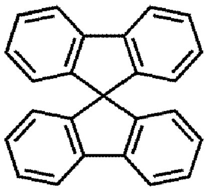
3(94)

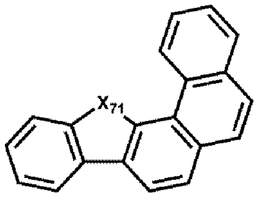
3(95)

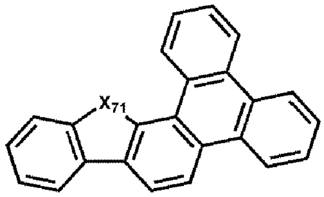
3(96)

wherein, in Formulae 3(1) to 3(96),
$X_{71}$ is the same as defined in claim 1,
$X_{72}$ is O, S, $N(R_{78a})$, $C(R_{78a})(R_{78b})$, or $Si(R_{78a})(R_{78b})$,
$X_{73}$ is O, S, $N(R_{79a})$, $C(R_{79a})(R_{79b})$, or $Si(R_{79a})(R_{79b})$, and
$R_{78a}$, $R_{78b}$, $R_{79a}$, and $R_{79b}$ are each the same as defined in connection with $R_{71}$ in claim 1.

**10.** The composition of any one of claims 7-9, wherein

in Formula 1,
a1 to a4 are each independently an integer from 1 to 20, and
at least one of $R_1$ to $R_4$ is each independently a substituted or unsubstituted $C_1$-$C_{60}$ alkoxy group, a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, or $-B(Q_6)(Q_7)$.

**11.** The composition of any one of claims 7-10, wherein

the Pt-containing organometallic compound is a compound represented by Formula 1-1 or 1-2:

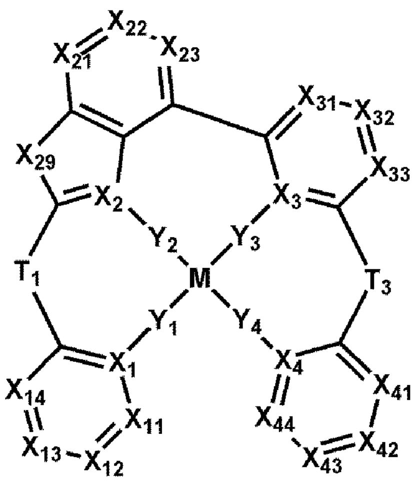
1-1

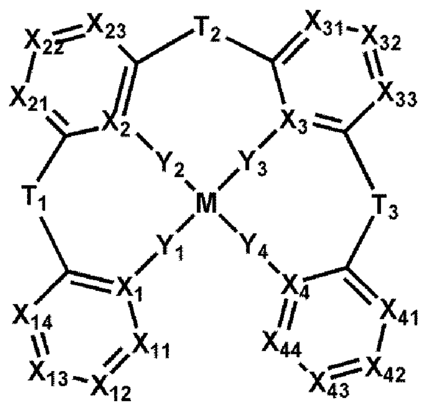
1-2

,

wherein, in Formulae 1-1 and 1-2,
M, $Y_1$ to $Y_4$, $X_1$ to $X_4$, and $T_1$ to $T_3$ are each the same as defined in claim 7,
$X_{11}$ is N or $C-[(L_{11})_{b11}-(R_{11})_{c11}]$, $X_{12}$ is N or $C-[(L_{12})_{b12}-(R_{12})_{c12}]$, $X_{13}$ is N or $C-[(L_{13})_{b13}-(R_{13})_{c13}]$, and $X_{14}$ is N or $C-[(L_{14})_{b14}-(R_{14})_{c14}]$,
$L_{11}$ to $L_{14}$, b11 to b14, $R_{11}$ to $R_{14}$, and c11 to c14 are each the same as defined in connection with $L_1$, b1, $R_1$, and c1 in claim 7, respectively,
$X_{21}$ is N or $C-[(L_{21})_{b21}-(R_{21})_{c21}]$, $X_{22}$ is N or $C-[(L_{22})_{b22}-(R_{22})_{c22}]$, and $X_{23}$ is N or $C-[(L_{23})_{b23}-(R_{23})_{c23}]$,
$L_{21}$ to $L_{23}$, b21 to b23, $R_{21}$ to $R_{23}$, and c21 to c23 are each the same as defined in connection with $L_2$, b2, $R_2$, and c2 in claim 7, respectively,

$X_{29}$ is O, S, $C(R_{27})(R_{28})$, $Si(R_{27})(R_{28})$, or $N-[(L_{29})_{b29}-(R_{29})_{c29}]$,
$R_{27}$ to $R_{29}$ are each the same as defined in connection with $R_2$ in claim 7, and $L_{29}$, b29, and c29 are each the same as defined in connection with $L_2$, b2, and c2 in claim 7, respectively,
$X_{31}$ is N or $C-[(L_{31})_{b31}-(R_{31})_{c31}]$, $X_{32}$ is N or $C-[(L_{32})_{b32}-(R_{32})_{c32}]$, and $X_{33}$ is N or $C-[(L_{33})_{b33}-(R_{33})_{c33}]$,
$L_{31}$ to $L_{33}$, b31 to b33, $R_{31}$ to $R_{33}$, and c31 to c33 are each the same as defined in connection with $L_3$, b3, $R_3$, and c3 in claim 7, respectively,
$X_{41}$ is N or $C-[(L_{41})_{b41}-(R_{41})_{c41}]$, $X_{42}$ is N or $C-[(L_{42})_{b42}-(R_{42})_{c42}]$, $X_{43}$ is N or $C-[(L_{43})_{b43}-(R_{43})_{c43}]$, and $X_{44}$ is N or $C-[(L_{44})_{b44}-(R_{44})_{c44}]$,
$L_{41}$ to $L_{44}$, b41 to b44, $R_{41}$ to $R_{44}$, and c41 to c44 are each the same as defined in connection with $L_4$, b4, $R_4$, and c4 in claim 7, respectively,
two of $R_{11}$ to $R_{14}$ are optionally linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two of $R_{21}$ to $R_{23}$ are optionally linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two of $R_{31}$ to $R_{33}$ are optionally linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$, and
two of $R_{41}$ to $R_{44}$ are optionally linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

**12.** The composition of any one of claims 1-11, wherein

the composition satisfies Equation 1 and Equation 2 below:

Equation 1

$$\text{HOMO (H2)} > \text{HOMO (D)}$$

Equation 2

$$\text{HOMO (H3)} > \text{HOMO (D)},$$

wherein, in Equations 1 and 2,
HOMO (H2) is an absolute value of a HOMO energy level of the second compound,
HOMO (H3) is an absolute value of a HOMO energy level of the third compound,
HOMO (D) is an absolute value of a HOMO energy level of the Pt-containing organometallic compound, and the HOMO energy level of the Pt-containing organometallic compound is measured using a photoelectron spectrometer in air;
preferably wherein
the difference between the absolute value of the HOMO energy level of the second compound and the absolute value of the HOMO energy level of the Pt-containing organometallic compound is 0.05 eV to 0.6 eV, and
the difference between the absolute value of the HOMO energy level of the third compound and the absolute value of the HOMO energy level of the Pt-containing organometallic compound is 0.05 eV to 0.6 eV.

**13.** An organic light-emitting device comprising:

a first electrode;
a second electrode; and
an organic layer disposed between the first electrode and the second electrode and including an emission layer, wherein the organic layer includes the composition of any one of claims 1-12;
preferably wherein
the emission layer includes the composition.

**14.** The organic light-emitting device of claim 13, wherein

the emission layer includes a dopant and a host,
the dopant includes the platinum-containing organometallic compound of the composition, and
the host includes the first compound of the composition, the second compound of the composition, and the third compound of the composition; and/or
wherein
the emission layer emits green light.

## Patentansprüche

**1.** Zusammensetzung, umfassend eine platinhaltige metallorganische Verbindung, eine erste Verbindung, eine zweite Verbindung und eine dritte Verbindung,

wobei die Zusammensetzung kein Iridium umfasst,
die Pt-haltige metallorganische Verbindung, die erste Verbindung, die zweite Verbindung und die dritte Verbindung sich voneinander unterscheiden,
die erste Verbindung mindestens eine Elektronentransporteinheit umfasst;
die zweite Verbindung und die dritte Verbindung kein Metall einschließen und die zweite Verbindung und die dritte Verbindung jeweils unabhängig voneinander durch eine der Formeln 3-1 bis 3-4 dargestellt werden,
sowohl der absolute Wert des HOMO-Energieniveaus der zweiten Verbindung als auch der absolute Wert des HOMO-Energieniveaus der dritten Verbindung jeweils 5,30 eV bis 5,85 eV beträgt,
die Differenz zwischen dem absoluten Wert des HOMO-Energieniveaus der zweiten Verbindung und dem absoluten Wert des HOMO-Energieniveaus der dritten Verbindung 0,01 eV bis 0,30 eV beträgt, und
sowohl das HOMO-Energieniveau der zweiten Verbindung als auch das HOMO-Energieniveau der dritten Verbindung jeweils unter Verwendung eines Photoelektronenspektrometers in Luft gemessen werden:

Formel 3-1

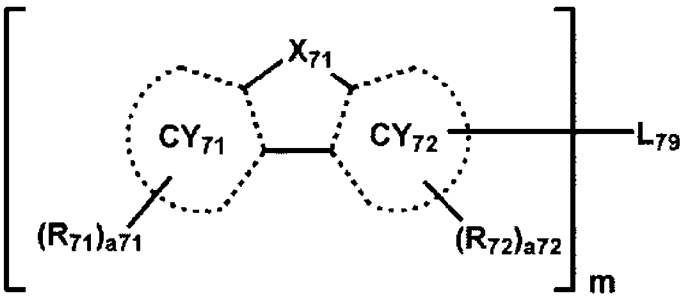

Formel 3-2

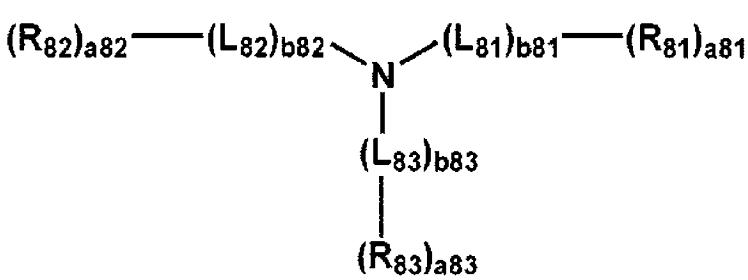

Formel 3-3

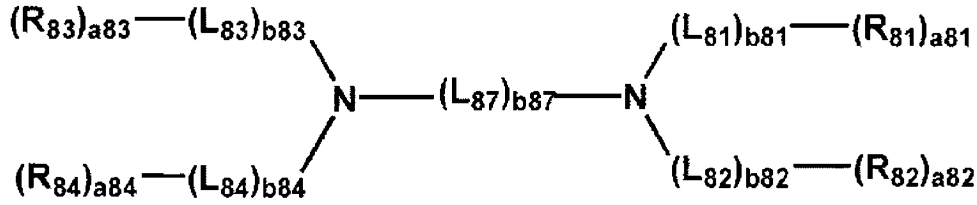

Formel 3-4

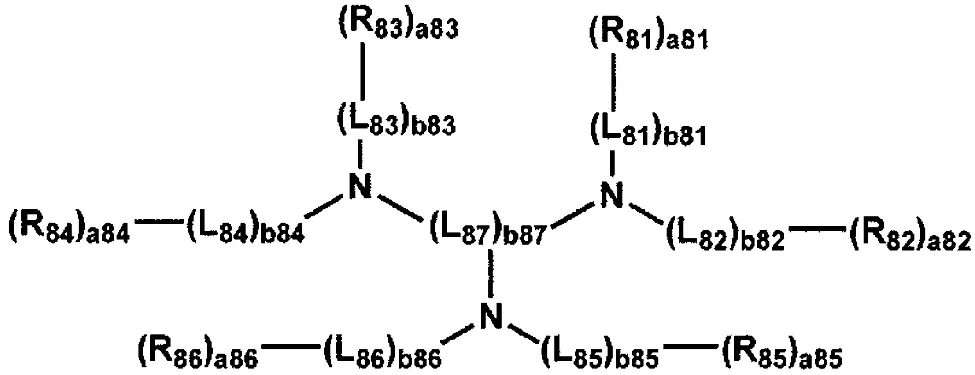

wobei

Ringe $CY_{71}$ und Ring $CY_{72}$ in Formel 3-1 jeweils unabhängig voneinander eine π-elektronenreiche $C_3$-$C_{30}$ cyclische Gruppe sind, und Ring $CY_{71}$ und Ring $CY_{72}$ in Formel 3-1 optional über eine π-elektronenreiche $C_3$-$C_{30}$ cyclische Gruppe miteinander verbunden sind,

$X_{71}$ in Formel 3-1 O, S, N-$(L_{75})_{b75}$-$(P_{76})_{a75}$, $C(R_{75})(R_{76})$ oder $Si(R_{75})(R_{76})$ ist,

m in Formel 3-1 1, 2 oder 3 ist, wobei $L_{79}$ fehlt, wenn m gleich 1 ist.

i) $L_{75}$, $L_{79}$ und $L_{81}$ bis $L_{87}$ in den Formeln 3-1 bis 3-4 jeweils unabhängig voneinander eine π-elektronenreiche $C_3$-$C_{30}$ cyclische Gruppe, unsubstituiert oder mit Deuterium substituiert, eine $C_1$-$C_{20}$-Alkylgruppe, eine $C_1$-$C_{20}$-Alkoxygruppe, eine Phenylgruppe, eine Naphthylgruppe, eine Anthracengruppe, eine Phenanthrengruppe, eine Triphenylengruppe, eine Fluorengruppe, eine Di($C_1$-$C_{10}$-Alkyl)fluorenylgruppe, eine Di($C_6$-$C_{60}$-Aryl)fluorenylgruppe, eine Dibenzosilolylgruppe, eine Di($C_1$-$C_{10}$-Alkyl)dibenzosilolylgruppe, eine Di($C_6$-$C_{60}$-Aryl) dibenzosilolylgruppe, eine Carbazolylgruppe, eine ($C_1$-$C_{10}$-Alkyl)carbazolylgruppe, eine ($C_6$-$C_{60}$-Aryl)carbazolylgruppe, eine Dibenzofuranylgruppe, eine Dibenzothiophenylgruppe, eine Biphenylgruppe, eine Terphenylgruppe, eine Tetraphenylgruppe, $-N(Q_{31})(Q_{32})$ oder eine beliebige Kombination davon sind, oder ii) $L_{79}$ in Formel 3-1 eine Einfachbindung ist,

$b_{75}$ und $b_{81}$ bis $b_{87}$ in den Formeln 3-1 bis 3-4 jeweils unabhängig voneinander ganze Zahlen von 1 bis 10 sind,

$R_{71}$, $R_{72}$, $R_{75}$, $R_{76}$ und $R_{81}$ bis $R_{86}$ in den Formeln 3-1 bis 3-4 jeweils unabhängig voneinander Folgendes sind:

Wasserstoff oder Deuterium;

eine $C_1$-$C_{20}$-Alkylgruppe, unsubstituiert oder mit Deuterium substituiert, eine Phenylgruppe, eine Naphthylgruppe, eine Anthracenylgruppe, eine Phenanthrenylgruppe, eine Triphenylenylgruppe, eine Fluorenylgruppe, eine Di($C_1$-$C_{10}$-Alkyl)fluorenylgruppe, eine Di($C_6$-$C_{10}$-Aryl)fluorenylgruppe, eine Dibenzosilolylgruppe, eine Di($C_1$-$C_{10}$-Alkyl)dibenzosilolylgruppe, eine Di($C_6$-$C_{60}$-Aryl)dibenzosilolylgruppe, eine Carbazolylgruppe, eine ($C_1$-$C_{10}$-Alkyl)carbazolylgruppe, eine ($C_6$-$C_{60}$-Aryl)carbazolylgruppe, eine Dibenzofuranylgruppe, eine Dibenzothiophenylgruppe, eine Biphenylgruppe, eine Terphenylgruppe, eine Tetraphenylgruppe, $-N(Q_{31})(Q_{32})$ oder eine beliebige andere Kombination davon;

eine π-elektronenreiche $C_3$-$C_{30}$ cyclische Gruppe, unsubstituiert oder mit Deuterium substituiert, eine $C_1$-$C_{20}$-Alkylgruppe, eine $C_1$-$C_{20}$-Alkoxygruppe, eine Phenylgruppe, eine Naphthylgruppe, eine Anthracenylgruppe, eine Phenanthrenylgruppe, eine Triphenylenylgruppe, eine Fluorenylgruppe, eine Di($C_1$-$C_{10}$-Akyl)fluorenylgruppe, eine Di($C_6$-$C_{60}$-Aryl)fluorenylgruppe, eine Dibenzosilolylgruppe, eine Di($C_1$-$C_{10}$-Alkyl)dibenzosilolylgruppe, eine Di($C_6$-$C_{60}$)-Aryl)dibenzosilolylgruppe, eine Carbazolylgruppe, eine ($C_1$-$C_{10}$-Alkyl)carbazolylgruppe, eine ($C_6$-$C_{60}$-Aryl)carbazolylgruppe, eine Dibenzofuranylgruppe, eine Dibenzothiophenylgruppe, eine Biphenylgruppe, eine Terphenylgruppe, eine Tetraphenylgruppe, $-N(Q_{31})(Q_{32})$ oder eine beliebige Kombination davon; oder $-N(Q_1)(Q_2)$,

a71, a72, a75 und a81 bis a86 in den Formeln 3-1 bis 3-4 jeweils unabhängig voneinander ganze Zahlen von 0 bis

20 sind,
wobei $Q_1$, $Q_2$, $Q_{31}$ und $Q_{32}$ jeweils unabhängig voneinander Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe, unsubstituiert oder mit Deuterium substituiert, eine $C_1$-$C_{60}$-Alkylgruppe, eine $C_6$-$C_{60}$-Arylgruppe oder eine beliebige Kombination davon; eine $C_2$-$C_{60}$-Alkenylgruppe; eine $C_2$-$C_{60}$-Alkinylgruppe; eine $C_1$-$C_{60}$-Alkoxygruppe; eine $C_3$-$C_{10}$-Cycloalkylgruppe; eine $C_2$-$C_{10}$-Heterocycloalkylgruppe; eine $C_3$-$C_{10}$-Cycloalkenylgruppe; eine $C_2$-$C_{10}$-Heterocycloalkenylgruppe; eine $C_6$-$C_{60}$-Arylgruppe, unsubstituiert oder mit Deuterium substituiert, eine $C_1$-$C_{60}$-Alkylgruppe, eine $C_6$-$C_{60}$-Arylgruppe oder eine beliebige Kombination davon; eine $C_6$-$C_{60}$-Aryloxygruppe; eine $C_6$-$C_{60}$-Arylthiogruppe; eine $C_1$-$C_{60}$-Heteroarylgruppe; eine monovalente nichtaromatische kondensierte polycyclische Gruppe; oder eine monovalente nichtaromatische kondensierte heteropolycyclische Gruppe sind.

**2.** Zusammensetzung nach Anspruch 1, wobei

die Pt-haltige metallorganische Verbindung Pt und einen vierzähnigen organischen Liganden umfasst, wobei das Pt und der vierzähnige organische Ligand 3 oder 4 cyclometallierte Ringe bilden;
wobei bevorzugt
der vierzähnige organische Ligand eine Benzimidazolgruppe und eine Pyridingruppe umfasst.

**3.** Zusammensetzung nach Anspruch 1 oder 2, wobei

der absolute Wert des HOMO-Energieniveaus der Pt-haltigen metallorganischen Verbindung 5,25 eV bis 5,55 eV beträgt, und
das HOMO-Energieniveau der Pt-haltigen metallorganischen Verbindung unter Verwendung eines Photoelektronenspektrometers in Luft gemessen wird.

**4.** Zusammensetzung eines der Ansprüche 1-3, wobei

die Elektronentransporteinheit eine Cyanogruppe, eine Fluorgruppe, eine $\pi$-elektronenarme stickstoffhaltige cyclische Gruppe, eine Gruppe, die durch eine der folgenden Formeln dargestellt wird, oder eine beliebige Kombination davon ist:

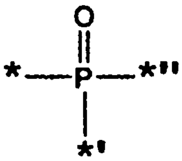 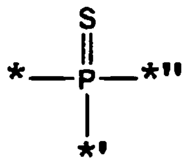 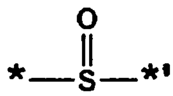 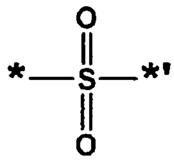 ,

wobei in den obigen Formeln *, *', und *" jeweils eine Bindungsstelle zu einem benachbarten Atom anzeigen.

**5.** Zusammensetzung eines der Ansprüche 1-4, wobei
mindestens eine der zweiten Verbindung und der dritten Verbindung keine Elektronentransporteinheit einschließt.

**6.** Zusammensetzung eines der Ansprüche 1-5, wobei
mindestens eine der zweiten Verbindung und der dritten Verbindung unabhängig voneinander Folgendes umfasst:

i) einen kondensierten Ring, in dem ein oder mehrere fünfte Ringe und ein oder mehrere sechste Ringe miteinander kondensiert sind,
ii) eine durch

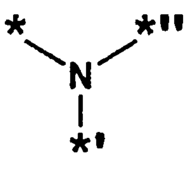

dargestellte Gruppe oder
iii) jede Kombination davon,
der fünfte Ring eine Cyclopentadiengruppe ist, eine Pyrrolgruppe, eine Furangruppe, eine Thiophengruppe oder eine Silolgruppe,
der sechste Ring eine $\pi$-elektronenreiche $C_3$-$C_{30}$ cyclische Gruppe ist, und
* und *' jeweils eine Bindungsstelle zu einem benachbarten Atom anzeigen.

**7.** Zusammensetzung eines der Ansprüche 1-6, wobei

die Pt-haltige metallorganische Verbindung eine metallorganische Verbindung ist, die durch die Formel 1 dargestellt wird,
die erste Verbindung eine Verbindung ist, die durch die Formel 2 dargestellt wird:

Formel 1

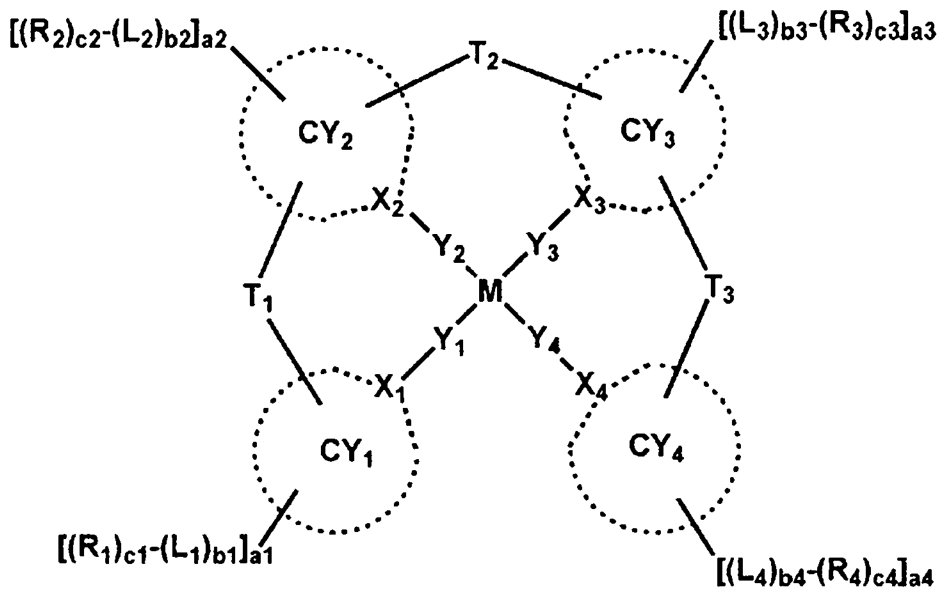

Formel 2

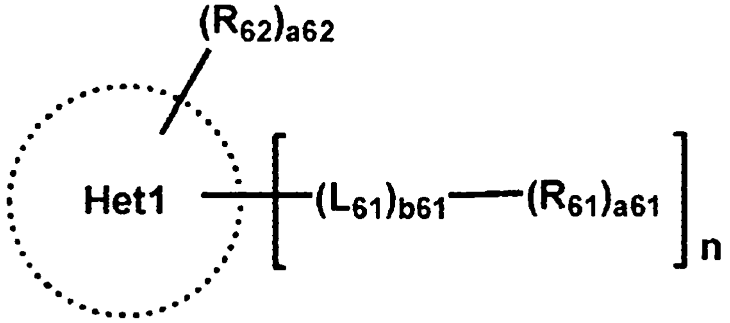

,

wobei
M in Formel 1 Pt ist,
$Y_1$ bis $Y_4$ in Formel 1 jeweils unabhängig voneinander eine chemische Bindung, O, S, $N(R_a)$, $C(R_a)(R_b)$ oder $Si(R_a)(R_b)$ sind,
$X_1$ bis $X_4$ in Formel 1 jeweils unabhängig voneiander C oder N sind,
Ring $CY_1$ bis Ring $CY_4$ in Formel 1 jeweils unabhängig voneinander eine $C_5$-$C_{30}$ carbocyclische Gruppe oder eine $C_1$-$C_{30}$ heterocyclische Gruppe sind,
$T_1$ in Formel 1 eine Einfachbindung, eine Doppelbindung, *-$N(R_{51})$-*', *-$B(R_{51})$-*', *-$P(R_{51})$-*', *-$C(R_{51})(R_{52})$-*',

$*-Si(R_{51})(R_{52})-*'$, $*-Ge(R_{51})(R_{52})-*'$, *-S-*', *-Se-*', *-O-*', *-C(=O)-*', *-S(=O)-*', $*-S(=O)_2-*'$, $*-C(R_{51})=*'$, $*=C(R_{51})-*'$, $*-C(R_{51})=C(R_{52})-*'$, *-C(=S)-*' oder *-C≡C-*' ist,

$T_2$ in Formel 1 eine Einfachbindung, eine Doppelbindung. $*-N(R_{53})-*'$, $*-B(R_{53})-*'$, $*-P(R_{53})-*'$, $*-C(R_{53})(R_{54})-*'$, $*-Si(R_{53})(R_{54})-*'$, $*-Ge(R_{53})(R_{54})-*'$, *-S-*', *-Se-*', *-O-*', *-C(=O)-*', *-S(=O)-*', $*-S(=O)_2-*'$, $*-C(R_{53})=*'$, $*=C(R_{53})-*'$, $*-C(R_{53})=C(R_{54})-*'$, *-C(=S)-*', oder *-C≡C-*' ist,

$T_3$ in Formel 1 eine Einfachbindung, eine Doppelbindung, $*-N(R_{55})-*'$, $*-B(R_{55})-*'$, $*-P(R_{55})-*'$, $*-C(R_{55})(R_{56})-*'$, $*-Si(R_{55})(R_{56})-*'$, $*-Ge(R_{55})(R_{56})-*'$, *-S-*', *-Se-*', *-O-*', *-C(=O)-*', *-S(=O)-*', $*-S(=O)_2-*'$, $*-C(R_{55})=*'$, $*=C(R_{55})-*'$, $*-C(R_{55})=C(R_{56})-*'$, *-C(=S)-*' oder *-C≡C-*' ist,

Het1 in Formel 2 eine $\pi$-elektronenarme, stickstoffhaltige $C_1$-$C_{30}$ cyclische Gruppe ist,

n in Formel 2 eine ganze Zahl von 1 bis 10 ist,

$L_1$ bis $L_4$ und $L_{61}$ in den Formeln 1 und 2 jeweils unabhängig voneinander eine Einfachbindung, eine $C_5$-$C_{30}$ carbocyclische Gruppe, unsubstituiert oder mit mindestens einem $P_{10a}$ substituiert, oder eine $C_1$-$C_{30}$ heterocyclische Gruppe, unsubstituiert oder mit mindestens einem $R_{10a}$ substituiert, sind,

$b_1$ bis $b_4$ und $b_{61}$ in den Formeln 1 und 2 jeweils unabhängig voneinander ganze Zahlen von 1 bis 10 sind,

$R_a$, $R_b$, $R_1$ bis $R_4$, $R_{51}$ bis $R_{56}$, $R_{61}$ und $R_{62}$ in den Formeln 1 und 2 jeweils unabhängig voneinander Wasserstoff, Deuterium, -F, -Cl, -Br, -I, $-SF_5$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_2$-$C_{10}$-Heterocycloalkylgruppe, eine substituierte oder unsubstituierte $C_3$-$C_{10}$-Cycloalkenylgruppe, eine substituierte oder unsubstituierte $C_2$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, $-N(Q_1)(Q_2)$, $-Si(Q_3)(Q_4)(Q_5)$, $-B(Q_6)(Q_7)$ oder $-P(=O)(Q_8)(Q_9)$ sind,

c1 bis c4 in Formel 1 jeweils unabhängig voneinander ganze Zahlen von 1 bis 10 sind,

a1 bis a4, a61 und a62 in den Formeln 1 und 2 jeweils unabhängig voneinander ganze Zahlen von 0 bis 20 sind,

zwei oder mehr von $R_a$, $R_b$, $R_1$ bis $R_4$, und $R_{51}$ bis $R_{56}$ in Formel 1 optional miteinander verbunden sind, um eine $C_5$-$C_{30}$ carbocyclische Gruppe, die unsubstituiert oder mit mindestens einem $R_{10a}$ substituiert ist, oder eine $C_1$-$C_{30}$ heterocyclische Gruppe, die unsubstituiert oder mit mindestens einem $R_{10a}$ substituiert ist, zu bilden,

$R_{10a}$ dasselbe ist, wie im Zusammenhang mit $R_1$ definiert,

* und *' jeweils eine Bindungsstelle zu einem benachbarten Atom anzeigen,

ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkylgruppe, der substituierten $C_2$-$C_{10}$-Heterocycloalkylgruppe, der substituierten $C_3$-$C_{10}$-Cycloalkenylgruppe, der substituierten $C_2$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht-aromatischen kondensierten polycyclischen Gruppe und der substituierten monovalenten nicht-aromatischen kondensierten heteropolycyclischen Gruppe Folgendes ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe;

eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe, jeweils substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_3$-$C_{10}$-Cycloalkylgruppe, eine $C_2$-$C_{10}$-Heterocycloalkylgruppe, eine $C_3$-$C_{10}$-Cycloalkenylgruppe, eine $C_2$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine einwertige nicht-aromatische kondensierte polycyclische Gruppe, eine einwertige nicht-aromatische kondensierte heteropolycyclische Gruppe, $-N(Q_{11})(Q_{12})$, $-Si(Q_{13})(Q_{14})(Q_{15})$, $-Br(Q_{16})(Q_{17})$, $-P(=O)(Q_{18})(Q_{19})$ oder eine beliebige Kombination davon;

eine $C_3$-$C_{10}$-Cycloalkylgruppe, eine $C_2$-$C_{10}$-Heterocycloalkylgruppe, eine $C_3$-$C_{10}$-Cycloalkenylgruppe, eine $C_2$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine einwertige nicht-aromatische kondensierte polycyclische Gruppe oder eine einwertige nicht-aromatische kondensierte heteropolycyclische Gruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_3$-$C_{10}$-Cycloalkylgruppe, eine $C_2$-$C_{10}$-Heterocycloalkylgruppe, eine $C_3$-$C_{10}$-Cycloalkenylgruppe, eine $C_2$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine einwertige nicht-aromatische kondensierte polycyclische Gruppe, eine einwertige nicht-aromatische kondensierte heteropolycyclische Gruppe, $-N(Q_{21})(Q_{22})$, $-Si(Q_{23})(Q_{24})(Q_{25})$, - $Ge(Q_{26})(Q_{27})$, $-P(=O)(Q_{28})$, $(Q_{29})$ oder eine beliebige Kombination davon;

$-N(Q_{31})(Q_{32})$, $-Si(Q_{33})(Q_{34})(Q_{35})$, $-B(Q_{36})(Q_{37})$ oder $-P(=O)(Q_{38})(Q_{39})$; oder

jede beliebige Kombination davon, und

$Q_1$ bis $Q_9$, $Q_{11}$ bis $Q_{19}$, $Q_{21}$ bis $Q_{29}$ und $Q_{31}$ bis $Q_{39}$ jeweils unabhängig voneinander Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine unsubstituierte oder mit Deuterium substituierte $C_1$-$C_{60}$-Alkylgruppe, eine $C_1$-$C_{60}$-Alkylgruppe, eine $C_6$-$C_{60}$-Arylgruppe oder eine beliebige Kombination davon; eine $C_2$-$C_{60}$-Alkenylgruppe; eine $C_2$-$C_{60}$-Alkinylgruppe; eine $C_1$-$C_{60}$-Alkoxygruppe; eine $C_3$-$C_{10}$-Cycloalkylgruppe; eine $C_2$-$C_{10}$-Heterocycloalkylgruppe; eine $C_3$-$C_{10}$-Cycloalkenylgruppe; eine $C_2$-$C_{10}$-Heterocycloalkenylgruppe; eine unsubstituierte oder mit Deuterium substituierte $C_6$-$C_{60}$-Arylgruppe, eine $C_1$-$C_{60}$-Alkylgruppe, eine $C_6$-$C_{60}$-Arylgruppe oder eine beliebige Kombination davon; eine $C_6$-$C_{60}$-Aryloxygruppe; eine $C_6$-$C_{60}$-Arylthiogruppe; eine $C_1$-$C_{60}$-Heteroarylgruppe; eine monovalente nicht-aromatische kondensierte polycyclische Gruppe; oder eine monovalente nicht-aromatische kondensierte heteropolycyclische Gruppe sind.

**8.** Zusammensetzung nach Anspruch 7, wobei

in Formel 1 $Y_1$ O oder S ist, $Y_2$ bis $Y_4$ jeweils eine chemische Bindung sind, $X_1$ und $X_3$ jeweils C sind, und $X_2$ und $X_4$ jeweils N sind; und/oder

wobei

die Het1-Gruppe in der Formel 2 durch eine der Formeln 2-1 bis 2-42 dargestellt wird:

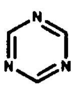
2-1

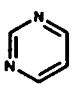
2-2

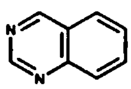
2-3

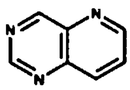
2-4

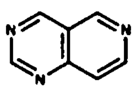
2-5

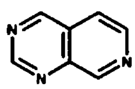
2-6

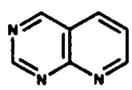
2-7

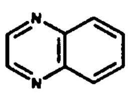
2-8

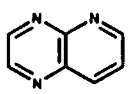
2-9

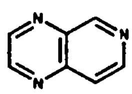
2-10

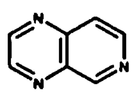
2-11

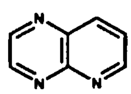
2-12

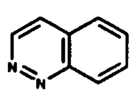
2-13

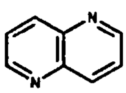
2-14

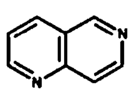
2-15

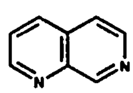
2-16

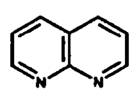
2-17

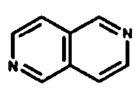
2-18

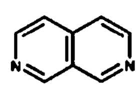
2-19

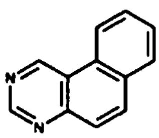
2-20

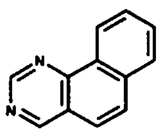
2-21

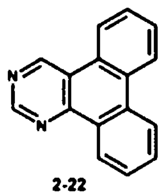
2-22

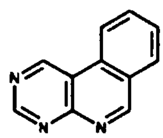
2-23

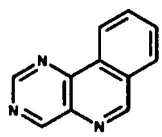
2-24

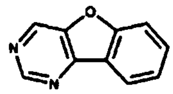
2-25

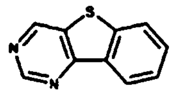
2-26

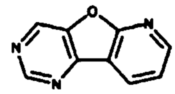
2-27

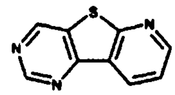
2-28

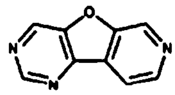
2-29

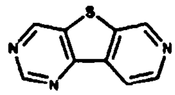
2-30

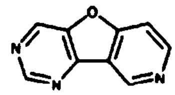
2-31

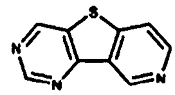
2-32

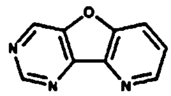
2-33

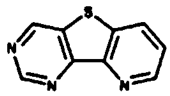
2-34

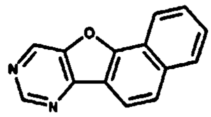
2-35

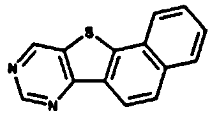
2-36

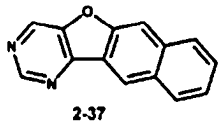
2-37

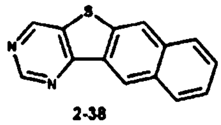
2-38

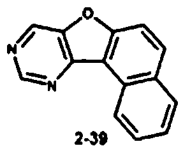
2-39

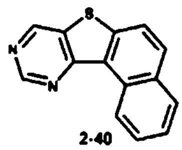
2-40

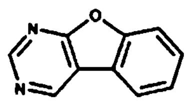
2-41

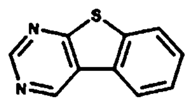
2-42

.

**9.** Zusammensetzung nach einem der Ansprüche 1-8, wobei

eine in Formel 3-1 durch

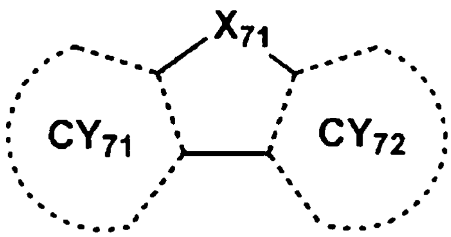

dargestellte Gruppe eine Gruppe ist, die durch eine der Formeln 3(1) bis 3(96) dargestellt wird:

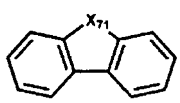
3(1)

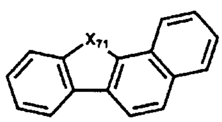
3(2)

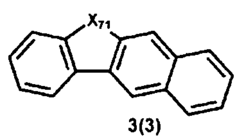
3(3)

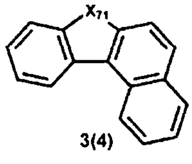
3(4)

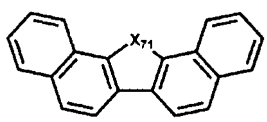
3(5)

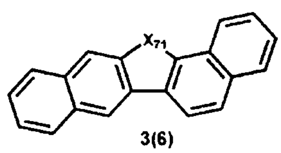
3(6)

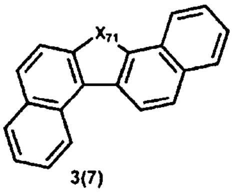
3(7)

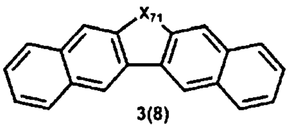
3(8)

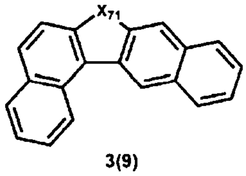
3(9)

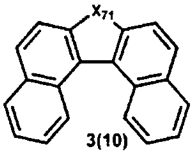
3(10)

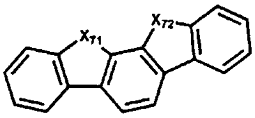
3(11)

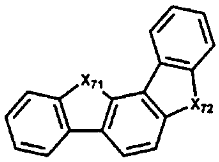
3(12)

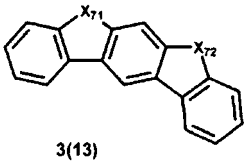
3(13)

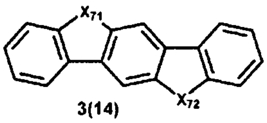
3(14)

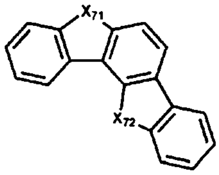
3(15)

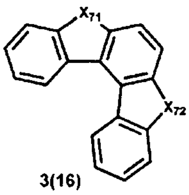
3(16)

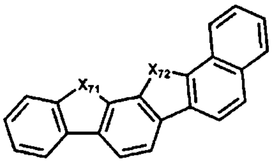
3(17)

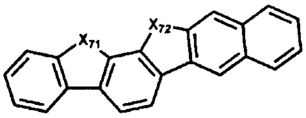
3(18)

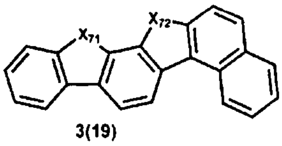
3(19)

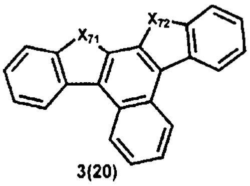
3(20)

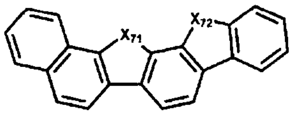
3(21)

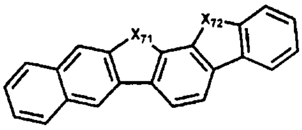
3(22)

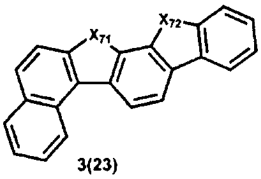
3(23)

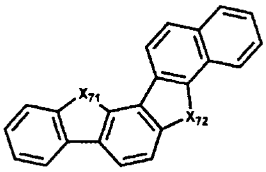
3(24)

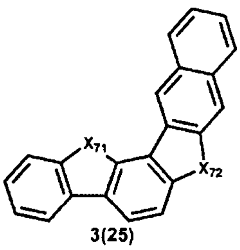
3(25)

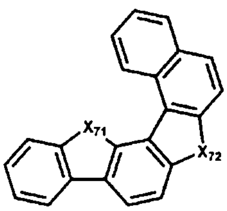
3(26)

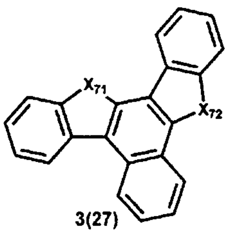
3(27)

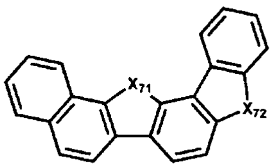
3(28)

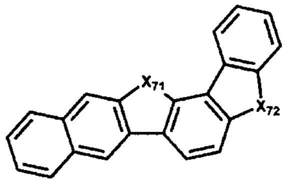
3(29)

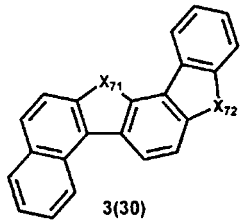
3(30)

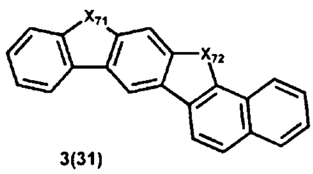
3(31)

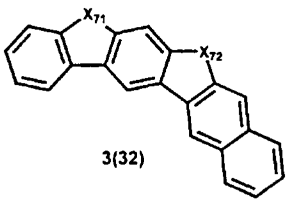
3(32)

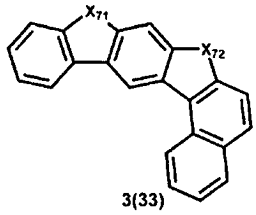
3(33)

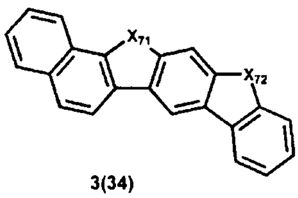
3(34)

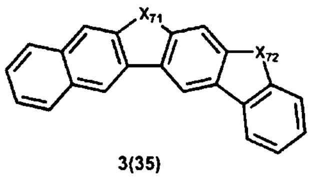
3(35)

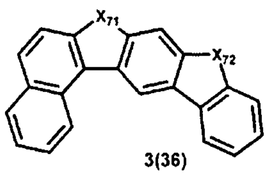
3(36)

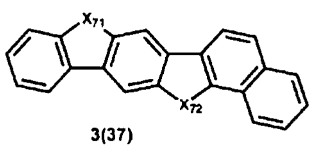
3(37)

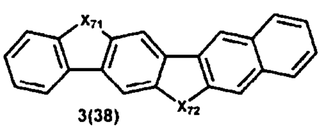
3(38)

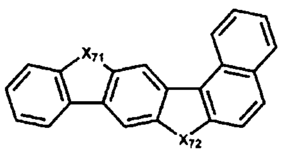
3(39)

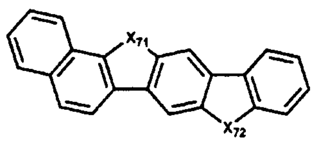
3(40)

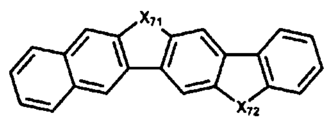
3(41)

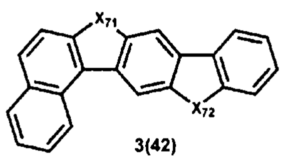
3(42)

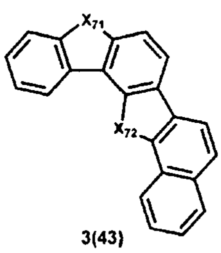
3(43)

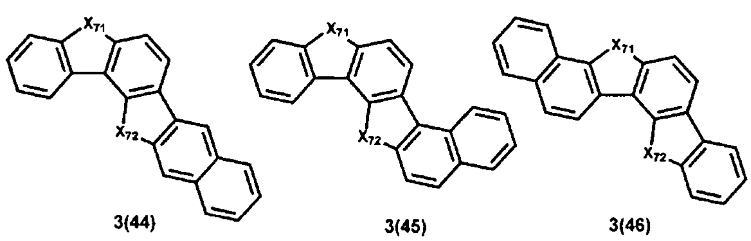
3(44)

3(45)

3(46)

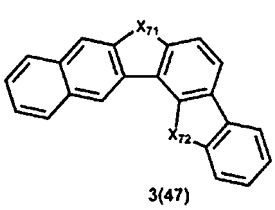
3(47)

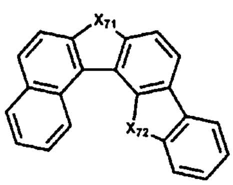
3(48)

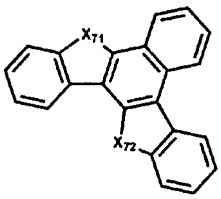
3(49)

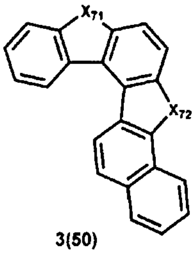
3(50)

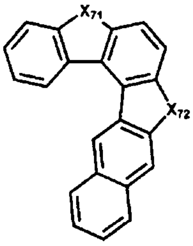
3(51)

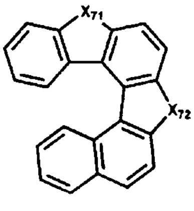
3(52)

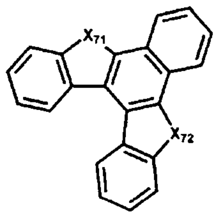
3(53)

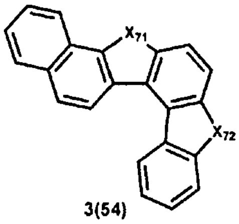
3(54)

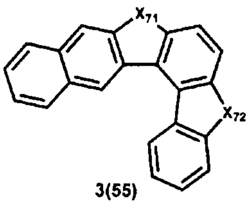
3(55)

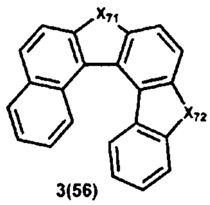
3(56)

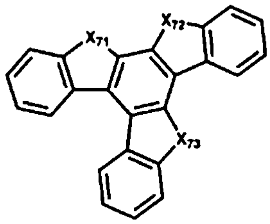
3(57)

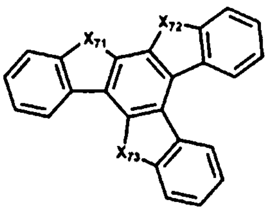
3(58)

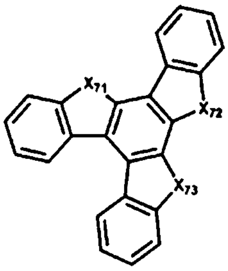
3(59)

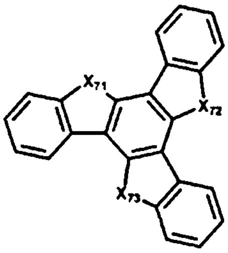
3(60)

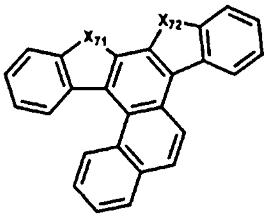
3(61)

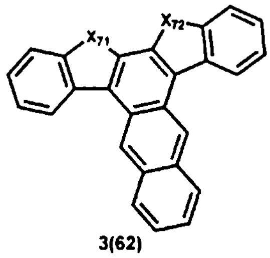
3(62)

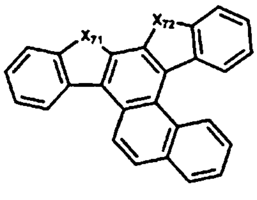
3(63)

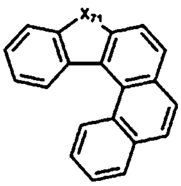
3(64)

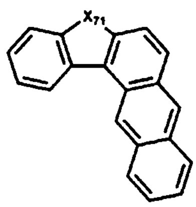
3(65)

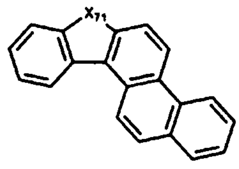
3(66)

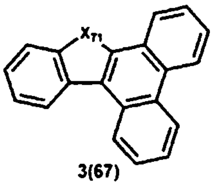
3(67)

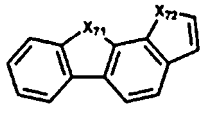
3(68)

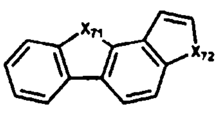
3(69)

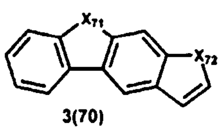
3(70)

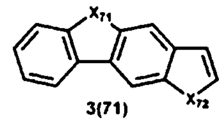
3(71)

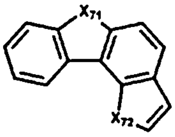
3(72)

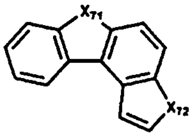
3(73)

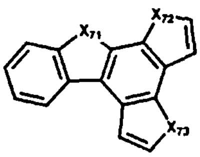
3(74)

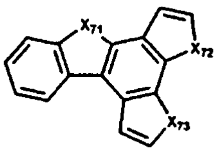
3(75)

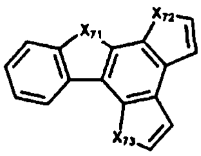
3(76)

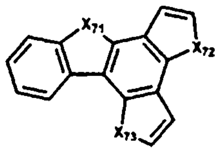
3(77)

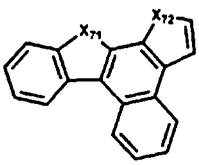
3(78)

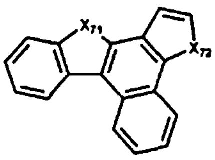
3(79)

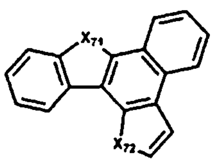
3(80)

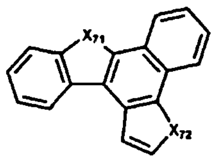
3(81)

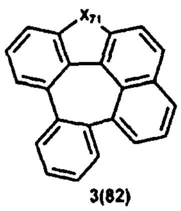
3(82)

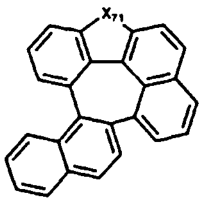
3(83)

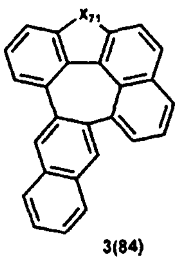
3(84)

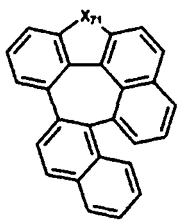
3(85)

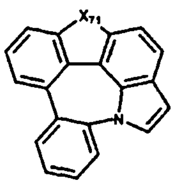
3(86)

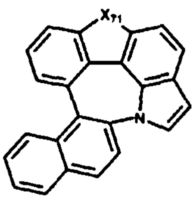
3(87)

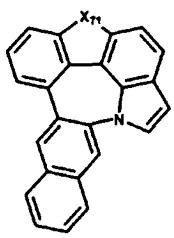
3(88)

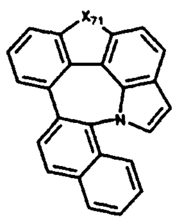
3(89)

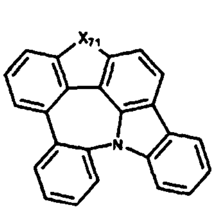
3(90)

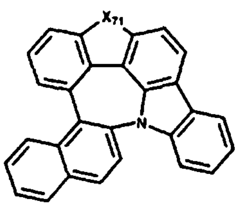
3(91)

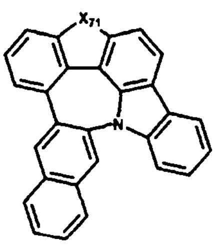
3(92)

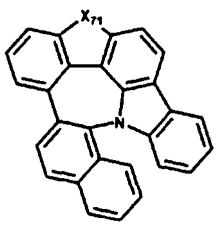
3(93)

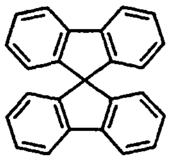

3(94)

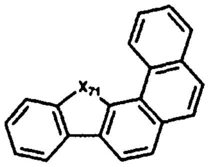

3(95)

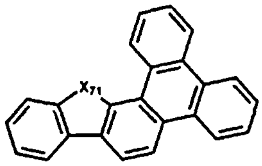

3(96)

',

wobei in den Formeln 3(1) bis 3(96),
$X_{71}$ dasselbe ist, wie in Anspruch 1 definiert,
$X_{72}$ O, S, $N(R_{78a})$, $C(R_{78a})(R_{78b})$ oder $Si(R_{78a})(R_{78b})$ ist,
$X_{73}$ O, S, $N(R_{79a})$, $C(R_{79a})(R_{79b})$ oder $Si(R_{79a})(R_{79b})$ ist, und
$R_{78a}$, $R_{78b}$, $R_{79a}$ und $R_{79b}$ dieselben sind, wie im Zusammenhang mit $R_{71}$ in Anspruch 1 definiert.

**10.** Zusammensetzung eines der Ansprüche 7-9, wobei

in der Formel 1,
a1 bis a4 jeweils unabhängig voneinander ganze Zahlen von 1 bis 20 sind, und
mindestens eines von $R_1$ bis $R_4$ jeweils unabhängig eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_2$-$C_{10}$-Heterocycloalkylgruppe, eine substituierte oder unsubstituierte $C_3$-$C_{10}$-Cycloalkenylgruppe, eine substituierte oder unsubstituierte $C_2$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, $-N(Q_1)(Q_2)$, $-Si(Q_3)(Q_4)(Q_5)$ oder $-B(Q_6)(Q_7)$ ist.

**11.** Zusammensetzung eines der Ansprüche 7-10, wobei

die Pt-haltige metallorganische Verbindung eine Verbindung ist, die durch die Formel 1-1 oder 1-2 dargestellt wird:

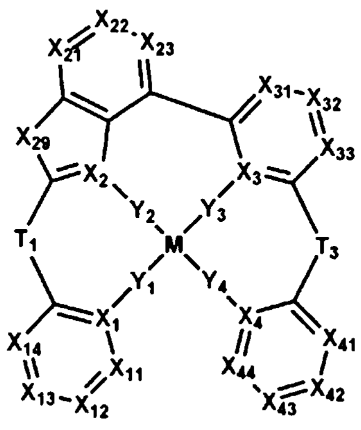

1-1

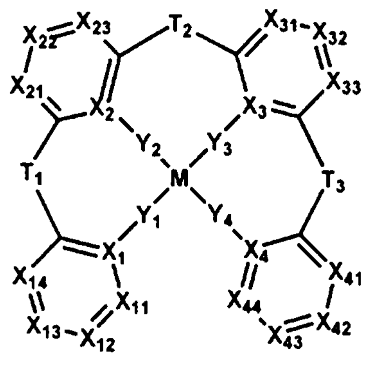

1-2

,

wobei in den Formeln 1-1 und 1-2
M, $Y_1$ bis $Y_4$, $X_1$ bis $X_4$, und $T_1$ bis $T_3$ jeweils dieselben sind, wie in Anspruch 7 definiert,
$X_{11}$ N oder $C-[(L_{11})_{b11}-(R_{11})_{c11}]$ ist, $X_{12}$ N oder $C-[(L_{12})_{b12}-(R_{12})_{c12}]$ ist, $X_{13}$ N oder $C-[(L_{13})_{b13}-(R_{13})_{c13}]$ ist, und $X_{14}$ N oder $C-[(L_{14})_{b14}-(R_{14})_{c14}]$ ist,
$L_{11}$ bis $L_{14}$, $b_{11}$ bis $b_{14}$, $R_{11}$ bis $R_{14}$, und c11 bis c14 jeweils dieselben sind, wie in Anspruch 7 im Zusammenhang mit $L_1$, $b_1$, $R_1$ und c1 definiert,
$X_{21}$ N oder $C-[(L_{21})_{b21}-(R_{21})_{c21}]$ ist, $X_{22}$ N oder $C-[(L_{22})_{b22}-(R_{22})_{c22}]$ ist, und $X_{23}$ N oder $C-[(L_{23})_{b23}-(R_{23})_{c23}]$ ist,
$L_{21}$ bis $L_{23}$, $b_{21}$ bis $b_{23}$, $R_{21}$ bis $R_{23}$, und c21 bis c23 jeweils dieselben sind, wie in Anspruch 7 im Zusammenhang

mit $L_2$, b2, $R_2$ und c2 definiert,
$X_{29}$ O, S, $C(R_{27})(R_{28})$, $Si(R_{27})(R_{28})$ oder $N-[(L_{29})_{b29}-(R_{29})_{c29}]$ ist,
$R_{27}$ bis $R_{29}$ jeweils dieselben sind, wie im Zusammenhang mit $R_2$ in Anspruch 7 definiert, und $L_{29}$, b29 und c29 jeweils dieselben sind, wie im Zusammenhang mit $L_2$, b2 und c2 in Anspruch 7 definiert,
$X_{31}$ N oder $C-[(L_{31})_{b31}-(R_{31})_{c31}]$ ist, $X_{32}$ N oder $C-[(L_{32})_{b32}-(R_{32})_{c32}]$ ist, und $X_{33}$ N oder $C-[(L_{33})_{b33}-(R_{33})_{c33}]$ ist,
$L_{31}$ bis $L_{33}$, b31 bis b33, $R_{31}$ bis $R_{33}$ und c31 bis c33 jeweils dieselben sind, wie in Anspruch 7 im Zusammenhang mit $L_3$, b3, $R_3$ und c3 definiert,
$X_{41}$ N oder $C-[(L_{41})_{b41}-(R_{41})_{c41}]$ ist, $X_{42}$ N oder $C-[(L_{42})_{b42}-(R_{42})_{c42}]$ ist, $X_{43}$ N oder $C-[(L_{43})_{b43}-(R_{43})_{c43}]$ ist, und $X_{44}$ N oder $C-[(L_{44})_{b44}-(R_{44})_{c44}]$ ist,
$L_{41}$ bis $L_{44}$, b41 bis b44, $R_{41}$ bis $R_{44}$ und c41 bis c44 jeweils dieselben sind, wie in Anspruch 7 im Zusammenhang mit $L_4$, b4, $R_4$ und c4 definiert,
zwei von $R_{11}$ bis $R_{14}$ optional miteinander verbunden sind, um eine $C_5$-$C_{30}$ carbocyclische Gruppe, die unsubstituiert oder mit mindestens einem $R_{10a}$ substituiert ist, oder eine $C_1$-$C_{30}$ heterocyclische Gruppe, die unsubstituiert oder mit mindestens einem $R_{10a}$ substituiert ist, zu bilden,
zwei von $R_{21}$ bis $R_{23}$ optional miteinander verbunden sind, um eine $C_5$-$C_{30}$ carbocyclische Gruppe, die unsubstituiert oder mit mindestens einem $R_{10a}$ substituiert ist, oder eine $C_1$-$C_{30}$ heterocyclische Gruppe, die unsubstituiert oder mit mindestens einem $R_{10a}$ substituiert ist, zu bilden,
zwei von $R_{31}$ bis $R_{33}$ optional miteinander verbunden sind, um eine $C_5$-$C_{30}$ carbocyclische Gruppe, die unsubstituiert oder mit mindestens einem $R_{10a}$ substituiert ist, oder eine $C_1$-$C_{30}$ heterocyclische Gruppe, die unsubstituiert oder mit mindestens einem $R_{10a}$ substituiert ist, zu bilden, und
zwei von $R_{41}$ bis $R_{44}$ optional miteinander verbunden sind, um eine $C_5$-$C_{30}$ carbocyclische Gruppe, die unsubstituiert oder mit mindestens einem $R_{10a}$ substituiert ist, oder eine $C_1$-$C_{30}$ heterocyclische Gruppe, die entweder unsubstituiert oder mit mindestens einem $R_{10a}$ substituiert ist, zu bilden.

**12.** Zusammensetzung nach einem der Ansprüche 1-11, wobei die Zusammensetzung die folgenden Gleichungen 1 und 2 erfüllt:

Gleichung 1

$$\text{HOMO (H2)} > \text{HOMO (D)}$$

Gleichung 2

$$\text{HOMO (H3)} > \text{HOMO (D)},$$

wobei in den Gleichungen 1 und 2

HOMO (H2) der absolute Wert des HOMO-Energieniveaus der zweiten Verbindung ist,
HOMO (H3) der absolute Wert des HOMO-Energieniveaus der dritten Verbindung ist,
HOMO (D) der absolute Wert des HOMO-Energieniveaus der Pt-haltigen metallorganischen Verbindung ist, und das HOMO-Energieniveau der Pt-haltigen metallorganischen Verbindung unter Verwendung eines Photoelektronenspektrometers in Luft gemessen wird;
wobei bevorzugt
die Differenz zwischen dem absoluten Wert des HOMO-Energieniveaus der zweiten Verbindung und dem absoluten Wert des HOMO-Energieniveaus der Pt-haltigen metallorganischen Verbindung 0,05 eV bis 0,6 eV beträgt, und
die Differenz zwischen dem absoluten Wert des HOMO-Energieniveaus der dritten Verbindung und dem absoluten Wert des HOMO-Energieniveaus der Pt-haltigen metallorganischen Verbindung 0,05 eV bis 0,6 eV beträgt.

**13.** Organische lichtemittierende Vorrichtung, umfassend:

eine erste Elektrode;
eine zweite Elektrode; und
eine organische Schicht, die zwischen der ersten Elektrode und der zweiten Elektrode angeordnet ist und eine Emissionsschicht einschließt,
wobei die organische Schicht die Zusammensetzung eines der Ansprüche 1-12 einschließt;

wobei bevorzugt
die Emissionsschicht die Zusammensetzung einschließt.

**14.** Organische lichtemittierende Vorrichtung nach Anspruch 13, wobei die Emissionsschicht ein Dotierungsmittel und ein Wirtsmaterial einschließt,

das Dotierungsmittel die platinhaltige metallorganische Verbindung der Zusammensetzung einschließt, und der Wirt die erste Verbindung der Zusammensetzung, die zweite Verbindung der Zusammensetzung und die dritte Verbindung der Zusammensetzung einschließt; und/oder
wobei
die Emissionsschicht grünes Licht emittiert.

## Revendications

**1.** Composition comprenant un composé organométallique contenant du platine, un premier composé, un deuxième composé et un troisième composé,

dans laquelle la composition ne comprend pas d'iridium,
le composé organométallique contenant du Pt, le premier composé, le deuxième composé et le troisième composé sont différents les uns des autres,
le premier composé comprend au moins une fraction de transport d'électrons,
le deuxième composé et le troisième composé n'incluent pas de métal et le deuxième composé et le troisième composé sont chacun représentés indépendamment par l'une des Formules 3-1 à 3-4,
chacune d'une valeur absolue d'un niveau d'énergie HOMO du deuxième composé et d'une valeur absolue d'un niveau d'énergie HOMO du troisième composé est entre 5,30 eV et 5,85 eV,
la différence entre la valeur absolue du niveau d'énergie HOMO du deuxième composé et la valeur absolue du niveau d'énergie HOMO du troisième composé est entre 0,01 eV et 0,30 eV, et
chacun du niveau d'énergie HOMO du deuxième composé et du niveau d'énergie HOMO du troisième composé est mesuré à l'aide d'un spectromètre photoélectronique dans l'air :

Formule 3-1

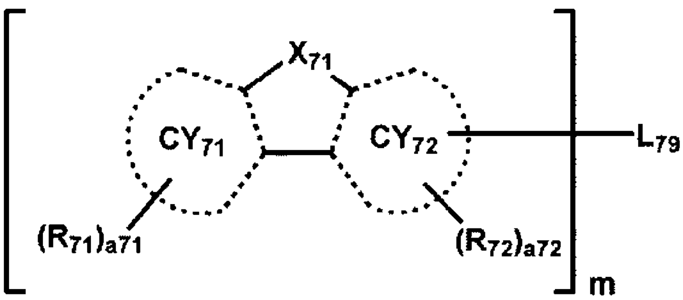

Formule 3-2

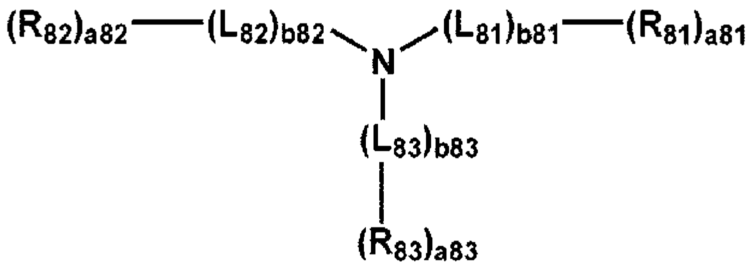

Formule 3-3

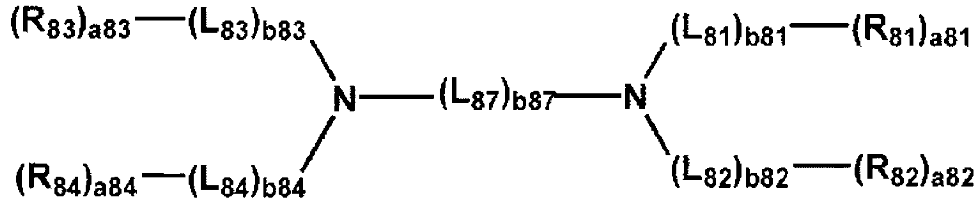

Formule 3-4

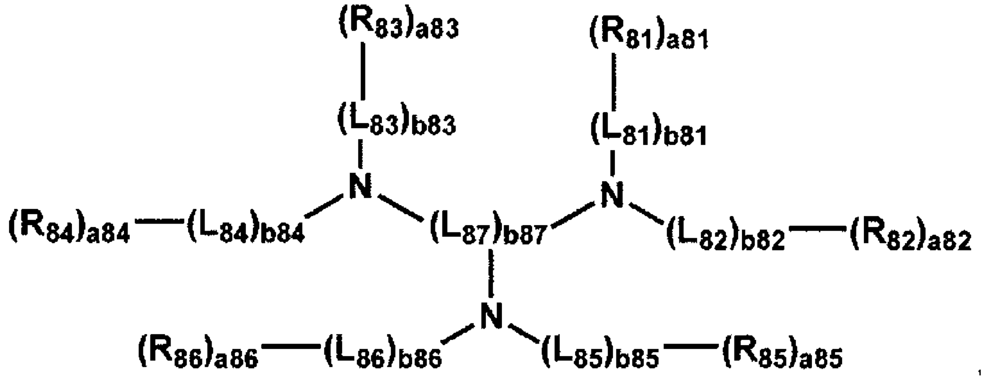

dans laquelle

le cycle $CY_{71}$ et le cycle $CY_{72}$ de la Formule 3-1 sont chacun indépendamment un groupe cyclique en $C_3$-$C_{30}$ riche en électrons $\pi$, et le cycle $CY_{71}$ et le cycle $CY_{72}$ de la Formule 3-1 sont, facultativement, liés l'un à l'autre via un groupe cyclique en $C_3$-$C_{30}$ riche en électrons $\pi$,

$X_{71}$ dans la Formule 3-1 est O, S, N-$(L_{75})_{b75}$-$(R_{75})_{a75}$, $C(R_{75})(R_{76})$, ou $Si(R_{75})(R_{76})$,

m dans la Formule 3-1 est 1, 2 ou 3, dans laquelle, lorsque m est 1, $L_{79}$ est absent,

i) $L_{75}$, $L_{79}$ et $L_{81}$ à $L_{87}$ des Formules 3-1 à 3-4 sont chacun indépendamment un groupe cyclique en $C_3$-$C_{30}$ riche en électrons $\pi$ non substitué ou substitué par le deutérium, un groupe alkyle en $C_1$-$C_{20}$, un groupe alcoxy en $C_1$-$C_{20}$, un groupe phényle, un groupe naphtyle, un groupe anthracényle, un groupe phénanthrényle, un groupe triphénylényle, un groupe fluorényle, un groupe di(alkyle en $C_1$-$C_{10}$)fluorényle, un groupe di(aryle en $C_6$-$C_{60}$) fluorényle, un groupe dibenzosilolyle, un groupe di(alkyle en $C_1$-$C_{10}$)dibenzosilolyle, un groupe di(aryle en $C_6$-$C_{60}$)dibenzosilolyle, un groupe carbazolyle, un groupe (alkyle en $C_1$-$C_{10}$)carbazolyle, un groupe (aryle en $C_6$-$C_{60}$)carbazolyle, un groupe dibenzofuranyle, un groupe dibenzothiophényle, un groupe biphényle, un groupe terphényle, un groupe tétraphényle, $-N(Q_{31})(Q_{32})$, ou n'importe quelle combinaison de ceux-ci, ou ii) $L_{79}$ dans la Formule 3-1 est une liaison simple,

$b_{75}$ et $b_{81}$ à $b_{87}$ dans les Formules 3-1 à 3-4 sont chacun indépendamment un entier de 1 à 10,

$R_{71}$, $R_{72}$, $R_{75}$, $R_{76}$, et $R_{81}$ à $R_{86}$ dans les Formules 3-1 à 3-4 sont chacun indépendamment : hydrogène ou deutérium ;

un groupe alkyle en $C_1$-$C_{20}$ non substitué ou substitué par le deutérium, un groupe phényle, un groupe naphtyle, un groupe anthracényle, un groupe phénanthrényle, un groupe triphénylényle, un groupe fluorényle, un groupe di(alkyle en $C_1$-$C_{10}$)fluorényle, un groupe di(aryle en $C_6$-$C_{60}$)fluorényle, un groupe dibenzosilolyle, un groupe di(alkyle en $C_1$-$C_{10}$)dibenzosilolyle, un groupe di(aryle en $C_6$-$C_{60}$)dibenzosilolyle, un groupe carbazolyle, un groupe (alkyle en $C_1$-$C_{10}$)carbazolyle, un groupe (aryle en $C_6$-$C_{60}$)carbazolyle, un groupe dibenzofuranyle, un groupe dibenzothiophényle, un groupe biphényle, un groupe terphényle, un groupe tétraphényle, $-N(Q_{31})(Q_{32})$, ou n'importe quelle combinaison de ceux-ci ;

un groupe cyclique en $C_3$-$C_{30}$ riche en électrons $\pi$ non substitué ou substitué par le deutérium, un groupe alkyle en $C_1$-$C_{20}$, un groupe alcoxy en $C_1$-$C_{20}$, un groupe phényle, un groupe naphtyle, un groupe anthracényle, un groupe phénanthrényle, un groupe triphénylényle, un groupe fluorényle, un groupe di(alkyle en $C_1$-$C_{10}$)fluorényle, un groupe di(aryle en $C_6$-$C_{60}$)fluorényle, un groupe dibenzosilolyle, un groupe di(alkyle en $C_1$-$C_{10}$) dibenzosilolyle, un groupe di(aryle en $C_6$-$C_{60}$)dibenzosilolyle, un groupe carbazolyle, un groupe (alkyle en $C_1$-$C_{10}$)carbazolyle, un groupe (aryle en $C_6$-$C_{60}$)carbazolyle, un groupe dibenzofuranyle, un groupe dibenzothiophényle, un groupe biphényle, un groupe terphényle, un groupe tétraphényle, $-N(Q_{31})(Q_{32})$, ou n'importe quelle combinaison de ceux-ci ; ou

$-N(Q_1)(Q_2)$,

a71, a72, a75 et a81 à a86 dans les Formules 3-1 à 3-4 sont chacun indépendamment un entier de 0 à 20, dans laquelle $Q_1$, $Q_2$, $Q_{31}$ et $Q_{32}$ sont chacun indépendamment l'hydrogène ; le deutérium ; -F ; -Cl ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe alkyle en $C_1$-$C_{60}$ non substitué ou substitué par le deutérium, un groupe alkyle en $C_1$-$C_{60}$, un groupe aryle en $C_6$-$C_{60}$ ou n'importe quelle combinaison de ceux-ci ; un groupe alcényle en $C_2$-$C_{60}$ ; un groupe alcynyle en $C_2$-$C_{60}$ ; un groupe alcoxy en $C_1$-$C_{60}$ ; un groupe cycloalkyle en $C_3$-$C_{10}$ ; un groupe hétérocycloalkyle en $C_2$-$C_{10}$ ; un groupe cycloalcényle en $C_3$-$C_{10}$ ; un groupe hétérocycloalcényle en $C_2$-$C_{10}$ ; un groupe aryle en $C_6$-$C_{60}$ non substitué ou substitué par le deutérium, un groupe alkyle en $C_1$-$C_{60}$, un groupe aryle en $C_6$-$C_{60}$ ou n'importe quelle combinaison de ceux-ci ; un groupe aryloxy en $C_6$-$C_{60}$ ; un groupe arylthio en $C_6$-$C_{60}$ ; un groupe hétéroaryle en $C_1$-$C_{60}$ ; un groupe polycyclique condensé non aromatique monovalent ; ou un groupe hétéropolycyclique condensé non aromatique monovalent.

**2.** Composition selon la revendication 1, dans laquelle

le composé organométallique contenant du Pt comprend du Pt et un ligand organique tétradentate, dans laquelle le Pt et le ligand organique tétradentate forment 3 ou 4 cycles cyclométallés ;
de préférence, dans laquelle
le ligand organique tétradentate comprend un groupe benzimidazole et un groupe pyridine.

**3.** Composition selon la revendication 1 ou 2, dans laquelle

une valeur absolue du niveau d'énergie HOMO du composé organométallique contenant du Pt est entre 5,25 eV et 5,55 eV, et
le niveau d'énergie HOMO du composé organométallique contenant du Pt est mesuré à l'aide d'un spectromètre photoélectronique dans l'air.

**4.** Composition selon l'une quelconque des revendications 1-3, dans laquelle

la fraction de transport d'électrons est un groupe cyano, un groupe fluoro, un groupe cyclique contenant de l'azote et déficient en électrons $\pi$, un groupe représenté par l'une des formules suivantes, ou n'importe quelle combinaison de ceux-ci :

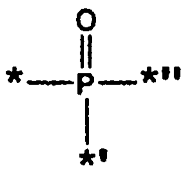
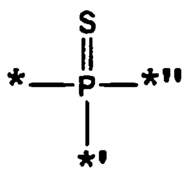
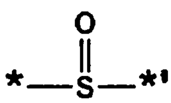
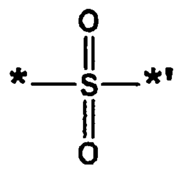
,

dans laquelle, dans les formules ci-dessus, *, *', et *" indiquent chacun un site de liaison à un atome voisin.

**5.** Composition selon l'une quelconque des revendications 1-4, dans laquelle
au moins un du deuxième composé et du troisième composé n'inclut pas de fraction de transport d'électrons.

**6.** Composition selon l'une quelconque des revendications 1-5, dans laquelle
au moins un du deuxième composé et du troisième composé comprend indépendamment :

i) un cycle condensé dans lequel un ou plusieurs cinquièmes cycles et un ou plusieurs sixièmes cycles sont condensés les uns avec les autres,
ii) un groupe représenté par

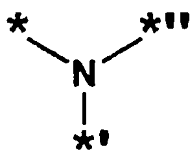
,

ou
iii) n'importe quelle combinaison de ceux-ci,
le cinquième cycle est un groupe cyclopentadiène, un groupe pyrrole, un groupe furane, un groupe thiophène ou un groupe silole,
le sixième cycle est un groupe cyclique en $C_3$-$C_{30}$ riche en électrons $\pi$, et
*, *', et *" indiquent chacun un site de liaison à un atome voisin.

**7.** Composition selon l'une quelconque des revendications 1-6, dans laquelle

le composé organométallique contenant du Pt est un composé organométallique représenté par la Formule 1, le premier composé est un composé représenté par la Formule 2 :

Formule 1

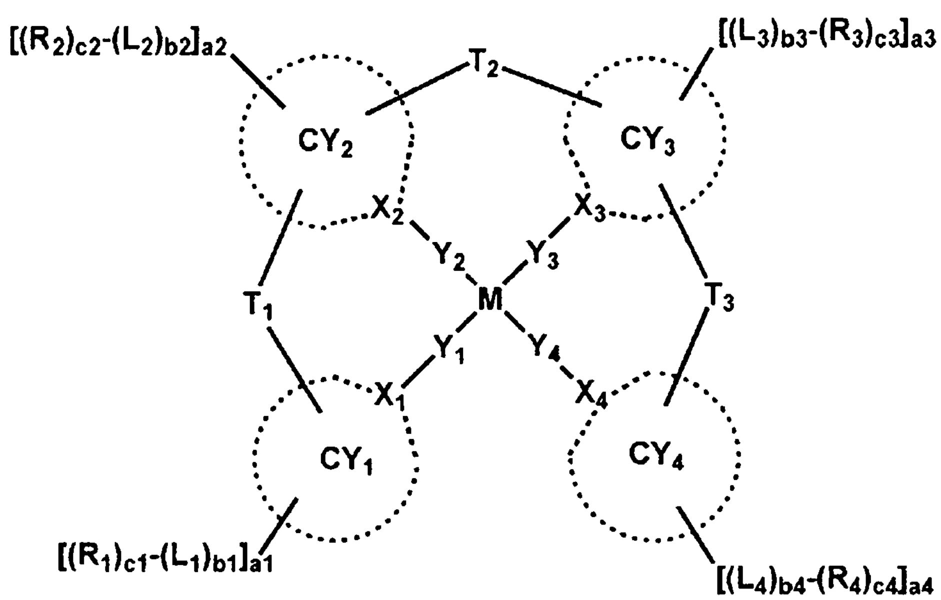

Formule 2

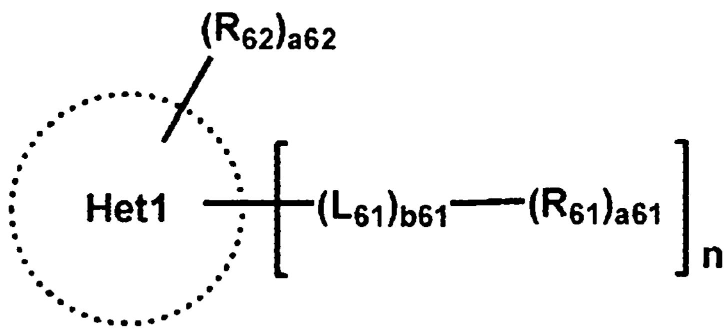

,

dans laquelle
M dans la Formule 1 est Pt,
$Y_1$ à $Y_4$ dans la Formule 1 sont chacun indépendamment une liaison chimique, O, S, $N(R_a)$, $C(R_a)(R_b)$, ou $Si(R_a)(R_b)$,
$X_1$ à $X_4$ dans la Formule 1 sont chacun indépendamment C ou N,
le cycle $CY_1$ au cycle $CY_4$ dans la Formule 1 sont chacun indépendamment un groupe carbocyclique en $C_5$-$C_{30}$ ou un groupe hétérocyclique en $C_1$-$C_{30}$,
$T_1$ dans la Formule 1 est une liaison simple, une liaison double, *-$N(R_{51})$-*', *-$B(R_{51})$-*', *- $P(R_{51})$-*', *-$C(R_{51})(R_{52})$-*', *-$Si(R_{51})(R_{52})$-*', *-$Ge(R_{51})(R_{52})$-*', *-S-*', *-Se-*', *-O-*', *-C(=O)-*', *-S(=O)-*', *-S(=O)2-*', *-$C(R_{51})$=*',

$*=C(R_{51})-*'$, $*-C(R_{51})=C(R_{52})-*'$, $*-C(=S)-*'$, ou $*-C\equiv C-*'$,

$T_2$ dans la Formule 1 est une liaison simple, une liaison double, $*-N(R_{53})-*'$, $-B(R_{53})-*'$, $*-P(R_{53})-*'$, $*-C(R_{53})(R_{54})-*'$, $*-Si(R_{53})(R_{54})-*'$, $*-Ge(R_{53})(R_{54})-*'$, $*-S-*'$, $*-Se-*'$, $*-O-*'$, $*-C(=O)-*'$, $*-S(=O)-*'$, $*-S(=O)_2-*'$, $*-C(R_{53})=*'$, $*=C(R_{53})-*'$, $*-C(R_{53})=C(R_{54})-*'$, $*-C(=S)-*'$, ou $*-C\equiv C-*'$,

$T_3$ dans la Formule 1 est une liaison simple, une liaison double, $*-N(R_{55})-*'$, $*-B(R_{55})-*'$, $*-P(R_{55})-*'$, $*-C(R_{55})(R_{56})-*'$, $*-Si(R_{55})(R_{56})-*'$, $*-Ge(R_{55})(R_{56})-*'$, $*-S-*'$, $*-Se-*'$, $*-O-*'$, $*-C(=O)-*'$, $*-S(=O)-*'$, $*-S(=O)_2-*'$, $*-C(R_{55})=*'$, $*=C(R_{55})-*'$, $*-C(R_{55})=C(R_{56})-*'$, $*-C(=S)-*'$, ou $*-C\equiv C-*'$,

Het1 dans la Formule 2 est un groupe cyclique en $C_1$-$C_{30}$ contenant de l'azote et déficient en électrons $\pi$,

n dans la Formule 2 est un entier compris entre 1 et 10,

$L_1$ à $L_4$, et $L_{61}$ dans les Formules 1 et 2 sont chacun indépendamment une liaison simple, un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$,

$b_1$ à $b_4$, et $b_{61}$ dans les Formules 1 et 2 sont chacun indépendamment un entier de 1 à 10,

Ra, $R_b$, $R_1$ à $R_4$, $R_{51}$ à $R_{56}$, $R_{61}$, et $R_{62}$ dans les Formules 1 et 2 sont chacun indépendamment l'hydrogène, le deutérium, -F, -Cl, -Br, -I, $-SF_5$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alcoxy en $C_1$-$C_{60}$ substitué ou non substitué, un groupe cycloalkyle en $C_3$-$C_{10}$ substitué ou non substitué, un groupe hétérocycloalkyle en $C_2$-$C_{10}$ substitué ou non substitué, un groupe cycloalcényle en $C_3$-$C_{10}$ substitué ou non substitué, un groupe hétérocycloalcényle en $C_2$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-B(Q_6)(Q_7)$, ou $-P(=O)(Q_8)(Q_9)$,

c1 à c4 dans la Formule 1 sont chacun indépendamment un entier compris entre 1 et 10,

a1 à a4, a61 et a62 dans les Formules 1 et 2 sont chacun indépendamment un entier compris entre 0 et 20,

deux ou plus des $R_a$, $R_b$, $R_1$ à $R_4$, et $R_{51}$ à $R_{56}$ dans la Formule 1 sont facultativement liés entre eux pour former un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$,

$R_{10a}$ est identique à celui défini en relation avec $R_1$,

* et *' indiquent chacun un site de liaison à un atome voisin,

un substituant du groupe alkyle en $C_1$-$C_{60}$ substitué, du groupe alcényle en $C_2$-$C_{60}$ substitué, du groupe alcynyle en $C_2$-$C_{60}$ substitué, du groupe alcoxy en $C_1$-$C_{60}$ substitué, du groupe cycloalkyle en $C_3$-$C_{10}$ substitué, du groupe hétérocycloalkyle en $C_2$-$C_{10}$ substitué, du groupe cycloalcényle en $C_3$-$C_{10}$ substitué, du groupe hétérocycloalcényle en $C_2$-$C_{10}$ substitué, du groupe aryle en $C_6$-$C_{60}$ substitué, du groupe aryloxy en $C_6$-$C_{60}$ substitué, du groupe arylthio en $C_6$-$C_{60}$ substitué, du groupe hétéroaryle en $C_1$-$C_{60}$ substitué, du groupe polycyclique condensé non aromatique monovalent substitué et du groupe hétéropolycyclique condensé non aromatique monovalent substitué est :

le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, ou un groupe alcoxy en $C_1$-$C_{60}$ ;

un groupe alkyle en $C_1$-$C_{60}$, un groupe alcényle en $C_2$-$C_{60}$, un groupe alcynyle en $C_2$-$C_{60}$, ou un groupe alcoxy en $C_1$-$C_{60}$, chacun substitué par le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en $C_3$-$C_{10}$, un groupe hétérocycloalcyle en $C_2$-$C_{10}$, un groupe cycloalcényle en $C_3$-$C_{10}$, un groupe hétérocycloalcényle en $C_2$-$C_{10}$, un groupe aryle en $C_6$-$C_{60}$, un groupe aryloxy en $C_6$-$C_{60}$, un groupe arythio en $C_6$-$C_{60}$, un groupe hétéroaryle en $C_1$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, $-P(=O)(Q_{18})(Q_{19})$, ou n'importe quelle combinaison de ceux-ci ;

un groupe cycloalkyle en $C_3$-$C_{10}$, un groupe hétérocycloalkyle en $C_2$-$C_{10}$, un groupe cycloalcényle en $C_3$-$C_{10}$, un groupe hétérocycloalcényle en $C_2$-$C_{10}$, un groupe aryle en $C_6$-$C_{60}$, un groupe aryloxy en $C_6$-$C_{60}$,

un groupe arylthio en $C_6$-$C_{60}$, un groupe hétéroaryle en $C_1$-$C_{60}$, un groupe polycyclique condensé non aromatique monovalent ou un groupe hétéropolycyclique condensé non aromatique monovalent, chacun non substitué ou substitué par le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe cycloalkyle en $C_3$-$C_{10}$, un groupe hétérocycloalkyle en $C_2$-$C_{10}$, un groupe cycloalcényle en $C_3$-$C_{10}$, un groupe hétérocycloalcényle en $C_2$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe polycyclique condensé non aromatique monovalent, un groupe hétéropolycyclique condensé non aromatique monovalent, - $N(Q_{21})(Q_{22})$, $-Si(Q_{23})(Q_{24})(Q_{25})$, $-B(Q_{26})(Q_{27})$, $-P(=O)(Q_{28})(Q_{29})$, ou n'importe quelle combinaison de ceux-ci ;
$-N(Q_{31})(Q_{32})$, $-Si(Q_{33})(Q_{34})(Q_{35})$, $-B(Q_{36})(Q_{37})$, ou $-P(=O)(Q_{38})(Q_{39})$) ; ou
n'importe quelle combinaison de ceux-ci, et
$Q_1$ à $Q_9$, $Q_{11}$ à $Q_{19}$, $Q_{21}$ à $Q_{29}$, et $Q_{31}$ à $Q_{39}$ sont chacun indépendamment l'hydrogène ; le deutérium ; -F ; -Cl ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe alkyle en $C_1$-$C_{60}$ non substitué ou substitué par le deutérium, un groupe alkyle en $C_1$-$C_{60}$, un groupe aryle en $C_6$-$C_{60}$ ou n'importe quelle combinaison de ceux-ci ; un groupe alcényle en $C_2$-$C_{60}$ ; un groupe alcynyle en $C_2$-$C_{60}$ ; un groupe alcoxy en $C_1$-$C_{60}$ ; un groupe cycloalkyle en $C_3$-$C_{10}$ ; un groupe hétérocycloalkyle en $C_2$-$C_{10}$ ; un groupe cycloalcényle en $C_3$-$C_{10}$ ; un groupe hétérocycloalcényle en $C_2$-$C_{10}$ ; un groupe aryle en $C_6$-$C_{60}$ non substitué ou substitué par le deutérium, un groupe alkyle en $C_1$-$C_{60}$, un groupe aryle en $C_6$-$C_{60}$ ou n'importe quelle combinaison de ceux-ci ; un groupe aryloxy en $C_6$-$C_{60}$ ; un groupe arylthio en $C_6$-$C_{60}$ ; un groupe hétéroaryle en $C_1$-$C_{60}$ ; un groupe polycyclique condensé non aromatique monovalent ; ou un groupe hétéropolycyclique condensé non aromatique monovalent.

**8.** Composition selon la revendication 7, dans laquelle

dans la Formule 1, $Y_1$ est O ou S, $Y_2$ à $Y_4$ sont chacun une liaison chimique, $X_1$ et $X_3$ sont chacun C, et $X_2$ et $X_4$ sont chacun N ; et/ou
dans laquelle
Het1 dans la Formule 2 est un groupe représenté par l'une des Formules 2-1 à 2-42 :

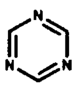
2-1
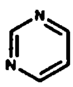
2-2
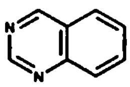
2-3
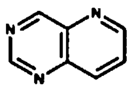
2-4
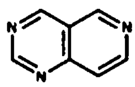
2-5
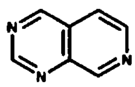
2-6
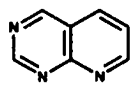
2-7

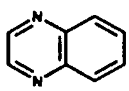
2-8
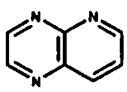
2-9
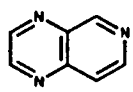
2-10
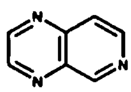
2-11
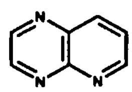
2-12
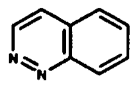
2-13

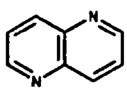
2-14
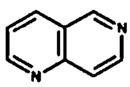
2-15
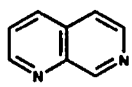
2-16
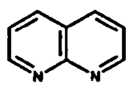
2-17
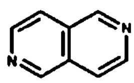
2-18
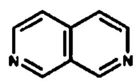
2-19

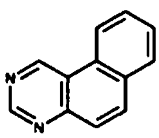
2-20
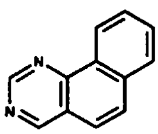
2-21
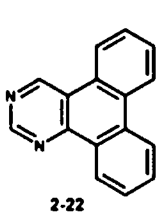
2-22
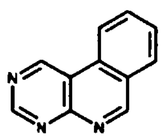
2-23
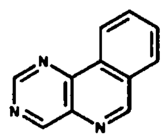
2-24

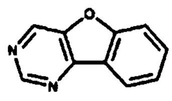
2-25
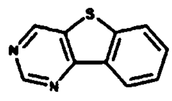
2-26
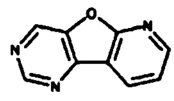
2-27
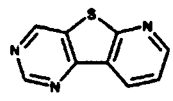
2-28

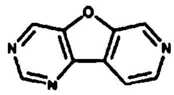
2-29
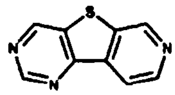
2-30
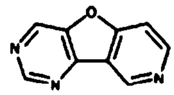
2-31
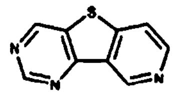
2-32

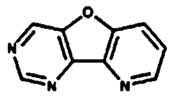
2-33
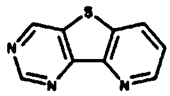
2-34
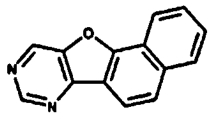
2-35
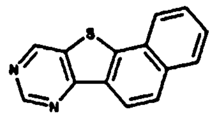
2-36

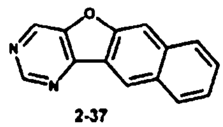
2-37
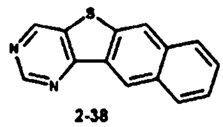
2-38
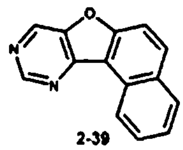
2-39
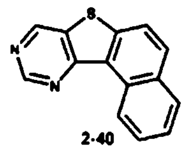
2-40

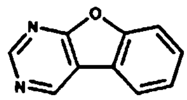
2-41
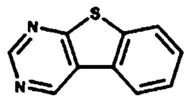
2-42

**9.** Composition selon l'une quelconque des revendications 1-8, dans laquelle

un groupe représenté par

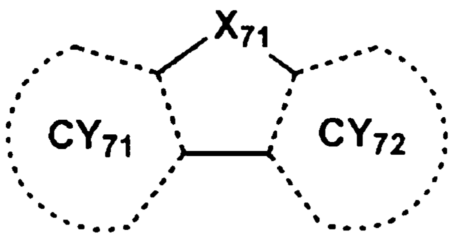

dans la Formule 3-1 est un groupe représenté par l'une des Formules 3(1) à 3(96) :

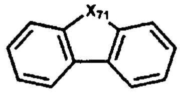
3(1)
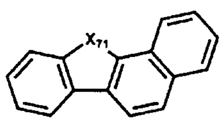
3(2)
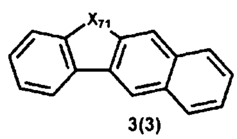
3(3)

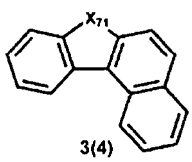
3(4)
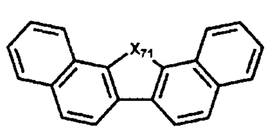
3(5)
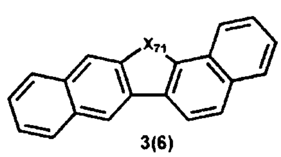
3(6)

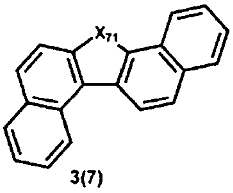
3(7)

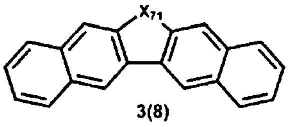
3(8)

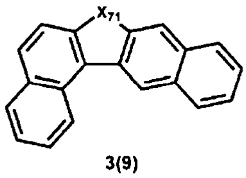
3(9)

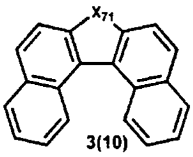
3(10)

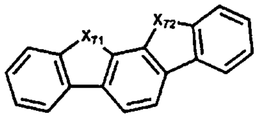
3(11)

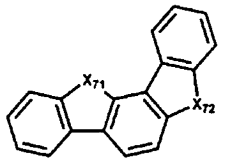
3(12)

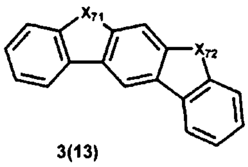
3(13)

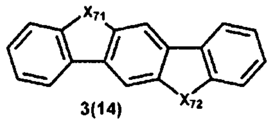
3(14)

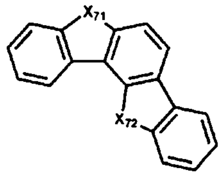
3(15)

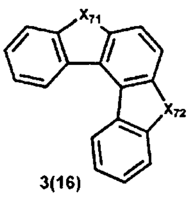
3(16)

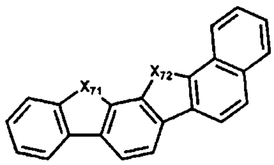
3(17)

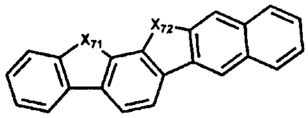
3(18)

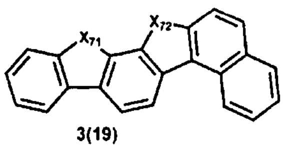
3(19)

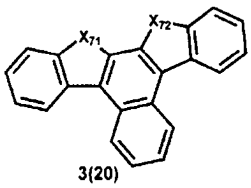
3(20)

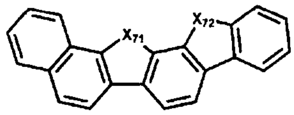
3(21)

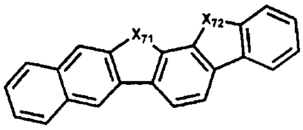
3(22)

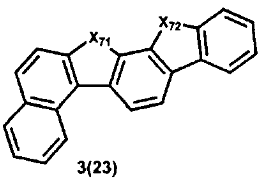
3(23)

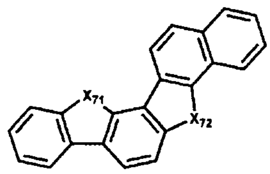
3(24)

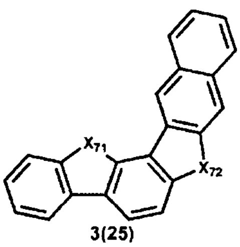
3(25)

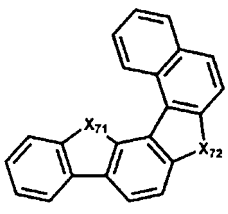
3(26)

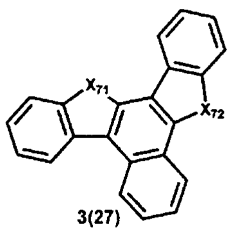
3(27)

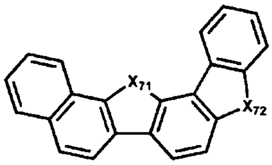
3(28)

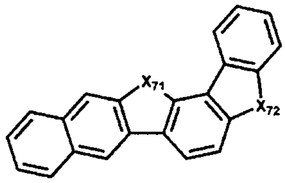
3(29)

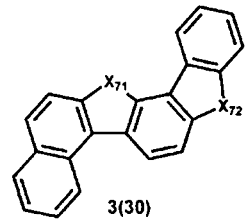
3(30)

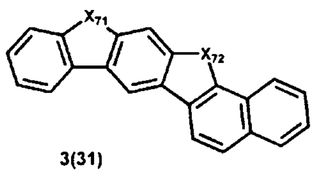
3(31)

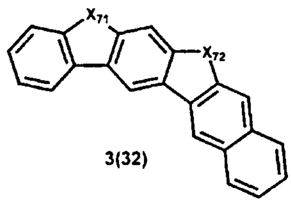
3(32)

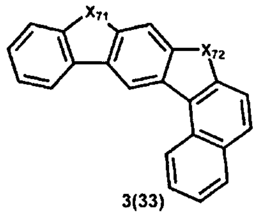
3(33)

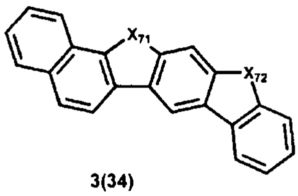
3(34)

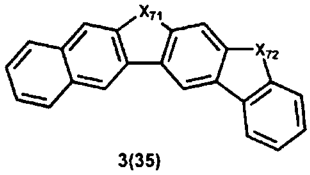
3(35)

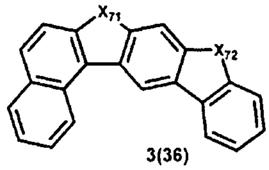
3(36)

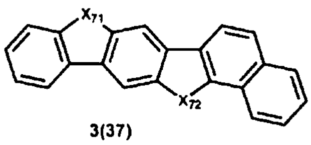
3(37)

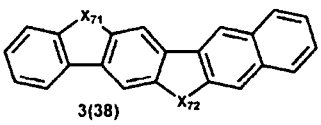
3(38)

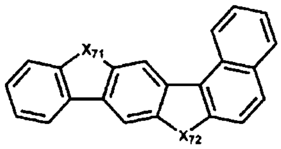
3(39)

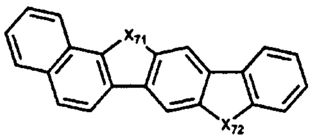
3(40)

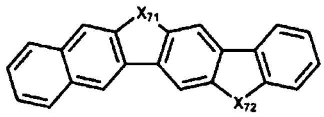
3(41)

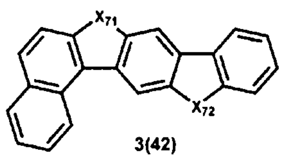
3(42)

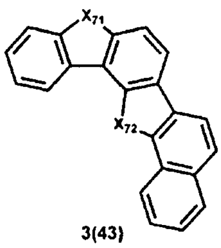
3(43)

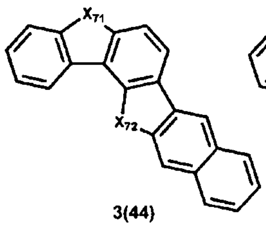
3(44)

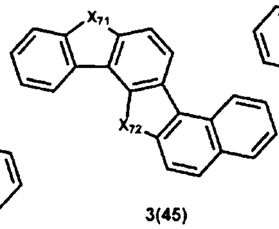
3(45)

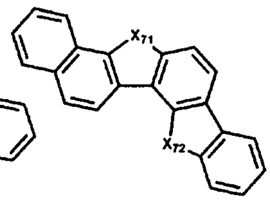
3(46)

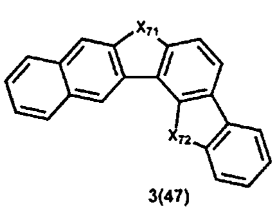
3(47)

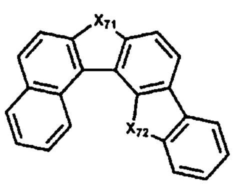
3(48)

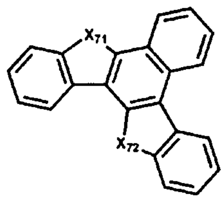
3(49)

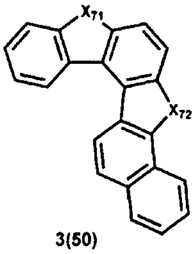
3(50)

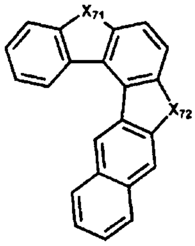
3(51)

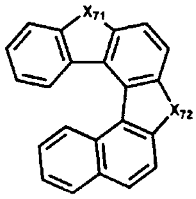
3(52)

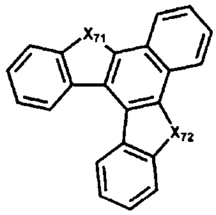
3(53)

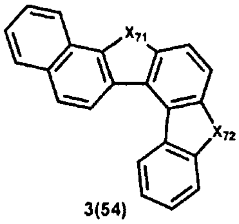
3(54)

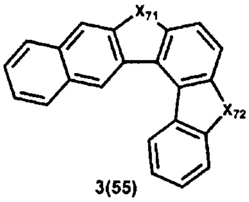
3(55)

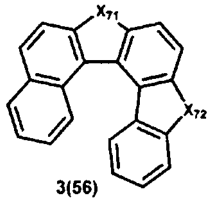
3(56)

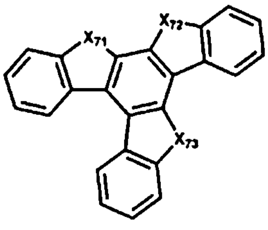
3(57)

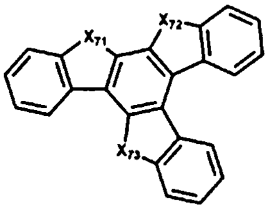
3(58)

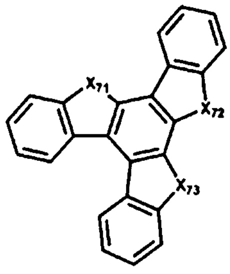
3(59)

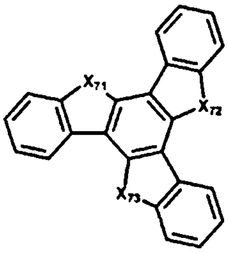
3(60)

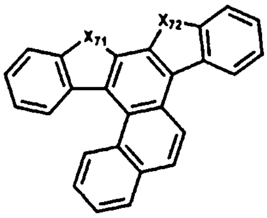
3(61)

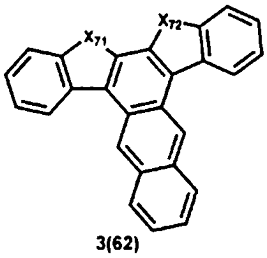
3(62)

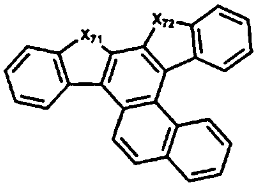
3(63)

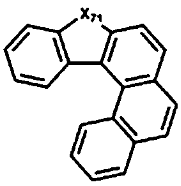
3(64)

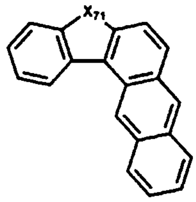
3(65)

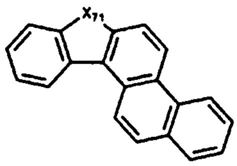
3(66)

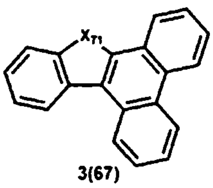
3(67)

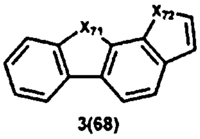
3(68)

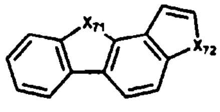
3(69)

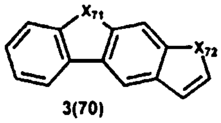
3(70)

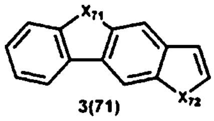
3(71)

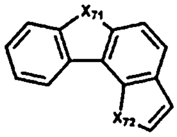
3(72)

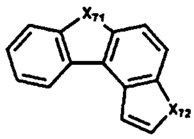
3(73)

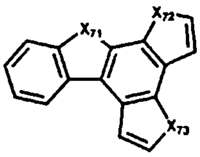
3(74)

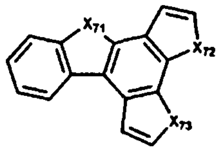
3(75)

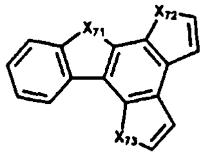
3(76)

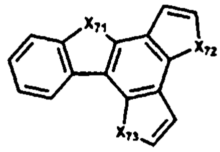
3(77)

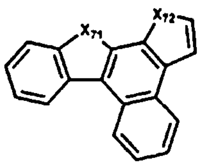
3(78)

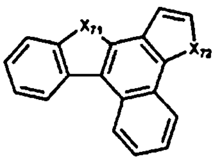
3(79)

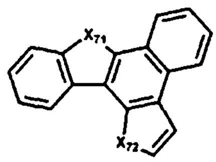
3(80)

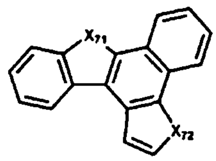
3(81)

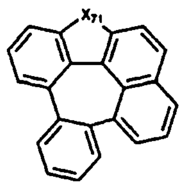
3(82)

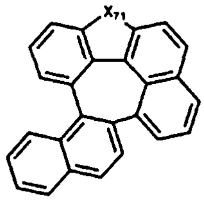
3(83)

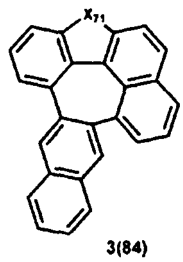
3(84)

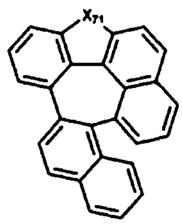
3(85)

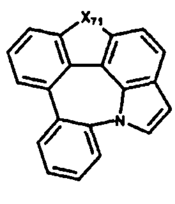
3(86)

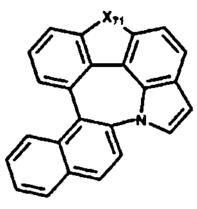
3(87)

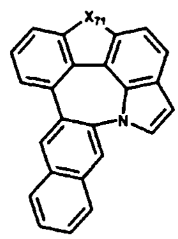
3(88)

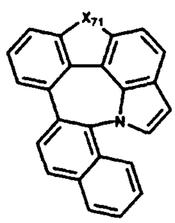
3(89)

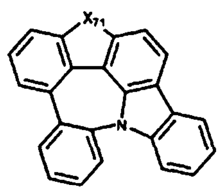
3(90)

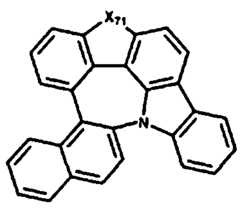
3(91)

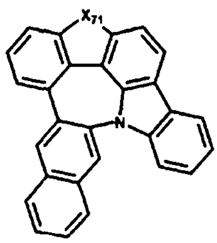
3(92)

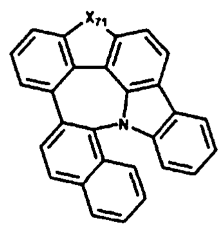
3(93)

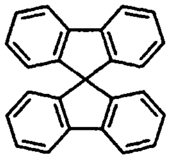

3(94)

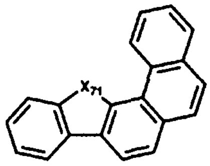

3(95)

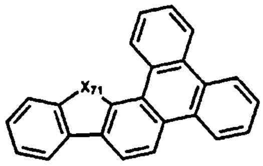

3(96)

',

dans laquelle, dans les Formules 3(1) à 3(96),

$X_{71}$ est identique à celui défini dans la revendication 1,

$X_{72}$ est O, S, $N(R_{78a})$, $C(R_{78a})(R_{78b})$ ou $Si(R_{78a})(R_{78b})$,

$X_{73}$ est O, S, $N(R_{79a})$, $C(R_{79a})(R_{79b})$ ou $Si(R_{79a})(R_{79b})$, et

$R_{78a}$, $R_{78b}$, $R_{79a}$ et $R_{79b}$ sont chacun identiques à ceux définis en relation avec $R_{71}$ dans la revendication 1.

**10.** Composition selon l'une quelconque des revendications 7-9, dans laquelle dans la Formule 1,

a1 à a4 sont chacun indépendamment un entier compris entre 1 et 20, et

au moins un de $R_1$ à $R_4$ est chacun, indépendamment, un groupe alcoxy en $C_1$-$C_{60}$ substitué ou non substitué, un groupe cycloalkyle en $C_3$-$C_{10}$ substitué ou non substitué, un groupe hétérocycloalkyle en $C_2$-$C_{10}$ substitué ou non substitué, un groupe cycloalcényle en $C_3$-$C_{10}$ substitué ou non substitué, un groupe hétérocycloalcényle en $C_2$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, ou $-B(Q_6)(Q_7)$.

**11.** Composition selon l'une quelconque des revendications 7-10, dans laquelle

le composé organométallique contenant du Pt est un composé représenté par la Formule 1-1 ou 1-2 :

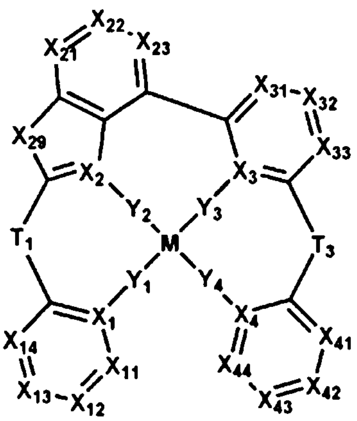

1-1

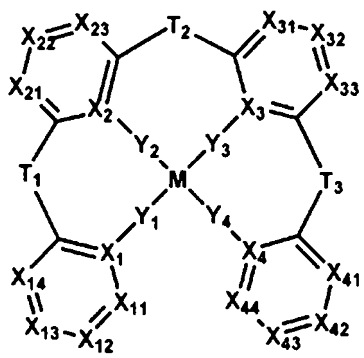

1-2

,

dans laquelle, dans les Formules 1-1 et 1-2,

M, $Y_1$ à $Y_4$, $X_1$ à $X_4$, et $T_1$ à $T_3$ sont chacun identiques à ceux définis dans la revendication 7,

$X_{11}$ est N ou $C-[(L_{11})_{b11}-(R_{11})_{c11}]$, $X_{12}$ est N ou $C-[(L_{12})_{b12}-(R_{12})_{c12}]$, $X_{13}$ est N ou $C-[(L_{13})_{b13}-(R_{13})_{c13}]$, et $X_{14}$ est N ou $C-[(L_{14})_{b14}-(R_{14})_{c14}]$,

$L_{11}$ à $L_{14}$, $b_{11}$ à $b_{14}$, $R_{11}$ à $R_{14}$ et c11 à c14 sont chacun identiques à ceux définis en relation avec $L_1$, $b_1$, $R_1$ et c1 dans la revendication 7, respectivement,

$X_{21}$ est N ou $C-[(L_{21})_{b21}-(R_{21})_{c21}]$, $X_{22}$ est N ou $C-[(L_{22})_{b22}-(R_{22})_{c22}]$, et $X_{23}$ est N ou $C-[(L_{23})_{b23}-(R_{23})_{c23}]$,

$L_{21}$ à $L_{23}$, $b_{21}$ à $b_{23}$, $R_{21}$ à $R_{23}$, et c21 à c23 sont chacun identiques à ceux définis en relation avec $L_2$, b2, $R_2$ et c2 dans la revendication 7, respectivement,

$X_{29}$ est O, S, $C(R_{27})(R_{28})$, $Si(R_{27})(R_{28})$, ou $N-[(L_{29})_{b29}-(R_{29})_{c29}]$,

$R_{27}$ à $R_{29}$ sont chacun identiques à ceux définis en relation avec $R_2$ dans la revendication 7, et $L_{29}$, b29 et c29 sont chacun identiques à ceux définis en relation avec $L_2$, b2 et c2 dans la revendication 7, respectivement,
$X_{31}$ est N ou C-$[(L_{31})_{b31}$-$(R_{31})_{c31}]$, $X_{32}$ est N ou C-$[(L_{32})_{b32}$-$(R_{32})_{c32}]$, et $X_{33}$ est N ou C-$[(L_{33})_{b33}$-$(R_{33})_{c33}]$,
$L_{31}$ à $L_{33}$, b31 à b33, $R_{31}$ à $R_{33}$, et c31 à c33 sont chacun identiques à ceux définis en relation avec $L_3$, b3, $R_3$ et c3 dans la revendication 7, respectivement,
X41 est N ou C-$[(L_{41})_{b41}$-$(R_{41})_{c41}]$, $X_{42}$ est N ou C-$[(L_{42})_{b42}$-$(R_{42})_{c42}]$, $X_{43}$ est N ou C-$[(L_{43})_{b43}$-$(R_{43})_{c43}]$, et $X_{44}$ est N ou C-$[(L_{44})_{b44}$-$(R_{44})_{c44}]$,
$L_{41}$ à $L_{44}$, b41 à b44, $R_{41}$ à $R_{44}$, et c41 à c44 sont chacun identiques à ceux définis en relation avec $L_4$, b4, $R_4$ et c4 dans la revendication 7, respectivement,
deux des $R_{11}$ à $R_{14}$ sont facultativement liés l'un à l'autre pour former un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$,
deux des $R_{21}$ à $R_{23}$ sont facultativement liés l'un à l'autre pour former un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$,
deux des $R_{31}$ à $R_{33}$ sont facultativement liés l'un à l'autre pour former un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$, et
deux des $R_{41}$ à $R_{44}$ sont facultativement liés l'un à l'autre pour former un groupe carbocyclique en $C_5$-$C_{30}$ non substitué ou substitué par au moins un $R_{10a}$, ou un groupe hétérocyclique en $C_1$-$C_{30}$ non substitué ou substitué par au moins un $R_{10a}$.

**12.** Composition selon l'une quelconque des revendications 1-11, dans laquelle la composition satisfait à l'Équation 1 et à l'Équation 2 ci-dessous :

Équation 1

$$\text{HOMO (H2)} > \text{HOMO (D)}$$

Équation 2

$$\text{HOMO (H3)} > \text{HOMO (D)},$$

dans laquelle, dans les Équations 1 et 2,

HOMO (H2) est une valeur absolue d'un niveau d'énergie HOMO du deuxième composé,
HOMO (H3) est une valeur absolue d'un niveau d'énergie HOMO du troisième composé,
HOMO (D) est une valeur absolue d"un niveau d'énergie HOMO du composé organométallique contenant du Pt, et
le niveau d'énergie HOMO du composé organométallique contenant du Pt est mesuré à l'aide d'un spectromètre photoélectronique dans l'air ;
de préférence, dans laquelle
la différence entre la valeur absolue du niveau d'énergie HOMO du deuxième composé et la valeur absolue du niveau d'énergie HOMO du composé organométallique contenant du Pt est entre 0,05 eV et 0,6 eV, et
la différence entre la valeur absolue du niveau d'énergie HOMO du troisième composé et la valeur absolue du niveau d'énergie HOMO du composé organométallique contenant du Pt est entre 0,05 eV et 0,6 eV.

**13.** Dispositif électroluminescent organique comprenant :

une première électrode ;
une seconde électrode ; et
une couche organique disposée entre la première électrode et la seconde électrode et incluant une couche d'émission,
dans lequel la couche organique inclut la composition selon l'une quelconque des revendications 1-12 ;
de préférence, dans lequel
la couche d'émission inclut la composition.

**14.** Dispositif électroluminescent organique selon la revendication 13, dans lequel la couche d'émission inclut un dopant et un hôte,

le dopant inclut le composé organométallique contenant du platine de la composition, et
l'hôte inclut le premier composé de la composition, le deuxième composé de la composition et le troisième composé de la composition ; et/ou
dans lequel
la couche d'émission émet de la lumière verte.

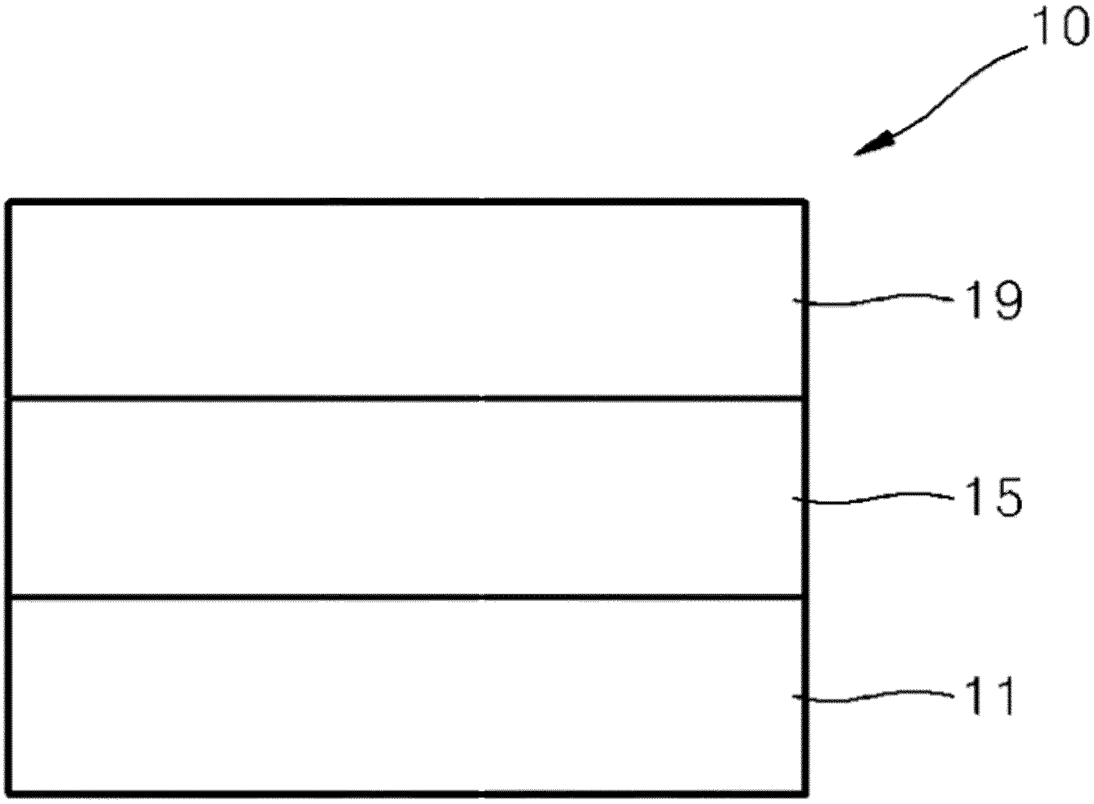
10
19
15
11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3435438 A2
- EP 3439063 A1